(19) Europäisches Patentamt
European Patent Office
Office européen des brevets

(11) EP 3 940 805 B1

(12) EUROPEAN PATENT SPECIFICATION

(45) Date of publication and mention of the grant of the patent:
**27.03.2024 Bulletin 2024/13**

(21) Application number: **21184613.4**

(22) Date of filing: **08.07.2021**

(51) International Patent Classification (IPC):
***H10K 50/11*** *(2023.01)* ***H10K 50/12*** *(2023.01)*
***H10K 85/30*** *(2023.01)* ***H10K 85/60*** *(2023.01)*

(52) Cooperative Patent Classification (CPC):
**H10K 85/636; H10K 85/346; H10K 85/40; H10K 85/654; H10K 85/657; H10K 85/6572; H10K 85/6574;** H10K 50/11; H10K 50/121; H10K 2101/10; H10K 2101/20; H10K 2101/90

(54) **LIGHT-EMITTING DEVICE AND ELECTRONIC APPARATUS COMPRISING SAME**

LICHTEMITTIERENDE VORRICHTUNG UND ELEKTRONISCHE VORRICHTUNG DAMIT

DISPOSITIF ÉLECTROLUMINESCENT ET APPAREIL ÉLECTRONIQUE LE COMPRENANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.07.2020 KR 20200086448**

(43) Date of publication of application:
**19.01.2022 Bulletin 2022/03**

(73) Proprietor: **Samsung Display Co., Ltd.**
**Gyeonggi-do 17113 (KR)**

(72) Inventors:
- **KO, Soobyung**
  **Yongin-si (KR)**
- **SHIN, Sujin**
  **Yongin-si (KR)**
- **AHN, Eunsoo**
  **Yongin-si (KR)**
- **LYU, Jaejin**
  **Yongin-si (KR)**
- **LEE, Jihyung**
  **Yongin-si (KR)**
- **HAN, Junghoon**
  **Yongin-si, (KR)**

(74) Representative: **Russell, Tim et al**
**Venner Shipley LLP**
**200 Aldersgate**
**London EC1A 4HD (GB)**

(56) References cited:
**EP-A1- 3 544 076 US-A1- 2019 153 308**

- **SI HYUN HAN ET AL: "Ideal blue thermally activated delayed fluorescence emission assisted by a thermally activated delayed fluorescence assistant dopant through a fast reverse intersystem crossing mediated cascade energy transfer process", JOURNAL OF MATERIALS CHEMISTRY C, vol. 7, no. 10, 13 February 2019 (2019-02-13), pages 3082-3089, XP055687954, GB ISSN: 2050-7526, DOI: 10.1039/C8TC06575F**
- **XIAO LIANG ET AL: "Peripheral Amplification of Multi-Resonance Induced Thermally Activated Delayed Fluorescence for Highly Efficient OLEDs", ANGEWANDTE CHEMIE INTERNATIONAL EDITION, vol. 57, no. 35, 30 July 2018 (2018-07-30) , pages 11316-11320, XP055537488, ISSN: 1433-7851, DOI: 10.1002/anie.201806323**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 940 805 B1

## Description

### CROSS-REFERENCE TO RELATED APPLICATION

This application claims priority to and the benefit of Korean Patent Application No. 10-2020-0086448, filed on July 13, 2020, in the Korean Intellectual Property Office.

### BACKGROUND

#### 1. Field

One or more aspects of embodiments of the present disclosure relate to a light-emitting device and an electronic apparatus comprising the light-emitting device.

#### 2. Description of Related Art

Light-emitting devices are self-emission devices that have wide viewing angles, high contrast ratios, short response times, and excellent characteristics in terms of brightness, driving voltage, and/or response speed.

Light-emitting devices may comprise a first electrode on a substrate, and a hole transport region, an emission layer, an electron transport region, and a second electrode sequentially stacked on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons. These excitons transit from an excited state to a ground state to thereby generate light.

The document EP 3 544 076 A1 is concerning an organic light-emitting diode used in an electronic apparatus which contains two electrodes and an emission layer comprising a first transition metal complex, a second heterocyclic compound and a third compound containing nitrogen-containing group.

### SUMMARY

The present invention is defined by the claims.

One or more aspects of embodiments of the present disclosure are directed toward a light-emitting device having high luminescence efficiency and long lifespan and an electronic apparatus comprising the light-emitting device.

Additional aspects will be set forth in part in the description which follows and, in part, will be apparent from the description, or may be learned by practice of the presented embodiments of the disclosure.

According to one or more embodiments, there is provided a light-emitting device comprising:

a first electrode;
a second electrode facing the first electrode; and
an interlayer located between the first electrode and the second electrode, the interlayer comprising an emission layer, wherein the interlayer comprises:

i) a first compound; and
ii) a second compound comprising at least one $\pi$ electron-deficient nitrogen-containing $C_1$-$C_{60}$ cyclic group, a third compound, a fourth compound capable of emitting delayed fluorescent light, or any combination thereof, and

the first compound, the second compound, the third compound, and the fourth compound may be different from one another,
wherein the first compound is represented by Formula 1

Formula 1

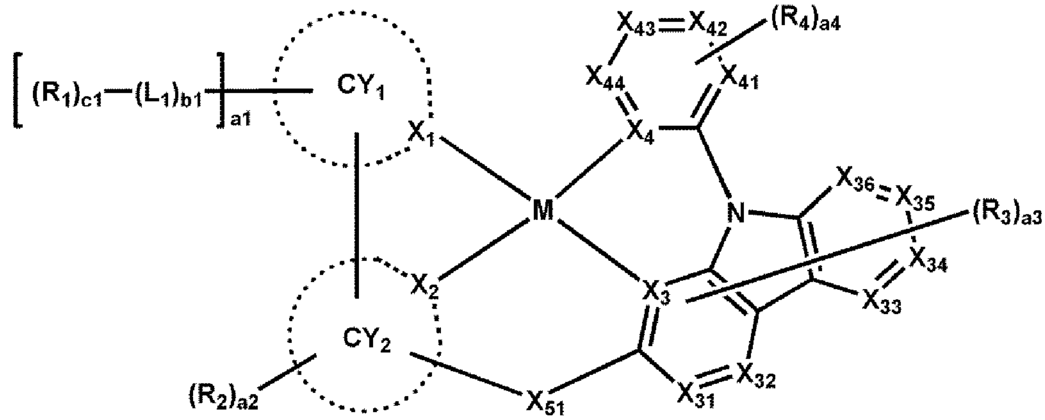

wherein, in Formula 1, M is platinum (Pt), palladium (Pd), gold (Au), nickel (Ni), silver (Ag), or copper (Cu),

in Formula 1, $X_1$ to $X_4$ are each independently be C or N,

in Formula 1, i) a bond between $X_1$ and M is a coordinate bond, and ii) one of a bond between $X_2$ and M, a bond between $X_3$ and M, and a bond between $X_4$ and M is a coordinate bond, and the other two bonds are each a covalent bond,

in Formula 1, ring $CY_1$ is i) a $X_1$-containing 5-membered ring, ii) a $X_1$-containing 5-membered ring condensed with at least one 6-membered ring, or iii) a $X_1$-containing 6-membered ring,

in Formula 1, ring $CY_2$ is a $C_3$-$C_{60}$ carbocyclic group or a $C_1$-$C_{60}$ heterocyclic group,

in Formula 1, $X_{31}$ to $X_{36}$ and $X_{41}$ to $X_{44}$ are each independently C or N,

in Formula 1, $X_{51}$ is *-N($R_5$)-*', *-B($R_5$)-*', *-P($R_5$)-*', *-C($R_{5a}$)($R_{5b}$)-*', *-Si($R_{5a}$)($R_{5b}$)-*', *-Ge($R_{5a}$)($R_{5b}$)-*', *-S-*', *-Se-*', *-O-*', *-C(=O)-*', *-S(=O)-*', *-S(=O)$_2$-*', *-C(Rs)=*', *=C($R_5$)-*', *-C($R_{5a}$)=C($R_{5b}$)-*', *-C(=S)-*', or *-C=C-*', and * and *' may each indicate a binding site to an adjacent atom,

in Formula 1, $L_1$ is a single bond, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,

in Formula 1, b1 is an integer from 1 to 5,

in Formula 1, c1 is an integer from 0 to 5, a1 and a4 are each independently be an integer from 0 to 4, a2 is an integer from 0 to 10, and a3 is an integer from 0 to 6, provided that the sum of a1 to a4 is 1 or greater, and at least one of *-$(L_1)_{b1}$-$(R_1)_{c1}$(s) in the number of a1, at least one of $R_2$(s) in the number of a2, at least one of $R_3$(s) in the number of a3, at least one of $R_4$(s) in the number of a4, or any combination thereof are each independently be the group represented by Formula 1-1 or the group represented by Formula 1-2,

in Formula 1, $R_1$ to $R_5$, $R_{5a}$, and $R_{5b}$ are each independently a group represented by Formula 1-1, a group represented by Formula 1-2, hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, - C($Q_1$)($Q_2$)($Q_3$), -Si($Q_1$)($Q_2$)($Q_3$), -N($Q_1$)($Q_2$), -B($Q_1$)($Q_2$), -C(=O)($Q_1$), -S(=O)$_2$($Q_1$), or - P(=O)($Q_1$)($Q_2$),

Formula 1-1

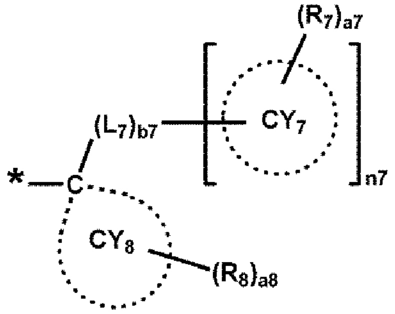

Formula 1-2

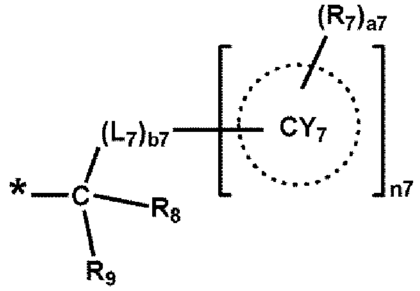

in Formulae 1-1 and 1-2, $L_7$ is a single bond, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
in Formulae 1-1 and 1-2, b7 is an integer from 1 to 5,
in Formulae 1-1 and 1-2, ring $CY_7$ is a $C_3$-$C_{60}$ carbocyclic group or a $C_1$-$C_{60}$ heterocyclic group,
in Formulae 1-1 and 1-2, n7 is an integer from 1 to 5,
in Formula 1-1, ring $CY_8$ is a non-aromatic $C_3$-$C_{60}$ carbocyclic group or a non-aromatic $C_1$-$C_{60}$ heterocyclic group,
in Formulae 1-1 and 1-2, $R_7$ to $R_9$ are each independently the same as described for $R_1$,
in Formulae 1-1 and 1-2, a7 and a8 are each independently an integer from 0 to 20,
at least two groups represented by $*-(L_1)_{b1}-(R_1)_{c1}$ in the number of a1 are optionally bound to form a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
at least two of $R_2$(s) in the number of a2 are optionally bound to form a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
at least two of $R_3$(s) in the number of a3 are optionally bound to form a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
at least two of $R_4$(s) in the number of a4 are optionally bound to form a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
at least two of $R_1$ to $R_5$, $R_{5a}$, and $R_{5b}$(s) are optionally bound to form a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$, and
each $R_{10a}$ is independently:
deuterium (-D), -F, -Cl, -Br, -I, a hydroxyl group, a cyano group, or a nitro group;
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each independently unsubstituted or substituted with deuterium, -F, - Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, - $Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, - $P(=O)(Q_{11})(Q_{12})$, or any combination thereof;
a $C_3$-$C_{60}$ carbocyclic group, a $C_1$-$C_{60}$ heterocyclic group, a $C_6$-$C_{60}$ aryloxy group, or a $C_6$-$C_{60}$ arylthio group, each independently unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, $-Si(Q_{21})(Q_{22})(Q_{23})$, $-N(Q_{21})(Q_{22})$, $-B(Q_{21})(Q_{22})$, $-C(=O)(Q_{21})$, $-S(=O)_2(Q_{21})$, $-P(=O)(Q_{21})(Q_{22})$, or any combination thereof; or
$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, or - $P(=O)(Q_{31})(Q_{32})$,
wherein $Q_1$ to $Q_3$, $Q_{11}$ to $Q_{13}$, $Q_{21}$ to $Q_{23}$, and $Q_{31}$ to $Q_{33}$ are each independently hydrogen; deuterium; -F; -Cl; -Br; -I; a hydroxyl group; a cyano group; a nitro group; a $C_1$-$C_{60}$ alkyl group; a $C_2$-$C_{60}$ alkenyl group; a $C_2$-$C_{60}$ alkynyl group; a $C_1$-$C_{60}$ alkoxy group; a $C_3$-$C_{60}$ carbocyclic group or a $C_1$-$C_{60}$ heterocyclic group, wherein, when present, each $C_1$-$C_{60}$ alkyl group; $C_2$-$C_{60}$ alkenyl group; $C_2$-$C_{60}$ alkynyl group; $C_1$-$C_{60}$ alkoxy group; $C_3$-$C_{60}$ carbocyclic group or $C_1$-$C_{60}$ heterocyclic group is optionally independently substituted with deuterium, -F, a cyano group, a $C_1$-$C_{60}$ alkyl group, a $C_1$-$C_{60}$ alkoxy group, a phenyl group, a biphenyl group, a pyridinyl group, a pyrimidinyl group, a pyridazinyl group, a pyrazinyl group, a triazinyl group, or any combination thereof, and
the third compound comprises a group represented by Formula 3

Formula 3

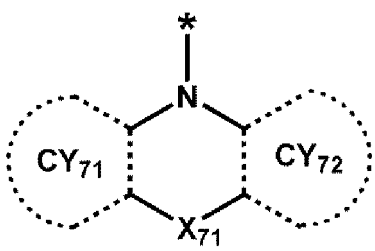
,

in Formula 3, ring $CY_{71}$ and ring $CY_{72}$ are each independently a π electron-rich $C_3$-$C_{60}$ cyclic group or a pyridine group,
in Formula 3, $X_{71}$ is a single bond or a linking group comprising O, S, N, B, C, Si, or any combination thereof,
in Formula 3, * indicates a binding site to an adjacent atom, and
the following compounds are excluded from the third compound:

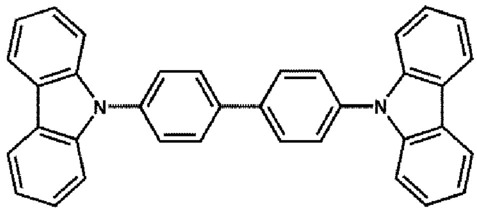

CBP

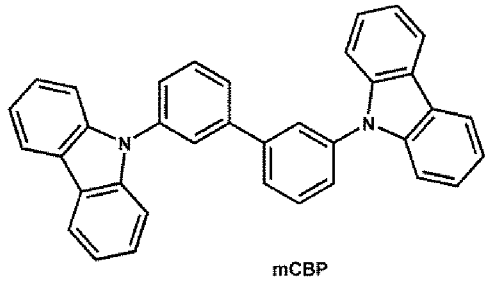

mCBP .

According to one or more embodiments, there is provided an electronic apparatus comprising a light-emitting device as described herein.

According to one or more embodiments, there is provided an organometallic compound represented by Formula 1:

## BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a schematic cross-sectional view of a light-emitting device according to one or more embodiments;
FIG. 2 is a schematic cross-sectional view of an electronic apparatus according to one or more embodiments;
FIG. 3 is a schematic cross-sectional view of an electronic apparatus according to one or more embodiments;
FIG. 4 is a graph showing electroluminescence (EL) spectra of organic light-emitting devices of Examples 1 to 6 and 11 and Comparative Example 1;
FIG. 5 is a graph of wavelength (nanometers, nm) versus normalized intensity (arbitrary unit, a.u.), showing EL spectra of the organic light-emitting devices of Examples 1, 7, and 8;
FIG. 6 is a graph of luminance ($cd/m^2$) versus luminescence efficiency (cd/A) of the organic light-emitting devices of Examples 1 to 8 and 11 and Comparative Example 1; and
FIG. 7 is a graph of time (hours) versus luminance (percent, %) of the organic light-emitting devices of Examples 1 to 8 and 11 and Comparative Example 1.

## DETAILED DESCRIPTION

Reference will now be made in more detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. The use of "may" when describing embodiments of the present disclosure refers to "one or more embodiments of the present disclosure."

A light-emitting device comprising: a first electrode; a second electrode facing the first electrode; an interlayer between the first electrode and the second electrode and comprising an emission layer, wherein the interlayer comprises:

i) a first compound; and
ii) a second compound comprising at least one $\pi$ electron-deficient nitrogen-containing $C_1$-$C_{60}$ cyclic group, a third, a fourth compound capable of emitting delayed fluorescent light, or any combination thereof, and

the first compound, the second compound, the third compound, and the fourth compound are different from one another,
wherein the first compound is represented by Formula 1

Formula 1

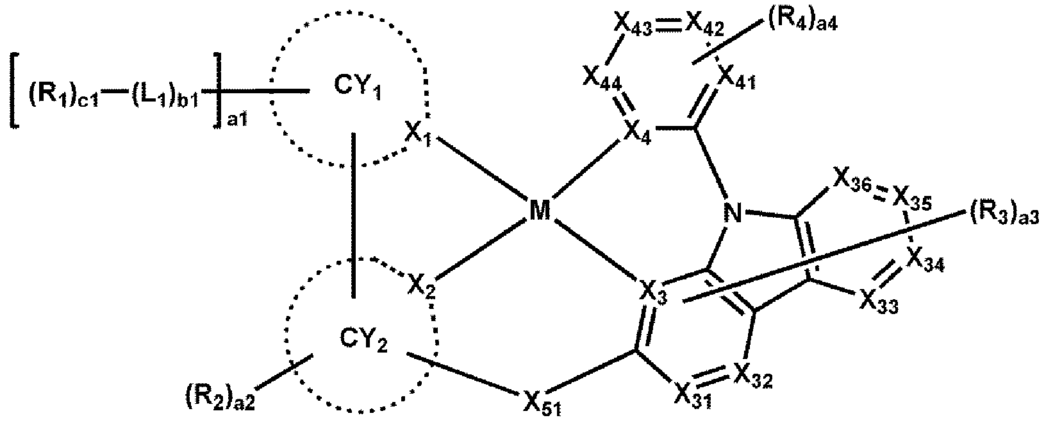

,

wherein Formula 1 may be understood by referring to the description of Formula 1 provided herein;
the third compound comprises a group represented by Formula 3

Formula 3

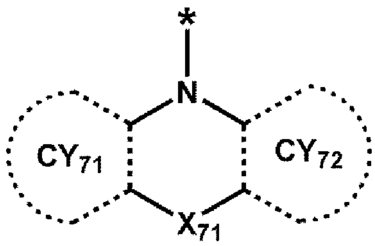

,

wherein Formula 3 may be understood by referring to the description of Formula 3 provided herein, and
the following compounds are excluded from the third compound:

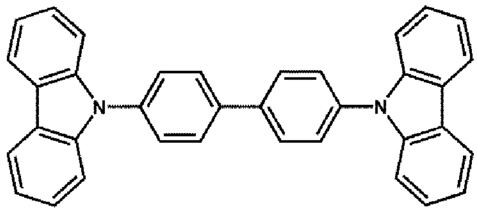

CBP

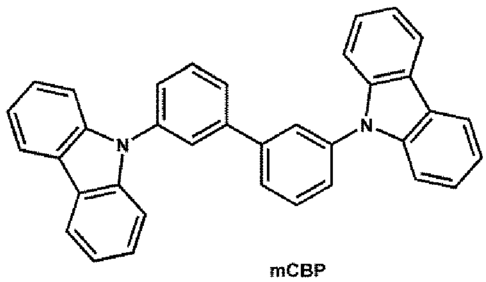

mCBP

.

Descriptions of the first compound to the fourth compound

The second compound may comprise a pyridine group, a pyrimidine group, a pyrazine group, a pyridazine group, a triazine group, or any combination thereof.

In some embodiments, the light-emitting device may further comprise at least one of the second compound and the third compound, in addition to the first compound.

In some embodiments, the light-emitting device may further comprise the fourth compound, in addition to the first compound.

In some embodiments, the light-emitting device may comprise the first compound, the second compound, the third compound, and the fourth compound.

In some embodiments, the interlayer may comprise the second compound. The interlayer may further comprise, in addition to the first compound and the second compound, the third compound, the fourth compound, or any combination thereof.

In some embodiments, a difference (an absolute value) between the triplet energy level (in electron Volts, eV)

of the fourth compound and the singlet energy level (in electron Volts, eV) of the fourth compound may be about 0 eV or higher and about 0.5 eV or lower (or, about 0 eV or higher and about 0.3 eV or lower).

In some embodiments, the fourth compound may be a compound comprising at least one cyclic group comprising boron (B) and nitrogen (N) as ring-forming atoms.

In some embodiments, the fourth compound may be a $C_8$-$C_{60}$ polycyclic group-containing compound comprising at least two cyclic groups that are condensed with each other sharing a boron atom (B).

In some embodiments, the fourth compound may comprise a condensed ring in which at least one third ring may be condensed with at least one fourth ring,

the third ring may be a cyclopentane group, a cyclohexane group, a cycloheptane group, a cyclooctane group, a cyclopentene group, a cyclohexene group, a cycloheptene group, a cyclooctene group, an adamantane group, a norbornene group, a norobornane group, a bicyclo[1.1.1]pentane group, a bicyclo[2.1.1]hexane group, a bicyclo[2.2.2]octane group, a benzene group, a pyridine group, a pyrimidine group, a pyridazine group, a pyrazine group, or a triazine group, and

the fourth ring may be a 1,2-azaborinine group, a 1 ,3-azaborinine group, a 1,4-azaborinine group, a 1,2-dihydro-1,2-azaborinine group, a 1,4-oxaborinine group, a 1,4-thiaborinine group, or a 1,4-dihydroborinine group.

In one or more embodiments, the interlayer may comprise the fourth compound. The interlayer may comprise, in addition to the first compound and the fourth compound, the second compound, the third compound, or any combination thereof.

In one or more embodiments, the interlayer may comprise the third compound. In some embodiments, the third compound may not comprise a compound represented by Formula 3-1. For example, the third compound may not be a compound represented by Formula 3-1.

The emission layer in the interlayer may comprise: i) the first compound; and ii) the second compound, the third compound, the fourth compound, or any combination thereof.

The emission layer may emit phosphorescent light or fluorescent light emitted from the first compound. For example, the emission layer may be capable of emitting the phosphorescent light or fluorescent light emitted from the first compound. For example, in use the emission layer may emit phosphorescent light or fluorescent light emitted from the first compound. For example, the first compound may be capable of emitting phosphorescent light or fluorescent light. For example, the first compound may be a phosphorescent light emitter or a fluorescent light emitter. In some embodiments, phosphorescent light or fluorescent light emitted from the first compound may be blue light. For example, the first compound may be a blue phosphorescent light emitter or a blue fluorescent light emitter.

In some embodiments, the emission layer in the light-emitting device may comprise the first compound and the second compound, and the first compound and the second compound may form an exciplex.

In some embodiments, the emission layer in the light-emitting device may comprise the first compound, the second compound, and the third compound, and the first compound and the second compound may form an exciplex.

In some embodiments, the emission layer in the light-emitting device may comprise the first compound and the fourth compound, and the fourth compound may serve to improve color purity, luminescence efficiency, and/or lifespan characteristics of the light-emitting device.

In some embodiments, the second compound may be a compound represented by Formula 2:

Formula 2

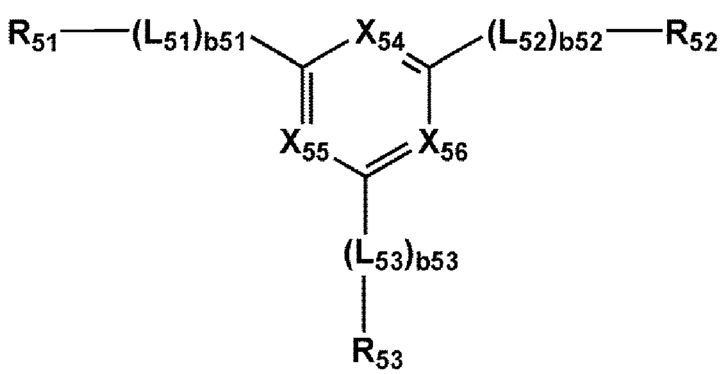

,

wherein, in Formula 2,

$L_{51}$ to $L_{53}$ may each independently be a single bond, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
b51 to b53 may each independently be an integer from 1 to 5,
$X_{54}$ may be N or C($R_{54}$), $X_{55}$ may be N or C($R_{55}$), $X_{56}$ may be N or C($R_{56}$), and at least one selected from $X_{54}$ to $X_{56}$ may be N,
$R_{51}$ to $R_{56}$ may each independently be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, -C($Q_1$)($Q_2$)($Q_3$), -Si($Q_1$)($Q_2$)($Q_3$), - N($Q_1$)($Q_2$), -B($Q_1$)($Q_2$), -C(=O)($Q_1$), -S(=O)$_2$($Q_1$), or -P(=O)($Q_1$)($Q_2$), and
each of $R_{10a}$ and $Q_1$ to $Q_3$ is independently the same as described in relation to Formula 1.

In one or more embodiments, the third compound may be a compound represented by Formula 3-1, a compound represented by Formula 3-2, a compound represented by Formula 3-3, a compound represented by Formula 3-4, a compound represented by Formula 3-5, or any combination thereof:

Formula 3-1

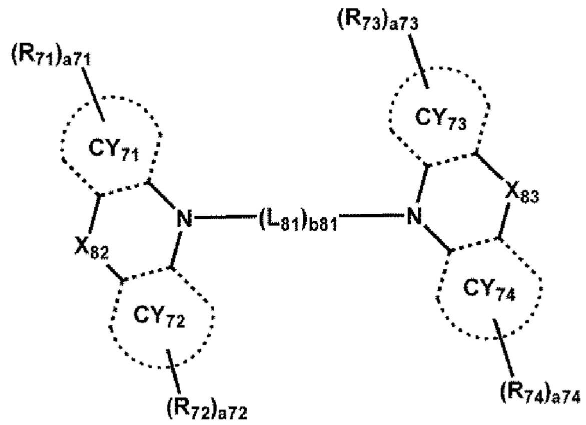

Formula 3-2

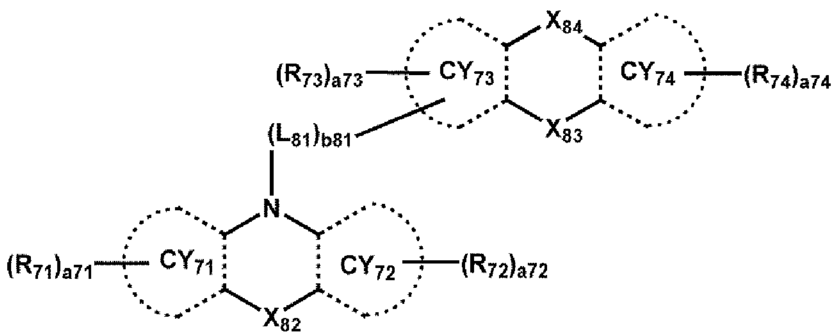

Formula 3-3

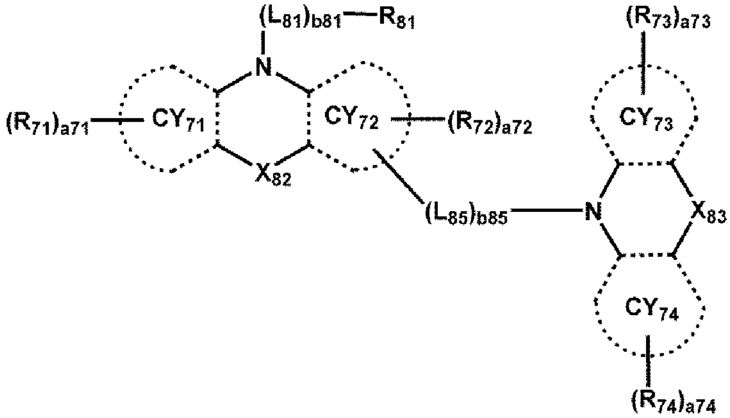

Formula 3-4

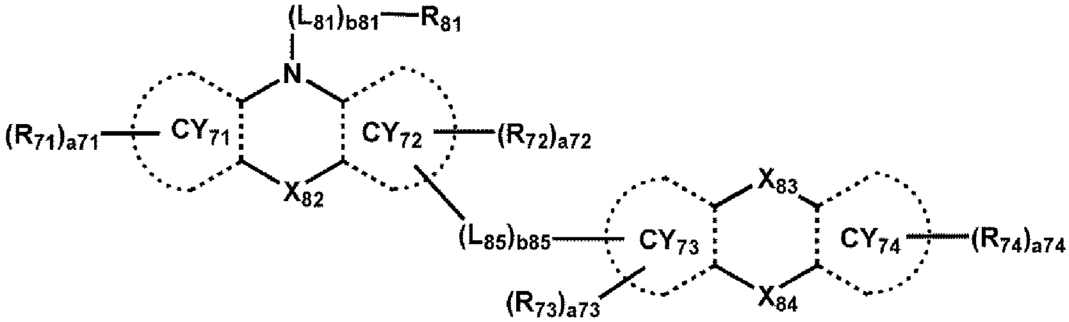

Formula 3-5

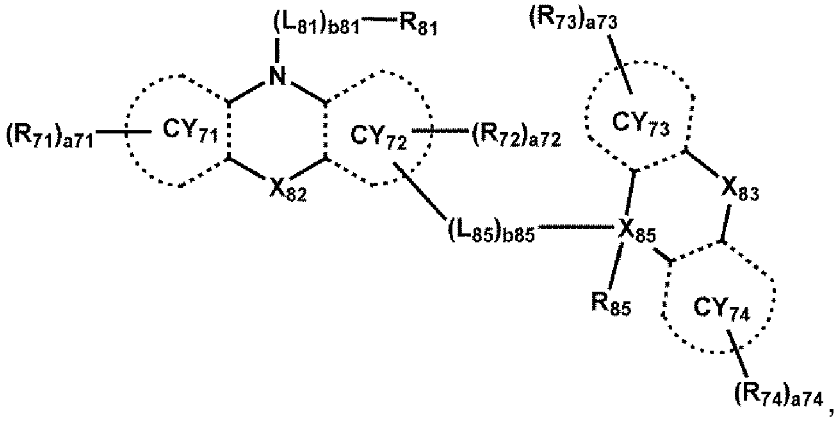

wherein, in Formulae 3-1 to 3-5,

ring $CY_{71}$ to ring $CY_{74}$ may each independently be a $\pi$ electron-rich $C_3$-$C_{60}$ cyclic group or a pyridine group,
$X_{82}$ may be a single bond, O, S, N-[$(L_{82})_{b82}$-$R_{82}$], C($R_{82a}$)($R_{82b}$), or Si(R82a)(R82b),
$X_{83}$ may be a single bond, O, S, N-[$(L_{83})_{b83}$-$R_{83}$], C($R_{83a}$)($R_{83b}$), or Si($R_{83a}$)($R_{83b}$),
$X_{84}$ may be O, S, N-[$(L_{84})_{b84}$-$R_{84}$], C($R_{84a}$)($R_{84b}$), or Si($R_{84a}$)($R_{84b}$),
$X_{85}$ may be C or Si,
$L_{81}$ to $L_{85}$ may each independently be a single bond, *-C($Q_4$)($Q_5$)-*', *-Si($Q_4$)($Q_5$)-*', a $\pi$ electron-rich $C_3$-$C_{60}$ cyclic group unsubstituted or substituted with at least one $R_{10a}$, or a pyridine group unsubstituted or substituted with at least one $R_{10a}$, wherein $Q_4$ and $Q_5$ may each be understood by referring to the description of $Q_1$ provided herein,
b81 to b85 may each independently be an integer from 1 to 5,

$R_{71}$ to $R_{74}$, $R_{81}$ to $R_{85}$, $R_{82a}$, $R_{82b}$, $R_{83a}$, $R_{83b}$, $R_{84a}$, and $R_{84b}$ may each independently be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, $-C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or $-P(=O)(Q_1)(Q_2)$,

each of $R_{10a}$ and $Q_1$ to $Q_3$ is independently the same as described in relation to Formula 1, and

a71 to a74 may each independently be an integer from 0 to 20. In some embodiments, the fourth compound may be a compound represented by Formula 502, a compound represented by Formula 503, or any combination thereof:

Formula 502

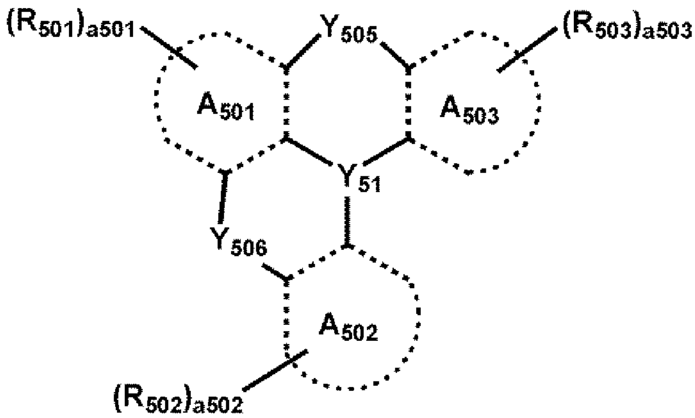

Formula 503

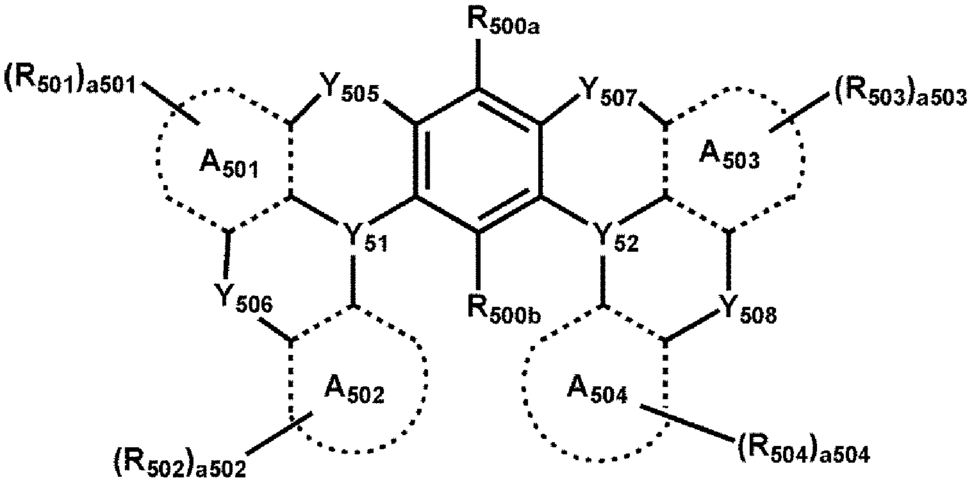

,

wherein, in Formulae 502 and 503,

ring $A_{501}$ to ring $A_{504}$ may each independently be a $C_3$-$C_{60}$ carbocyclic group or a $C_1$-$C_{60}$ heterocyclic group,

$Y_{505}$ may be O, S, $N(R_{505})$, $B(R_{505})$, $C(R_{505a})(R_{505b})$, or $Si(R_{505a})(R_{505b})$,

$Y_{506}$ may be O, S, $N(R_{506})$, $B(R_{506})$, $C(R_{506a})(R_{506b})$, or $Si(R_{506a})(R_{506b})$,

$Y_{507}$ may be O, S, $N(R_{507})$, $B(R_{507})$, $C(R_{507a})(R_{507b})$, or $Si(R_{507a})(R_{507b})$,

$Y_{508}$ may be O, S, $N(R_{508})$, $B(R_{508})$, $C(R_{508a})(R_{508b})$, or $Si(R_{508a})(R_{508b})$,

$Y_{51}$ and $Y_{52}$ may each independently be B, P(=O), or S(=O),

$R_{500a}$, $R_{500b}$, $R_{501}$ to $R_{508}$, $R_{505a}$, $R_{505b}$, $R_{506a}$, $R_{506b}$, $R_{507a}$, $R_{507b}$, $R_{508a}$, and $R_{508b}$ may each independently be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$,

a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, -$C(Q_1)(Q_2)(Q_3)$, -$Si(Q_1)(Q_2)(Q_3)$, - $N(Q_1)(Q_2)$, -$B(Q_1)(Q_2)$, -$C(=O)(Q_1)$, -$S(=O)_2(Q_1)$, or -$P(=O)(Q_1)(Q_2)$,
each of $R_{10a}$ and $Q_1$ to $Q_3$ is independently the same as described in relation to Formula 1, and
a501 to a504 may each independently be an integer from 0 to 20.

**Descriptions of Formulae**

In Formula 1, M may be platinum (Pt), palladium (Pd), gold (Au), nickel (Ni), silver (Ag), or copper (Cu).
In Formula 1, $X_1$ to $X_4$ may each independently be C or N.
In some embodiments, in Formula 1, $X_1$ may be C, and C may be a carbon atom in a carbene moiety.
In one or more embodiments, in Formula 1, $X_1$ may be N.
In one or more embodiments, in Formula 1, $X_2$ and $X_3$ may each be C, and $X_4$ may be N.
In Formula 1, i) a bond between $X_1$ and M may be a coordinate bond, and ii) one of a bond between $X_2$ and M, a bond between $X_3$ and M, and a bond between $X_4$ and M may be a coordinate bond, and the other two bonds may each be a covalent bond.
In some embodiments, in Formula 1, a bond between $X_2$ and M and a bond between $X_3$ and M may each be a covalent bond, and a bond between $X_4$ and M may be a coordinate bond.
In Formula 1, ring $CY_1$ may be i) a $X_1$-containing 5-membered ring, ii) a $X_1$-containing 5-membered ring condensed with at least one 6-membered ring, or iii) a $X_1$-containing 6-membered ring. In some embodiments, in Formula 1, ring $CY_1$ may be i) a $X_1$-containing 5-membered ring or ii) a $X_1$-containing 5-membered ring condensed with at least one 6-membered ring. For example, ring $CY_1$ may comprise a 5-membered ring bound to M in Formula 1 via $X_1$.
In some embodiments, the $X_1$-containing 5-membered ring in ring $CY_1$ in Formula 1 may be a pyrrole group, a pyrazole group, an imidazole group, a triazole group, an oxazole group, an isooxazole group, a thiazole group, an isothiazole group, an oxadiazole group, or a thiadiazole group.
In some embodiments, the 6-membered ring that may be condensed to the $X_1$-containing 5-membered ring in ring $CY_1$ in Formula 1 or the $X_1$-containing 6-membered ring may be a benzene group, a pyridine group, or a pyrimidine group.
In some embodiments, in Formula 1, a group represented by

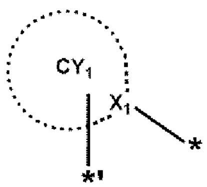

may be represented by one of Formulae CY1-1 to CY1-42:

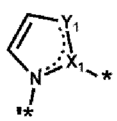
CY1-1
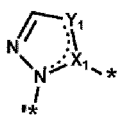
CY1-2
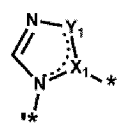
CY1-3
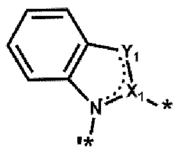
CY1-4
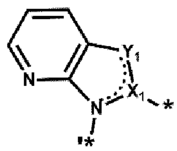
CY1-5
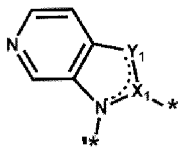
CY1-6
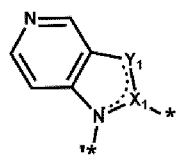
CY1-7

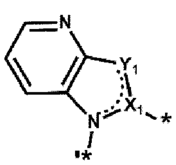
CY1-8
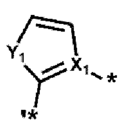
CY1-9
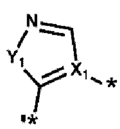
CY1-10
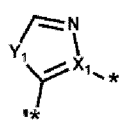
CY1-11
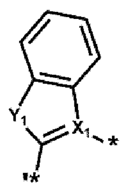
CY1-12
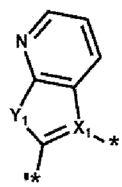
CY1-13
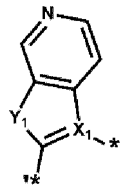
CY1-14

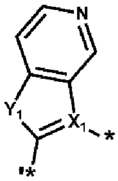
CY1-15
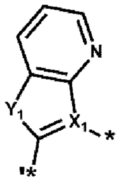
CY1-16
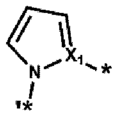
CY1-17
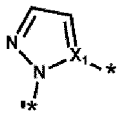
CY1-18
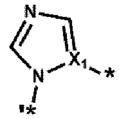
CY1-19
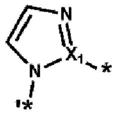
CY1-20
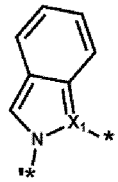
CY1-21
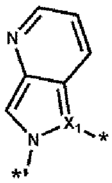
CY1-22
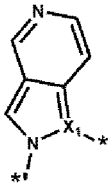
CY1-23
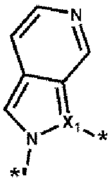
CY1-24
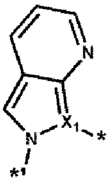
CY1-25
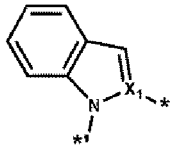
CY1-26
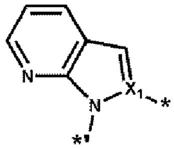
CY1-27
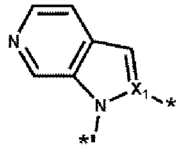
CY1-28
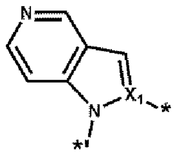
CY1-29
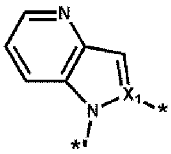
CY1-30
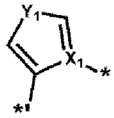
CY1-31
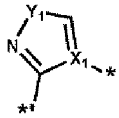
CY1-32
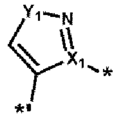
CY1-33
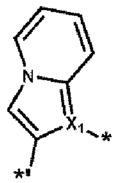
CY1-34
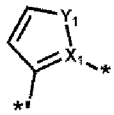
CY1-35
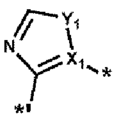
CY1-36
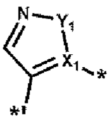
CY1-37
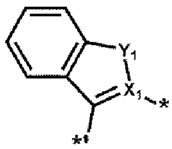
CY1-38
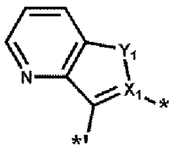
CY1-39
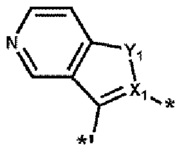
CY1-40
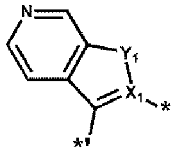
CY1-41
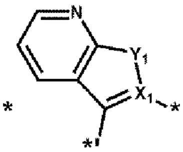
CY1-42 ,

wherein, in Formulae CY1-1 to CY1-42,

$Y_1$ may be O, S, N, C, or Si,
* indicates a binding site to M in Formula 1, and
*' indicates a binding site to an adjacent atom in Formula 1.

In some embodiments, in Formulae CY1-1 to CY1-8, $X_1$ may be C, and $X_1$ in Formulae CY1-9 to CY1-42 may be N.
In Formula 1, ring $CY_2$ may be a $C_3$-$C_{60}$ carbocyclic group or a $C_1$-$C_{60}$ heterocyclic group.
In some embodiments, ring $CY_2$ may be a benzene group, a pyridine group, a pyrimidine group, a naphthalene group, a dibenzofuran group, a dibenzothiophene group, a carbazole group, a fluorene group, or a dibenzosilole group.
In some embodiments, in Formula 1, a group represented by

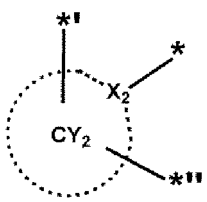

may be a group represented by one of Formulae CY2-1 to CY2-11:

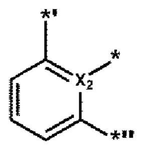
CY2-1
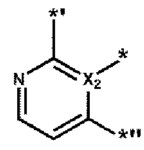
CY2-2
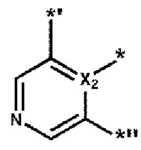
CY2-3
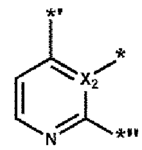
CY2-4
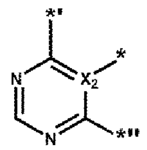
CY2-5
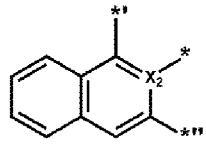
CY2-6

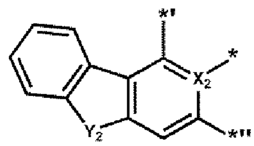
CY2-7
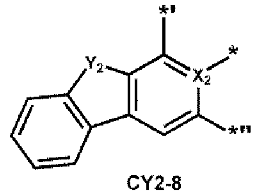
CY2-8
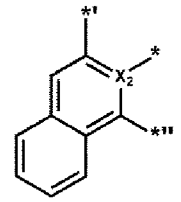
CY2-9
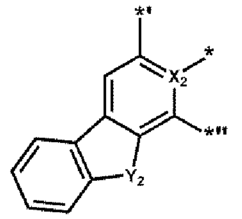
CY2-10

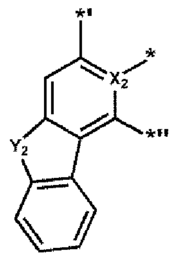
CY2-11

wherein, in Formulae CY2-1 to CY2-11,

$Y_2$ may be O, S, N, C, or Si,
* indicates a binding site to M in Formula 1,
*' indicates a binding site to ring $CY_1$ in Formula 1, and
*" indicates a binding site to $X_{51}$ in Formula 1.

In Formula 1, $X_{31}$ to $X_{36}$ and $X_{41}$ to $X_{44}$ may each independently be C or N.
In some embodiments, in Formula 1, $X_{31}$ to $X_{36}$ and $X_{41}$ to $X_{44}$ may each be C.
In Formula 1, $X_{51}$ may be *-N($R_5$)-*', *-B($R_5$)-*', *-P($R_5$)-*', *-C($R_{5a}$)($R_{5b}$)-*', *-Si($R_{5a}$)($R_{5b}$)-*', *-Ge($R_{5a}$)($R_{5b}$)-*', *-S-*', *-Se-*', *-O-*', *-C(=O)-*', *-S(=O)-*', *-S(=O)$_2$-*', *-C(Rs)=*', *=C($R_5$)-*', *-C($R_{5a}$)=C($R_{5b}$)-*', *-C(=S)-*', or *-C≡C-*'. * and *' each indicate a binding site to an adjacent atom. $R_5$, $R_{5a}$, and $R_{5b}$ may respectively be understood by referring to the descriptions of $R_5$, $R_{5a}$, and $R_{5b}$ provided herein. $R_{5a}$ and $R_{5b}$ may optionally be bound to each other to form a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$ (e.g., Compound 109, and/or the like).
In some embodiments, in Formula 1, $X_{51}$ may be *-N($R_5$)-*', *-B($R_5$)-*', *-C($R_{5a}$)($R_{5b}$)-*', *-Si($R_{5a}$)($R_{5b}$)-*', *-S-*', or *-O-*'.
$L_1$ in Formula 1 may be a single bond, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$.
In Formula 1, b1 indicates the number of $L_1$(s), and b1 may be an integer from 1 to 5. When b1 is 2 or greater, at least two $L_1$(s) may be identical to different from each other. In some embodiments, b1 may be 1 or 2.
In Formula 1, $R_1$ to $R_5$, $R_{5a}$, and $R_{5b}$ may each independently be a group represented by Formula 1-1, a group represented by Formula 1-2, hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, - C($Q_1$)($Q_2$)($Q_3$), -Si($Q_1$)($Q_2$)($Q_3$), -N($Q_1$)($Q_2$), -B($Q_1$)($Q_2$), -C(=O)($Q_1$), -S(=O)$_2$($Q_1$), or - P(=O)($Q_1$)($Q_2$):

Formula 1-1

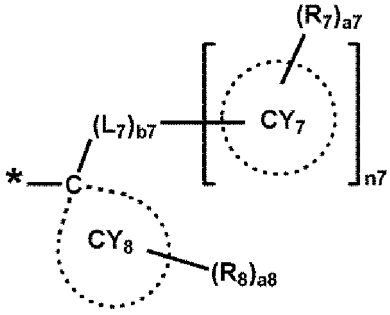

Formula 1-2

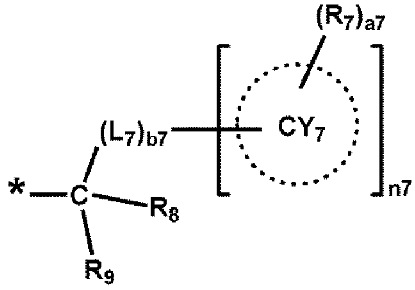

.

Formulae 1-1 and 1-2 may each be understood by referring to the descriptions of Formulae 1-1 and 1-2 provided herein.

In Formula 1, c1 may be an integer from 0 to 5, a1 and a4 may each independently be an integer from 0 to 4, a2 may be an integer from 0 to 10, and a3 may be an integer from 0 to 6, provided that the sum of a1 to a4 may be 1 or greater, and at least one of *-$(L_1)_{b1}$-$(R_1)_{c1}$(s) in the number of a1, at least one of $R_2$(s) in the number of a2, at least one of $R_3$(s) in the number of a3, at least one of $R_4$(s) in the number of a4, or any combination thereof may each independently be the group represented by Formula 1-1 or the group represented by Formula 1-2. For example, the organometallic compound represented by Formula 1 may comprise the group represented by Formula 1-1, the group represented by Formula 1-2, or any combination thereof.

In some embodiments, in Formula 1, a4 may be an integer from 1 to 4, at least one of $R_4$(s) in the number of a4 may each independently be the group represented by Formula 1-1 or the group represented by Formula 1-2.

$L_7$ in Formulae 1-1 and 1-2 may be a single bond, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$.

In Formulae 1-1 and 1-2, b7 indicates the number of $L_7$(s), and b7 may be an integer from 1 to 5. When b7 is 2 or greater, at least two $L_7$(s) may be identical to different from each other. In some embodiments, b7 may be 1 or 2.

In Formulae 1-1 and 1-2, ring $CY_7$ may be a $C_3$-$C_{60}$ carbocyclic group or a $C_1$-$C_{60}$ heterocyclic group.

In some embodiments, in Formulae 1-1 and 1-2, ring $CY_7$ may be i) a first ring, ii) a second ring, iii) a condensed ring in which at least two first rings are condensed, iv) a condensed ring in which at least two second rings are condensed, or v) a condensed ring in which at least one first ring and at least one second ring are condensed,

the first ring may be a cyclopentane group, a cyclohexane group, a cycloheptane group, a cyclooctane group, a cyclopentene group, a cyclohexene group, a cycloheptene group, a cyclooctene group, an adamantane group, a norbornene group, a norobornane group, a bicyclo[1.1.1]pentane group, a bicyclo[2.1.1]hexane group, a bicyclo[2.2.2]octane group, or a benzene group, and

the second ring may be a pyrrole group, a furan group, a thiophene group, a silole group, a pyrazole group, an imidazole group, a triazole group, an oxazole group, an isooxazole group, a thiazole group, an isothiazole group, an oxadiazole group, a thiadiazole group, a pyridine group, a pyrimidine group, a pyridazine group, a pyrazine group, a triazine group, a 1,2-azaborinine group, a 1,3-azaborinine group, a 1,4-azaborinine group, a 1,2-dihydro-1,2-azaborinine group, a 1,4-oxaborinine group, a 1,4-thiaborinine group, or a 1,4-dihydroborinine group.

In one or more embodiments, in Formulae 1-1 and 1-2, ring $CY_7$ may be a benzene group, a naphthalene group, a phenanthrene group, a carbazole group, a [1,2]azaborinino[1,2-a][1,2]azaborinine group, or a benzo[1,2]azaborinino[1,2-a][1,2]azaborinine group.

In one or more embodiments, in Formulae 1-1 and 1-2, ring $CY_7$ may be a group represented by one of Formulae CY7-1 to CY7-33:

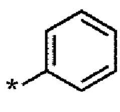

CY7-1

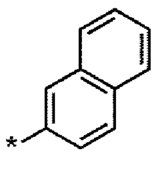

CY7-2

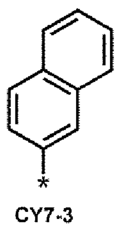

CY7-3

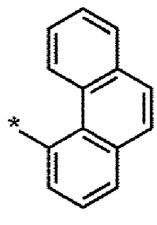

CY7-4

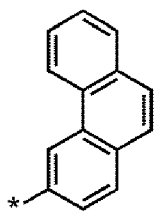

CY7-5

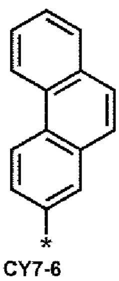

CY7-6

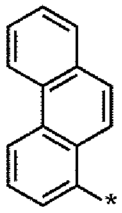
CY7-7

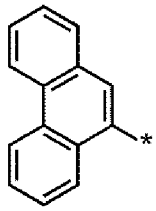
CY7-8

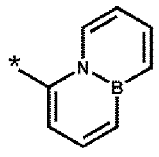
CY7-9

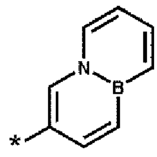
CY7-10

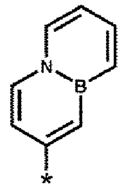
CY7-11

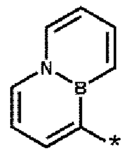
CY7-12

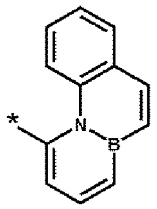
CY7-13

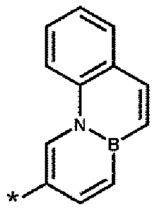
CY7-14

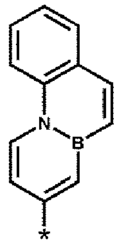
CY7-15

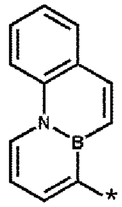
CY7-16

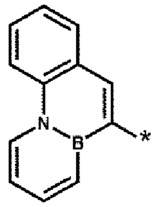
CY7-17

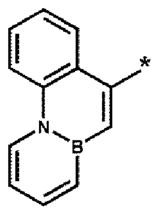
CY7-18

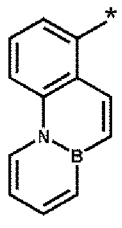
CY7-19

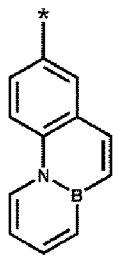
CY7-20

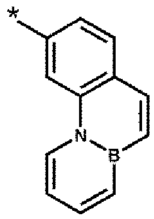
CY7-21

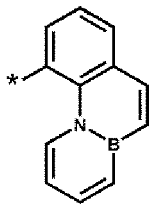
CY7-22

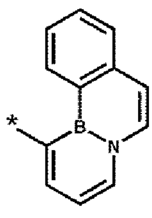
CY7-23

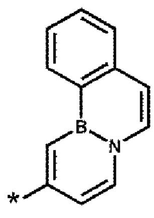
CY7-24

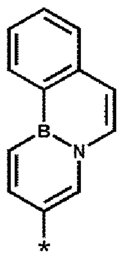
CY7-25

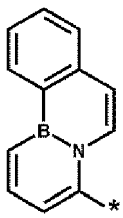
CY7-26

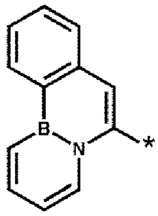
CY7-27

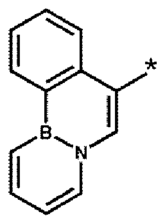
CY7-28

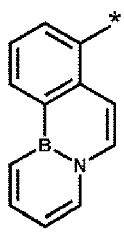
CY7-29

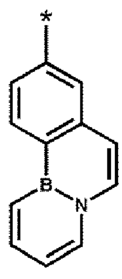
CY7-30

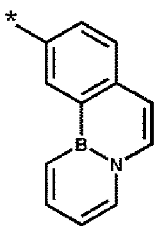
CY7-31

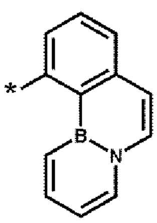
CY7-32

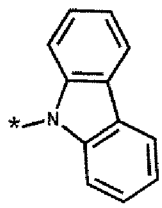
CY7-33

In Formulae CY7-1 to CY7-33, * indicates a binding site to $L_7$ in Formulae 1-1 and 1-2.

In Formulae 1-1 and 1-2, n7 indicates the number of groups represented by

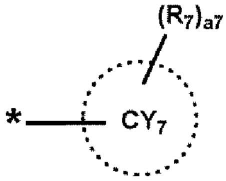

,

and n7 may be an integer from 1 to 5. When n7 is 2 or greater, at least two groups represented by

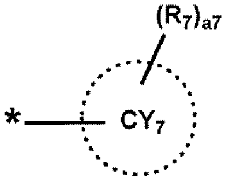

may be identical to or different from each other. In some embodiments, n7 may be 1.

In Formula 1-1, ring $CY_8$ may be a non-aromatic $C_3$-$C_{60}$ carbocyclic group or a non-aromatic $C_1$-$C_{60}$ heterocyclic group.

In some embodiments, in Formula 1-1, ring $CY_8$ may be a cyclopentane group, a cyclohexane group, a cycloheptane group, a cyclooctane group, a cyclopentene group, a cyclohexene group, a cycloheptene group, a cyclooctene group, an adamantane group, a norbornene group, a norobornane group, a bicyclo[1.1.1]pentane group, a bicyclo[2.1.1]hexane group, or a bicyclo[2.2.2]octane group.

In one or more embodiments, in Formula 1-1, ring $CY_8$ may be a group represented by one of Formulae CY8-1 to CY8-8:

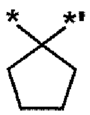

CY8-1

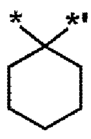

CY8-2

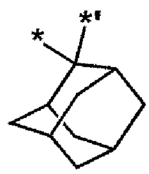

CY8-3

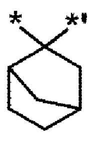

CY8-4

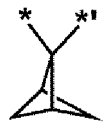

CY8-5

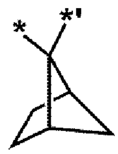

CY8-6

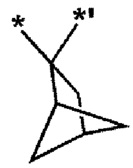

CY8-7

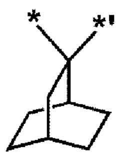

CY8-8

,

wherein, in Formulae CY8-1 to CY8-8, * indicates a binding site to an adjacent atom in Formula 1, and *' indicates a binding site to $L_7$ in Formula 1-1.

In Formulae 1-1 and 1-2, $R_7$ to $R_9$ may each be understood by referring to the descriptions of $R_1$ provided herein.

In Formulae 1-1 and 1-2, a7 and a8 may respectively indicate the number of Rz(s) and Rs(s), and a7 and a8 may each independently be an integer from 0 to 20. When a7 is 2 or greater, at least two Rz(s) may be identical to or different from each other. When a8 is 2 or greater, at least two $R_8$(s) may be identical to or different from each other.

In Formula 1, i) at least two of groups represented by $*-(L_1)_{b1}-(R_1)_{c1}$ in the number of a1 may optionally be bound to each other (via a single bond, a double bond, or a first linking group) to form a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$, ii) at least two of $R_2$(s) in the number of a2 may optionally be bound to each other (via a single bond, a double bond, or a first linking group) to form a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$, iii) at least two of $R_3$ in the number of a3 may optionally be bound to each other (via a single bond, a double bond, or a first linking group) to form a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$, iv) at least two of $R_4$ in the number of a4 may optionally be bound to each

other (via a single bond, a double bond, or a first linking group) to form a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$, and/or v) at least two of $R_1$ to $R_5$, $R_{5a}$, and $R_{5b}$ may optionally be bound to each other (via a single bond, a double bond, or a first linking group) to form a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$. The first linking group may be selected from *-N($R_{95}$)-*', *-B($R_{95}$)-*', *-P($R_{95}$)-*', *-C($R_{95a}$)($R_{95b}$)-*', *-Si($R_{95a}$)($R_{95b}$)-*', *-Ge($R_{95a}$)($R_{95b}$)-*', *-S-*', *-Se-*', *-O-*', *-C(=O)-*', *-S(=O)-*', *-S(=O)$_2$-*', *-C($R_{95}$)=*', *=C($R_{95}$)-*', *-C($R_{95a}$)=C($R_{95b}$)-*', *-C(=S)-*', and *-C=C-*', and $R_{95}$, $R_{95a}$, and $R_{95b}$ may each be understood by referring to the description of $R_{10a}$ provided herein.

In some embodiments, the first compound represented by Formula 1 may comprise at least one deuterium.

In one or more embodiments, the group represented by Formula 1-1 and the group represented by Formula 1-2 may each comprise at least one deuterium.

In one or more embodiments, in Formula 1, 1) a1 may not be 0, and 2) in at least one of *-$(L_1)_{b1}$-$(R_1)_{c1}$ in a1 number of *-$(L_1)_{b1}$-$(R_1)_{c1}$(s), i) $L_1$ may not be a single bond, and ii) at least one of $R_1$(s) in the number of c1 may be a $C_3$-$C_{60}$ carbocyclic unsubstituted or substituted with at least one $R_{10a}$, or a $C_1$-$C_{60}$ heterocyclic group unsubstituted or substituted with at least one $R_{10a}$.

In one or more embodiments, in Formula 1, the group represented by *-$(L_1)_{b1}$-$(R_1)_{c1}$ may comprise at least one deuterium.

In one or more embodiments, in Formula 1, the group represented by

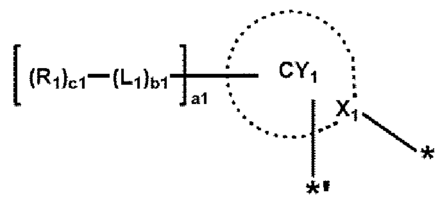

may be represented by one of Formulae CY1(1) to CY1(6):

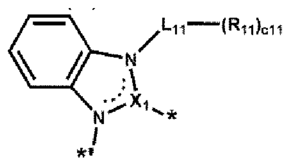

CY1(1)

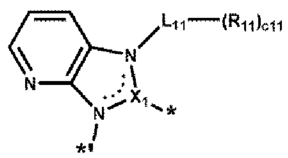

CY1(2)

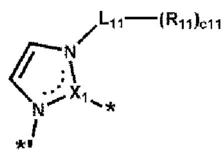

CY1(3)

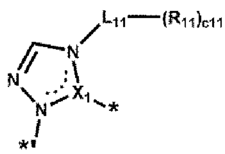

CY1(4)

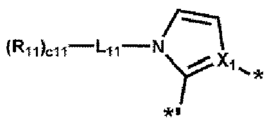

CY1(5)

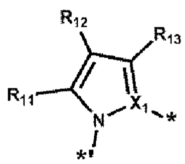

CY1(6)

,

wherein, in Formulae CY1(1) to CY1(6),

$X_1$ may be selected from O, S, N($R_{21}$), C($R_{21}$)($R_{22}$), and Si($R_{21}$)($R_{22}$),
$L_{11}$ and c11 may respectively be understood by referring to the descriptions of $L_1$ and c1 provided herein,
$R_{11}$ to $R_{13}$ may each be understood by referring to the description of $R_1$ provided herein, wherein $R_{11}$ to $R_{13}$ may not each be hydrogen,
* indicates a binding site to M in Formula 1, and
*' indicates a binding site to an adjacent atom in Formula 1.

In some embodiments, in Formulae CY1(1) to CY1(5), 1) $L_{11}$ may not be a single bond, and 2) at least one of $R_{11}$(s) in the number of c11 may be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$.

In some embodiments, in Formulae CY1(1) to CY1(4), $X_1$ may be C, and in Formulae CY1(5) and CY1(6), $X_1$ may be N.

In some embodiments, $L_{11}$ in Formulae CY1(1) to CY1(5) may be a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$.

In one or more embodiments, the group represented by

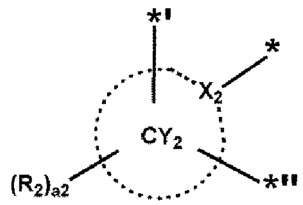

in Formula 1 may be one of groups represented by Formulae CY2(1) to CY2(26):

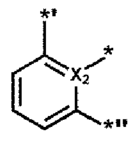
CY2(1)
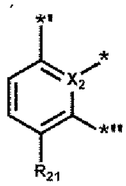
CY2(2)
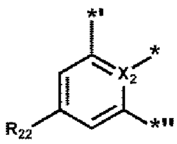
CY2(3)
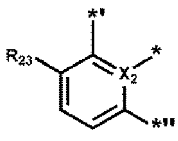
CY2(4)
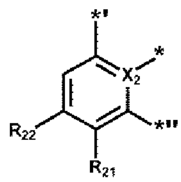
CY2(5)
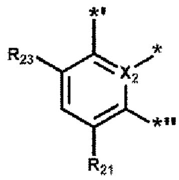
CY2(6)
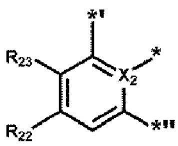
CY2(7)
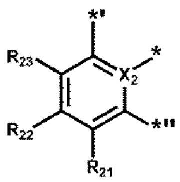
CY2(8)
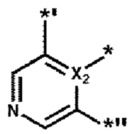
CY2(9)
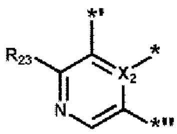
CY2(10)
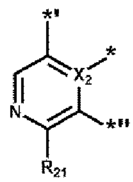
CY2(11)
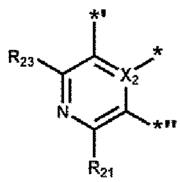
CY2(12)
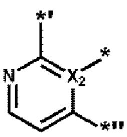
CY2(13)
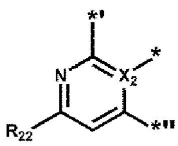
CY2(14)
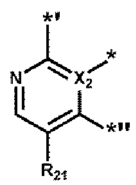
CY2(15)
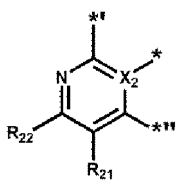
CY2(16)
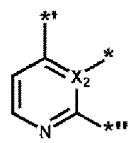
CY2(17)
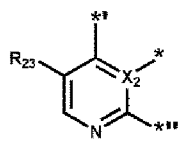
CY2(18)
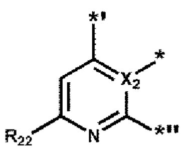
CY2(19)
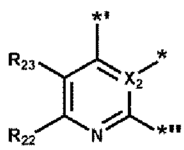
CY2(20)
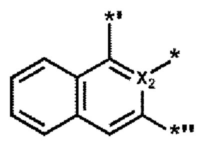
CY2(21)
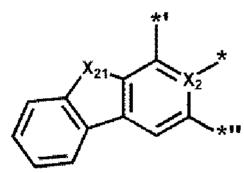
CY2(22)
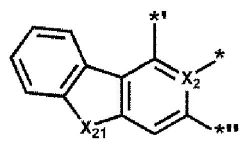
CY2(23)
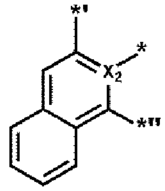
CY2(24)
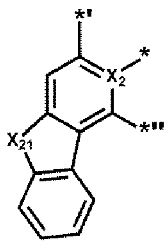
CY2(25)
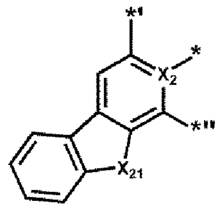
CY2(26)

,

wherein, in Formulae CY2(1) to CY2(26),

$X_2$ may be understood by referring to the description of $X_{21}$ provided herein,
$X_{21}$ may be selected from O, S, $N(R_{21})$, $C(R_{21})(R_{22})$, and $Si(R_{21})(R_{22})$,
$R_{21}$ to $R_{23}$ may each be understood by referring to the description of $R_2$ provided herein, wherein $R_{21}$ to $R_{23}$ may not each be hydrogen,
* indicates a binding site to M in Formula 1, and
*' indicates a binding site to ring $CY_1$ in Formula 1, and
*" indicates a binding site to $X_{51}$ in Formula 1.

In one or more embodiments, in Formula 1, the group represented by

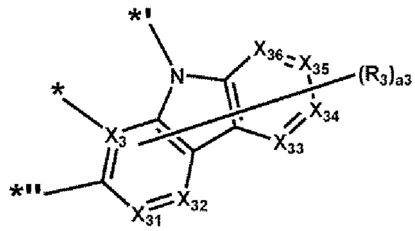

may be a group represented by one of Formulae CY3(1) to CY3(7):

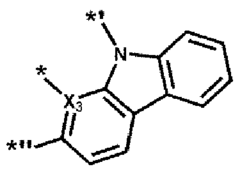
CY3(1)

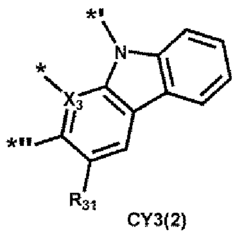
CY3(2)

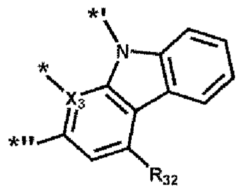
CY3(3)

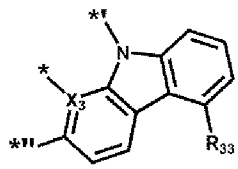
CY3(4)

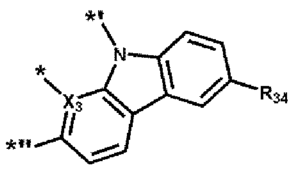
CY3(5)

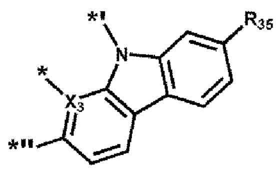
CY3(6)

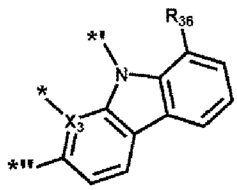
CY3(7)

,

wherein, in Formulae CY3(1) to CY3(7),

$X_3$ may be understood by referring to the description of $X_3$ provided herein,
$R_{31}$ to $R_{36}$ may each be understood by referring to the description of $R_3$ provided herein, wherein $R_{31}$ to $R_{36}$ may not each be hydrogen,
* indicates a binding site to M in Formula 1,
*' indicates a binding site to an adjacent atom in Formula 1, and
*" indicates a binding site to $X_{51}$ in Formula 1.

In one or more embodiments, in Formula 1, the group represented by

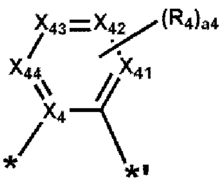

may be a group represented by one of Formulae CY4(1) to CY4(8):

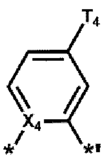
CY4(1)

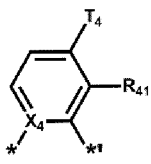
CY4(2)

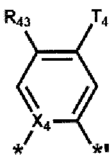
CY4(3)

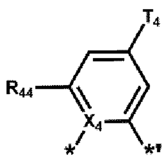
CY4(4)

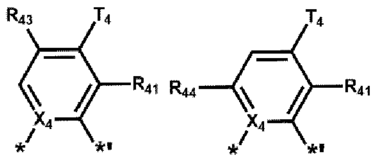
CY4(5)

CY4(6)

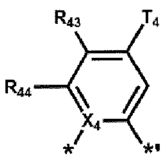
CY4(7)

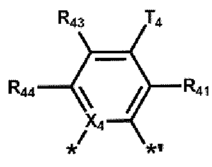
CY4(8)

,

wherein, in Formulae CY4(1) to CY4(8),

$X_4$ may be understood by referring to the description of $X_4$ provided herein,
$T_4$ may be the group represented by Formula 1-1 or the group represented by Formula 1-2,
$R_{41}$, $R_{43}$, and $R_{44}$ may each be understood by referring to the description of $R_4$ provided herein, wherein $R_{41}$, $R_{43}$, and $R_{44}$ may not each be hydrogen,
* indicates a binding site to M in Formula 1, and
*' indicates a binding site to an adjacent atom in Formula 1.

In Formula 2, b51 to b53 may respectively indicate the number of $L_{51}$(s) to $L_{53}$(s), and b51 to b53 may each be an integer from 1 to 5. When b51 is 2 or greater, at least two $L_{51}$(s) may be identical to or different from each other, when b52 is 2 or greater, at least two $L_{52}$(s) may be identical to or different from each other, and when b53 is 2 or greater, at least two $L_{53}$(s) may be identical to or different from each other. In some embodiments, b51 to b53 may each independently be 1 or 2.

In Formulae 1, 1-1, 1-2 and 2, $L_1$, $L_7$, and $L_{51}$ to $L_{53}$ may each independently be:

a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzooxasiline group, a dibenzothiasiline group, a dibenzodihydroazasiline group, a dibenzodihydrodisiline group, a dibenzodihydrosiline group, a dibenzodioxane group, a dibenzooxathiene group, a dibenzooxazine group, a dibenzopyran group, a dibenzodithiine group, a dibenzothiazine group, a dibenzothiopyran group, a dibenzocyclohexadiene group, a dibenzodihydropyridine group, or a dibenzodihydropyrazine group, each independently unsubstituted or substituted with deuterium, -F, -Cl, -Br, -I, a hydroxyl group, a cyano group, a nitro group, a $C_1$-$C_{20}$ alkyl group, a $C_1$-$C_{20}$ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, $-O(Q_{31})$, $-S(Q_{31})$, $-Si(Q_{31})(Q_{32})(Q_{33})$, $-N(Q_{31})(Q_{32})$, $-B(Q_{31})(Q_{32})$, $-P(Q_{31})(Q_{32})$, $-C(=O)(Q_{31})$, $-S(=O)_2(Q_{31})$, $-P(=O)(Q_{31})(Q_{32})$, or any combination thereof,
wherein $Q_{31}$ to $Q_{33}$ may each independently be hydrogen, deuterium, a $C_1$-$C_{20}$ alkyl group, a $C_1$-$C_{20}$ alkoxy group, a phenyl group, a biphenyl group, a terphenyl group, a pyridinyl group, a pyrimidinyl group, a pyridazinyl group, a pyrazinyl group, or a triazinyl group.

In some embodiments, in Formula 2, a bond between $L_{51}$ and $R_{51}$, a bond between $L_{52}$ and $R_{52}$, a bond between

$L_{53}$ and $R_{53}$, a bond between at least two $L_{51}$(s), a bond between at least two $L_{52}$(s), a bond between at least two $L_{53}$(s), a bond between $L_{51}$ and a carbon atom between $X_{54}$ and $X_{55}$ in Formula 2, a bond between $L_{52}$ and a carbon atom between $X_{54}$ and $X_{56}$ in Formula 2, and a bond between $L_{53}$ and a carbon atom between $X_{55}$ and $X_{56}$ in Formula 2 may each be a "carbon-carbon single bond".

In Formula 2, $X_{54}$ may be N or C($R_{54}$), $X_{55}$ may be N or C($R_{55}$), $X_{56}$ may be N or C($R_{56}$), and at least one selected from $X_{54}$ to $X_{56}$ may be N, wherein $R_{54}$ to $R_{56}$ may respectively be understood by referring to the descriptions of $R_{54}$ to $R_{56}$ provided herein. In some embodiments, two or three of $X_{54}$ to $X_{56}$ may each be N.

In the present specification, $R_{51}$ to $R_{56}$, $R_{71}$ to $R_{74}$, $R_{81}$ to $R_{85}$, $R_{82a}$, $R_{82b}$, $R_{83a}$, $R_{83b}$, $R_{84a}$ and $R_{84b}$, $R_{500a}$, $R_{500b}$, $R_{501}$ to $R_{508}$, $R_{505a}$, $R_{505b}$, $R_{506a}$, $R_{506b}$, $R_{507a}$, $R_{507b}$, $R_{508a}$, and $R_{508b}$ may each independently be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, -C($Q_1$)($Q_2$)($Q_3$), -Si($Q_1$)($Q_2$)($Q_3$), -N($Q_1$)($Q_2$), -B($Q_1$)($Q_2$), -C(=O)($Q_1$), -S(=O)$_2$($Q_1$), or -P(=O)($Q_1$)($Q_2$). $Q_1$ to $Q_3$ may respectively be understood by referring to the descriptions of $Q_1$ to $Q_3$ provided herein.

In some embodiments, i) in Formula 1, $R_1$ to $R_5$, $R_{5a}$, and $R_{5b}$, other than the group represented by Formula 1-1 and the group represented by Formula 1-2, ii) in Formulae 1-1 and 1-2, $R_7$ to $R_9$, iii) $R_{51}$ to $R_{56}$, $R_{71}$ to $R_{74}$, $R_{81}$ to $R_{85}$, $R_{82a}$, $R_{82b}$, $R_{83a}$, $R_{83b}$, $R_{84a}$, $R_{84b}$, $R_{500a}$, $R_{500b}$, $R_{501}$ to $R_{508}$, $R_{505a}$, $R_{505b}$, $R_{506a}$, $R_{506b}$, $R_{507a}$, $R_{507b}$, $R_{508a}$, and $R_{508b}$ in Formulae 2, 3-1 to 3-5, 502, and 503, and iv) $R_{10a}$ may each independently be:

hydrogen, deuterium, -F, -Cl, -Br, -I, a hydroxyl group, a cyano group, a nitro group, a $C_1$-$C_{20}$ alkyl group, or a $C_1$-$C_{20}$ alkoxy group;

a $C_1$-$C_{20}$ alkyl group or a $C_1$-$C_{20}$ alkoxy group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{10}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl (thienyl) group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl (benzothienyl) group, an benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl (dibenzothienyl) group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each independently unsubstituted or substituted with deuterium, -F, -Cl, -Br, -I, $-CD_3$, $- CD_2H$, $-CDH_2$, $-CF_3$, $-CF_2H$, $-CFH_2$, a hydroxyl group, a cyano group, a nitro group, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{10}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O($Q_{31}$), -S($Q_{31}$), -Si($Q_{31}$)($Q_{32}$)($Q_{33}$), -N($Q_{31}$)($Q_{32}$), - B($Q_{31}$)($Q_{32}$), -P($Q_{31}$)($Q_{32}$), -C(=O)($Q_{31}$), -S(=O)$_2$($Q_{31}$), -P(=O)($Q_{31}$)($Q_{32}$), or any combination thereof; or

$-C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or $-P(=O)(Q_1)(Q_2)$, wherein $Q_1$ to $Q_3$ and $Q_{31}$ to $Q_{33}$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or $-CD_2CDH_2$;
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each independently unsubstituted or substituted with deuterium, a $C_1$-$C_{10}$ alkyl group, a phenyl group, a biphenyl group, a pyridinyl group, a pyrimidinyl group, a pyridazinyl group, a pyrazinyl group, a triazinyl group, or any combination thereof:

Formula 91

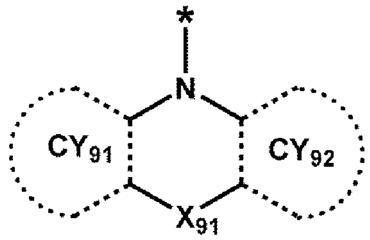
,

wherein, in Formula 91,
ring $CY_{91}$ to ring $CY_{92}$ may each independently be a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,
$X_{91}$ may be a single bond, O, S, $N(R_{91})$, $B(R_{91})$, $C(R_{91a})(R_{91b})$, or $Si(R_{91a})(R_{91b})$,
$R_{91}$, $R_{91a}$, and $R_{91b}$ may respectively be understood by referring to the descriptions of $R_{82}$, $R_{82a}$, and $R_{82b}$ provided herein,
$R_{10a}$ may be understood by referring to the description of $R_{10a}$ provided herein, and
* indicates a binding site to an adjacent atom.

In some embodiments, in Formula 91,

ring $CY_{91}$ and ring $CY_{92}$ may each independently be a benzene group, a pyridine group, a pyrimidine group, a pyrazine group, a pyridazine group, or a triazine group, each independently unsubstituted or substituted with at least one $R_{10a}$,
$R_{91}$, $R_{91a}$ and $R_{91b}$ may each independently be:
hydrogen or a $C_1$-$C_{10}$ alkyl group; or
a phenyl group, a pyridinyl group, a pyrimidinyl group, a pyridazinyl group, a pyrazinyl group, or a triazinyl group, each independently unsubstituted or substituted with deuterium, a $C_1$-$C_{10}$ alkyl group, a phenyl group, a biphenyl group, a pyridinyl group, a pyrimidinyl group, a pyridazinyl group, a pyrazinyl group, a triazinyl group, or any combination thereof.

In one or more embodiments, i) in Formula 1, $R_1$ to $R_5$, $R_{5a}$, $R_{5b}$, and $R_7$ to $R_9$, other than the group represented by Formula 1-1 and the group represented by Formula 1-2, ii) $R_{51}$ to $R_{56}$, $R_{71}$ to $R_{74}$, $R_{81}$ to $R_{85}$, $R_{82a}$, $R_{82b}$, $R_{83a}$, $R_{83b}$, $R_{84a}$, $R_{84b}$, $R_{500a}$, $R_{500b}$, $R_{501}$ to $R_{508}$, $R_{505a}$, $R_{505b}$, $R_{506a}$, $R_{506b}$, $R_{507a}$, $R_{507b}$, $R_{508a}$, and $R_{508b}$ in Formulae 2, 3-1 to 3-5, 502, and 503, and iii) $R_{10a}$ may each independently be hydrogen, deuterium, -F, a cyano group, a nitro group, $-CH_3$, $-CD_3$, $-CD_2H$, $-CDH_2$, $-CF_3$, $-CF_2H$, $-CFH_2$, a group represented by one of Formulae 9-1 to 9-19, a group represented by one of Formulae 10-1 to 10-246, $-C(Q_1)(Q_2)(Q_3)$, $-Si(Q_1)(Q_2)(Q_3)$, or $-P(=O)(Q_1)(Q_2)$, wherein $Q_1$ to $Q_3$ may respectively be understood by referring to the descriptions of $Q_1$ to $Q_3$ provided herein:

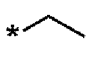
9-1

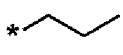
9-2

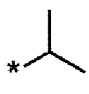
9-3

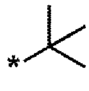
9-4

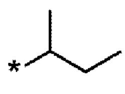
9-5

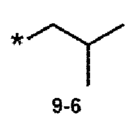
9-6

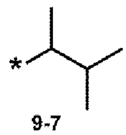
9-7

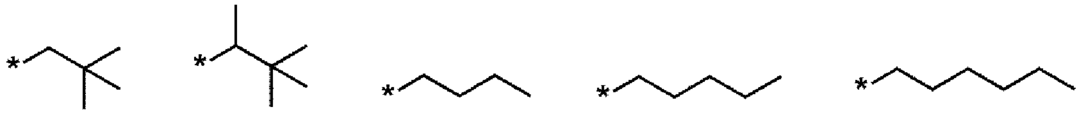
9-8 9-9 9-10 9-11 9-12

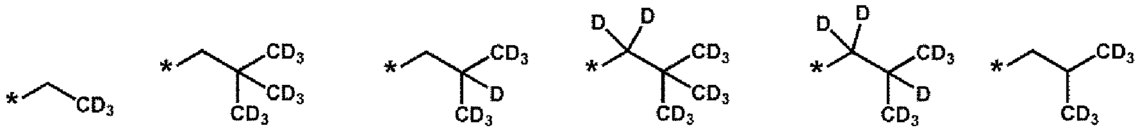
9-13 9-14 9-15 9-16 9-17 9-18

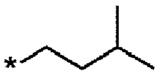
9-19

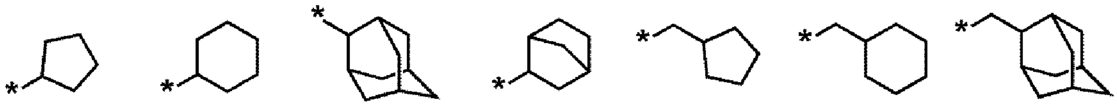
10-1 10-2 10-3 10-4 10-5 10-6 10-7

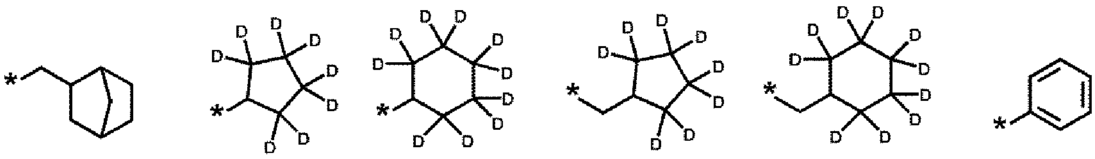
10-8 10-9 10-10 10-11 10-12 10-13

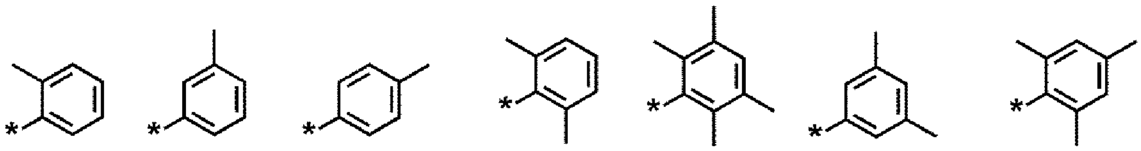
10-14 10-15 10-16 10-17 10-18 10-19 10-20

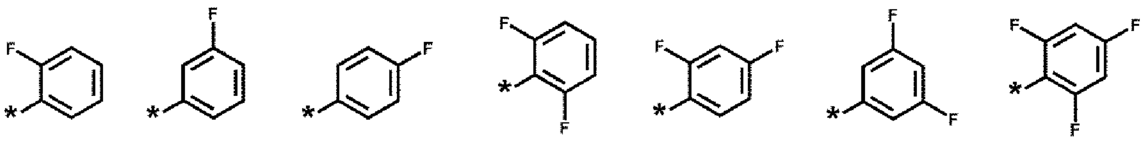
10-21 10-22 10-23 10-24 10-25 10-26 10-27

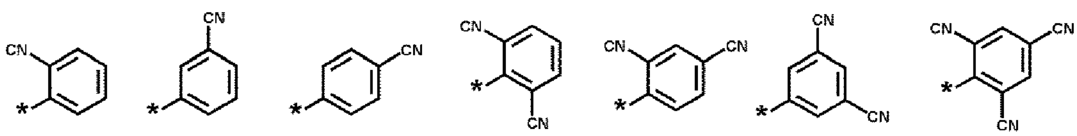
10-28 10-29 10-30 10-31 10-32 10-33 10-34

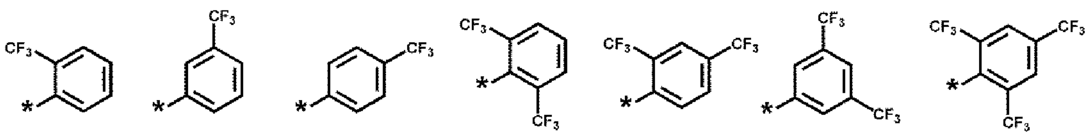
10-35 10-36 10-37 10-38 10-39 10-40 10-41

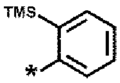 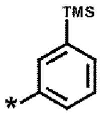 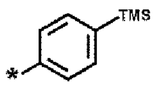 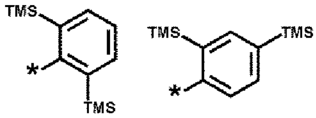 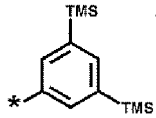 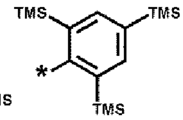

10-42 10-43 10-44 10-45 10-46 10-47 10-48

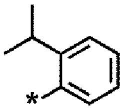 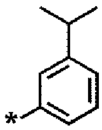 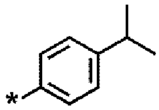 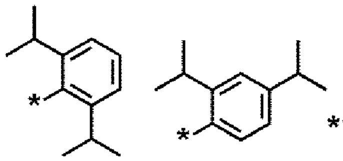 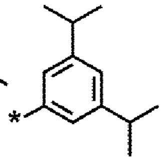 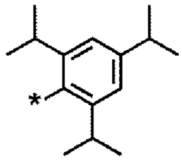

10-49 10-50 10-51 10-52 10-53 10-54 10-55

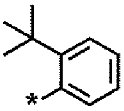 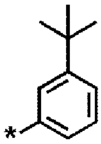 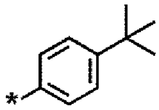 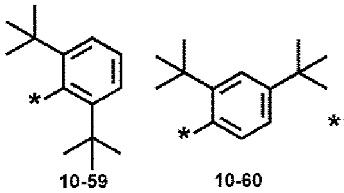 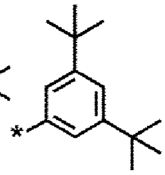 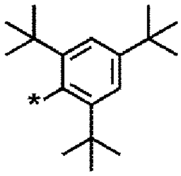

10-56 10-57 10-58 10-59 10-60 10-61 10-62

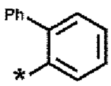 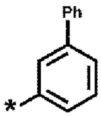 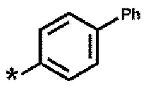 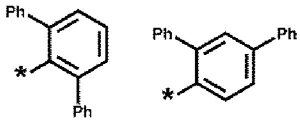 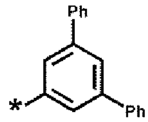 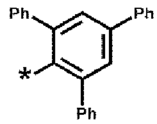

10-63 10-64 10-65 10-66 10-67 10-68 10-69

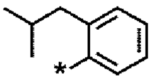 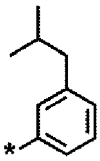 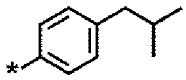 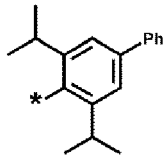 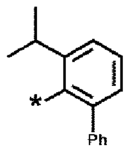 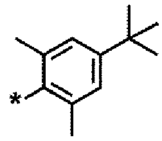

10-70 10-71 10-72 10-73 10-74 10-75

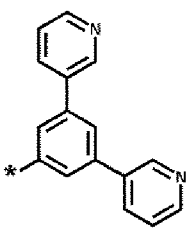 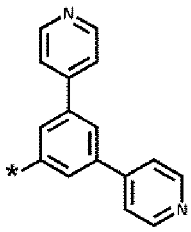 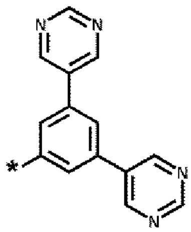 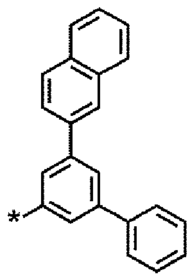 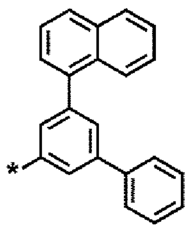

10-76 10-77 10-78 10-79 10-80

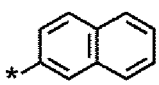 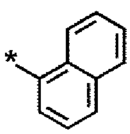 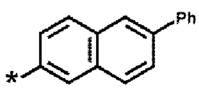 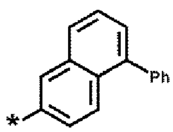 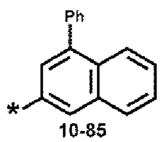

10-81 10-82 10-83 10-84 10-85

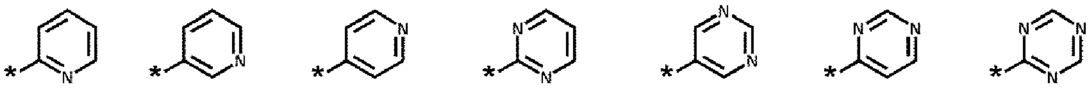
10-86 10-87 10-88 10-89 10-90 10-91 10-92

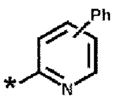 10-93
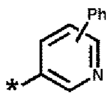 10-94
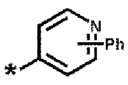 10-95
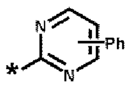 10-96
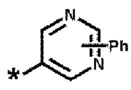 10-97
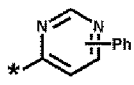 10-98
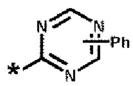 10-99

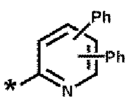 10-100
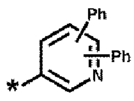 10-101
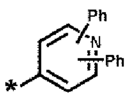 10-102
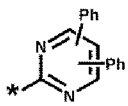 10-103
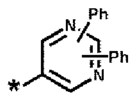 10-104
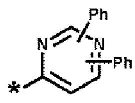 10-105
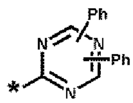 10-106

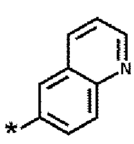 10-107
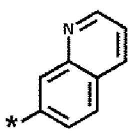 10-108
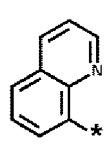 10-109
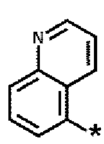 10-110
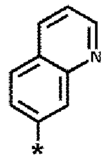 10-111
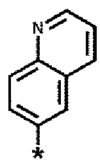 10-112

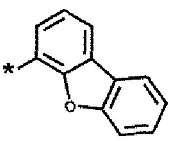 10-113
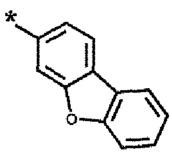 10-114
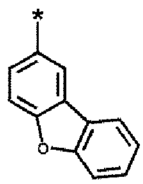 10-115
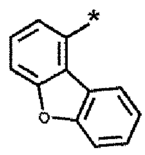 10-116
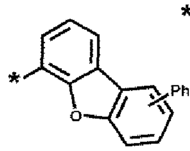 10-117
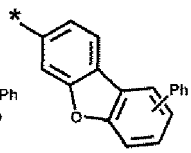 10-118

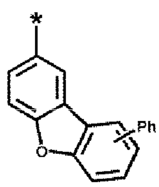 10-119
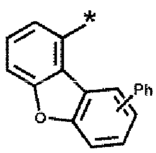 10-120
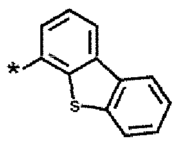 10-121
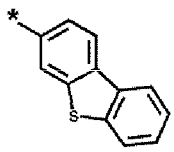 10-122
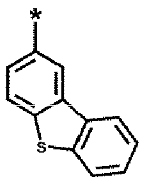 10-123
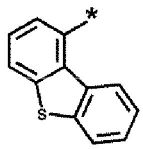 10-124

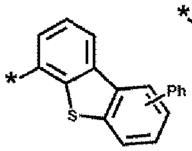 10-125
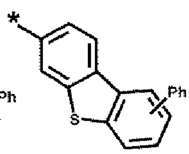 10-126
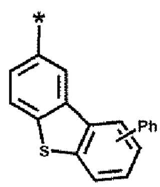 10-127
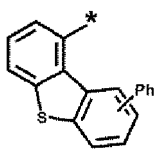 10-128
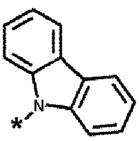 10-129
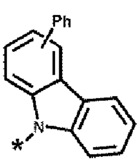 10-130

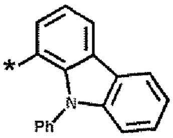 10-131 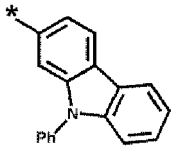 10-132 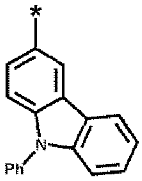 10-133 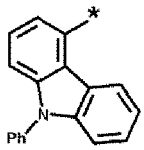 10-134 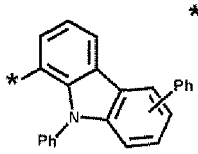 10-135 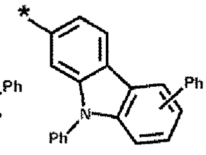 10-136

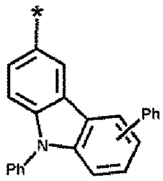 10-137 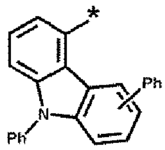 10-138 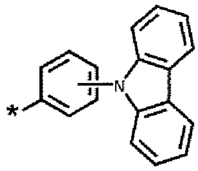 10-139 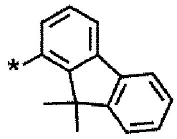 10-140 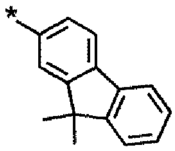 10-141 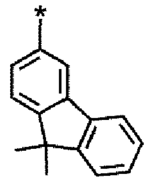 10-142

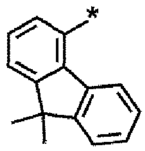 10-143 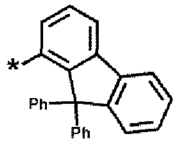 10-144 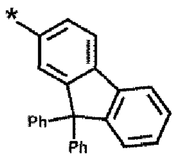 10-145 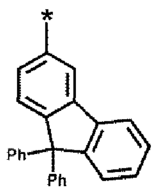 10-146 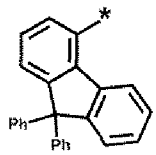 10-147

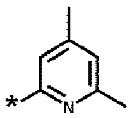 10-148 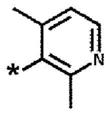 10-149 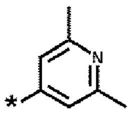 10-150 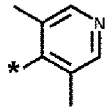 10-151 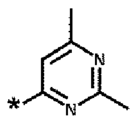 10-152 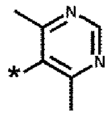 10-153 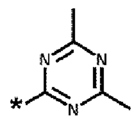 10-154

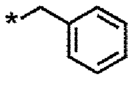 10-155 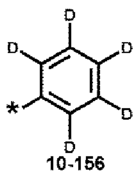 10-156 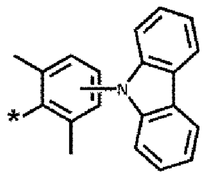 10-157 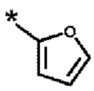 10-158 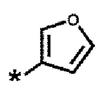 10-159 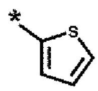 10-160 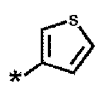 10-161

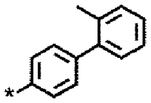 10-162 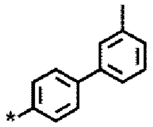 10-163 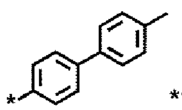 10-164 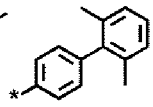 10-165 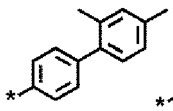 10-166 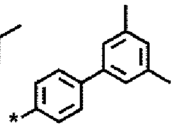 10-167 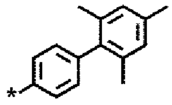 10-168

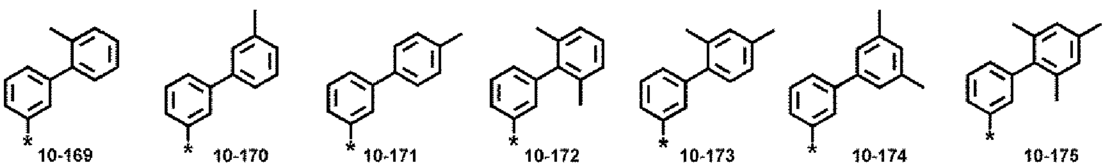

10-169 10-170 10-171 10-172 10-173 10-174 10-175

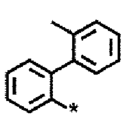 10-176 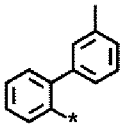 10-177 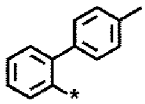 10-178 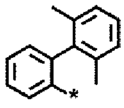 10-179 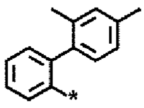 10-180 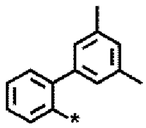 10-181 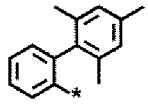 10-182

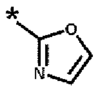 10-183 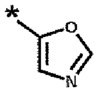 10-184 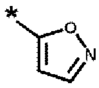 10-185 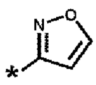 10-186 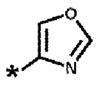 10-187 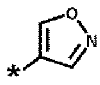 10-188 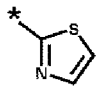 10-189 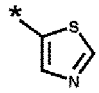 10-190 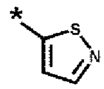 10-191

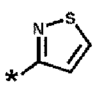 10-192 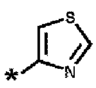 10-193 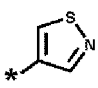 10-194 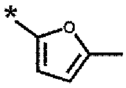 10-195 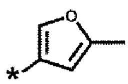 10-196 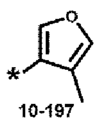 10-197 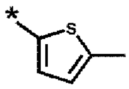 10-198 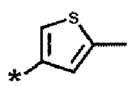 10-199 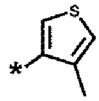 10-200

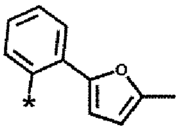 10-201 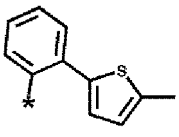 10-202 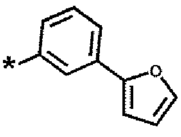 10-203 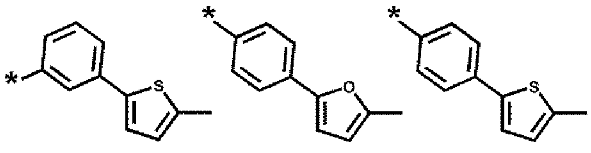 10-204 10-205 10-206

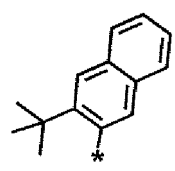 10-207 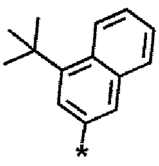 10-208 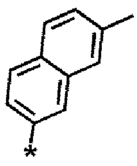 10-209 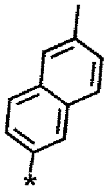 10-210 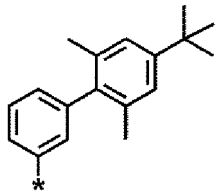 10-211 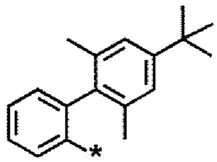 10-212

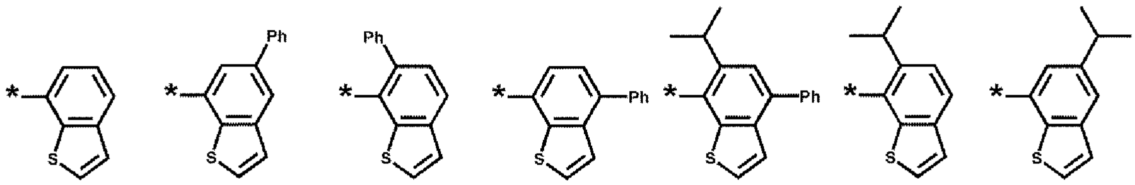 10-213 10-214 10-215 10-216 10-217 10-218 10-219

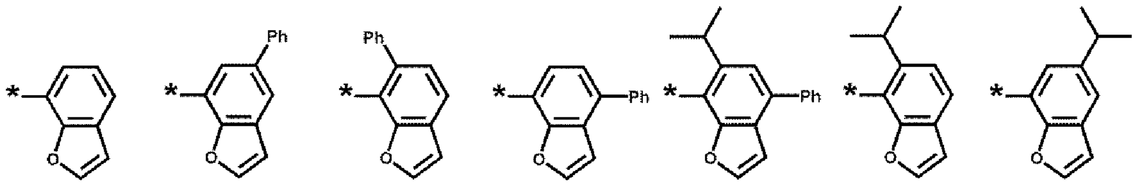 10-220 10-221 10-222 10-223 10-224 10-225 10-226

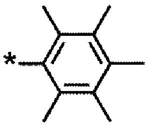
10-227

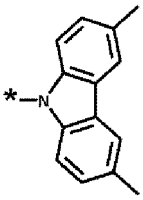
10-228

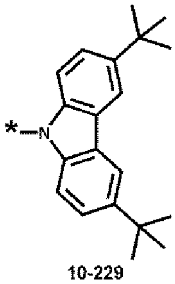
10-229

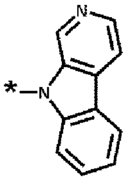
10-230

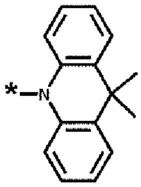
10-231

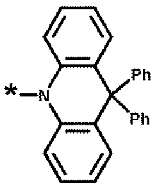
10-232

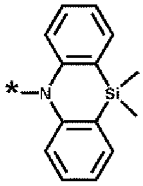
10-233

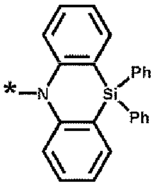
10-234

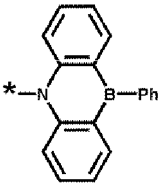
10-235

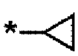
10-236

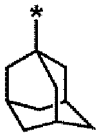
10-237

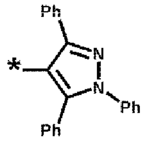
10-238

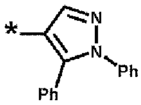
10-239

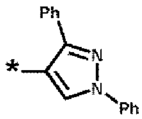
10-240

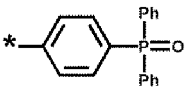
10-241

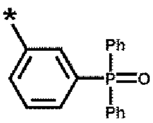
10-242

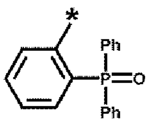
10-243

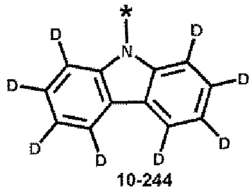
10-244

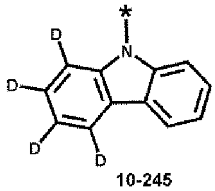
10-245

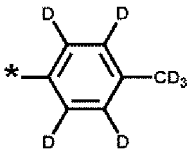
10-246 ,

wherein, in Formulae 9-1 to 9-19 and 10-1 to 10-246, * indicates a binding site to an adjacent atom, "Ph" represents a phenyl group, and "TMS" represents a trimethylsilyl group.

In Formulae 3-1 to 3-5, 502, and 503, a71 to a74 and a501 to a504 may respectively indicate the number of $R_{71}$(s) to $R_{74}$(s) and $R_{501}$ (s) to $R_{504}$(s), and a71 to a74 and a501 to a504 may each independently be an integer from 0 to 20. When a71 is 2 or greater, at least two $R_{71}$(s) may be identical to or different from each other, when a72 is 2 or greater, at least two $R_{72}$(s) may be identical to or different from each other, when a73 is 2 or greater, at least two $R_{73}$(s) may be identical to or different from each other, when a74 is 2 or greater, at least two $R_{74}$(s) may be identical to or different from each other, when a501 is 2 or greater, at least two $R_{501}$ (s) may be identical to or different from each other, when a502 is 2 or greater, at least two $R_{502}$(s) may be identical to or different from each other, when a503 is 2 or greater, at least two $R_{503}$(s) may be identical to or different from each other, and when a504 is 2 or greater, at least two $R_{504}$(s) may be identical to or different from each other. a71 to a74 and a501 to a504 may each independently be an integer from 0 to 8.

In Formula 1, i) at least two of groups represented by $*-(L_1)_{b1}-(R_1)_{c1}$ in the number of a1 may optionally be bound to each other (via a single bond, a double bond, or a first linking group) to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, ii) at least two of $R_2$(s) in the number of a2 may optionally be bound to each other (via a single bond, a double bond, or a first linking group) to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, iii) at least two of $R_3$ in the number of a3 may optionally be bound to each other (via a single bond, a double bond, or a first linking group) to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, iv) at least two of $R_4$ in the number of a4 may optionally be bound to each other

(via a single bond, a double bond, or a first linking group) to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, and v) at least two of $R_1$ to $R_5$, $R_{5a}$, and $R_{5b}$ may optionally be bound to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$. The first linking group may be selected from *-N($R_{95}$)-*', *-B($R_{95}$)-*', *-P($R_{95}$)-*', *-C($R_{95a}$)($R_{95b}$)-*', *-Si($R_{95a}$)($R_{95b}$)-*', *-Ge($R_{95a}$)($R_{95b}$)-*', *-S-*', *-Se-*', *-O-*', *-C(=O)-*', *-S(=O)-*', *-S(=O)$_2$-*', *-C($R_{95}$)=*', *=C($R_{95}$)-*', *-C($R_{95a}$)=C($R_{95b}$)-*', *-C(=S)-*', and *-C≡C-*', and $R_{95}$, $R_{95a}$, and $R_{95b}$ may each be understood by referring to the description of $R_1$ provided herein.

In some embodiments, in Formula 2, the group represented by *-($L_{51}$)$_{b51}$-$R_{51}$ and the group represented by *-($L_{52}$)$_{b52}$-$R_{52}$ may not be a phenyl group.

In some embodiments, in Formula 2, the group represented by *-($L_{51}$)$_{b51}$-$R_{51}$ may be identical to the group represented by *-($L_{52}$)$_{b52}$-$R_{52}$.

In one or more embodiments, in Formula 2, the group represented by *-($L_{51}$)$_{b51}$-$R_{51}$ and the group represented by *-($L_{52}$)$_{b52}$-$R_{52}$ may be different from each other.

In one or more embodiments, in Formula 2, b51 and b52 may each independently be 1, 2, or 3, $L_{51}$ and $L_{52}$ may each independently be a benzene group, a pyridine group, a pyrimidine group, a pyridazine group, a pyrazine group, or a triazine group, each independently unsubstituted or substituted with at least one $R_{10a}$.

In some embodiments, in Formula 2, $R_{51}$ and $R_{52}$ may each independently be a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, -C($Q_1$)($Q_2$)($Q_3$), or - Si($Q_1$)($Q_2$)($Q_3$),

wherein $Q_1$ to $Q_3$ may each independently be a $C_3$-$C_{60}$ carbocyclic group or a $C_1$-$C_{60}$ heterocyclic group, each independently unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof.

In some embodiments,

in Formula 2, the group represented by *-($L_{51}$)$_{b51}$-$R_{51}$ may be a group represented by one of Formulae CY51-1 to CY51-26,

in Formula 2, the group represented by *-($L_{52}$)$_{b52}$-$R_{52}$ may be a group represented by one of Formulae CY52-1 to CY52-26, and/or

in Formula 2, the group represented by *-($L_{53}$)$_{b53}$-$R_{53}$ may be a group represented by one of Formulae CY53-1 to CY53-27, -C($Q_1$)($Q_2$)($Q_3$), or - Si($Q_1$)($Q_2$)($Q_3$):

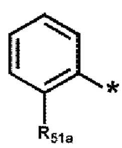
CY51-1

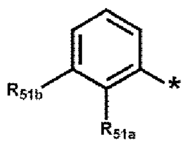
CY51-2

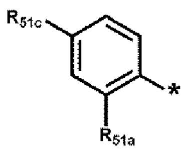
CY51-3

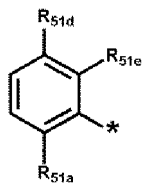
CY51-4

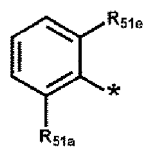
CY51-5

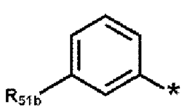
CY51-6

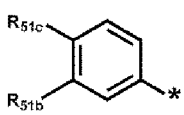
CY51-7

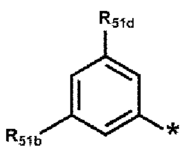
CY51-8

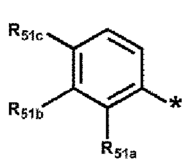
CY51-9

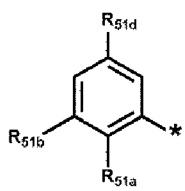
CY51-10

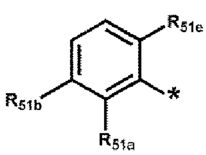
CY51-11

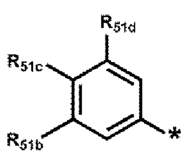
CY51-12

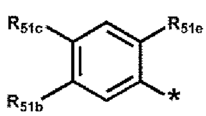
CY51-13

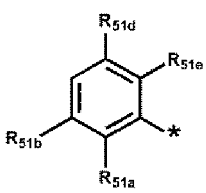
CY51-14

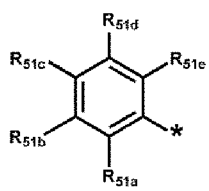
CY51-15

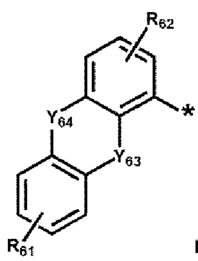
CY51-16

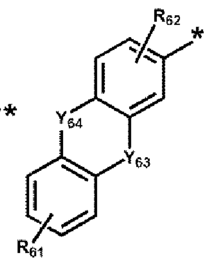
CY51-17

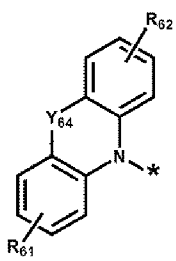
CY51-18

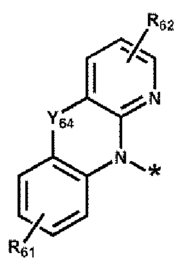
CY51-19

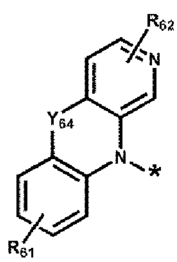
CY51-20

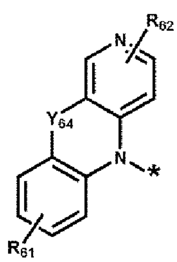
CY51-21

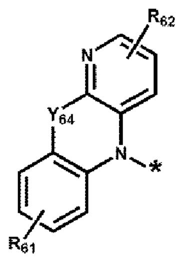
CY51-22

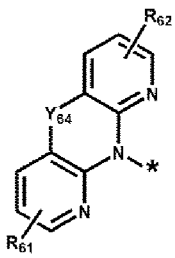
CY51-23

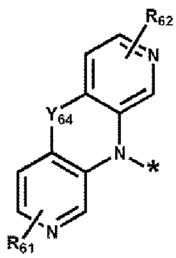
CY51-24

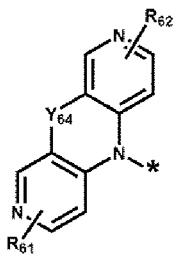
CY51-25

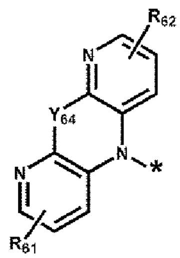
CY51-26

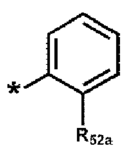
CY52-1

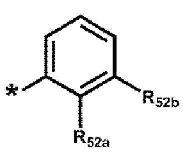
CY52-2

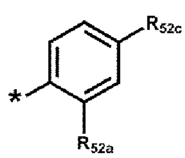
CY52-3

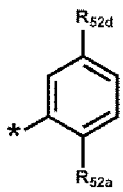
CY52-4

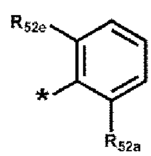
CY52-5

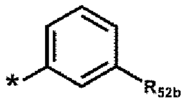
CY52-6

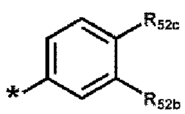
CY52-7

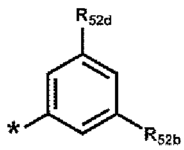
CY52-8

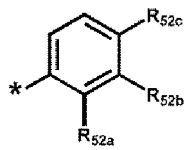
CY52-9

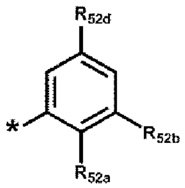
CY52-10

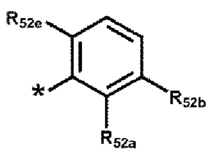
CY52-11

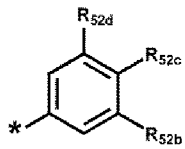
CY52-12

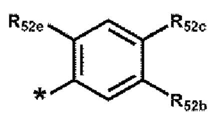
CY52-13

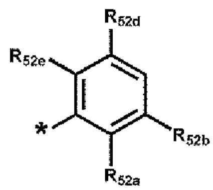
CY52-14

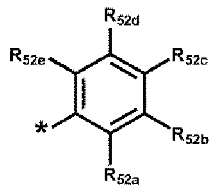
CY52-15

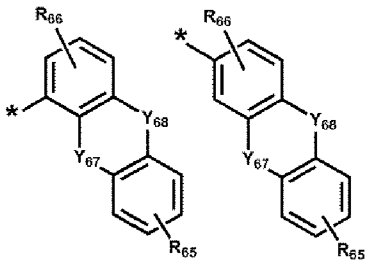
CY52-16 CY52-17

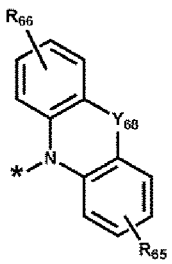
CY52-18

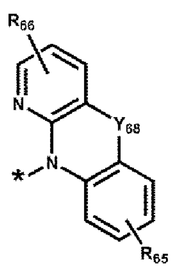
CY52-19

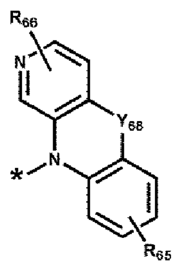
CY52-20

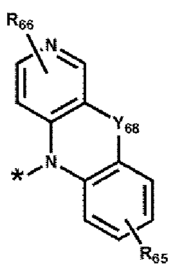
CY52-21

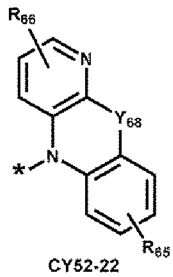
CY52-22

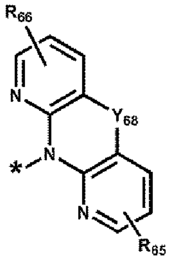
CY52-23

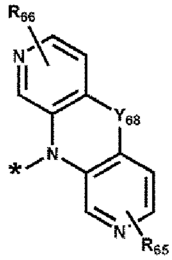
CY52-24

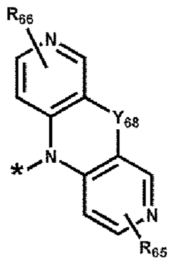
CY52-25

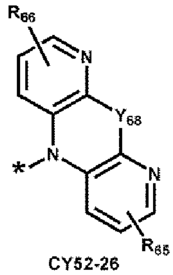
CY52-26

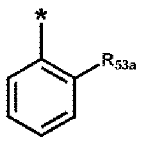
CY53-1

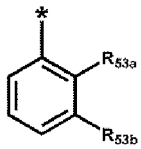
CY53-2

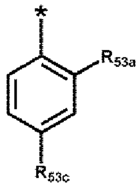
CY53-3

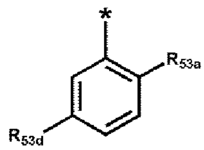
CY53-4

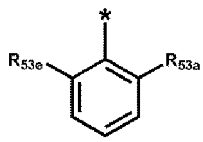
CY53-5

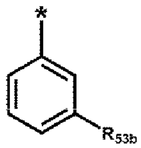
CY53-6

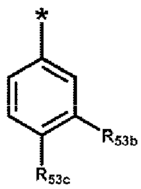
CY53-7

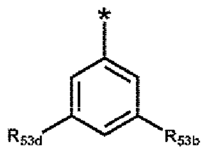
CY53-8

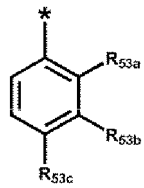
CY53-9

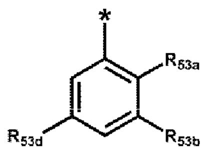
CY53-10

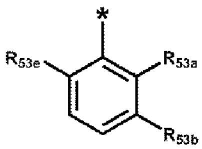
CY53-11

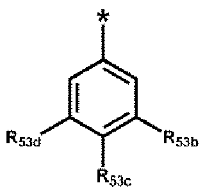
CY53-12

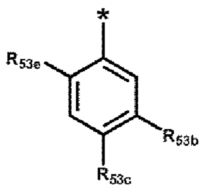
CY53-13

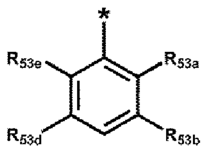
CY53-14

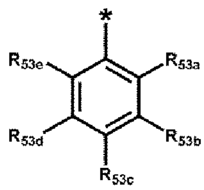
CY53-15

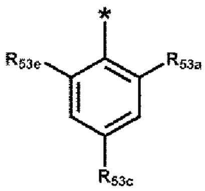
CY53-16

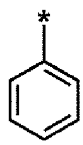
CY53-17

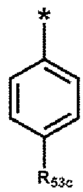
CY53-18

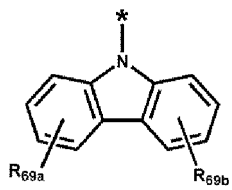
CY53-19

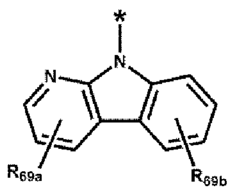
CY53-20

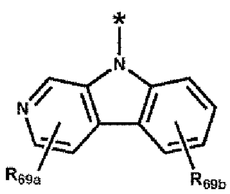
CY53-21

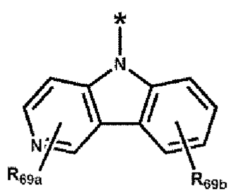
CY53-22

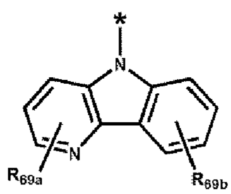
CY53-23

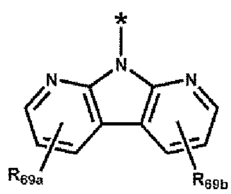
CY53-24

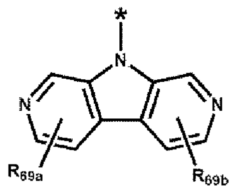
CY53-25

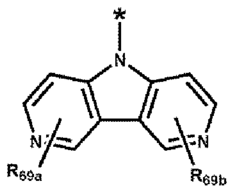
CY53-26

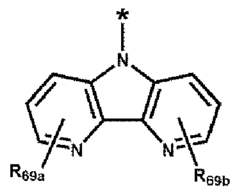
CY53-27

,

wherein, in Formulae CY51-1 to CY51-26, CY52-1 to CY52-26, and CY53-1 to CY53-27,

$Y_{63}$ may be a single bond, O, S, $N(R_{63})$, $B(R_{63})$, $C(R_{63a})(_{63b})$, or $Si(R_{63a})(R_{63b})$,

$Y_{64}$ may be a single bond, O, S, $N(R_{64})$, $B(R_{64})$, $C(R_{64a})(R_{64b})$, or Si(R64a)(R64b),

$Y_{67}$ may be a single bond, O, S, $N(R_{67})$, $B(R_{67})$, $C(R_{67a})(R_{67b})$, or $Si(R_{67a})(R_{67b})$,

$Y_{68}$ may be a single bond, O, S, $N(R_{68})$, $B(R_{68})$, $C(R_{68a})(R_{68b})$, or $Si(R_{68a})(R_{68b})$,

$Y_{63}$ and $Y_{64}$ in Formulae CY51-16 and CY51-17 may not be a single bond at the same time,

$Y_{67}$ and $Y_{68}$ in Formulae CY52-16 and CY52-17 may not be a single bond at the same time,

$R_{51a}$ to $R_{51e}$, $R_{61}$ to $R_{64}$, $R_{63a}$, $R_{63b}$, $R_{64a}$, and $R_{64b}$ may each be understood by referring to the description of $R_{51}$, and $R_{51a}$ to $R_{51e}$ may not each be hydrogen,

$R_{52a}$ to $R_{52e}$, $R_{65}$ to $R_{68}$, $R_{67a}$, $R_{67b}$, $R_{68a}$, and $R_{68b}$ may each be understood by referring to the description of $R_{52}$, and $R_{52a}$ to $R_{52e}$ may not each be hydrogen,

$R_{53a}$ to $R_{53e}$, $R_{69a}$, and $R_{69b}$ may each be understood by referring to the description of $R_{53}$, and $R_{53a}$ to $R_{53e}$ may not each be hydrogen, and

* indicates a binding site to an adjacent atom.

In some embodiments, $R_{51a}$ to $R_{51e}$ and $R_{52a}$ to $R_{52e}$ in Formulae CY51-1 to CY51-26 and Formula CY52-1 to 52-26 may each independently be:

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{10}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each independently unsubstituted or substituted with deuterium, -F, -Cl, - Br, -I, $-CD_3$, $-CD_2H$, $-CDH_2$, $-CF_3$, $-CF_2H$, $-CFH_2$, a hydroxyl group, a cyano group, a nitro group, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a $C_1$-$C_{10}$ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or any combination thereof; or

$-C(Q_1)(Q_2)(Q_3)$ or $-Si(Q_1)(Q_2)(Q_3)$,

wherein $O_1$ to $Q_3$ may each independently be a phenyl group, a naphthyl group, a pyridinyl group, a pyrimidinyl group, a pyridazinyl group, a pyrazinyl group, or a triazinyl group, each independently unsubstituted or substituted with deuterium, a $C_1$-$C_{10}$ alkyl group, a phenyl group, a biphenyl group, a pyridinyl group, a pyrimidinyl group, a

pyridazinyl group, a pyrazinyl group, a triazinyl group, or any combination thereof,

in Formulae CY51-16 and CY51-17, i) $Y_{63}$ may be O or S, and $Y_{64}$ may be $Si(R_{64a})(R_{64b})$, or ii) $Y_{63}$ may be $Si(R_{63a})(R_{63b})$, and $Y_{64}$ may be O or S,

in Formulae CY52-16 and CY52-17, i) $Y_{67}$ may be O or S, and $Y_{68}$ may be $Si(R_{68a})(R_{68b})$, or ii) $Y_{67}$ may be $Si(R_{67a})(R_{67b})$, and $Y_{68}$ may be O or S.

In Formulae 3-1 to 3-5, $L_{81}$ to $L_{85}$ may each independently be:

a single bond; or

*-C($Q_4$)($Q_5$)-*' or *-Si($Q_4$)($Q_5$)-*'; or

a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each independently unsubstituted or substituted with deuterium, -F, -Cl, -Br, -I, a hydroxyl group, a cyano group, a nitro group, a $C_1$-$C_{20}$ alkyl group, a $C_1$-$C_{20}$ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O($Q_{31}$), -S($Q_{31}$), - Si($Q_{31}$)($Q_{32}$)($Q_{33}$), -N($Q_{31}$)($Q_{32}$), -B($Q_{31}$)($Q_{32}$), -P($Q_{31}$)($Q_{32}$), -C(=O)($Q_{31}$), -S(=O)$_2$($Q_{31}$), - P(=O)($Q_{31}$)($Q_{32}$), or any combination thereof,

wherein $Q_4$, $Q_5$, and $Q_{31}$ to $Q_{33}$ may each independently be hydrogen, deuterium, a $C_1$-$C_{20}$ alkyl group, a $C_1$-$C_{20}$ alkoxy group, a phenyl group, a biphenyl group, a terphenyl group, a pyridinyl group, a pyrimidinyl group, a pyridazinyl group, a pyrazinyl group, or a triazinyl group.

In some embodiments, in Formulae 3-1 and 3-2, the group represented by

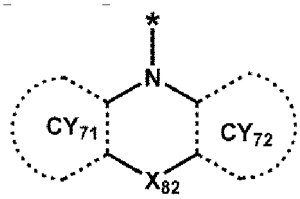

may be a group represented by one of Formulae CY71-1 (1) to CY71-1(8), and/or

in Formulae 3-1 and 3-3, the group represented by

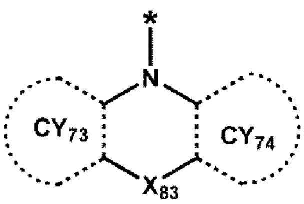

may be a group represented by one of Formulae CY71-2(1) to CY71-2(8), and/or

in Formulae 3-2 and 3-4, the group represented by

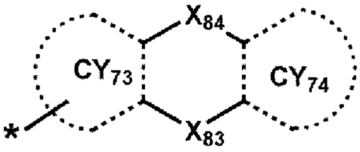

may be a group represented by one of Formulae CY71-3(1) to CY71-3(32), and/or in Formulae 3-3 to 3-5, the group represented by

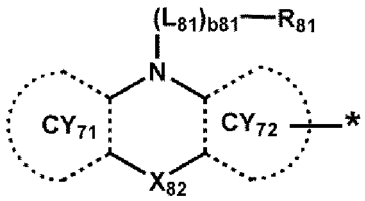

may be a group represented by one of Formulae CY71-4(1) to CY71-4(32), and/or in Formula 3-5, the group represented by

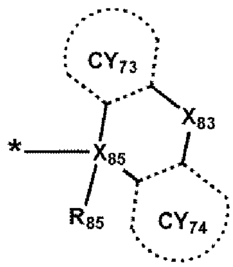

may be a group represented by one of Formulae CY71-5(1) to CY71-5(8):

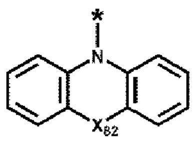
CY71-1(1)

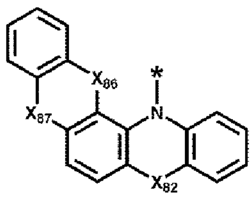
CY71-1(2)

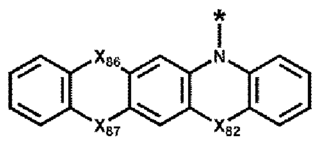
CY71-1(3)

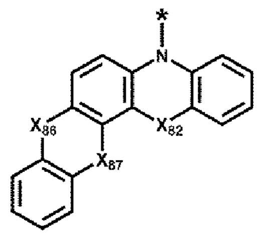
CY71-1(4)

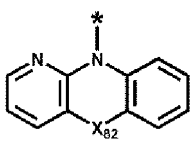
CY71-1(5)

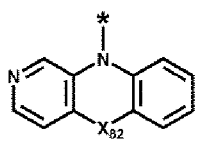
CY71-1(6)

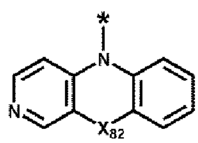
CY71-1(7)

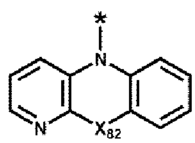
CY71-1(8)

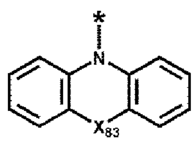
CY71-2(1)

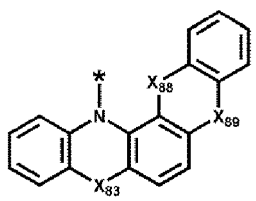
CY71-2(2)

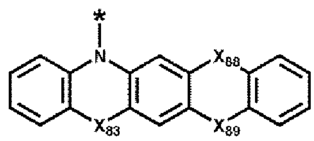
CY71-2(3)

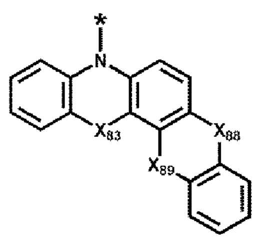
CY71-2(4)

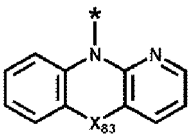
CY71-2(5)

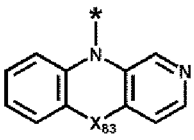
CY71-2(6)

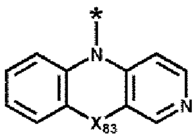
CY71-2(7)

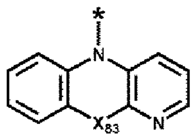
CY71-2(8)

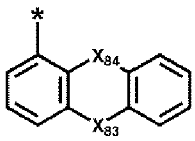
CY71-3(1)

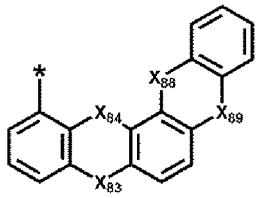
CY71-3(2)

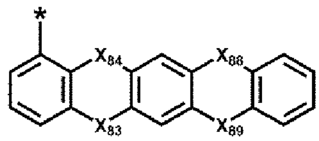
CY71-3(3)

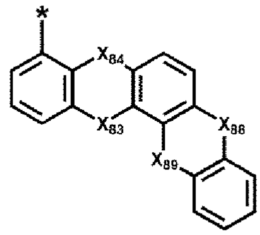
CY71-3(4)

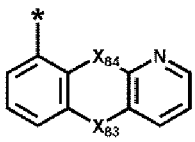
CY71-3(5)

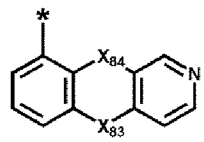
CY71-3(6)

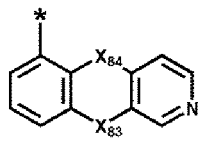
CY71-3(7)

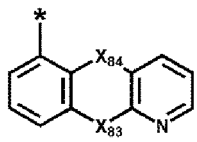
CY71-3(8)

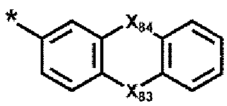
CY71-3(9)

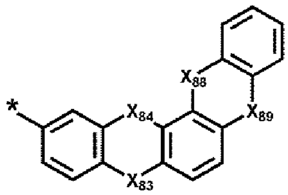
CY71-3(10)

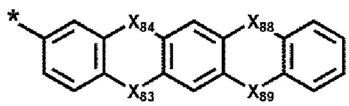
CY71-3(11)

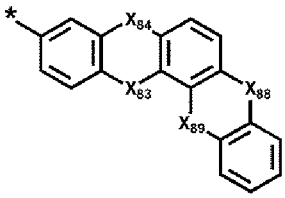
CY71-3(12)

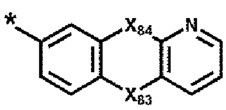
CY71-3(13)

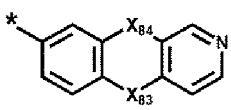
CY71-3(14)

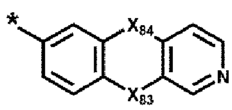
CY71-3(15)

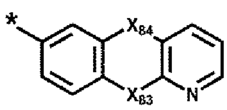
CY71-3(16)

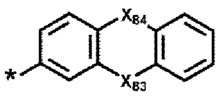
CY71-3(17)

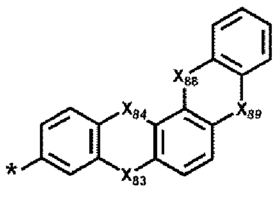
CY71-3(18)

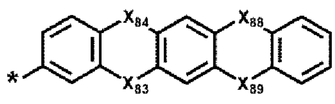
CY71-3(19)

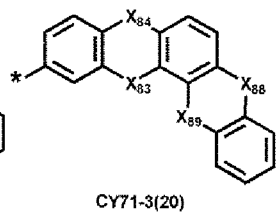
CY71-3(20)

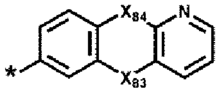
CY71-3(21)

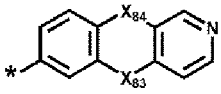
CY71-3(22)

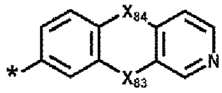
CY71-3(23)

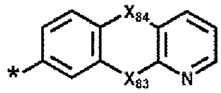
CY71-3(24)

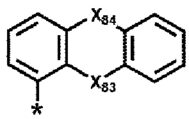
CY71-3(25)
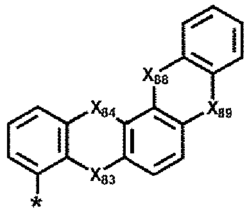
CY71-3(26)
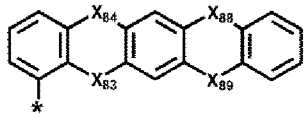
CY71-3(27)
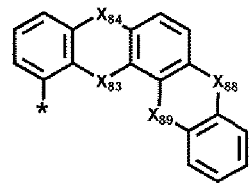
CY71-3(28)

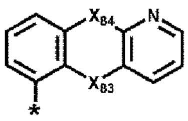
CY71-3(29)
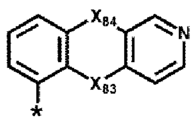
CY71-3(30)
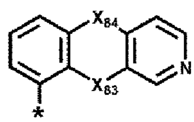
CY71-3(31)
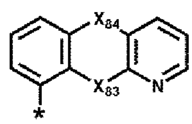
CY71-3(32)

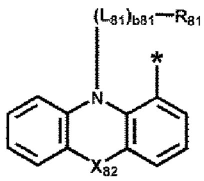
CY71-4(1)
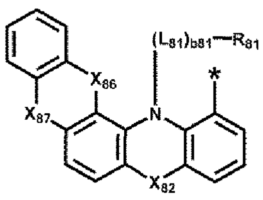
CY71-4(2)
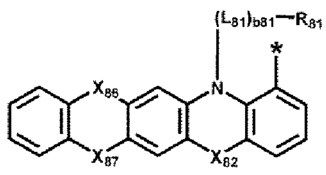
CY71-4(3)
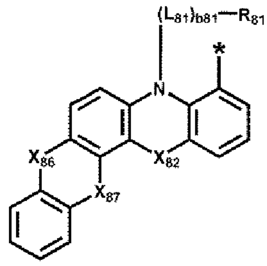
CY71-4(4)

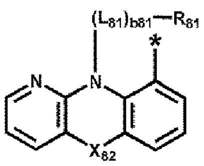
CY71-4(5)
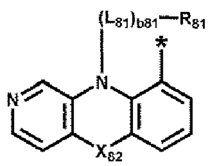
CY71-4(6)
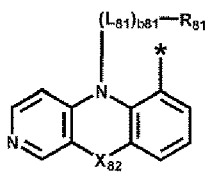
CY71-4(7)
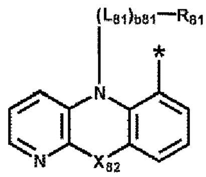
CY71-4(8)

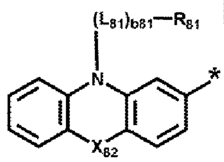
CY71-4(9)
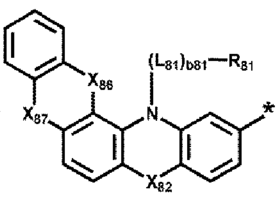
CY71-4(10)
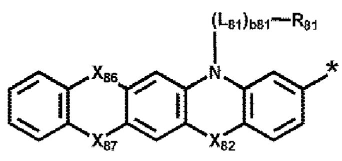
CY71-4(11)
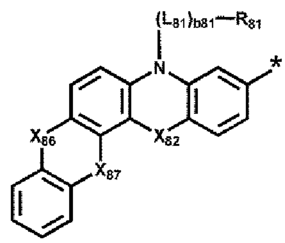
CY71-4(12)

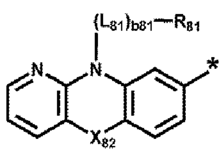
CY71-4(13)
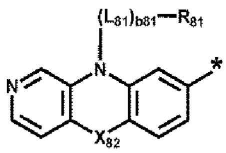
CY71-4(14)
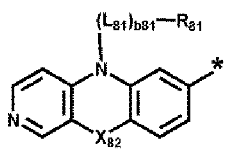
CY71-4(15)
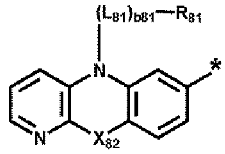
CY71-4(16)

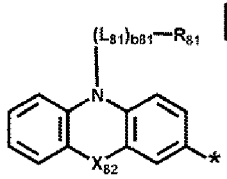
CY71-4(17)

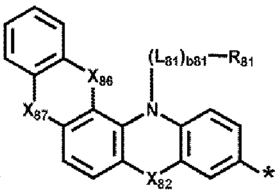
CY71-4(18)

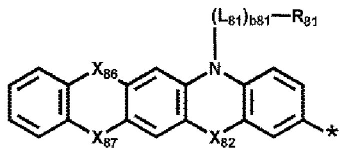
CY71-4(19)

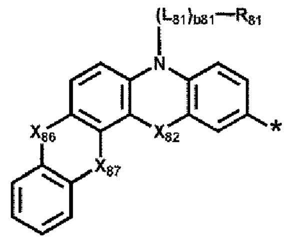
CY71-4(20)

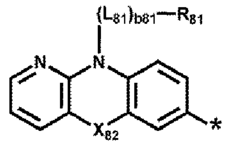
CY71-4(21)

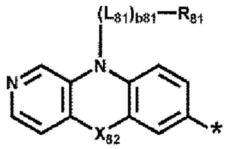
CY71-4(22)

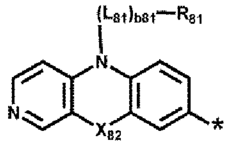
CY71-4(23)

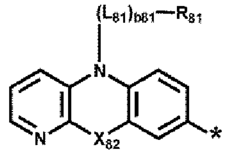
CY71-4(24)

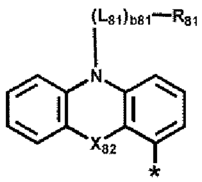
CY71-4(25)

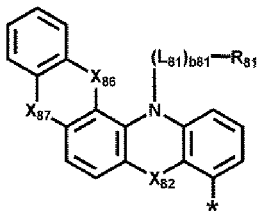
CY71-4(26)

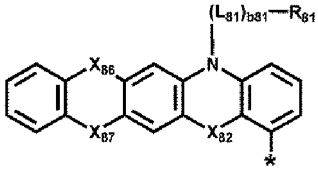
CY71-4(27)

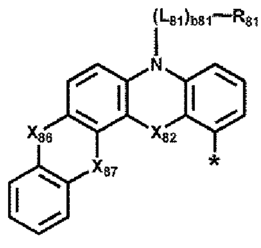
CY71-4(28)

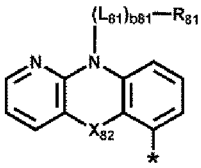
CY71-4(29)

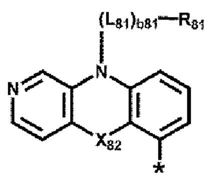
CY71-4(30)

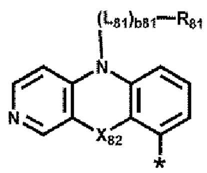
CY71-4(31)

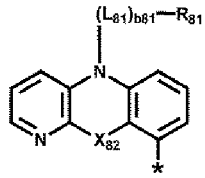
CY71-4(32)

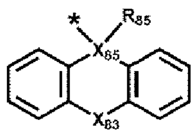
CY71-5(1)

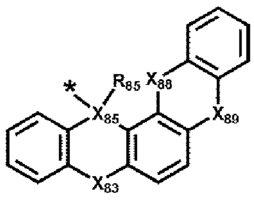
CY71-5(2)

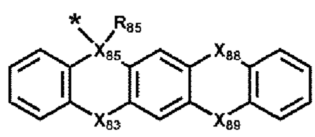
CY71-5(3)

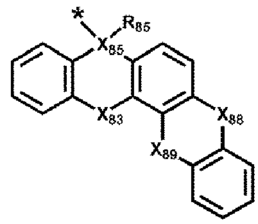
CY71-5(4)

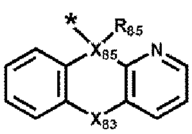
CY71-5(5)

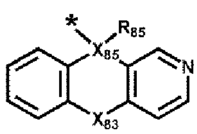
CY71-5(6)

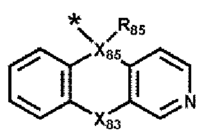
CY71-5(7)

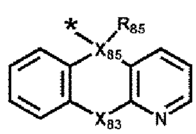
CY71-5(8)

,

wherein, in Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),

$X_{82}$ to $X_{85}$, $L_{81}$, b81, $R_{81}$, and $R_{85}$ may respectively be understood by referring to the descriptions of $X_{82}$ to $X_{85}$, $L_{81}$, b81, $R_{81}$, and $R_{85}$ provided herein,

$X_{86}$ may be a single bond, O, S, $N(R_{86})$, $B(R_{86})$, $C(R_{86a})(R_{86b})$, or Si(R86a)(R86b),

$X_{87}$ may be a single bond, O, S, $N(R_{87})$, $B(R_{87})$, $C(R_{87a})(R_{87b})$, or $Si(R_{87a})(R_{87b})$,
in Formulae CY71-1(1) to CY71-1(8) and CY71-4(1) to CY71-4(32), $X_{86}$ and $X_{87}$ may not be a single bond at the same time,
$X_{88}$ may be a single bond, O, S, $N(R_{88})$, $B(R_{88})$, $C(R_{88a})(R_{88b})$, or $Si(R_{88a})(R_{88b})$,
$X_{89}$ may be a single bond, O, S, $N(R_{89})$, $B(R_{89})$, $C(R_{89a})(R_{89b})$, or $Si(R_{89}a)(R_{89b})$,
in Formulae CY71-2(1) to CY71-2(8), CY71 -3(1) to CY71-3(32), and CY71-5(1) to CY71-5(8), $X_{88}$ and $X_{89}$ may not be a single bond at the same time, and
$R_{86}$ to $R_{89}$, $R_{86a}$, $R_{86b}$, $R_{87a}$, $R_{87b}$, $R_{88a}$, $R_{88b}$, $R_{89a}$, and $R_{89b}$ may each be understood by referring to the description of $R_{81}$ provided herein.

## Detailed examples of Compounds

In some embodiments, the first compound (the organometallic compound represented by Formula 1) may comprise (e.g., may be) at least one of Compounds D1 to D315, at least one of Compounds 1 to 120, or any combination thereof:

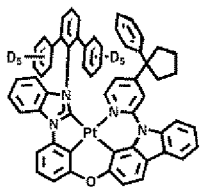
D1

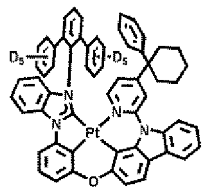
D2

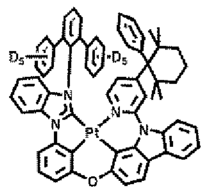
D3

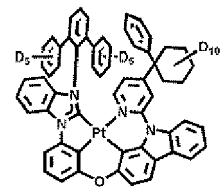
D4

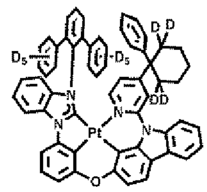
D5

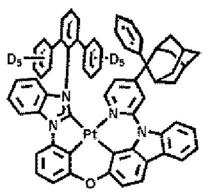
D6

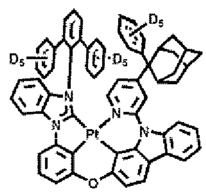
D7

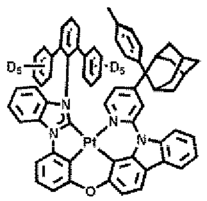
D8

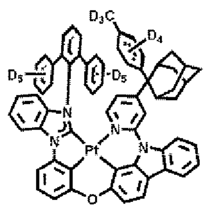
D9

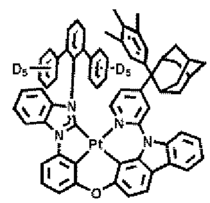
D10

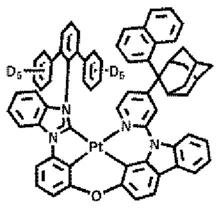
D11

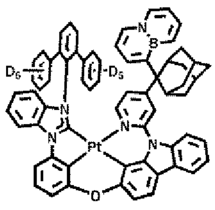
D12

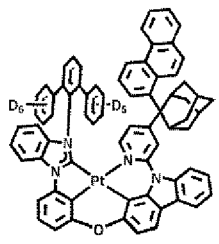
D13

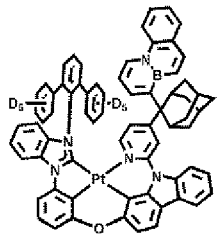
D14

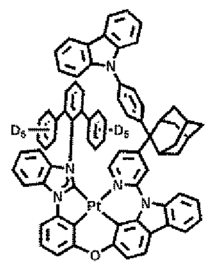
D15

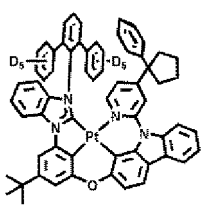
D16

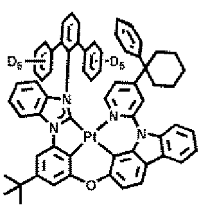
D17

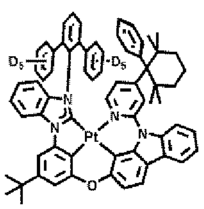
D18

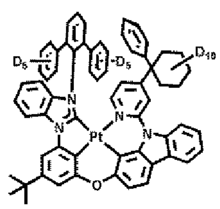
D19

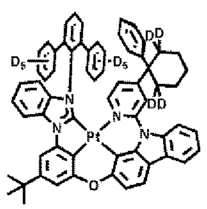
D20

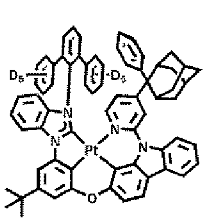
D21

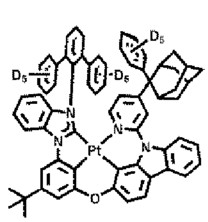
D22

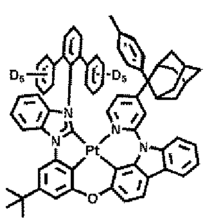
D23

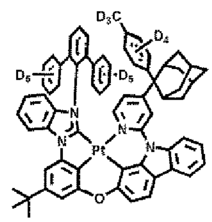
D24

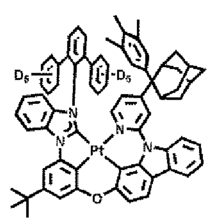
D25

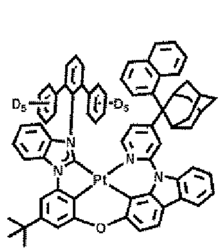
D26

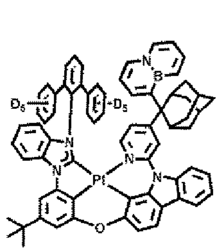
D27

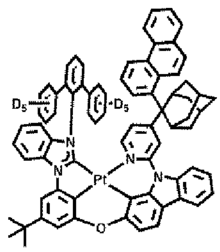
D28

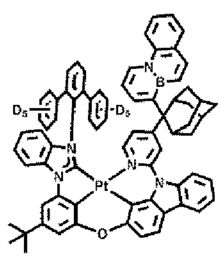
D29

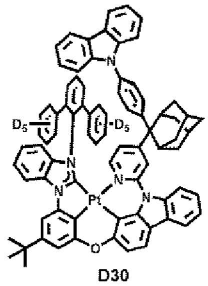
D30

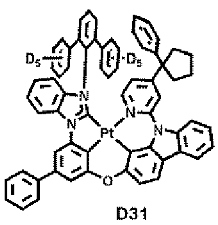
D31

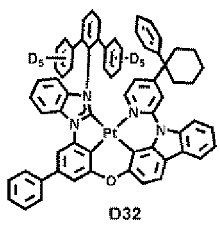
D32

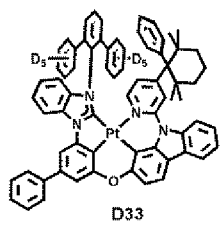
D33

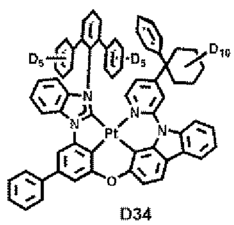
D34

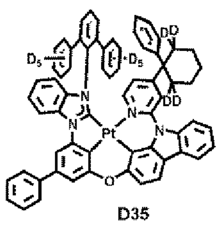
D35

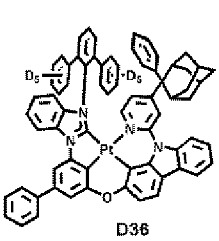
D36

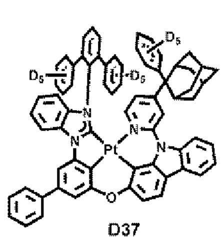
D37

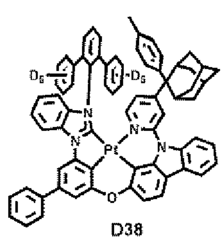
D38

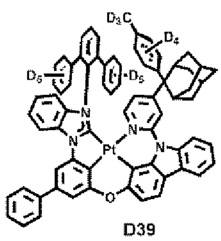
D39

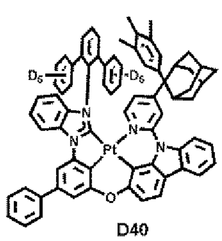
D40

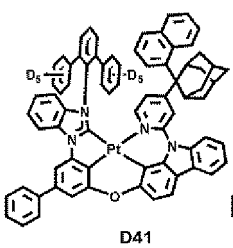
D41

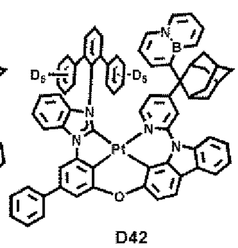
D42

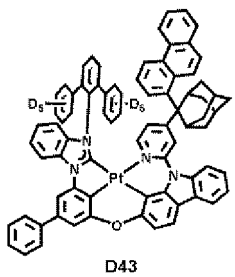
D43

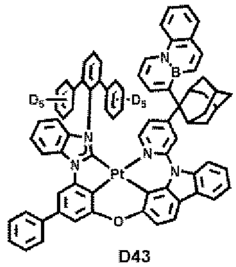
D43

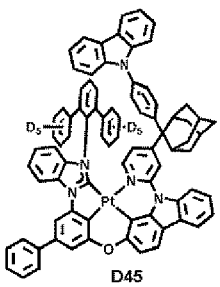
D45

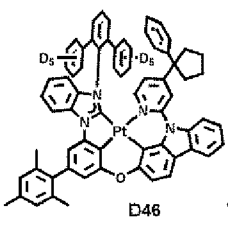
D46

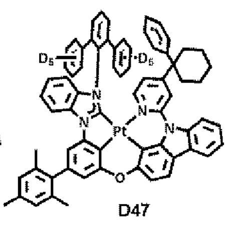
D47

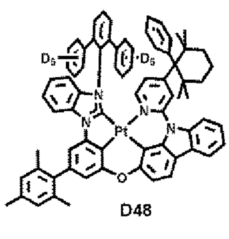
D48

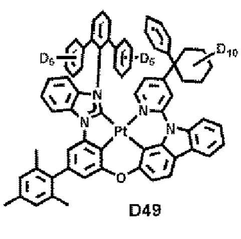
D49

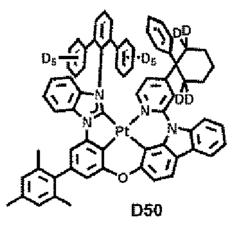
D50

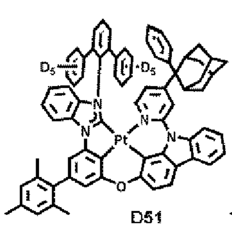
D51
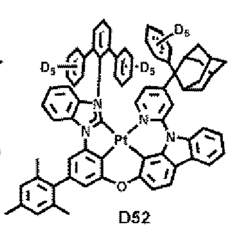
D52
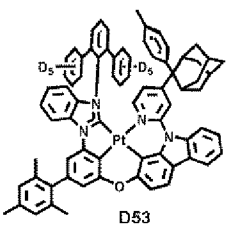
D53
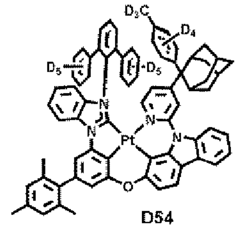
D54
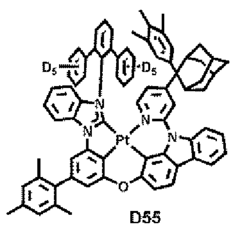
D55
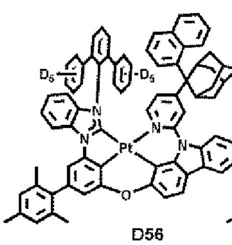
D56
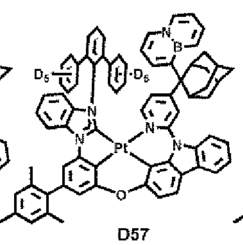
D57
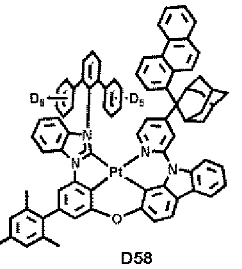
D58
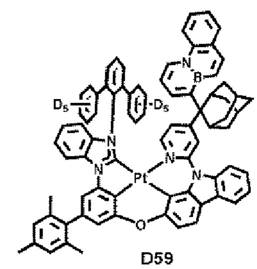
D59
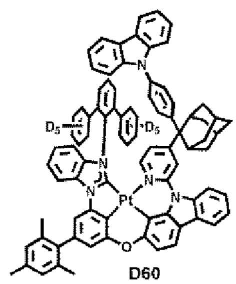
D60
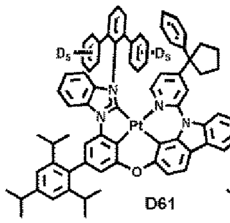
D61
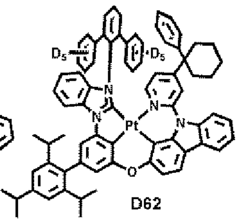
D62
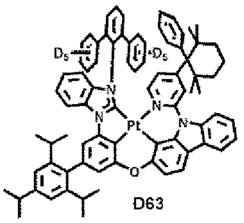
D63
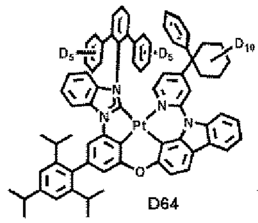
D64
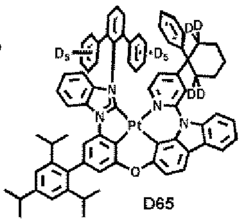
D65
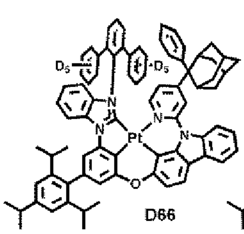
D66
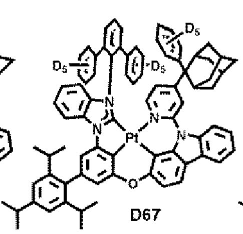
D67
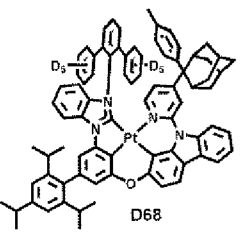
D68
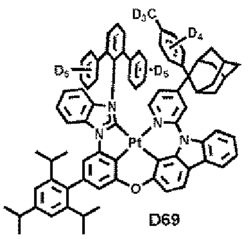
D69
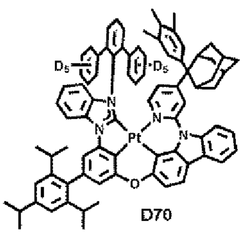
D70
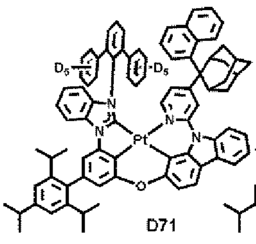
D71
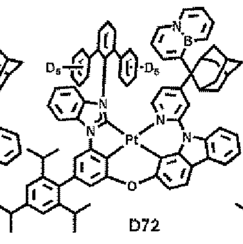
D72
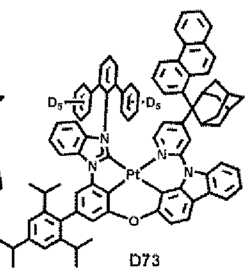
D73
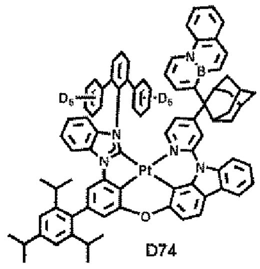
D74
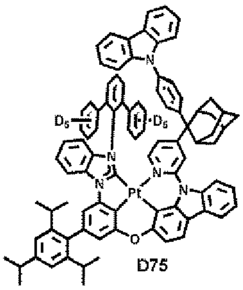
D75
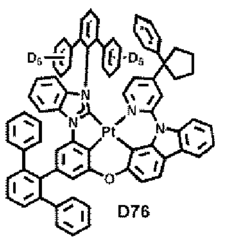
D76
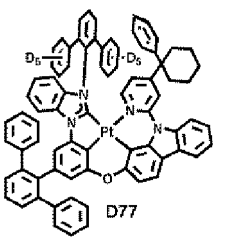
D77
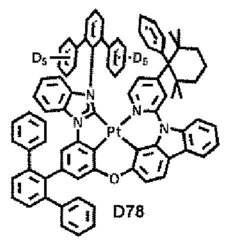
D78
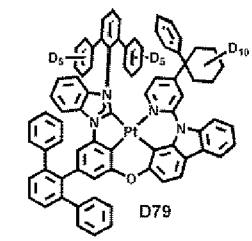
D79
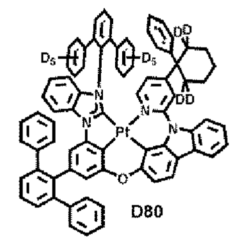
D80

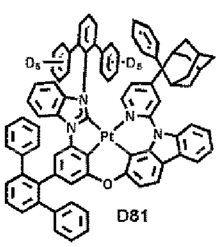
D81

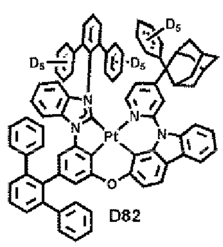
D82

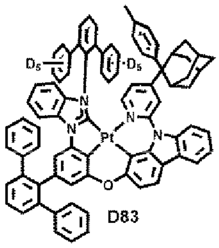
D83

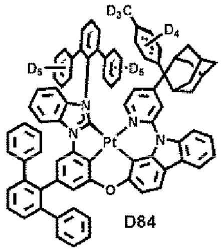
D84

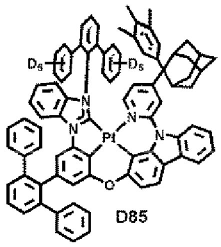
D85

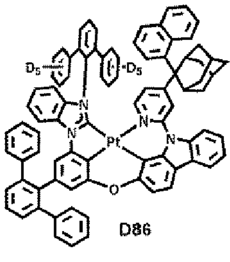
D86

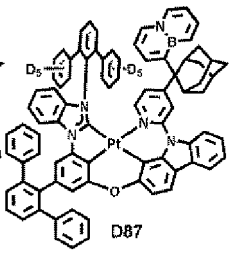
D87

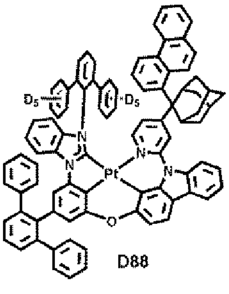
D88

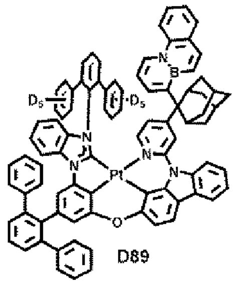
D89

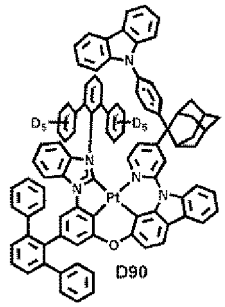
D90

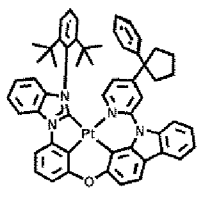
D91

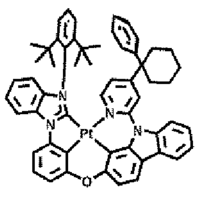
D92

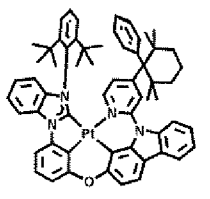
D93

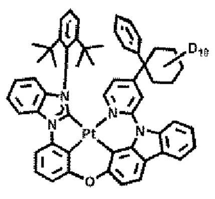
D94

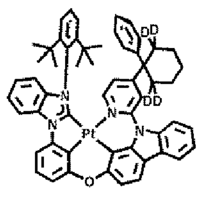
D95

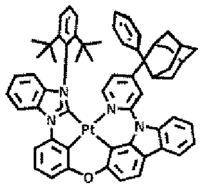
D96

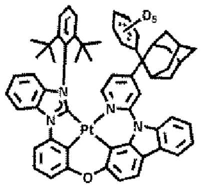
D97

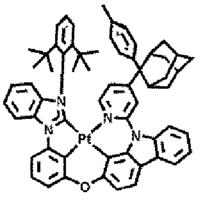
D98

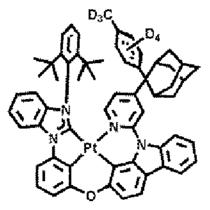
D99

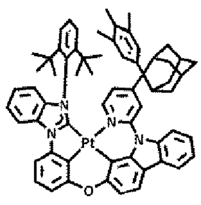
D100

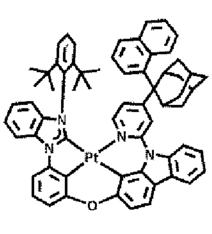
D101

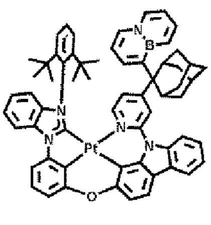
D102

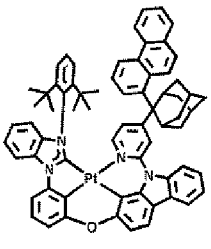
D103

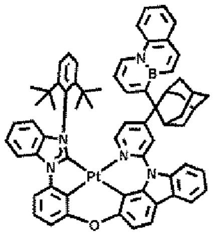
D104

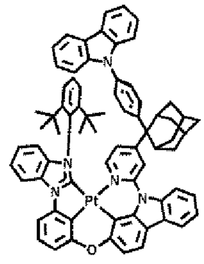
D105

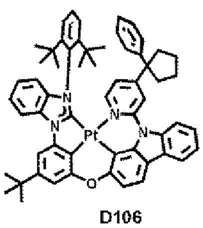
D106

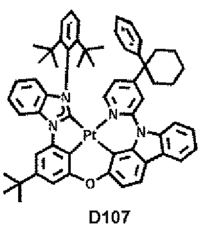
D107

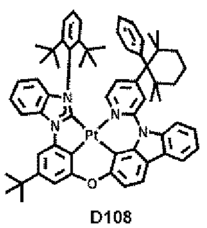
D108

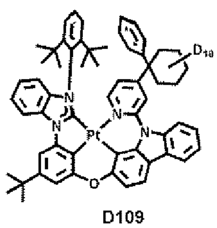
D109

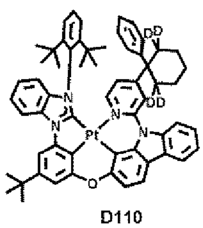
D110

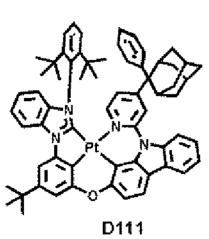
D111

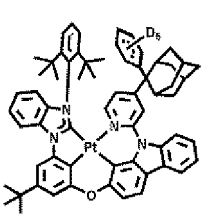
D112

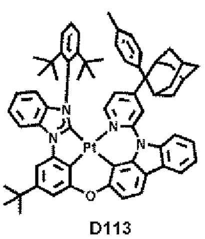
D113

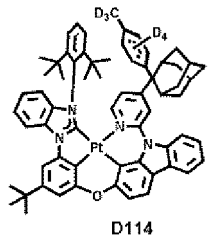
D114

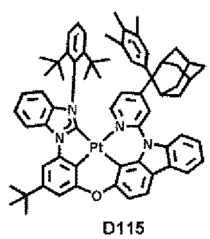
D115

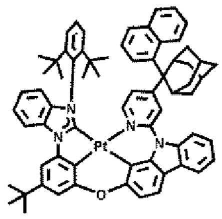
D116

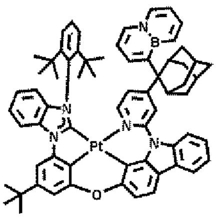
D117

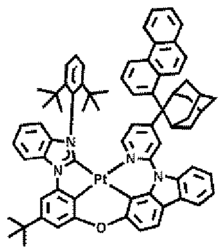
D118

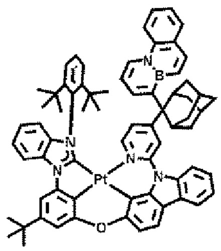
D119

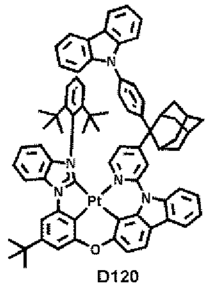
D120

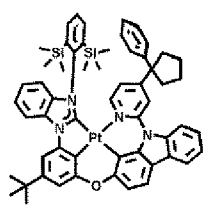
D121

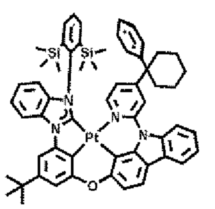
D122

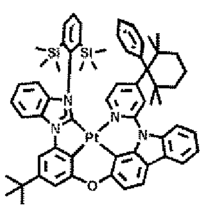
D123

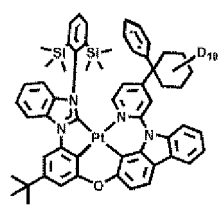
D124

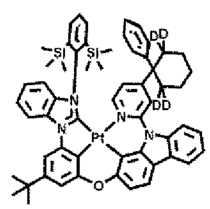
D125

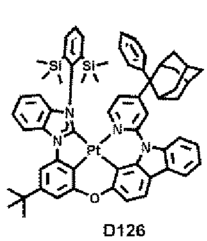
D126

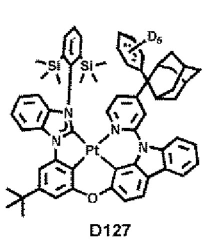
D127

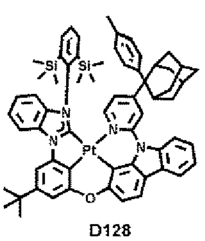
D128

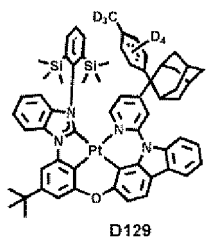
D129

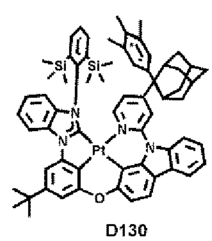
D130

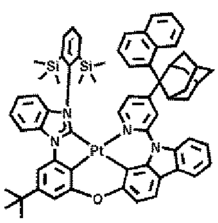
D131

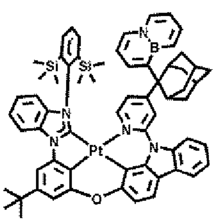
D132

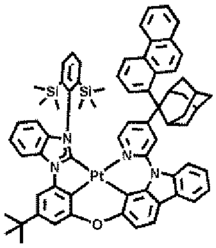
D133

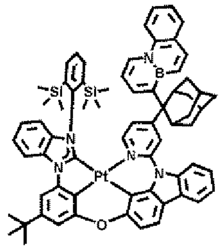
D134

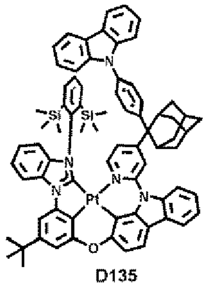
D135

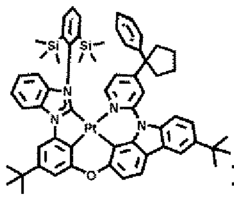
D136

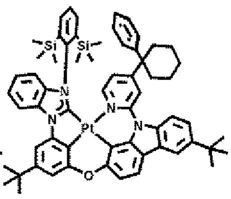
D137

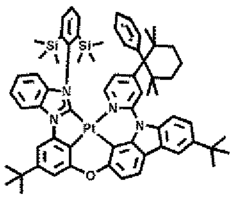
D138

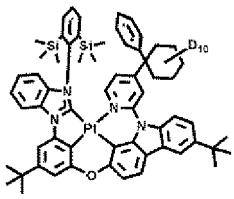
D139

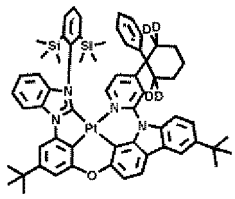
D140

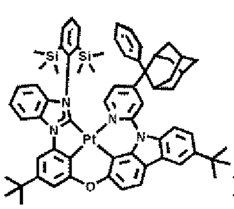
D141

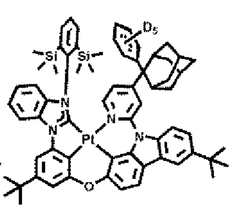
D142

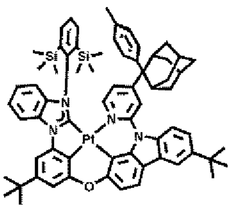
D143

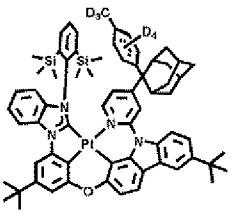
D144

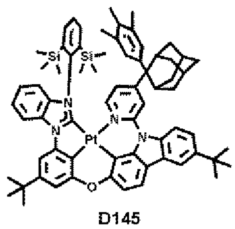
D145

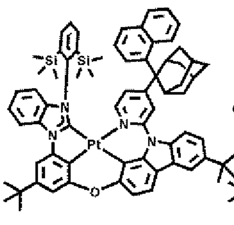
D146

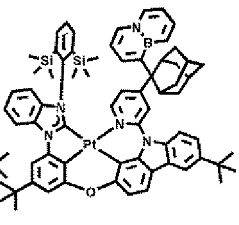
D147

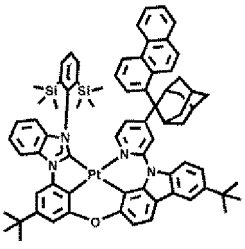
D148

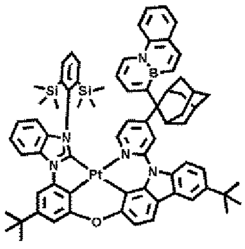
D149

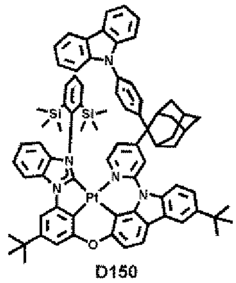
D150

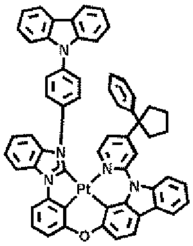
D151

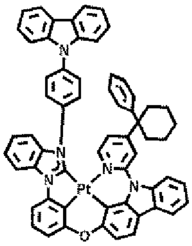
D152

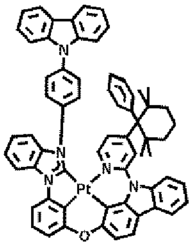
D153

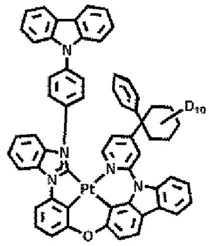
D154

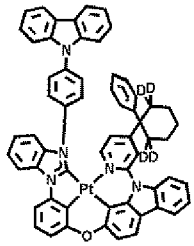
D155

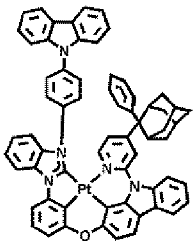
D156

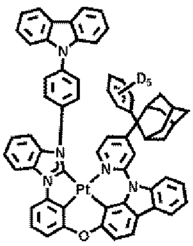
D157

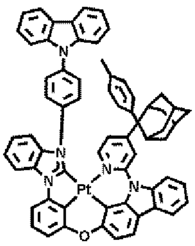
D158

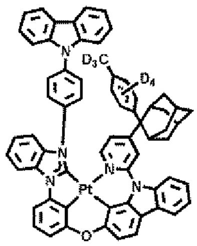
D159

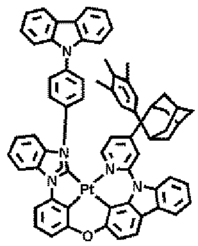
D160

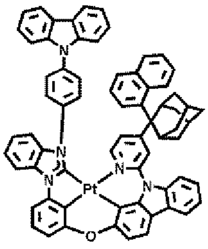
D161

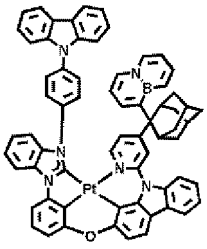
D162

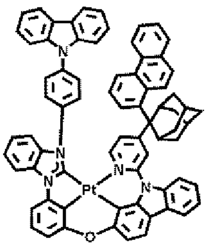
D163

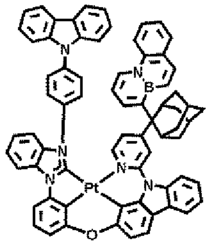
D164

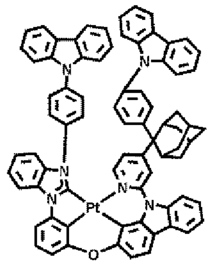
D165

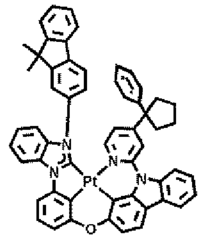
D166
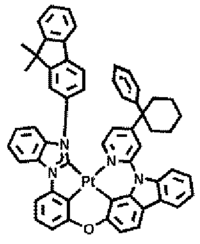
D167
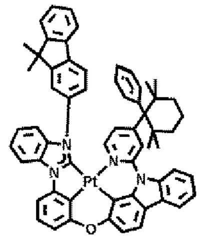
D168
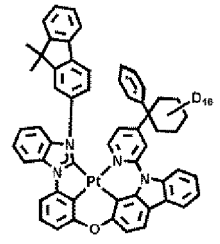
D169
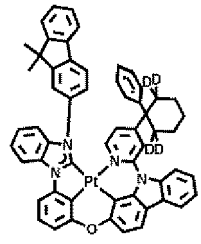
D170

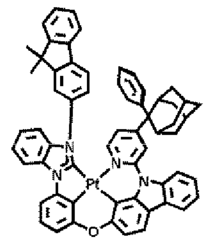
D171
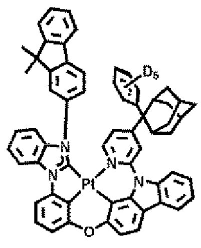
D172
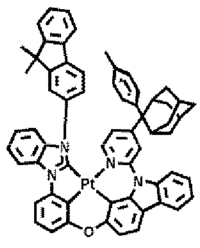
D173
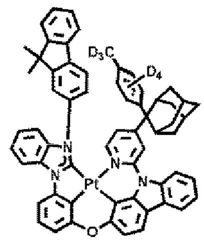
D174
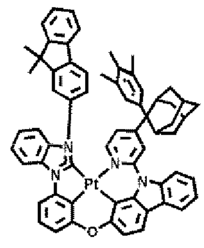
D175

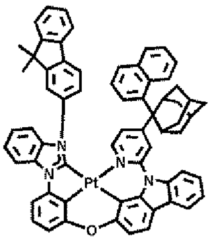
D176
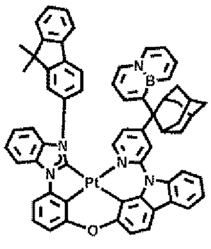
D177
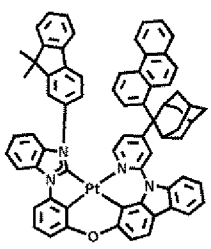
D178
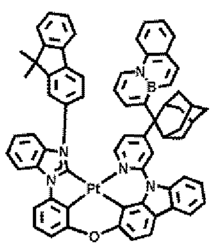
D179
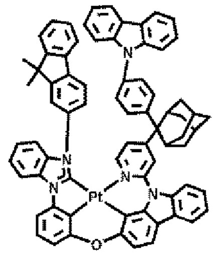
D180

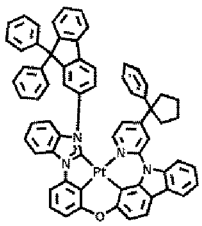
D181
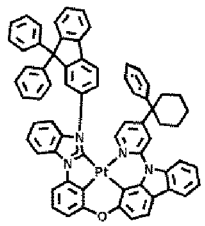
D182
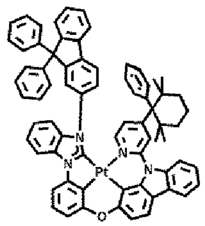
D183
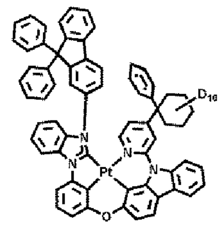
D184
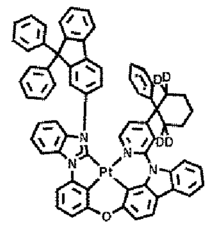
D185

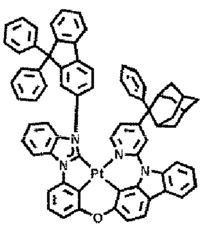
D186
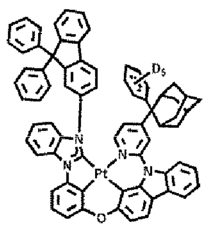
D187
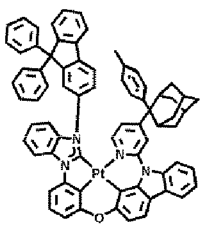
D188
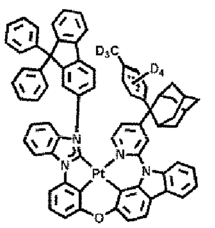
D189
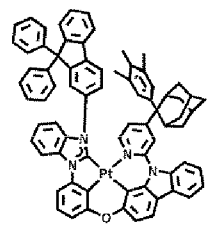
D190

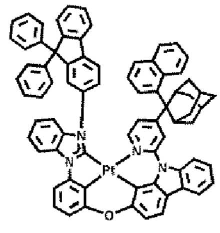
D191

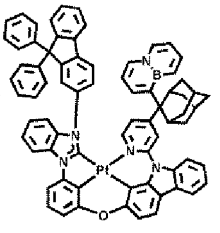
D192

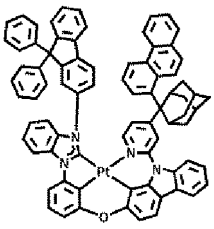
D193

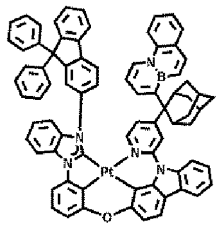
D194

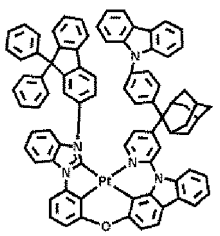
D195

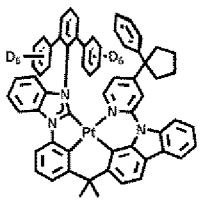
D196

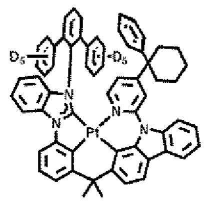
D197

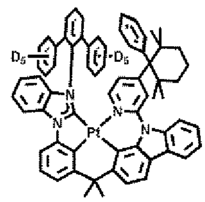
D198

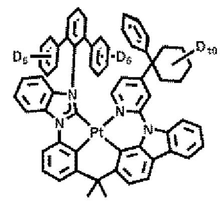
D199

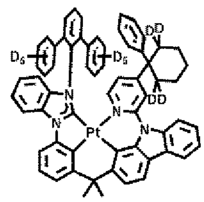
D200

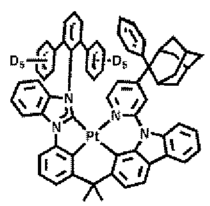
D201

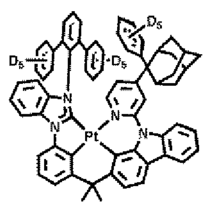
D202

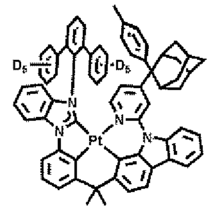
D203

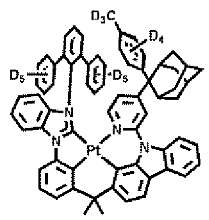
D204

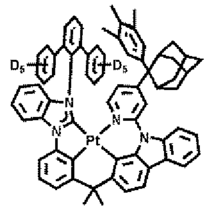
D205

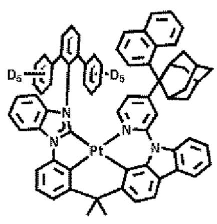
D206

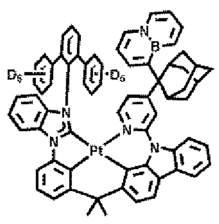
D207

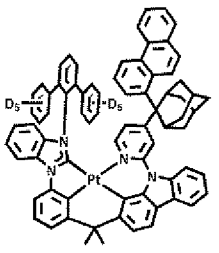
D208

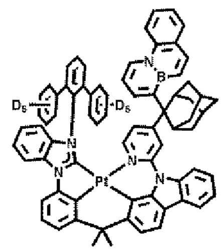
D209

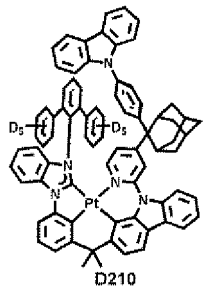
D210

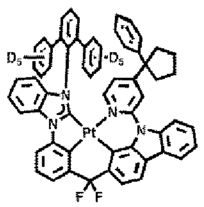
D211

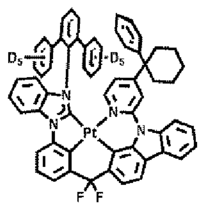
D212

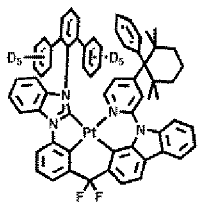
D213

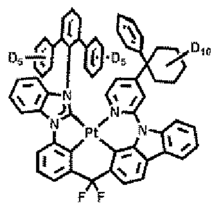
D214

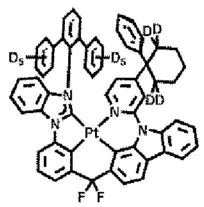
D215

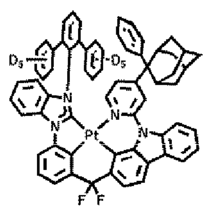
D216

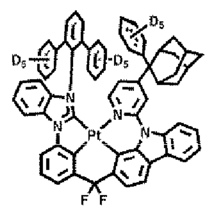
D217

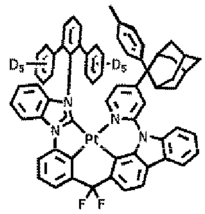
D218

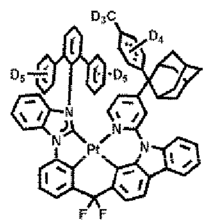
D219

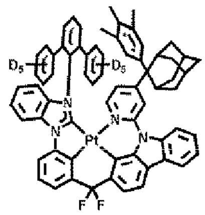
D220

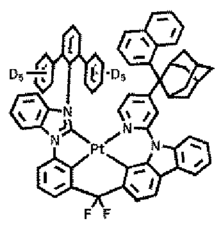
D221

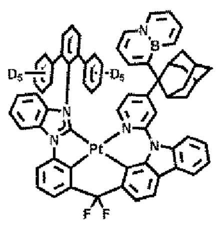
D222

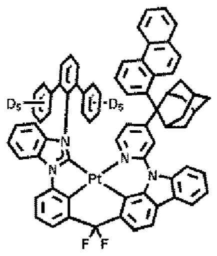
D223

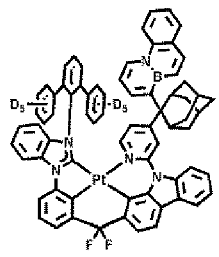
D224

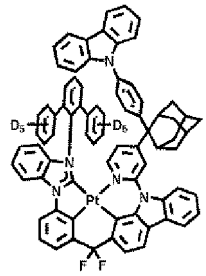
D225

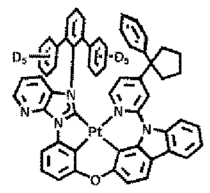
D226

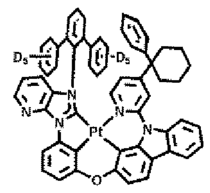
D227

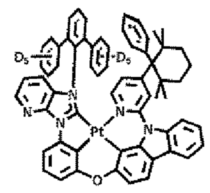
D228

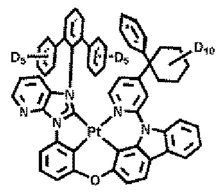
D229

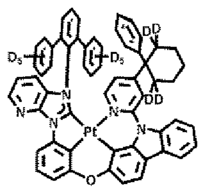
D230

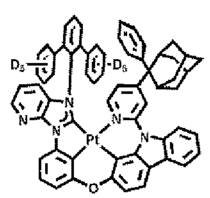
D231

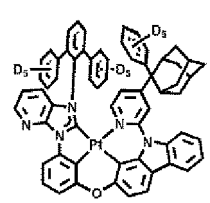
D232

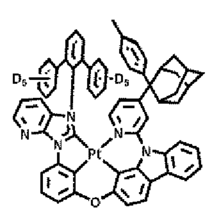
D233

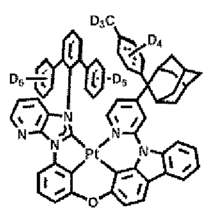
D234

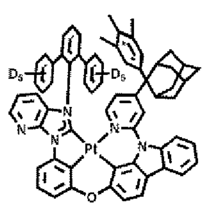
D235

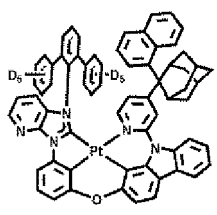
D236

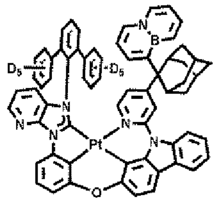
D237

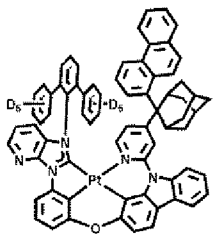
D238

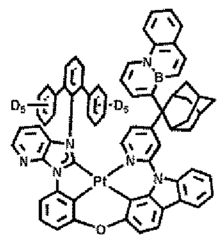
D239

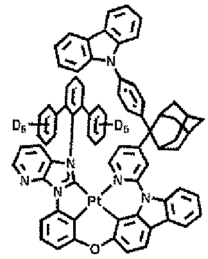
D240

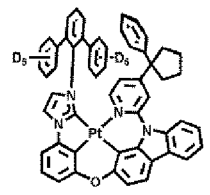
D241

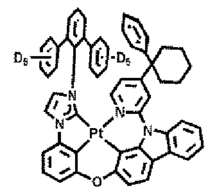
D242

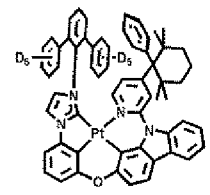
D243

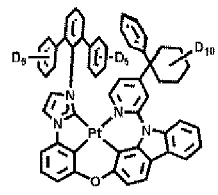
D244

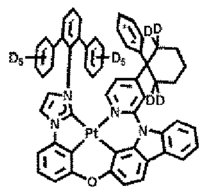
D245

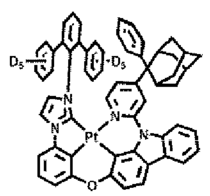
D246

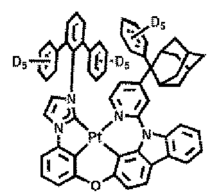
D247

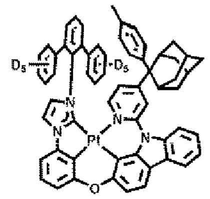
D248

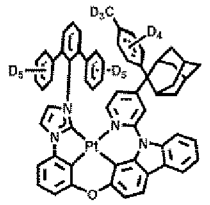
D249

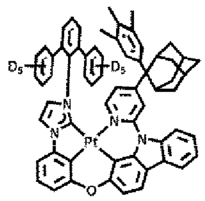
D250

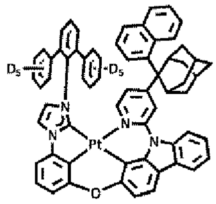
D251

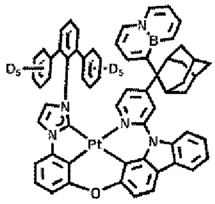
D252

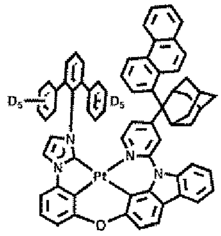
D253

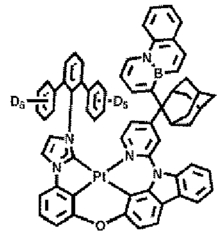
D254

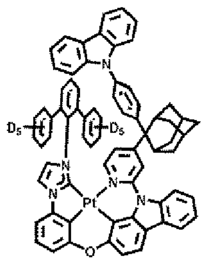
D255

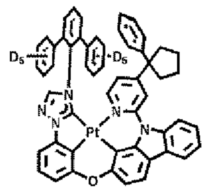
D256

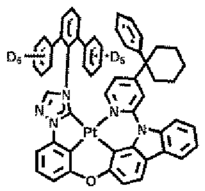
D257

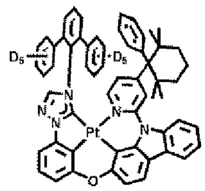
D258

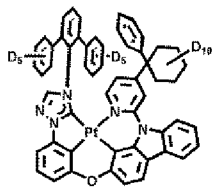
D259

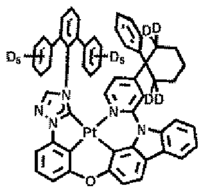
D260

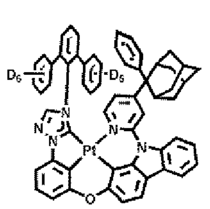
D261

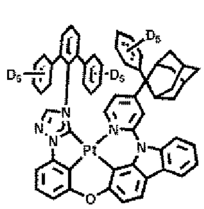
D262

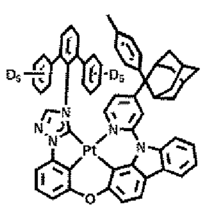
D263

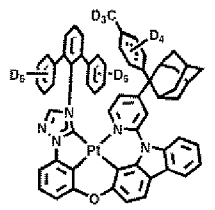
D264

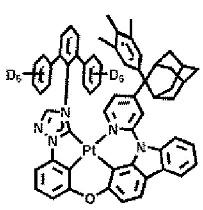
D265

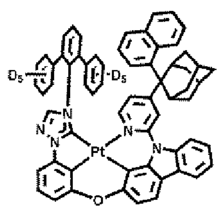
D266

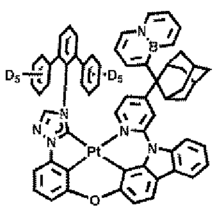
D267

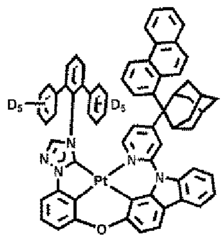
D268

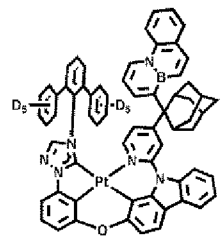
D269

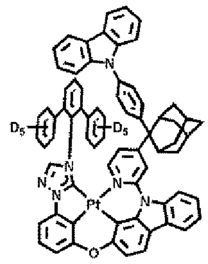
D270

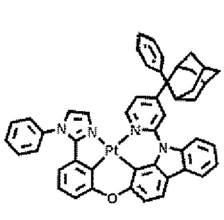
D271

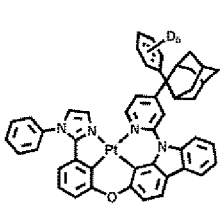
D272

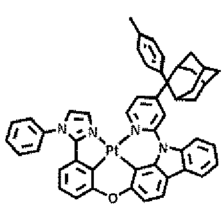
D273

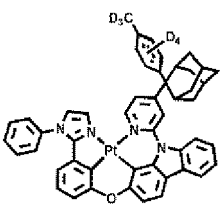
D274

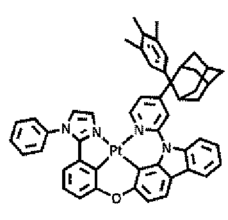
D275

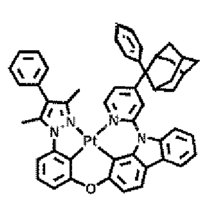
D276

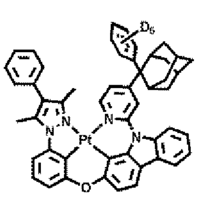
D277

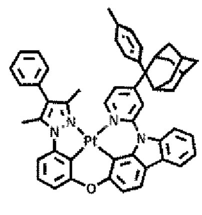
D278

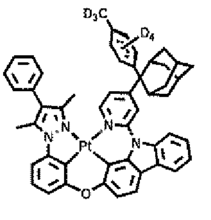
D279

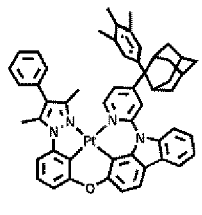
D280

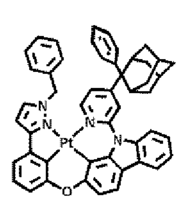
D281

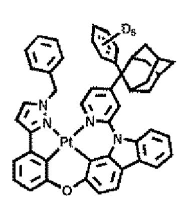
D282

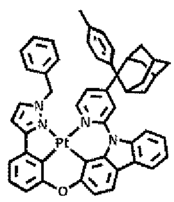
D283

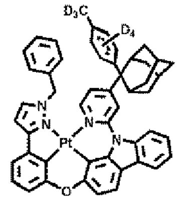
D284

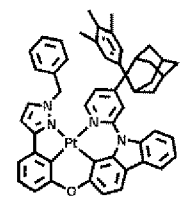
D285

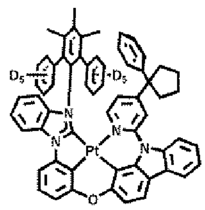
D286

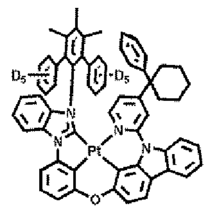
D287

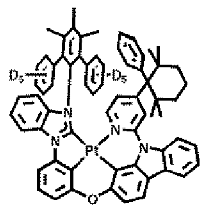
D288

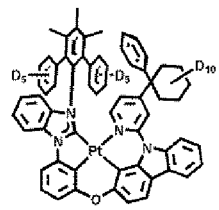
D289

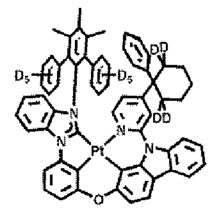
D290

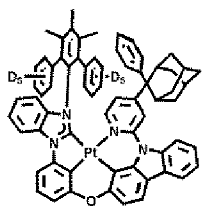
D291

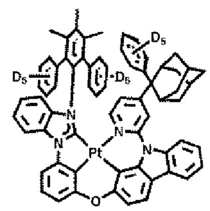
D292

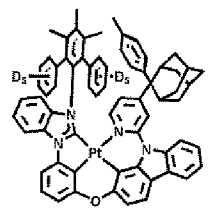
D293

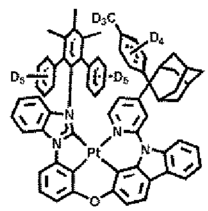
D294

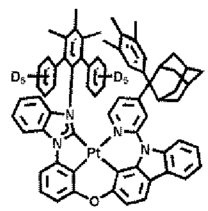
D295

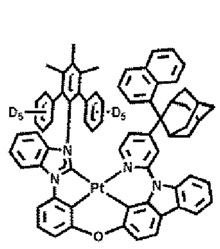
D296

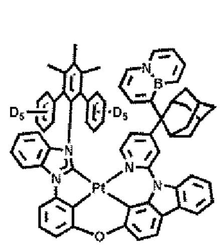
D297

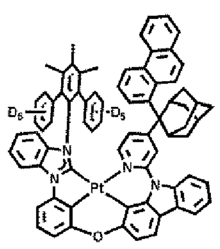
D298

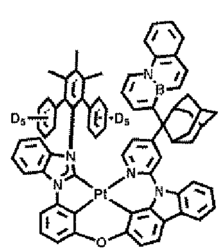
D299

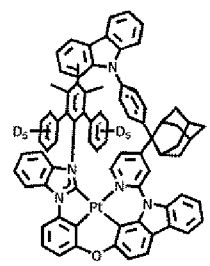
D300

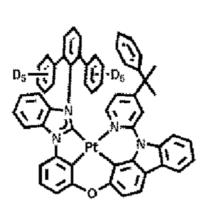
D301

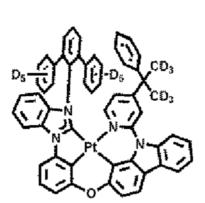
D302

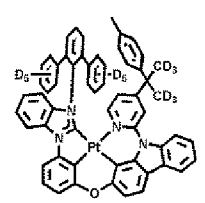
D303

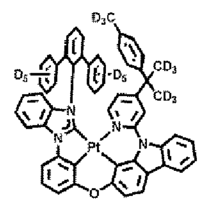
D304

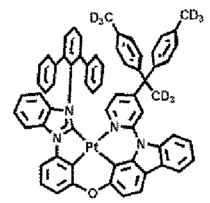
D305

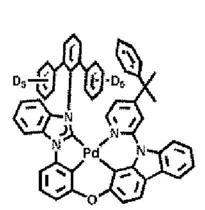
D306

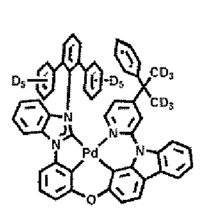
D307

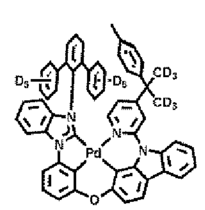
D308

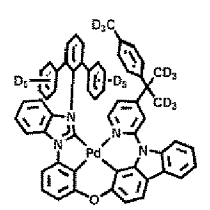
D309

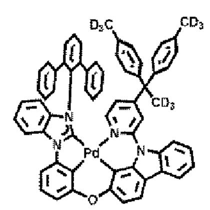
D310

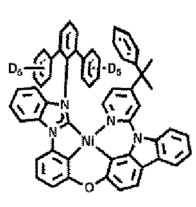
D311
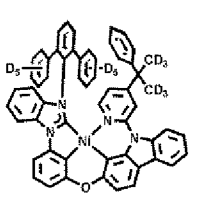
D312
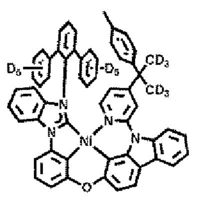
D313
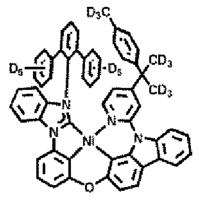
D314
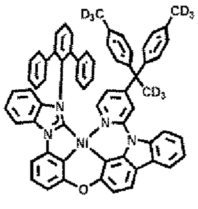
D315

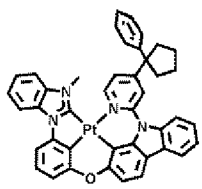
1
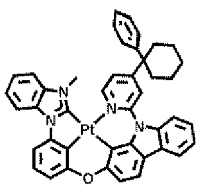
2
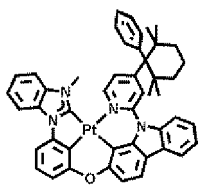
3
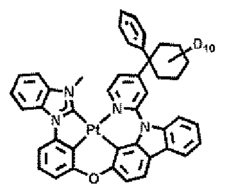
4
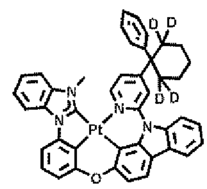
5

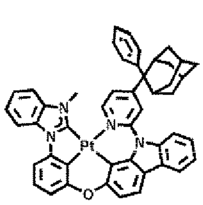
6
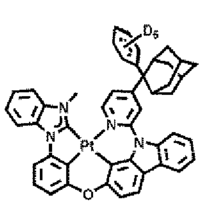
7
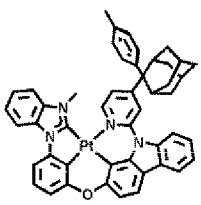
8
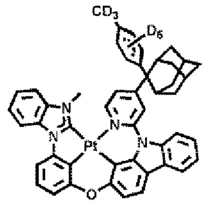
9
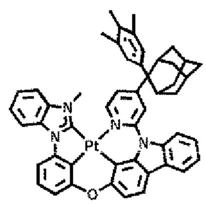
10

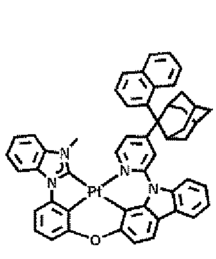
11
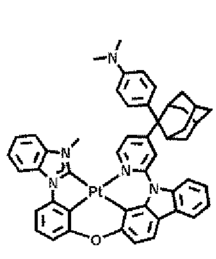
12
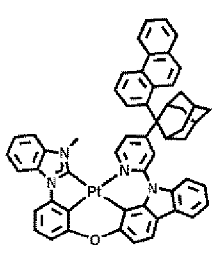
13
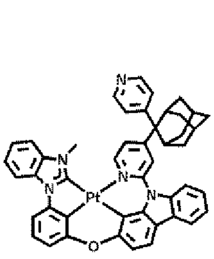
14
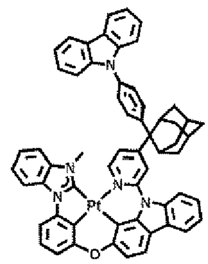
15

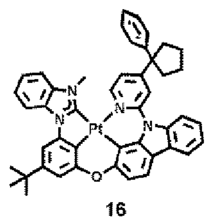
16
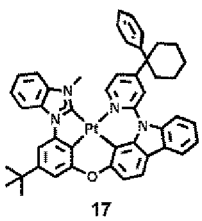
17
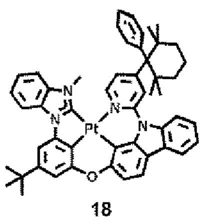
18
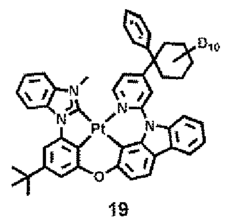
19
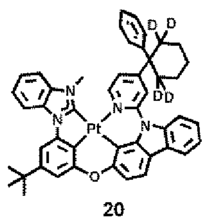
20

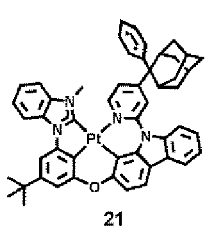
21
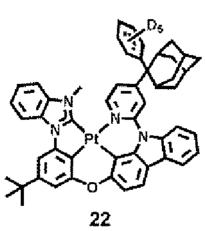
22
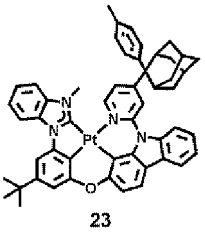
23
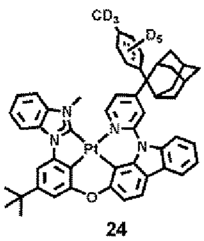
24
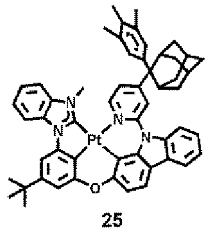
25

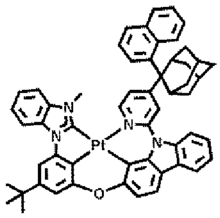
**26**

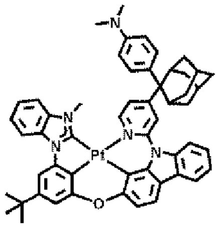
**27**

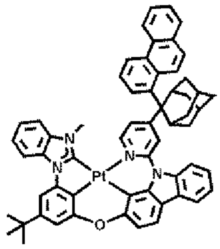
**28**

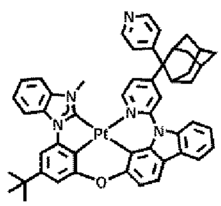
**29**

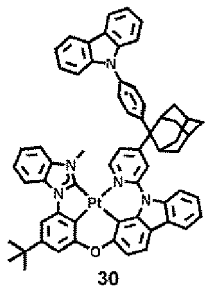
**30**

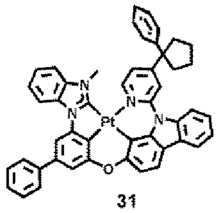
**31**

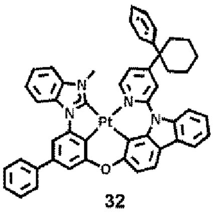
**32**

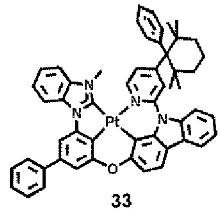
**33**

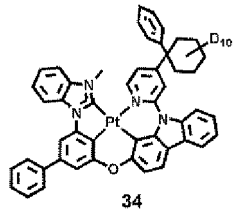
**34**

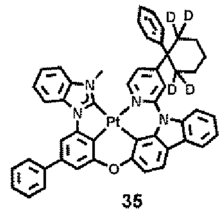
**35**

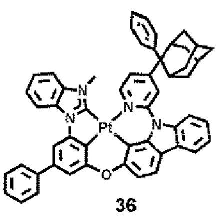
**36**

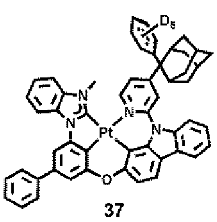
**37**

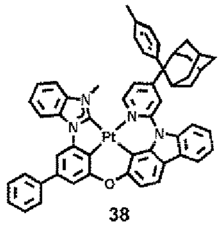
**38**

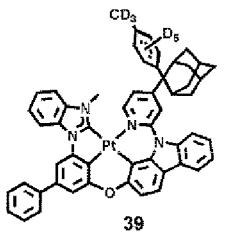
**39**

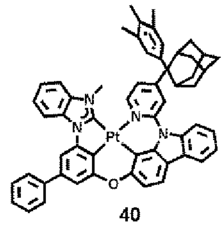
**40**

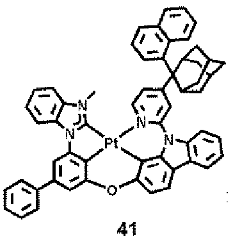
**41**

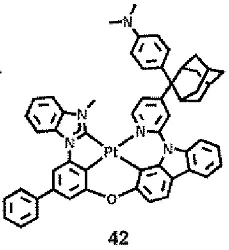
**42**

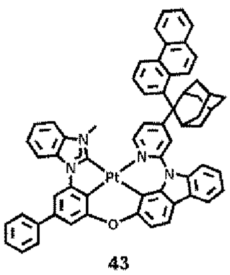
**43**

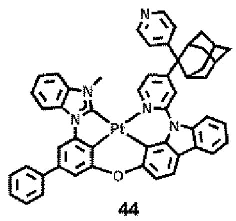
**44**

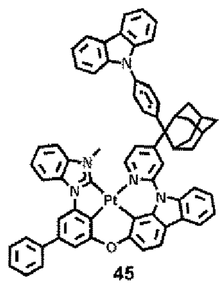
**45**

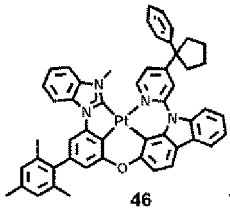
**46**

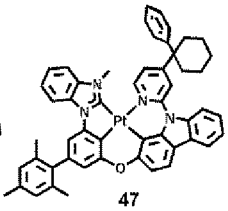
**47**

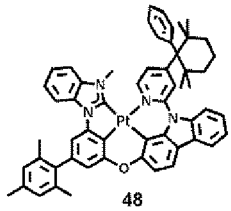
**48**

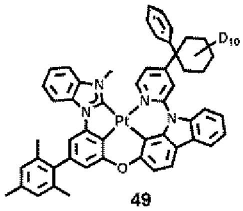
**49**

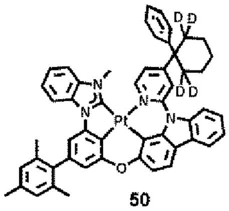
**50**

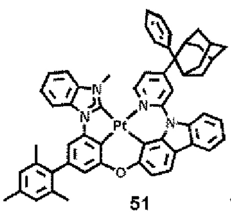
**51**

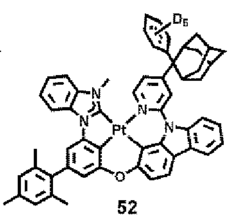
**52**

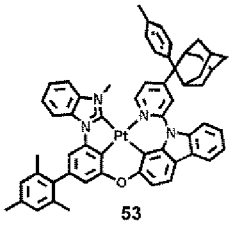
**53**

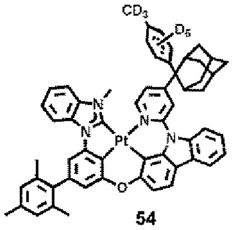
**54**

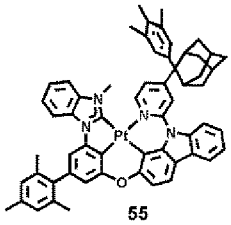
**55**

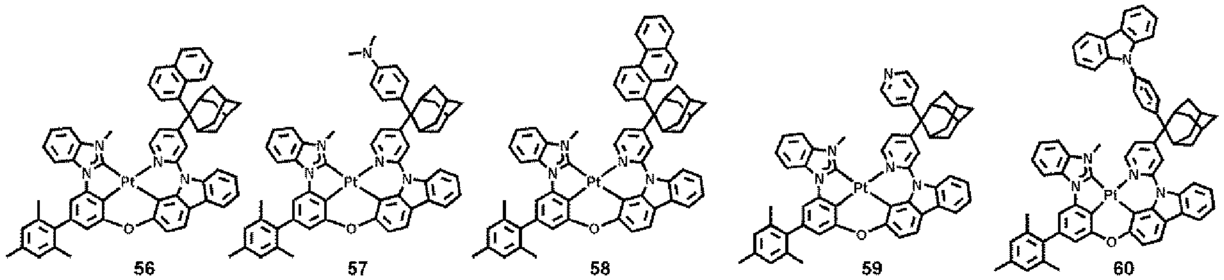

56 57 58 59 60

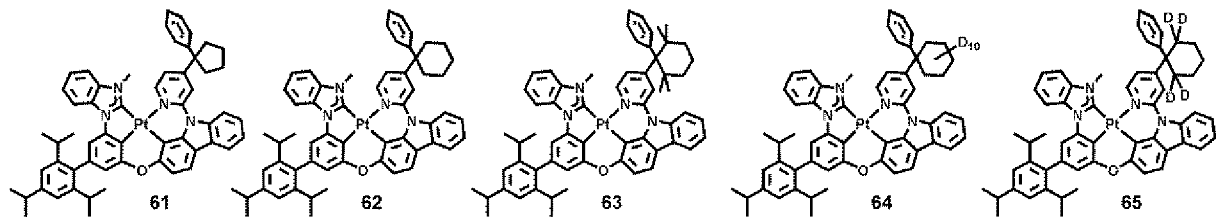

61 62 63 64 65

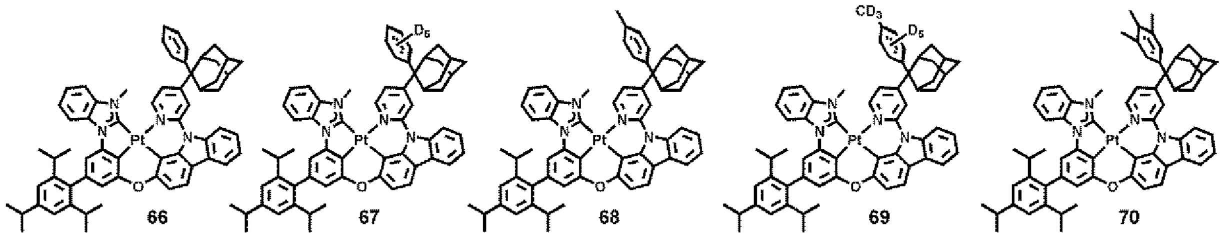

66 67 68 69 70

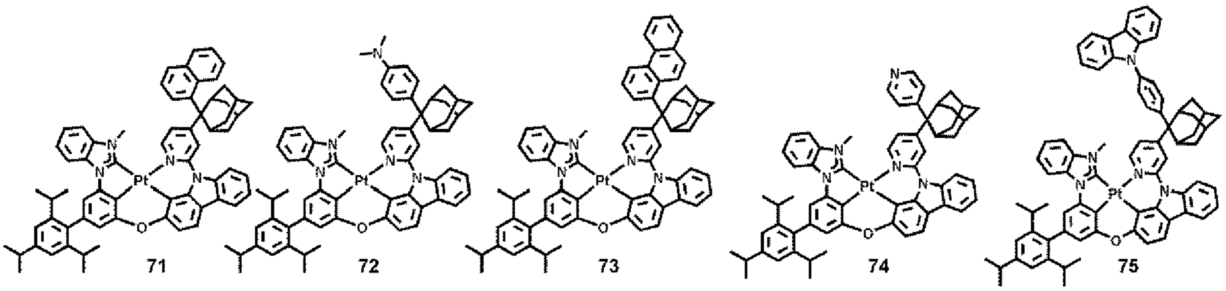

71 72 73 74 75

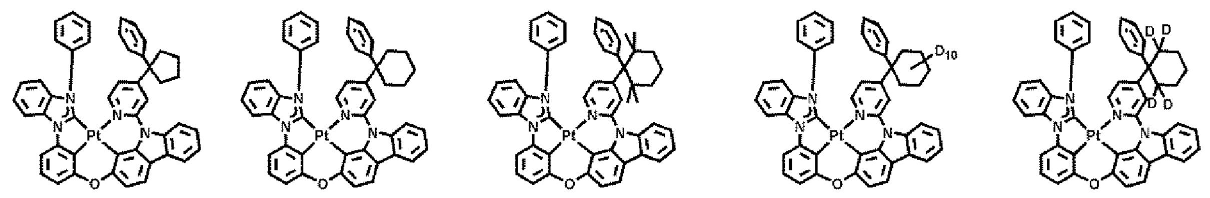

76 77 78 79 80

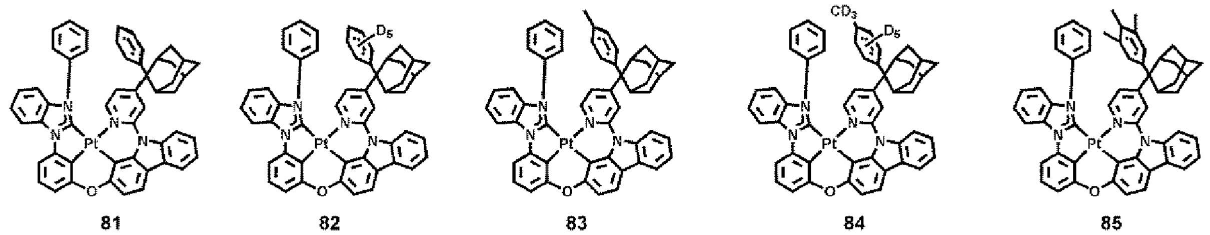

81 82 83 84 85

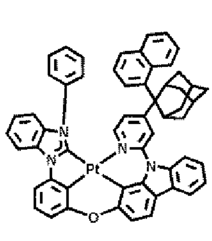
86

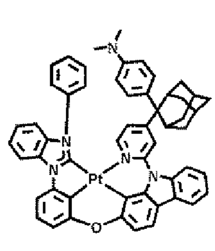
87

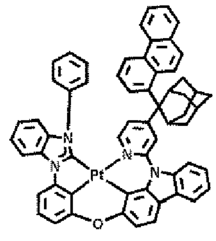
88

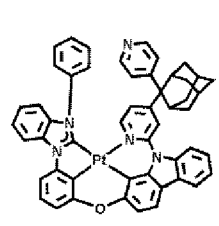
89

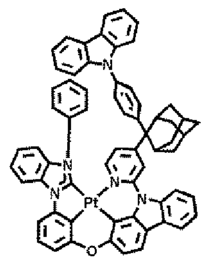
90

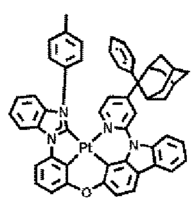
91

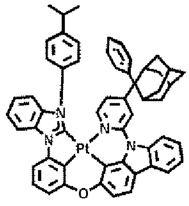
92

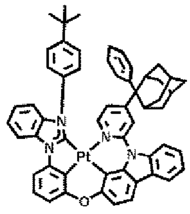
93

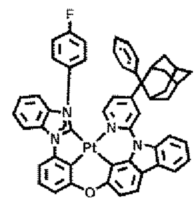
94

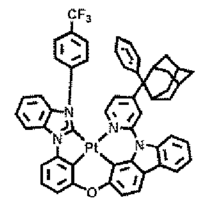
95

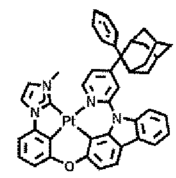
96

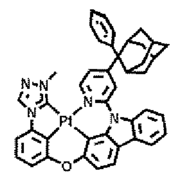
97

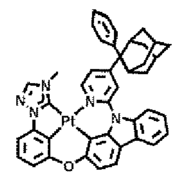
98

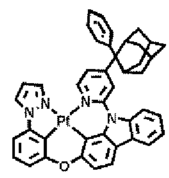
99

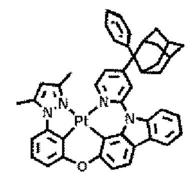
100

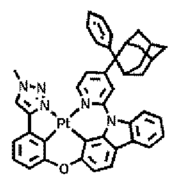
101

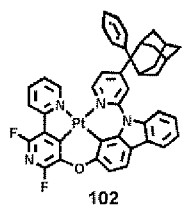
102

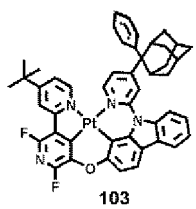
103

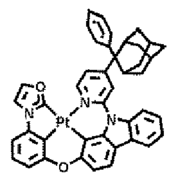
104

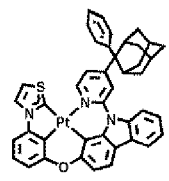
105

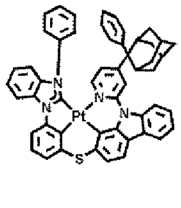
106

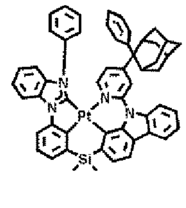
107

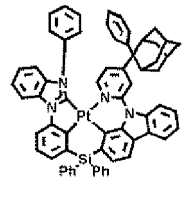
108

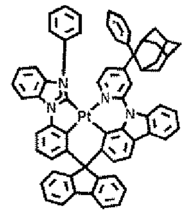
109

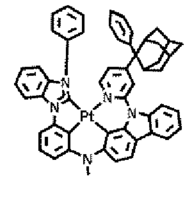
110

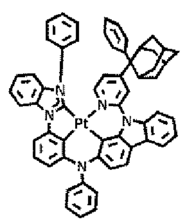
111

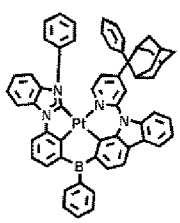
112

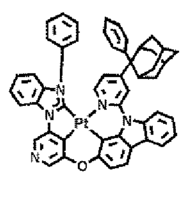
113

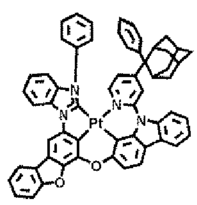
114

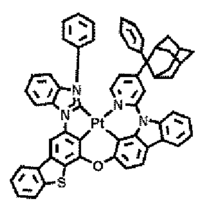
115

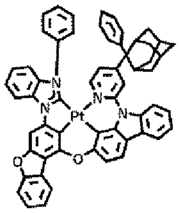 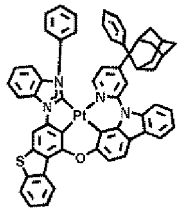 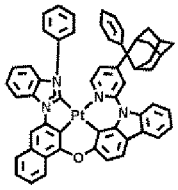 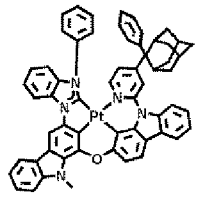 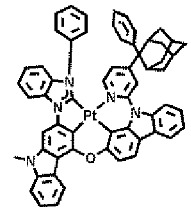

116 117 118 119 120 .

In one or more embodiments, the second compound may comprise (e.g., may be) at least one of Compounds ETH1 to ETH84:

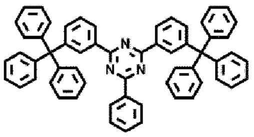
ETH1
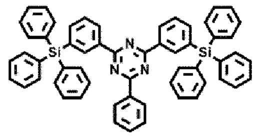
ETH2
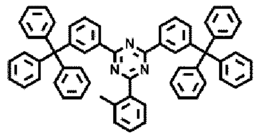
ETH3
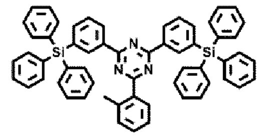
ETH4

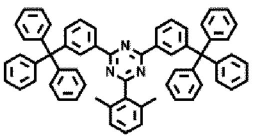
ETH5
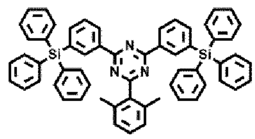
ETH6
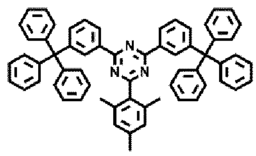
ETH7
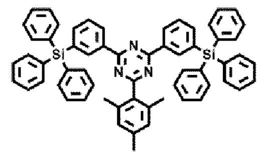
ETH8

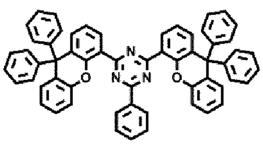
ETH9
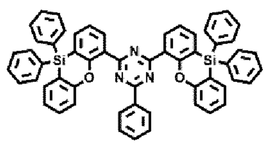
ETH10
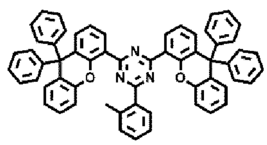
ETH11
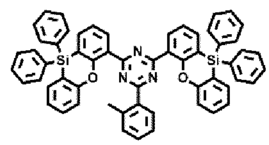
ETH12

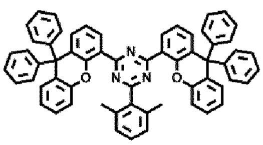
ETH13
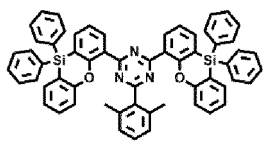
ETH14
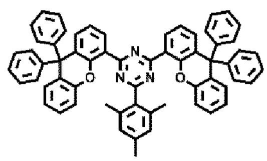
ETH15
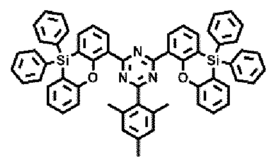
ETH16

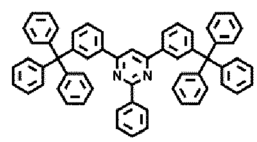
ETH17
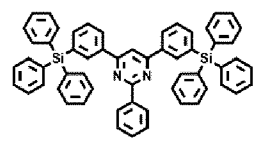
ETH18
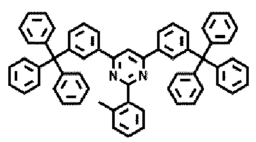
ETH19
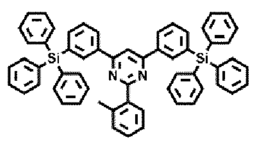
ETH20

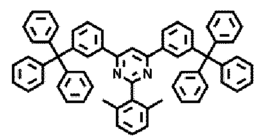
ETH21
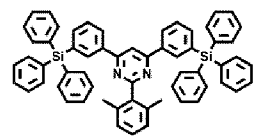
ETH22
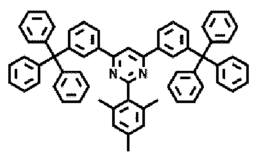
ETH23
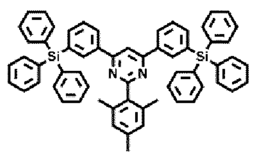
ETH24

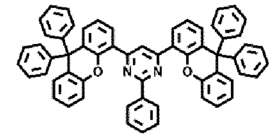
ETH25

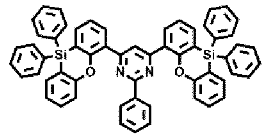
ETH26

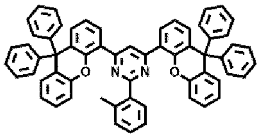
ETH27

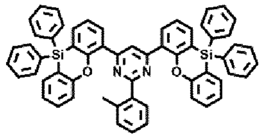
ETH28

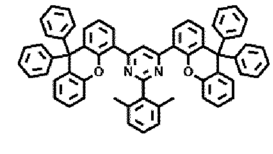
ETH29

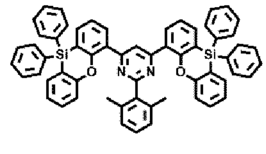
ETH30

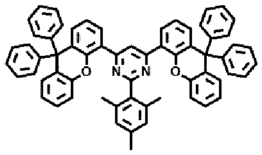
ETH31

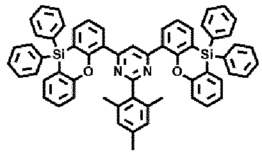
ETH32

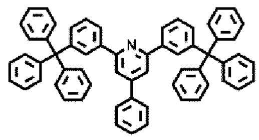
ETH33

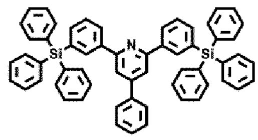
ETH34

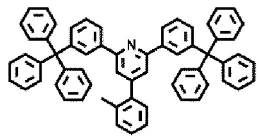
ETH35

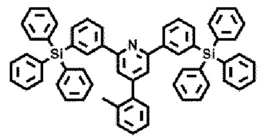
ETH36

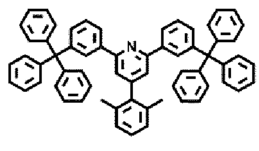
ETH37

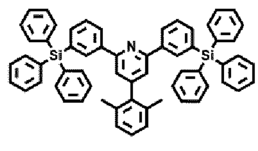
ETH38

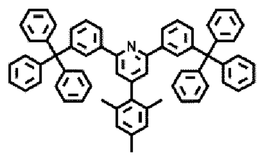
ETH39

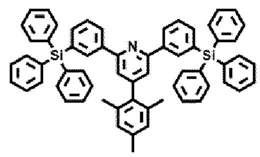
ETH40

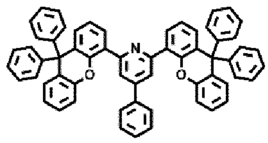
ETH41

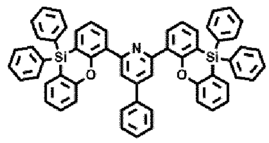
ETH42

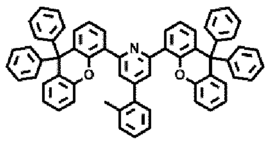
ETH43

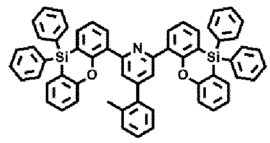
ETH44

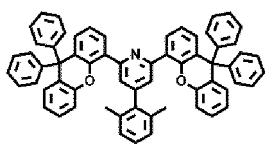
ETH45

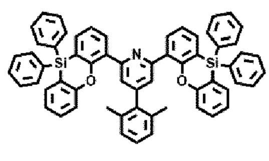
ETH46

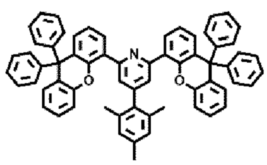
ETH47

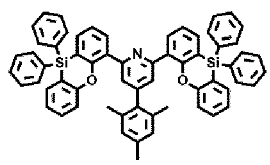
ETH48

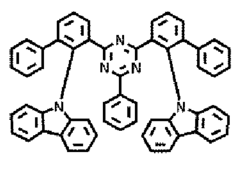
ETH49

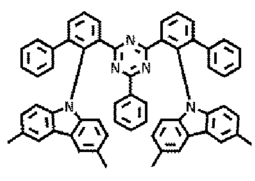
ETH50

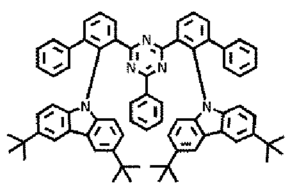
ETH51

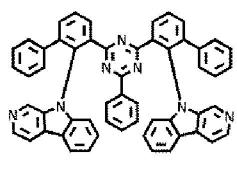
ETH52

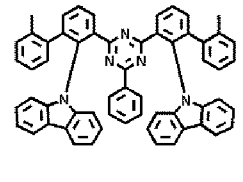
ETH53

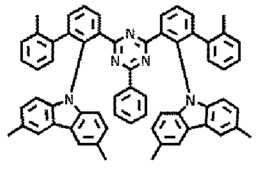
ETH54

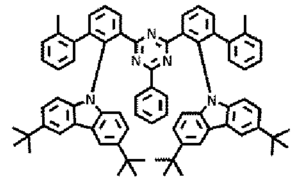
ETH55

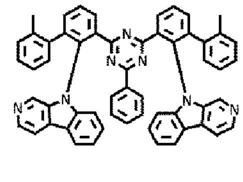
ETH56

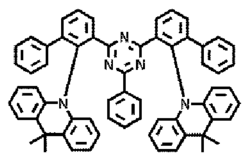
ETH57

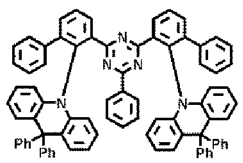
ETH58

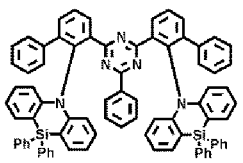
ETH59

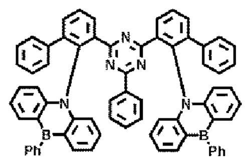
ETH60

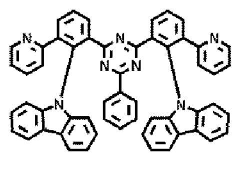
ETH61

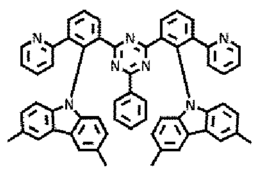
ETH62

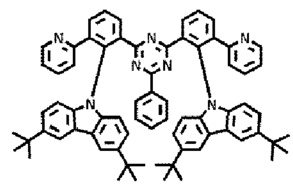
ETH63

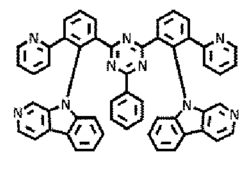
ETH64

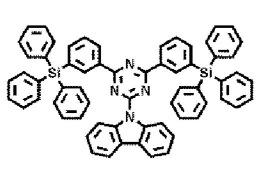
ETH65

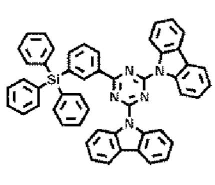
ETH66

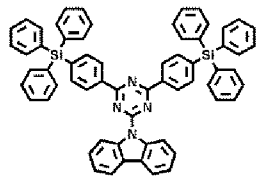
ETH67

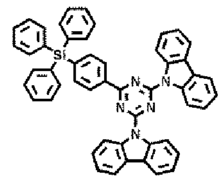
ETH68

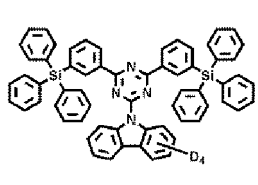
ETH69

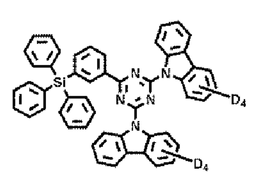
ETH70

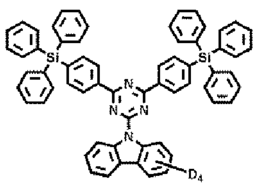
ETH71

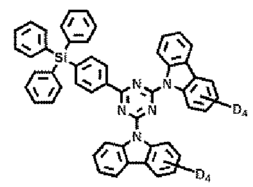
ETH72

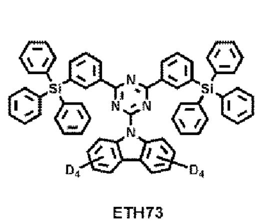
ETH73

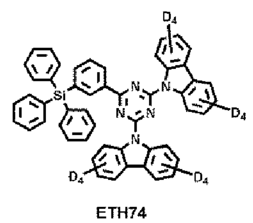
ETH74

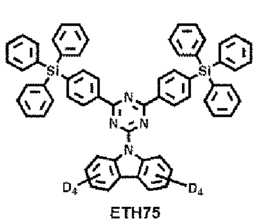
ETH75

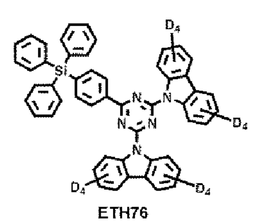
ETH76

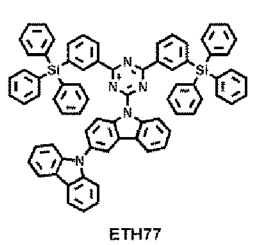
ETH77

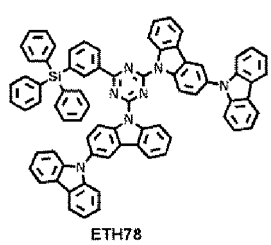
ETH78

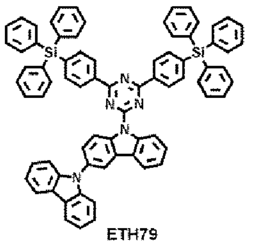
ETH79

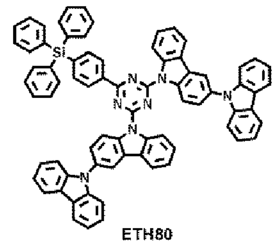
ETH80

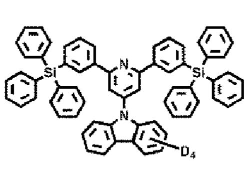
ETH81

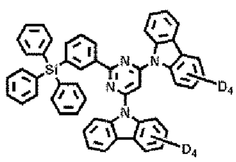
ETH82

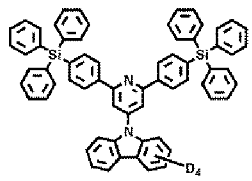
ETH83

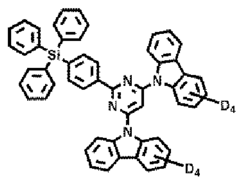
ETH84.

In one or more embodiments, the third compound may comprise (e.g., may be at least one of Compounds HTH1 to HTH52:

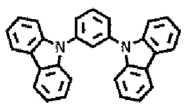
HTH1

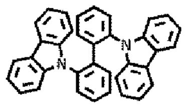
HTH2

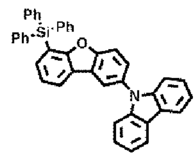
HTH3

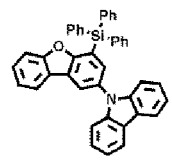
HTH4

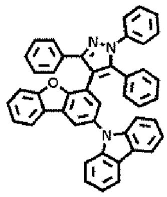
HTH5

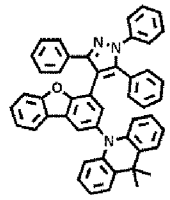
HTH6

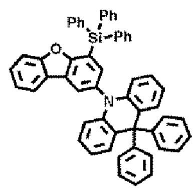
HTH7

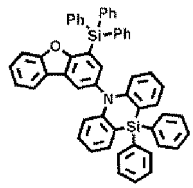
HTH8

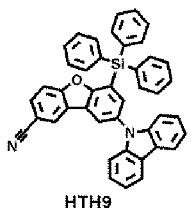
HTH9

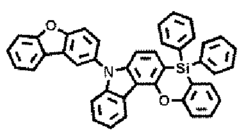
HTH10

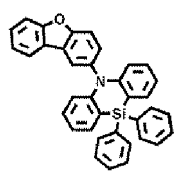
HTH11

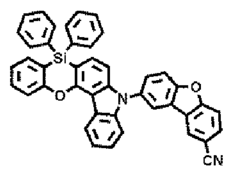
HTH12

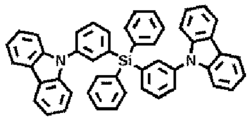
HTH13

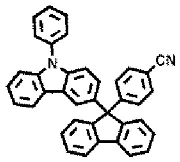
HTH14

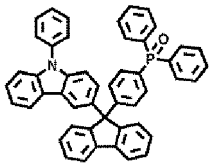
HTH15

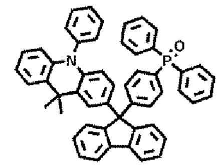
HTH16

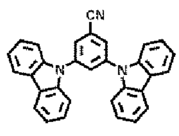
HTH17

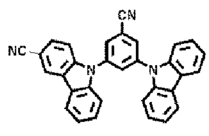
HTH18

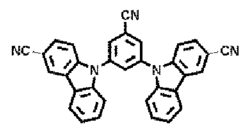
HTH19

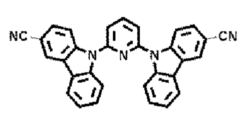
HTH20

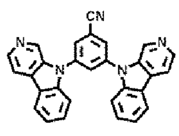
HTH21

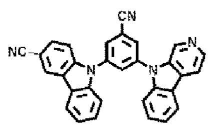
HTH22

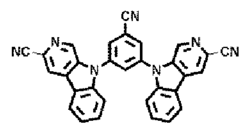
HTH23

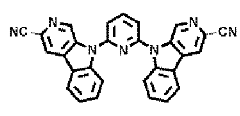
HTH24

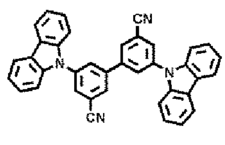
HTH25

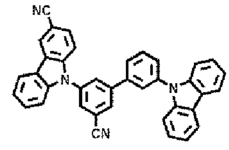
HTH26

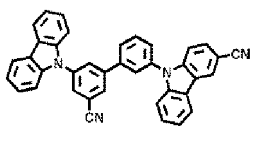
HTH27

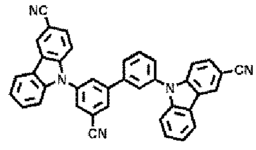
HTH28

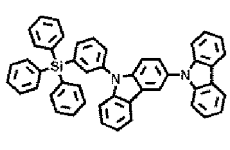
HTH29

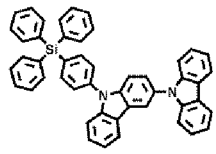
HTH30

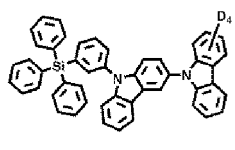
HTH31

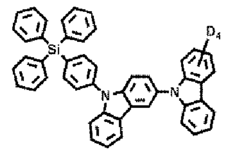
HTH32

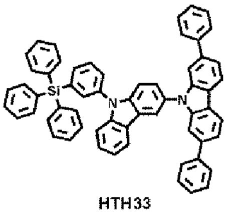
HTH33

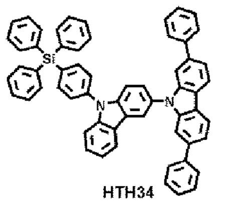
HTH34

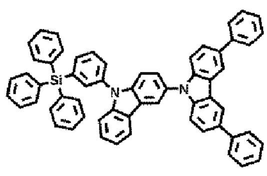
HTH35

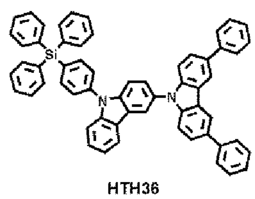
HTH36

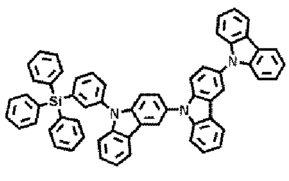
HTH37

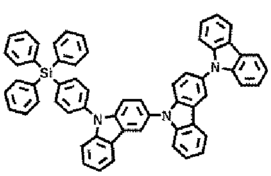
HTH38

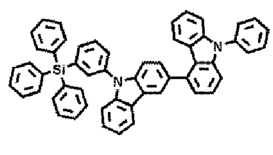
HTH39

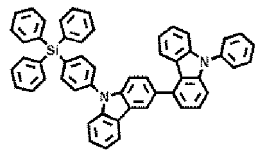
HTH40

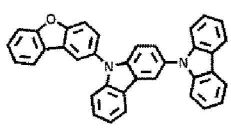
HTH41

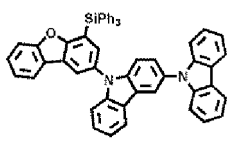
HTH42

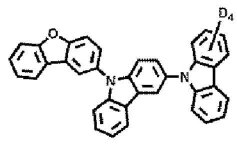
HTH43

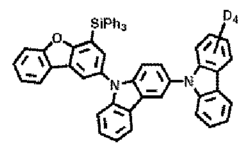
HTH44

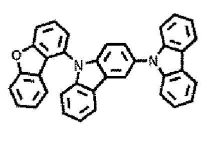
HTH45

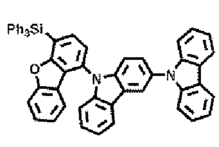
HTH46

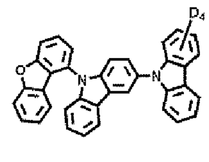
HTH47

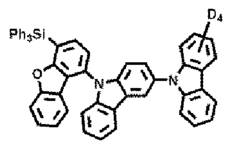
HTH48

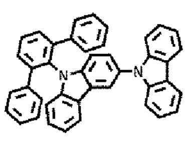
HTH49

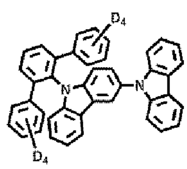
HTH50

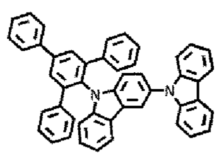
HTH51

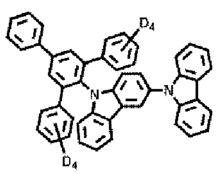
HTH52

.

In one or more embodiments, the fourth compound may comprise (e.g., may be) at least one of Compounds DFD1 to DFD14:

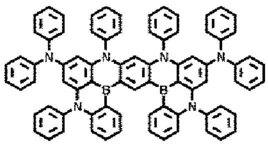
DFD1

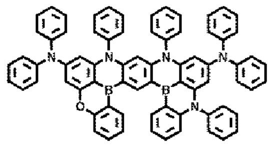
DFD2

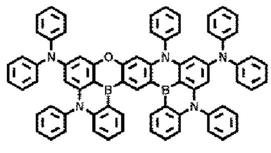
DFD3

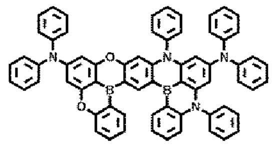
DFD4

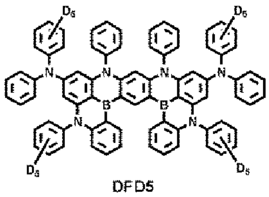
DFD5

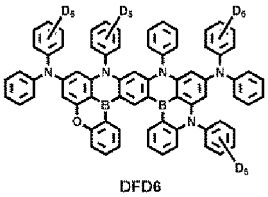
DFD6

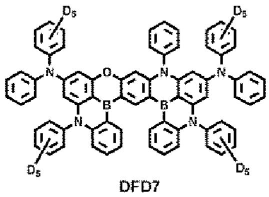
DFD7

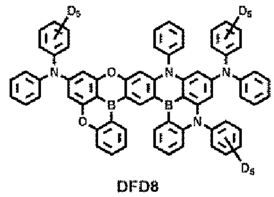
DFD8

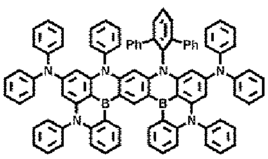
DFD9

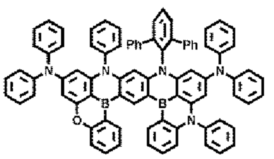
DFD10

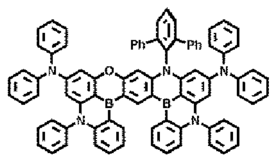
DFD11

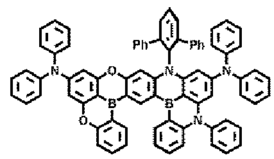
DFD12

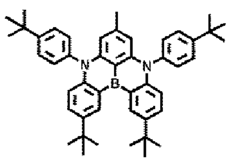
DFD13

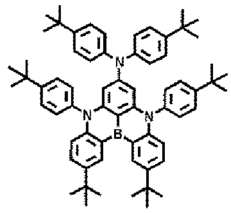
DFD14

.

In the Compounds, "Ph" represents a phenyl group, "$D_5$" represents substitution with five deuterium atoms, and "$D_4$" represents substitution with four deuterium atoms. In some embodiments, the group represented by

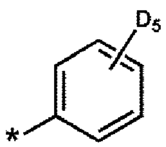

may be identical to the group represented by

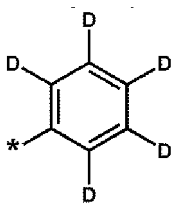

.

In some embodiments, the light-emitting device may satisfy at least one of Conditions 1 to 4:

Condition 1
LUMO energy level (eV) of the third compound > LUMO energy level (eV) of the first compound,
Condition 2
LUMO energy level (eV) of the first compound > LUMO energy level (eV) of the second

compound,
Condition 3
HOMO energy level (eV) of the first compound > HOMO energy level (eV) of the third compound, and
Condition 4
HOMO energy level (eV) of the third compound > HOMO energy level (eV) of the second compound.

The HOMO and LUMO energy levels of the first compound, the second compound, and the third compound may each be a negative value, and the HOMO and LUMO energy levels may be actual measurement value according to the methods described in Evaluation Example 1 provided herein.
In one or more embodiments, the absolute value of a difference between the LUMO energy level of the first compound and the LUMO energy level of the second compound may be about 0.1 eV or higher and about 1.0 eV or lower, the absolute value of a difference between the LUMO energy level of the first compound and the LUMO energy level of the third compound may be about 0.1 eV or higher and about 1.0 eV or lower, the absolute value of a difference between the HOMO energy level of the first compound and the HOMO energy level of the second compound may be 1.25 eV or lower (e.g., about 1.25 eV or lower and about 0.2 eV or higher), and the absolute value of a difference between the HOMO energy level of the first compound and the HOMO energy level of the third compound may be 1.25eV or lower (e.g., about 1.25 eV or lower and about 0.2 eV or higher).
When the relationships between LUMO energy level and HOMO energy level satisfy the conditions as described above, the balance between holes and electrons injected into the emission layer can be made.
The light-emitting device may have a structure of a first embodiment or a second embodiment:

**Descriptions of first embodiment**

According to the first embodiment, the first compound may be comprised in an emission layer in an interlayer of a light-emitting device, wherein the emission layer may further comprise a host, and the first compound may be different from the host. The emission layer may emit phosphorescent light or fluorescent light emitted from the first compound.
According to the first embodiment, the first compound may be a dopant or an emitter. In some embodiments, the first compound may be a phosphorescent dopant or a phosphorescent emitter.
Phosphorescent light or fluorescent light emitted from the first compound may be blue light. For example, the first compound may be a blue phosphorescent light emitter or a blue fluorescent light emitter.
The emission layer may further comprise an ancillary dopant. The ancillary dopant may serve to improve luminescence efficiency from the first compound by effectively (or suitably) transferring energy to a dopant or the first compound as an emitter.
The ancillary dopant may be different from the first compound and the host.
In some embodiments, the ancillary dopant may be a delayed fluorescence-emitting compound.
In some embodiments, the ancillary dopant may be a compound comprising at least one cyclic group comprising boron (B) and nitrogen (N) as ring-forming atoms.

**Descriptions of second embodiment**

According to the second embodiment, the first compound may be comprised in an emission layer in an interlayer of a light-emitting device, wherein the emission layer may further comprise a host and a dopant, and the first compound may be different from the host and from the dopant. The emission layer may emit phosphorescent light or fluorescent light (e.g., delayed fluorescent light) emitted from the dopant.
For example, the first compound in the second embodiment may serve as an ancillary dopant that transfers energy to a dopant (or an emitter), not as a dopant (or an emitter) itself.
In some embodiments, the first compound in the second embodiment may serve as an emitter and as an ancillary dopant that transfers energy to a dopant (or an emitter).
For example, phosphorescent light or fluorescent light emitted from the dopant (or the emitter) in the second embodiment may be blue phosphorescent light or blue fluorescent light (e.g., blue delayed fluorescent light).
The dopant (or the emitter) in the second embodiment may be a phosphorescent dopant material (e.g., the organometallic compound represented by Formula 1, the organometallic compound represented by Formula 401, or any combination thereof) or a fluorescent dopant material (e.g, the compound represented by Formula 501, the compound represented by Formula 502, the compound represented by Formula 503, or any combination thereof).
In the first embodiment and the second embodiment, the blue light may be blue light having a maximum emission

wavelength in a range of about 390 nanometers (nm) to about 500 nm, about 410 nm to about 490 nm, about 430 nm to about 480 nm, about 440 nm to about 475 nm, or about 455 nm to about 470 nm.

The ancillary dopant in the first embodiment may comprise, e.g. the fourth compound represented by Formula 502 or Formula 503.

The host in the first embodiment and the second embodiment may be any suitable host material (e.g., the compound represented by Formula 301, the compound represented by 301-1, the compound represented by Formula 301-2, or any combination thereof).

In some embodiments, the host in the first embodiment and the second embodiment may be the second compound, the third compound, or any combination thereof.

In one or more embodiments, the light-emitting device may further comprise at least one of a first capping layer located outside a first electrode or a second capping layer located outside a second electrode, and at least one of the first capping layer or the second capping layer may comprise the organometallic compound represented by Formula 1. The first capping layer and the second capping layer may respectively be understood by referring to the descriptions of the first capping layer and the second capping layer provided herein.

In some embodiments, the light-emitting device may comprise:

a first capping layer located outside the first electrode and comprising the organometallic compound represented by Formula 1;
a second capping layer located outside the second electrode and comprising the organometallic compound represented by Formula 1; or
the first capping layer and the second capping layer.

The expression that an "(interlayer and/or a capping layer) comprises at least one organometallic compound represented by Formula 1" as used herein may be construed as meaning that the "(interlayer and/or the capping layer) may comprise one organometallic compound of Formula 1 or two or more different organometallic compounds of Formula 1".

For example, the interlayer and/or the capping layer may comprise Compound D1 only as the organometallic compound. In this embodiment, Compound D1 may be comprised in the emission layer of the light-emitting device. In some embodiments, Compounds D1 and D2 may be comprised in the interlayer as organometallic compounds. In this embodiment, Compounds D1 and D2 may be comprised in the same layer (for example, both Compounds D1 and D2 may be comprised in an emission layer) or in different layers (for example, Compound D1 may be comprised in an emission layer, and Compound D2 may be comprised in an electron transport region).

The term "interlayer" as used herein refers to a single layer and/or a plurality of all layers located between a first electrode and a second electrode in a light-emitting device.

According to one or more embodiments, an electronic apparatus may comprise the light-emitting device. The electronic apparatus may further comprise a thin-film transistor. In some embodiments, the electronic apparatus may further comprise a thin-film transistor comprising a source electrode and drain electrode, and a first electrode of the light-emitting device may be electrically connected to the source electrode or the drain electrode. The electronic apparatus may further comprise a color filter, a color-conversion layer, a touchscreen layer, a polarization layer, or any combination thereof. The electronic apparatus may be understood by referring to the description of the electronic apparatus provided herein.

According to one or more embodiments, an organometallic compound may be represented by Formula 1, wherein Formula 1 may be understood by referring to the description of Formula 1 provided herein.

In the organometallic compound represented by Formula 1, the sum of a1 to a4 may be 1 or greater, and at least one of $*-(L_1)_{b1}-(R_1)_{c1}$(s) in the number of a1, at least one of $R_2$(s) in the number of a2, at least one of $R_3$(s) in the number of a3, at least one of $R_4$(s) in the number of a4, or any combination thereof may each independently be the group represented by Formula 1-1 or the group represented by Formula 1-2:

Formula 1-1

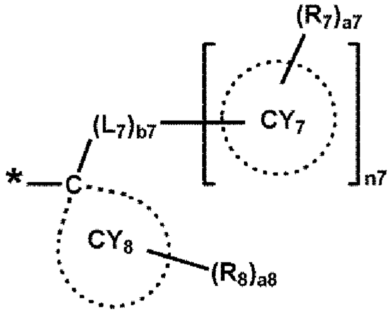

Formula 1-2

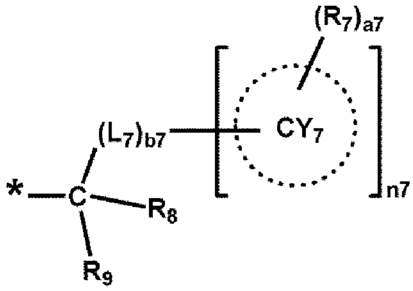

.

For example, the organometallic compound represented by Formula 1 may comprise the group represented by Formula 1-1 and/or the group represented by Formula 1-2.

A moiety represented by ring $CY_7$ in Formulae 1-1 and 1-2, a moiety represented by ring $CY_8$ in Formula 1-1, and $R_8$ and $R_9$ in Formula 1-2 may each have a high triplet energy level (e.g., a triplet energy level as high as 0.01 eV). Accordingly, in Formula 1, energy transfer by metal to ligand charge transfer, and energy transfer by intramolecular through-space charge transfer, may both be activated. In addition, Formulae 1-1 and 1-2 may each have structural rigidity due to ring $CY_7$.

Therefore, a light-emitting device (e.g., an organic light-emitting device) comprising the organometallic compound represented by Formula 1 (or the first compound represented by Formula 1) may have high color purity, high luminescence efficiency, low driving voltage, and long lifespan characteristics.

In one or more embodiments, the organometallic compound represented by Formula 1 may emit blue light. In some embodiments, the organometallic compound represented by Formula 1 may emit blue light having a maximum emission wavelength in a range of about 390 nm to about 500 nm, about 410 nm to about 490 nm, about 430 nm to about 480 nm, about 440 nm to about 475 nm, or about 455 nm to about 470 nm.

In one or more embodiments, the organometallic compound represented by Formula 1 may have a color purity of a bottom emission CIEx coordinate in a range of about 0.12 to about 0.15, or about 0.13 to about 0.14, and a bottom emission CIEy coordinate in a range of about 0.06 to about 0.25, about 0.10 to about 0.20, or about 0.13 to about 0.20.

Methods of synthesizing the organometallic compound represented by Formula 1 may be easily understood to those of ordinary skill in the art by referring to Synthesis Examples and Examples described herein.

**Description of FIG. 1**

FIG. 1 is a schematic view of a light-emitting device 10 according to one or more embodiments. The light-emitting device 10 may comprise a first electrode 110, an interlayer 130, and a second electrode 150.

Hereinafter, the structure of the light-emitting device 10 according to one or more embodiments and a method of manufacturing the light-emitting device 10 according to one or more embodiments will be described in connection with FIG. 1.

**First electrode 110**

In FIG. 1, a substrate may be additionally located under the first electrode 110 or above the second electrode 150. The substrate may be a glass substrate and/or a plastic substrate. The substrate may be a flexible substrate comprising plastic having excellent heat resistance and durability, for example, polyimide, polyethylene terephthalate (PET), polycarbonate, polyethylene naphtalate, polyarylate (PAR), polyetherimide, or any combination thereof.

The first electrode 110 may be formed by depositing or sputtering, onto the substrate, a material for forming the first electrode 110. When the first electrode 110 is an anode, a high work function material that may easily (or suitably) inject holes may be used as a material for a first electrode 110.

The first electrode 110 may be a reflective electrode, a semi-transmissive electrode, or a transmissive electrode. When the first electrode 110 is a transmissive electrode, a material for forming the first electrode 110 may be indium tin oxide (ITO), indium zinc oxide (IZO), tin oxide ($SnO_2$), zinc oxide (ZnO), or any combinations thereof. In some embodiments, when the first electrode 110 is a semi-transmissive electrode or a reflective electrode, magnesium (Mg), silver (Ag), aluminum (Al), aluminum-lithium (Al-Li), calcium (Ca), magnesium-indium (Mg-In), magnesium-silver (Mg-Ag), or any combination thereof may be used as a material for forming the first electrode 110.

The first electrode 110 may have a single-layered structure comprising (e.g., consisting of) a single layer or a multi-layered structure comprising two or more layers. In some embodiments, the first electrode 110 may have a triple-layered structure of ITO/Ag/ITO.

**Interlayer 130**

The interlayer 130 may be on the first electrode 110. The interlayer 130 may comprise an emission layer.
The interlayer 130 may further comprise a hole transport region between the first electrode 110 and the emission layer, and an electron transport region between the emission layer and the second electrode 150.
The interlayer 130 may further comprise metal-containing compounds such as organometallic compounds, inorganic materials such as quantum dots, and/or the like, in addition to various organic materials.
The interlayer 130 may comprise: i) at least two emitting units sequentially stacked between the first electrode 110 and the second electrode 150; and ii) a charge-generation layer located between the at least two emitting units. When the interlayer 130 comprises the at least two emitting units and the charge generation layer, the light-emitting device 10 may be a tandem light-emitting device.

**Hole transport region in interlayer 130**

The hole transport region may have i) a single-layered structure comprising or consisting of a single layer comprising or consisting of a single material, ii) a single-layered structure comprising or consisting of a single layer comprising a plurality of different materials, or iii) a multi-layered structure having a plurality of layers comprising a plurality of different materials.
The hole transport region may comprise a hole injection layer (HIL), a hole transport layer (HTL), an emission auxiliary layer, an electron blocking layer (EBL), or a combination thereof.
For example, the hole transport region may have a multi-layered structure, e.g., a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein layers of each structure are sequentially stacked on the first electrode 110 in each stated order.
The hole transport region may comprise the compound represented by Formula 201, the compound represented by Formula 202, or any combination thereof: Formula 201

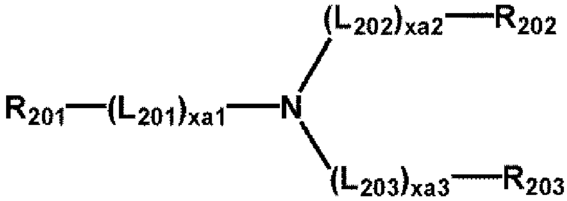

Formula 202

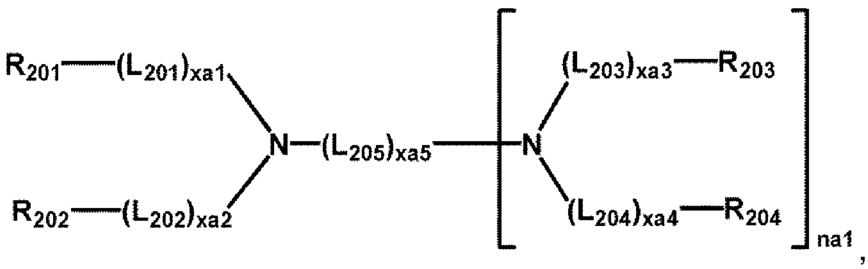

wherein, in Formulae 201 and 202,

$L_{201}$ to $L_{204}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
$L_{205}$ may be *-O-*', *-S-*', *-N($Q_{201}$)-*', a $C_1$-$C_{20}$ alkylene group unsubstituted or substituted with at least one $R_{10a}$, a $C_2$-$C_{20}$ alkenylene group unsubstituted or substituted with at least one $R_{10a}$, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
xa1 to xa4 may each independently be an integer from 0 to 5,
xa5 may be an integer from 1 to 10,

$R_{201}$ to $R_{204}$ and $Q_{201}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
$R_{201}$ and $R_{202}$ may optionally be bound to each other via a single bond, a $C_1$-$C_5$ alkylene group unsubstituted or substituted with at least one $R_{10a}$, or a $C_2$-$C_5$ alkenylene group unsubstituted or substituted with at least one $R_{10a}$, to form a $C_8$-$C_{60}$ polycyclic group (e.g., a carbazole group and/or the like) that is unsubstituted or substituted with at least one $R_{10a}$ (e.g., Compound HT16 described herein),
$R_{203}$ and $R_{204}$ may optionally be bound to each other via a single bond, a $C_1$-$C_5$ alkylene group unsubstituted or substituted with at least one $R_{10a}$, or a $C_2$-$C_5$ alkenylene group unsubstituted or substituted with at least one $R_{10a}$, to form a $C_8$-$C_{60}$ polycyclic group unsubstituted or substituted with at least one $R_{10a}$, and
na1 may be an integer from 1 to 4.

In some embodiments, Formulae 201 and 202 may each comprise at least one of groups represented by Formulae CY201 to CY217:

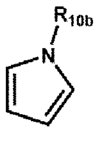
CY201
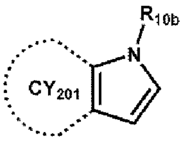
CY202
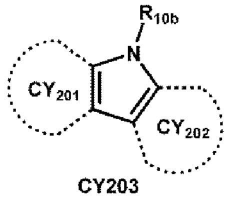
CY203
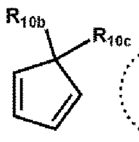
CY204
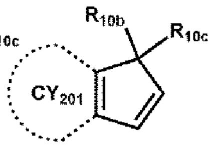
CY205
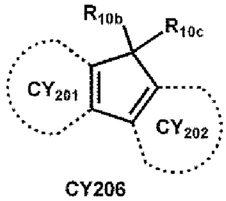
CY206

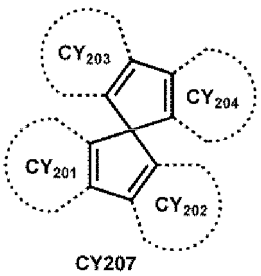
CY207
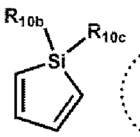
CY208
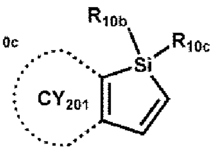
CY209
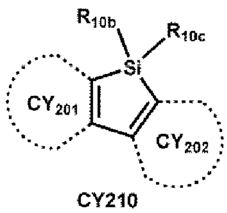
CY210
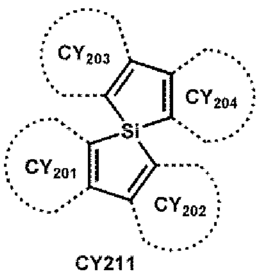
CY211

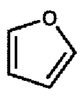
CY212
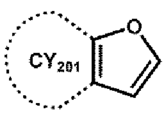
CY213
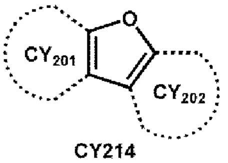
CY214
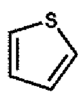
CY215
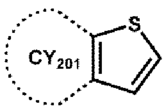
CY216
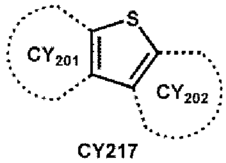
CY217 ,

wherein, in Formulae CY201 to CY217, $R_{10b}$ and $R_{10b}$ may each be understood by referring to the descriptions of $R_{10a}$, ring $CY_{201}$ to ring $CY_{204}$ may each independently be a $C_3$-$C_{20}$ carbocyclic group or a $C_1$-$C_{20}$ heterocyclic group, and hydrogen atoms in Formulae CY201 to CY217 may each independently be unsubstituted or substituted with $R_{10a}$.

In some embodiments, in Formulae CY201 to CY217, ring $CY_{201}$ to ring $CY_{204}$ may each independently be a benzene group, a naphthalene group, a phenanthrene group, or an anthracene group.

In one or more embodiments, Formulae 201 and 202 may each comprise at least one of groups represented by Formula CY201 to CY203.

In one or more embodiments, Formula 201 may comprise at least one of groups represented by Formulae CY201 to CY203 and at least one of groups represented by Formulae CY204 to CY217.

In one or more embodiments, in Formula 201, xa1 may be 1, $R_{201}$ may be a group represented by any one of Formulae CY201 to CY203, xa2 may be 0, and $R_{202}$ may be a group represented by any one of Formulae CY204 to CY207.

In one or more embodiments, Formula 201 and 202 may each not comprise groups represented by Formulae CY201 to CY203.

In one or more embodiments, Formula 201 and 202 may each not comprise groups represented by Formulae CY201 to CY203, and comprise at least one of groups represented by Formulae CY204 to CY217.

In one or more embodiments, Formula 201 and 202 may each not comprise groups represented by Formulae CY201 to CY217.

In some embodiments, the hole transport region may comprise one selected from Compounds HT1 to HT44, m-MTDATA, TDATA, 2-TNATA, NPB (NPD), β-NPB, TPD, spiro-TPD, spiro-NPB, methylated-NPB, TAPC, HMTPD,

4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphorsulfonic acid (PANI/CSA), polyaniline/poly(4-styrenesulfonate) (PANI/PSS), and any combinations thereof:

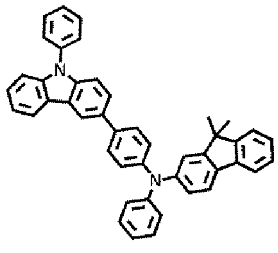

HT1

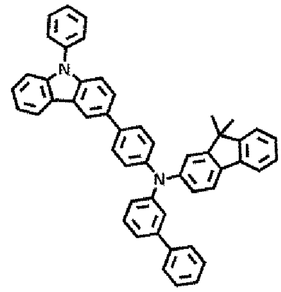

HT2

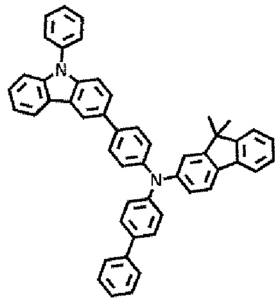

HT3

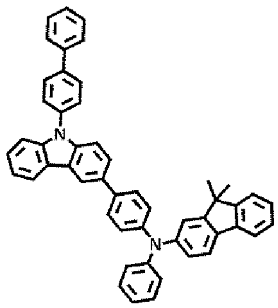

HT4

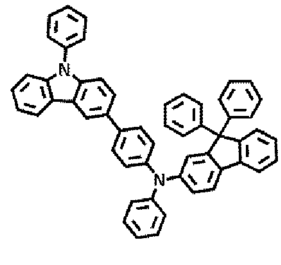

HT5

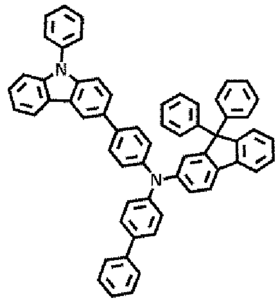

HT6

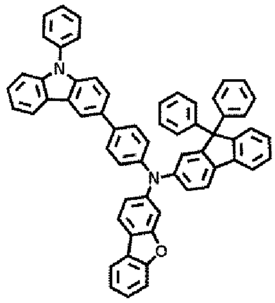

HT7

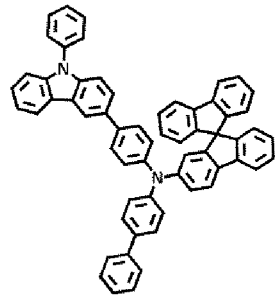

HT8

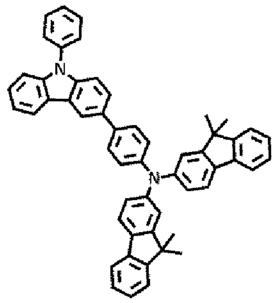

HT9

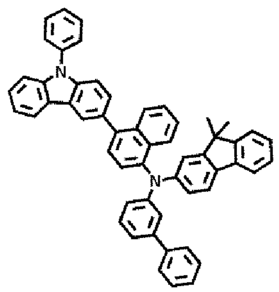

HT10

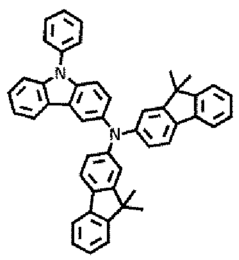

HT11

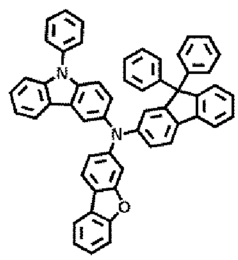

HT12

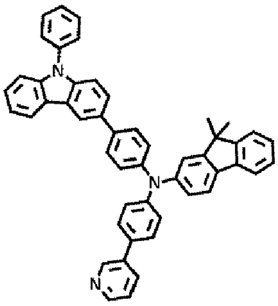
HT13

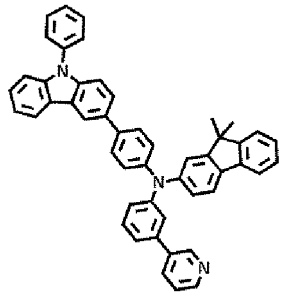
HT14

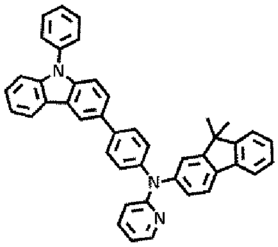
HT15

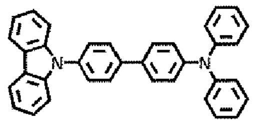
HT16

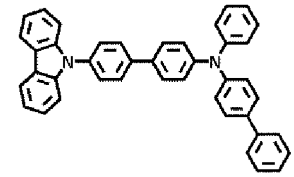
HT17

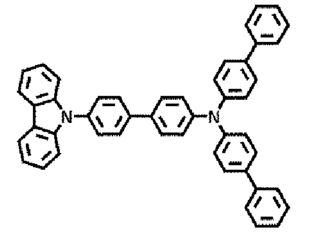
HT18

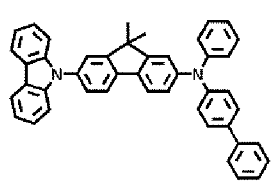
HT19

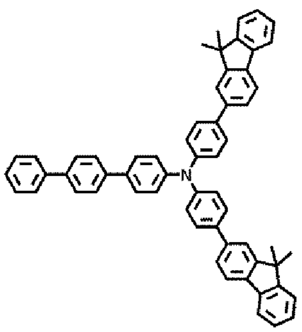
HT20

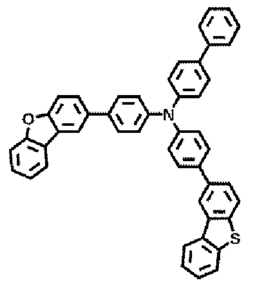
HT21

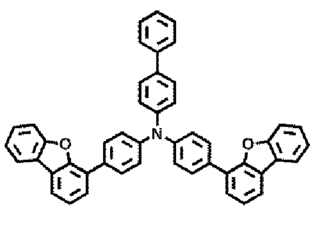
HT22

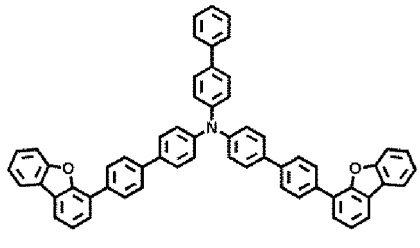
HT23

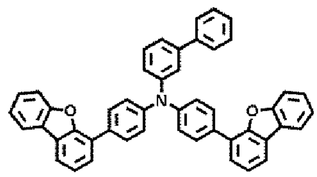
HT24

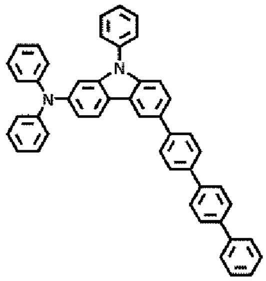
HT25

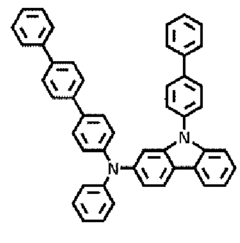
HT26

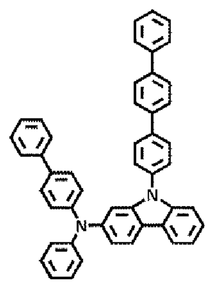
HT27

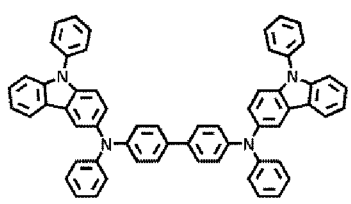

HT28

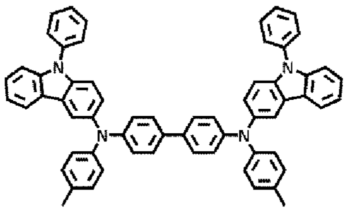

HT29

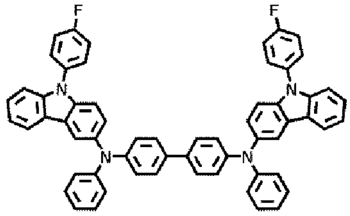

HT30

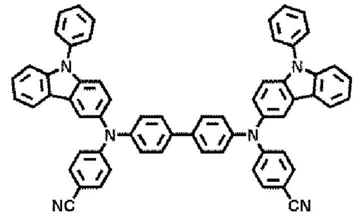

HT31

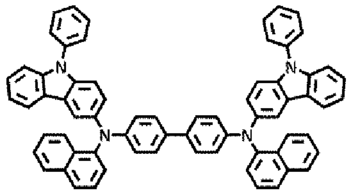

HT32

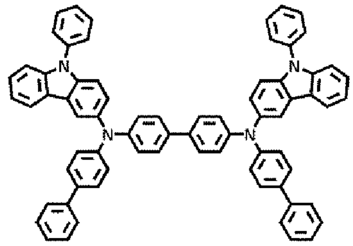

HT33

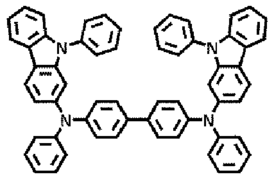

HT34

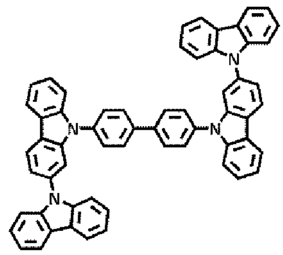

HT35

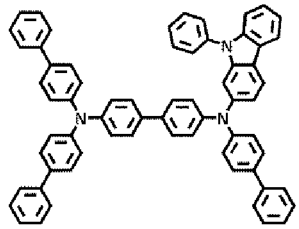

HT36

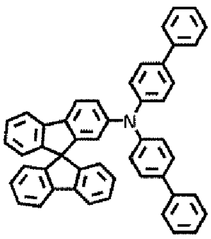

HT37

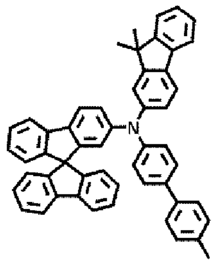

HT38

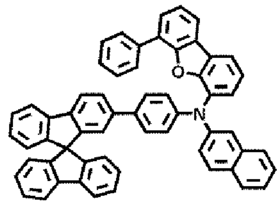

HT39

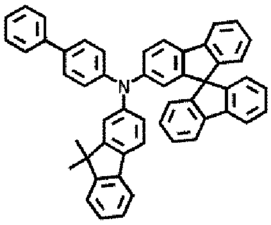

HT40

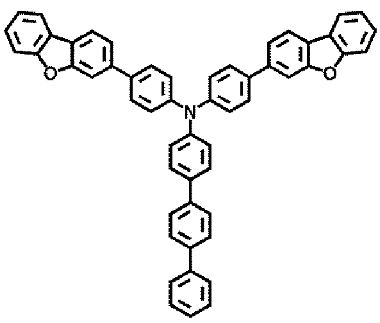

HT41

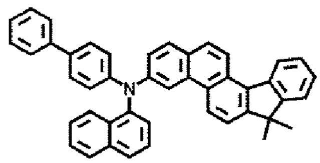

HT42

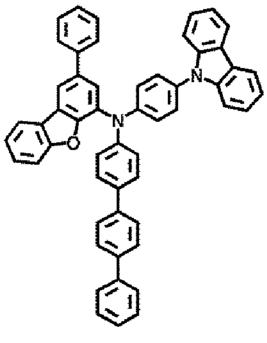

HT43

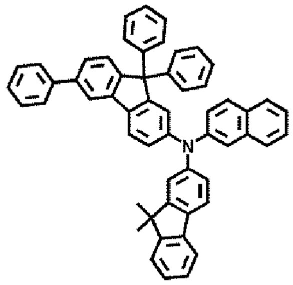

HT44

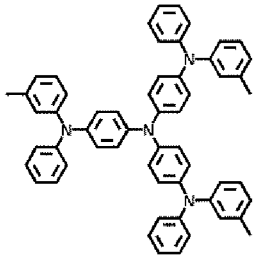

m-MTDATA

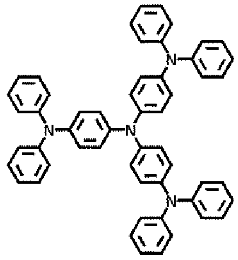

TDATA

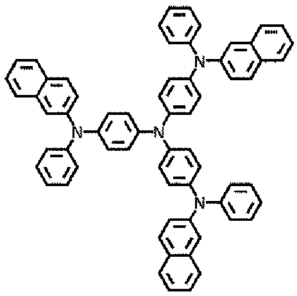

2-TNATA

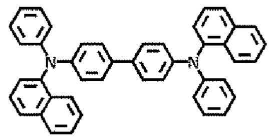

NPB

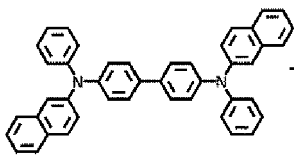

β-NPB

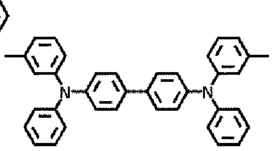

TPD

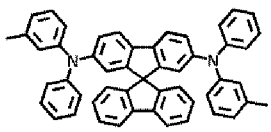

Spiro-TPD

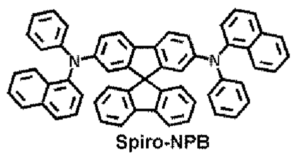

Spiro-NPB

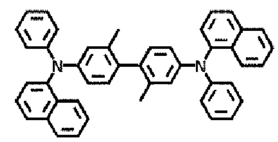

methylated-NPB

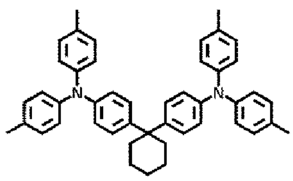

TAPC

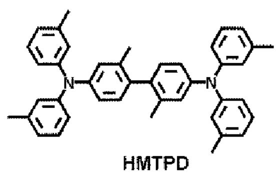

HMTPD

The thickness of the hole transport region may be in a range of about 50 (Angstroms) Å to about 10,000 Å, and in some embodiments, about 100 Å to about 4,000 Å. When the hole transport region comprises a hole injection layer, a hole transport layer, or any combination thereof, the thickness of the hole injection layer may be in a range of about 100 Å to about 9,000 Å, and in some embodiments, about 100 Å to about 1,000 Å, and the thickness of the hole transport layer may be in a range of about 50 Å to about 2,000 Å, and in some embodiments, about 100 Å to about 1,500 Å. When the thicknesses of the hole transport region, the hole injection layer, and the hole transport layer are within any of their respective ranges, excellent (or improved) hole transport characteristics may be obtained without a substantial increase in driving voltage.

The emission auxiliary layer may increase light emission efficiency by compensating for an optical resonance distance according to the wavelength of light emitted by an emission layer. The electron blocking layer may reduce or eliminate the flow of electrons from an electron transport region. The emission auxiliary layer and the electron blocking layer may each independently comprise any of the aforementioned materials.

**p-dopant**

The hole transport region may comprise a charge generating material, as well as the aforementioned materials, to improve conductive properties of the hole transport region. The charge generating material may be substantially homogeneously or non-homogeneously dispersed (for example, as a single layer consisting of charge generating material) in the hole transport region.

The charge generating material may comprise, for example, a p-dopant.

In some embodiments, a lowest unoccupied molecular orbital (LUMO) energy level of the p-dopant may be -3.5 eV or less.

In some embodiments, the p-dopant may comprise a quinone derivative, a cyano group-containing compound, elements EL1 and EL2-containing compound, or any combination thereof.

Examples of the quinone derivative may comprise TCNQ, F4-TCNQ, and the like.

Examples of the cyano group-containing compound comprise HAT-CN, a compound represented by Formula 221, and the like:

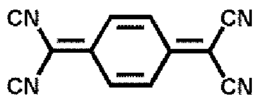

TCNQ

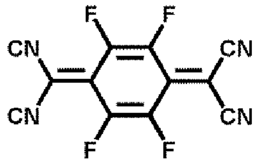

F4-TCNQ

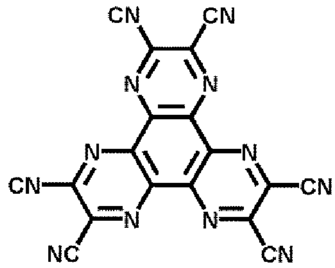

HAT-CN

Formula 221

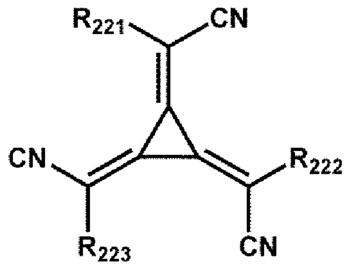

,

wherein, in Formula 221,

$R_{221}$ to $R_{223}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, and

at least one of $R_{221}$ to $R_{223}$ may each independently be: a $C_3$-$C_{60}$ carbocyclic group or a $C_1$-$C_{60}$ heterocyclic group, each independently substituted with a cyano group; -F; -Cl; -Br; -I; a $C_1$-$C_{20}$ alkyl group substituted with a cyano group, -F, -Cl, -Br, - I, or any combination thereof; or any combination thereof.

In the elements EL1 and EL2-containing compound, element EL1 may be metal, metalloid, or a combination thereof, and element EL2 may be non-metal, metalloid, or a combination thereof.

Non-limiting examples of the metal may comprise: an alkali metal (e.g., lithium (Li), sodium (Na), potassium (K), rubidium (Rb), cesium (Cs), and/or the like); an alkaline earth metal (e.g., beryllium (Be), magnesium (Mg), calcium (Ca), strontium (Sr), barium (Ba), and/or the like); a transition metal (e.g., titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), and/or the like); post-transition metal (e.g., zinc (Zn), indium (In), tin (Sn), and/or the like); a lanthanide metal (e.g., lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium(Lu), and/or the like); and the like.

Non-limiting examples of the metalloid may comprise silicon (Si), antimony (Sb), tellurium (Te), and the like.

Non-limiting examples of the non-metal may comprise oxygen (O), halogen (e.g., F, Cl, Br, I, and the like), and the like.

For example, the elements EL1 and EL2-containing compound may comprise a metal oxide, a metal halide

(e.g., metal fluoride, metal chloride, metal bromide, metal iodide, and/or the like), a metalloid halide (e.g., a metalloid fluoride, a metalloid chloride, a metalloid bromide, a metalloid iodide, and/or the like), a metal telluride, or any combination thereof.

Non-limiting examples of the metal oxide may comprise tungsten oxide (e.g., WO, $W_2O_3$, $WO_2$, $WO_3$, $W_2O_5$, and/or the like), vanadium oxide (e.g., VO, $V_2O_3$, $VO_2$, $V_2O_5$, and/or the like), molybdenum oxide (MoO, $Mo_2O_3$, $MoO_2$, MoOs, $Mo_2O_5$, and/or the like), rhenium oxide (e.g., ReOs, and/or the like), and the like.

Non-limiting examples of the metal halide may comprise alkali metal halide, alkaline earth metal halide, transition metal halide, post-transition metal halide, lanthanide metal halide, and the like.

Non-limiting examples of the alkali metal halide may comprise LiF, NaF, KF, RbF, CsF, LiCl, NaCl, KCl, RbCl, CsCl, LiBr, NaBr, KBr, RbBr, CsBr, LiI, NaI, KI, RbI, CsI, and the like.

Non-limiting examples of the alkaline earth metal halide may comprise $BeF_2$, $MgF_2$, $CaF_2$, $SrF_2$, $BaF_2$, $BeCl_2$, $MgCl_2$, $CaCl_2$, $SrCl_2$, $BaCl_2$, $BeBr_2$, $MgBr_2$, $CaBr_2$, $SrBr_2$, $BaBr_2$, $BeI_2$, $MgI_2$, $CaI_2$, $SrI_2$, $BaI_2$, and the like.

Non-limiting examples of the transition metal halide may comprise titanium halide (e.g., $TiF_4$, $TiCl_4$, $TiBr_4$, $TiI_4$, and/or the like), zirconium halide (e.g., $ZrF_4$, $ZrCl_4$, $ZrBr_4$, $ZrI_4$, and/or the like), hafnium halide(e.g., $HfF_4$, $HfCl_4$, $HfBr_4$, $HfI_4$, and/or the like), vanadium halide (e.g., $VF_3$, $VCl_3$, VBrs, $VI_3$, and/or the like), niobium halide (e.g., $NbF_3$, $NbCl_3$, $NbBr_3$, $NbI_3$, and/or the like), tantalum halide (e.g., $TaF_3$, $TaCl_3$, $TaBr_3$, $TaI_3$, and/or the like), chromium halide (e.g., $CrF_3$, $CrCl_3$, $CrBr_3$, $CrI_3$, and/or the like), molybdenum halide (e.g., $MoF_3$, $MoCl_3$, $MoBr_3$, $MoI_3$, and/or the like), tungsten halide (e.g., $WF_3$, $WCl_3$, WBrs, $WI_3$, and/or the like), manganese halide (e.g., $MnF_2$, $MnCl_2$, $MnBr_2$, $MnI_2$, and/or the like), technetium halide (e.g., $TcF_2$, $TcCl_2$, $TcBr_2$, $TcI_2$, and/or the like), rhenium halide (e.g., $ReF_2$, $ReCl_2$, $ReBr_2$, $ReI_2$, and/or the like), iron halide (e.g., $FeF_2$, $FeCl_2$, $FeBr_2$, $FeI_2$, and/or the like), ruthenium halide (e.g., $RuF_2$, $RuCl_2$, $RuBr_2$, $RuI_2$, and/or the like), osmium halide (e.g., $OsF_2$, $OsCl_2$, $OsBr_2$, $OsI_2$, and/or the like), cobalt halide (e.g., $CoF_2$, $CoCl_2$, $CoBr_2$, $CoI_2$, and/or the like), rhodium halide (e.g., $RhF_2$, $RhCl_2$, $RhBr_2$, $RhI_2$, and/or the like), iridium halide (e.g., $IrF_2$, $IrCl_2$, $IrBr_2$, $IrI_2$, and/or the like), nickel halide (e.g., $NiF_2$, $NiCl_2$, $NiBr_2$, $NiI_2$, and/or the like), palladium halide (e.g., $PdF_2$, $PdCl_2$, $PdBr_2$, $PdI_2$, and/or the like), platinum halide (e.g., $PtF_2$, $PtCl_2$, $PtBr_2$, $PtI_2$, and/or the like), copper halide (e.g., CuF, CuCl, CuBr, CuI, and/or the like), silver halide (e.g., AgF, AgCl, AgBr, AgI, and/or the like), gold halide (e.g., AuF, AuCl, AuBr, AuI, and/or the like), and the like.

Non-limiting examples of the post-transition metal halide may comprise zinc halide (e.g., $ZnF_2$, $ZnCl_2$, $ZnBr_2$, $ZnI_2$, and/or the like), indium halide (e.g., $InI_3$ and/or the like), tin halide (e.g., $SnI_2$ and/or the like), and the like.

Non-limiting examples of the lanthanide metal halide may comprise YbF, $YbF_2$, $YbF_3$, $SmF_3$, YbCl, $YbCl_2$, $YbCl_3$, $SmCl_3$, YbBr, $YbBr_2$, $YbBr_3$, $SmBr_3$, YbI, $YbI_2$, $YbI_3$, $SmI_3$, and the like.

Non-limiting examples of the metalloid halide may comprise antimony halide (e.g., $SbCl_5$ and/or the like) and the like.

Non-limiting examples of the metal telluride may comprise alkali metal telluride (e.g., $Li_2Te$, $Na_2Te$, $K_2Te$, $Rb_2Te$, $Cs_2Te$, and/or the like), alkaline earth metal telluride (e.g., BeTe, MgTe, CaTe, SrTe, BaTe, and/or the like), transition metal telluride (e.g., $TiTe_2$, $ZrTe_2$, $HfTe_2$, $V_2Te_3$, $Nb_2Te_3$, $Ta_2Te_3$, $Cr_2Te_3$, $Mo_2Te_3$, $W_2Te_3$, MnTe, TcTe, ReTe, FeTe, RuTe, OsTe, CoTe, RhTe, IrTe, NiTe, PdTe, PtTe, $Cu_2Te$, CuTe, $Ag_2Te$, AgTe, $Au_2Te$, and/or the like), post-transition metal telluride (e.g., ZnTe and/or the like), lanthanide metal telluride (e.g., LaTe, CeTe, PrTe, NdTe, PmTe, EuTe, GdTe, TbTe, DyTe, HoTe, ErTe, TmTe, YbTe, LuTe, and/or the like), and the like.

## Emission layer in interlayer 130

When the light-emitting device 10 is a full color light-emitting device, the emission layer may be patterned into a red emission layer, a green emission layer, and/or a blue emission layer, according to a sub-pixel. In one or more embodiments, the emission layer may have a stacked structure. The stacked structure may comprise two or more layers selected from a red emission layer, a green emission layer, and a blue emission layer. The two or more layers may be in direct contact with each other. In some embodiments, the two or more layers may be separated from each other. In one or more embodiments, the emission layer may comprise two or more materials. The two or more materials may comprise a red light-emitting material, a green light-emitting material, or a blue light-emitting material. The two or more materials may be mixed with each other in a single layer. The two or more materials mixed with each other in the single layer may emit white light.

In some embodiments, the emission layer may comprise a host and a dopant (or an emitter). In some embodiments, the emission layer may further comprise an ancillary dopant that promotes energy transfer to a dopant (or an emitter), in addition to the host and the dopant (or the emitter). When the emission layer comprises the dopant (or the emitter) and the ancillary dopant, the dopant (or the emitter) may be different from the ancillary dopant.

The first compound may serve as the dopant (or the emitter) or as the ancillary dopant.

The amount of the dopant (or the emitter) in the emission layer may be in a range of about 0.01 parts to about 15 parts by weight based on 100 parts by weight of the host.

The thickness of the emission layer may be in a range of about 100 Å to about 1,000 Å, and in some embodiments,

about 200 Å to about 600 Å. When the thickness of the emission layer is within any of these ranges, improved luminescence characteristics may be obtained without a substantial increase in driving voltage.

**Host**

The host in the emission layer may comprise the second compound, the third compound, or any combination thereof.

In some embodiments, the host may further comprise a compound represented by Formula 301:

Formula 301 $[Ar_{301}]_{xb11}-[(L_{301})_{xb1}-R_{301}]_{xb21}$,

wherein, in Formula 301,

$Ar_{301}$ and $L_{301}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
xb11 may be 1, 2, or 3,
xb1 may be an integer from 0 to 5,
$R_{301}$ may be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, $-Si(Q_{301})(Q_{302})(Q_{303})$, $-N(Q_{301})(Q_{302})$, $-B(Q_{301})(Q_{302})$, $-C(=O)(Q_{301})$, $-S(=O)_2(Q_{301})$, or $-P(=O)(Q_{301})(Q_{302})$,
xb21 may be an integer from 1 to 5, and
$Q_{301}$ to $Q_{303}$ may each be understood by referring to the description of $Q_1$ provided herein.

In some embodiments, when xb11 in Formula 301 is 2 or greater, at least two $Ar_{301}$(s) may be bound via a single bond.

In some embodiments, the host may comprise a compound represented by Formula 301-1, a compound represented by Formula 301-2, or any combination thereof:

Formula 301-1

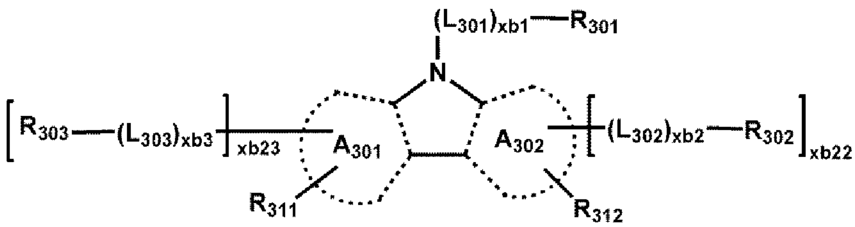

Formula 301-2

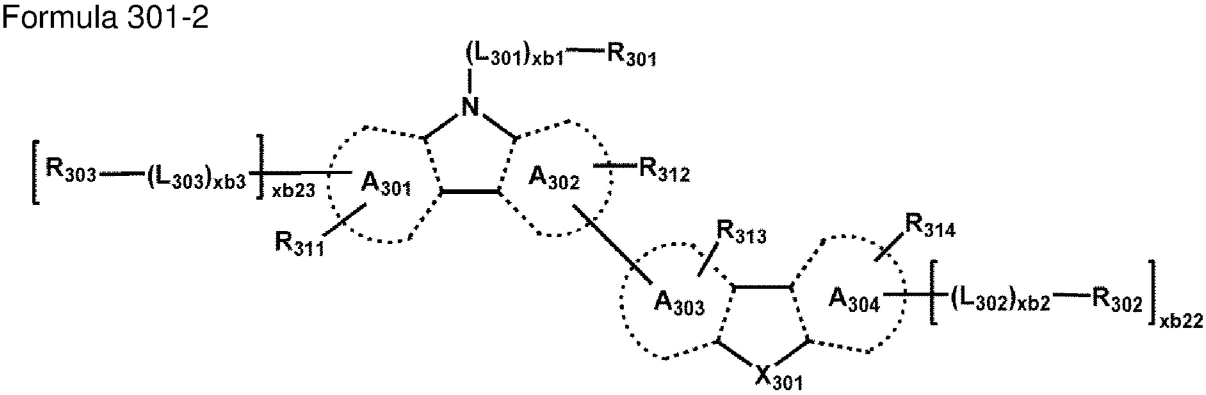

,

wherein, in Formulae 301-1 to 301-2,

ring $A_{301}$ to ring $A_{304}$ may each independently be a $C_3$-$C_{60}$ carbocyclic group unsubstituted or substituted with at

least one $R_{10a}$ or a $C_1$-$C_{60}$ heterocyclic group unsubstituted or substituted with at least one $R_{10a}$,
$X_{301}$ may be O, S, N-[$(L_{304})_{xb4}$-$R_{304}$], C($R_{304}$)($R_{305}$), or Si($R_{304}$)($R_{305}$),
xb22 and xb23 may each independently be 0, 1, or 2,
$L_{301}$, xb1, and $R_{301}$ may respectively be understood by referring to the descriptions of $L_{301}$, xb1, and $R_{301}$ provided herein,
$L_{302}$ to $L_{304}$ may each be understood by referring to the description of $L_{301}$ provided herein,
xb2 to xb4 may each be understood by referring to the description of xb1 provided herein, and
$R_{302}$ to $R_{305}$ and $R_{311}$ to $R_{314}$ may each be understood by referring to the description of $R_{301}$ provided herein.

In some embodiments, the host may comprise an alkaline earth metal complex. For example, the host may comprise a Be complex (e.g., Compound H55), a Mg complex, a Zn complex, or any combination thereof.

In some embodiments, the host may comprise one of Compounds H1 to H124, 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), or any combination thereof:

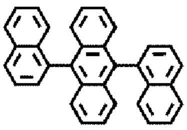
H1

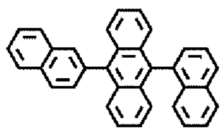
H2

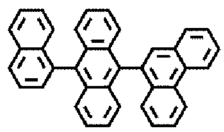
H3

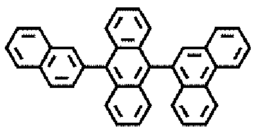
H4

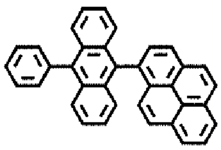
H5

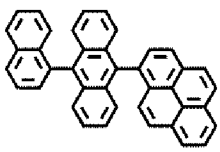
H6

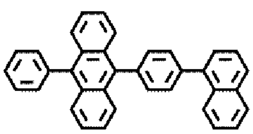
H7

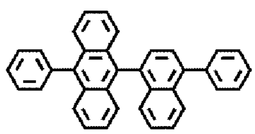
H8

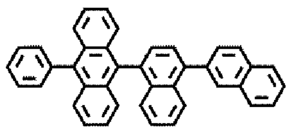
H9

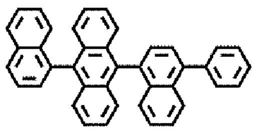
H10

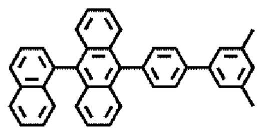
H11

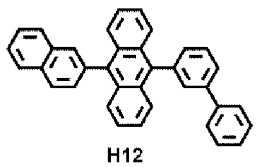
H12

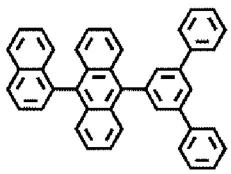
H13

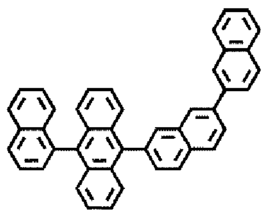
H14

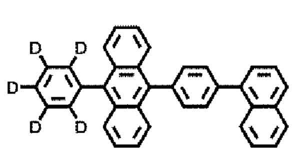
H15

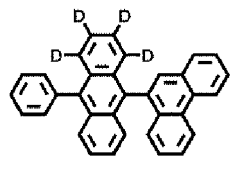
H16

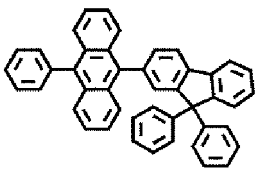
H17

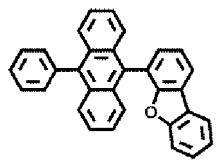
H18

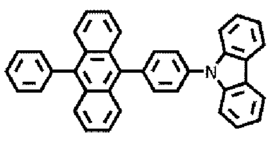
H19

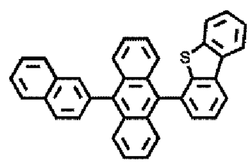
H20

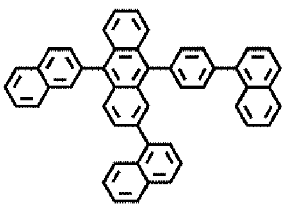
H21

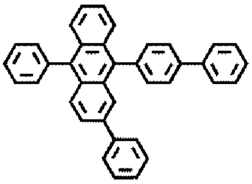
H22

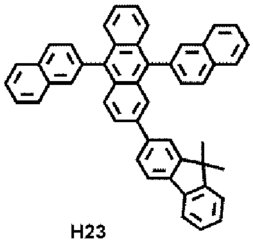
H23

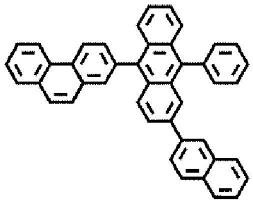
H24

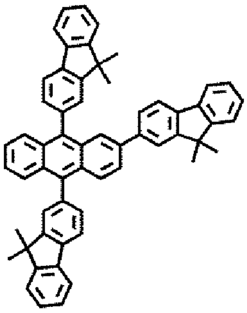
H25

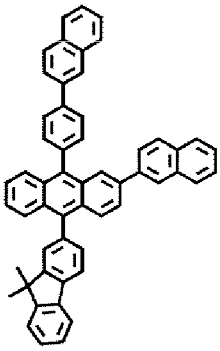
H26

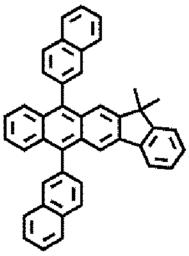
H27

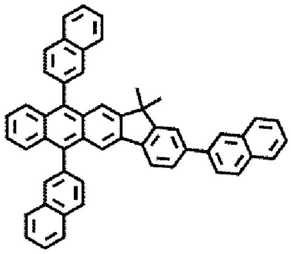
H28

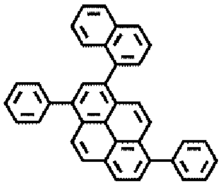
H29

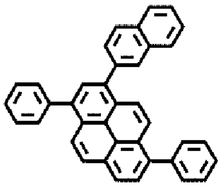
H30

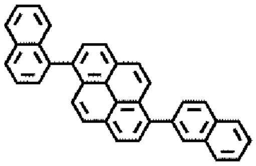
H31

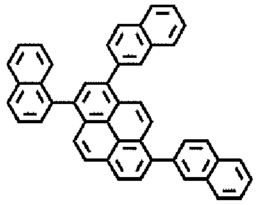
H32

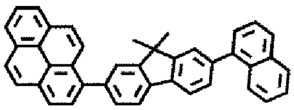
H33

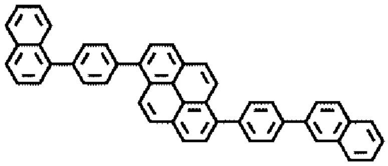
H34

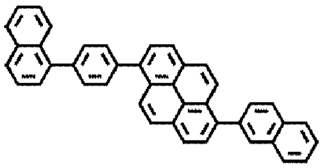
H35

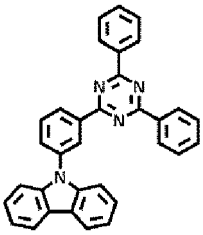
H36

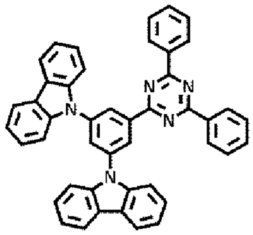
H37

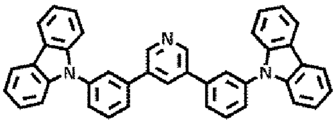
H38

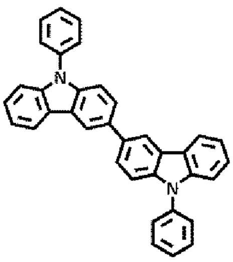
H39

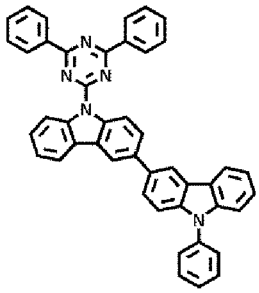
H40

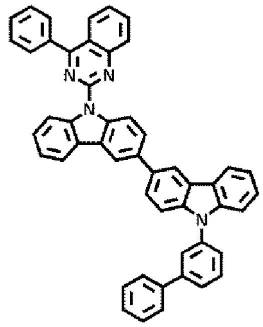
H41

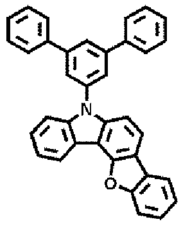
H42

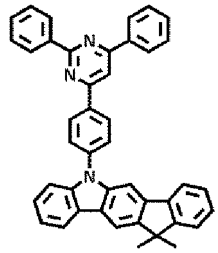
H43

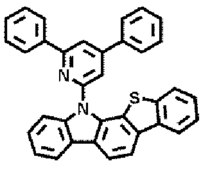
H44

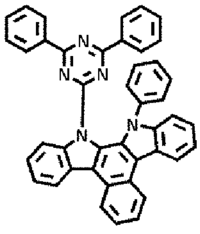
H45

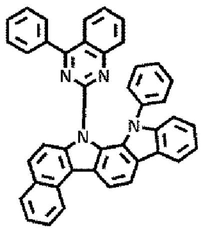
H46

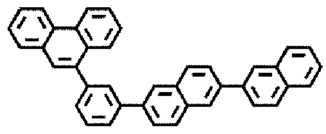
H47

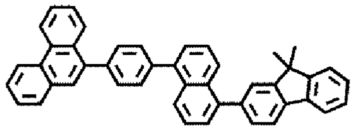
H48

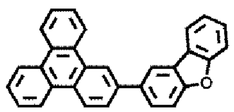
H49

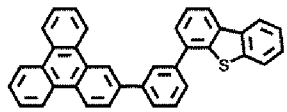
H50

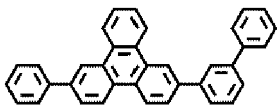
H51

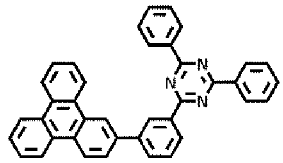
H52

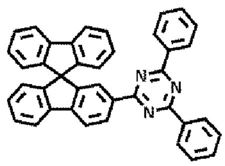
H53

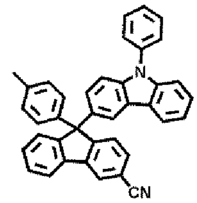
H54

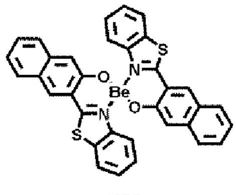
H55

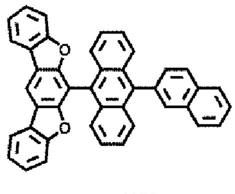
H56

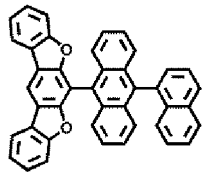
H57

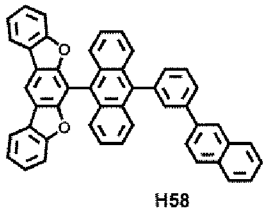
H58

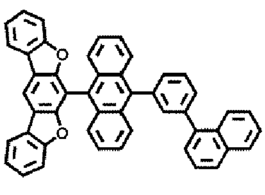
H59

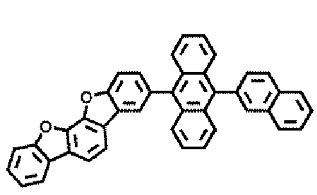
H60

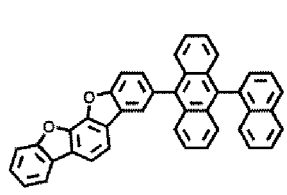
H61

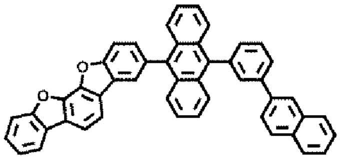
H62

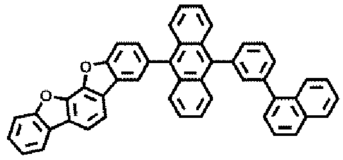
H63

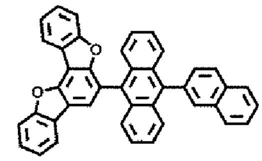
H64

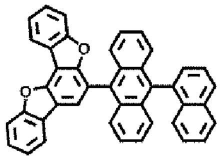
H65

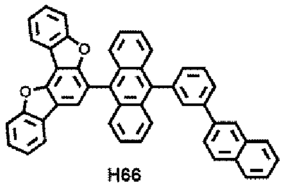
H66

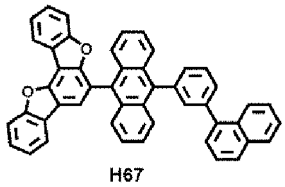
H67

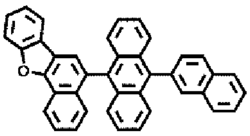
H68

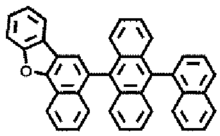
H69

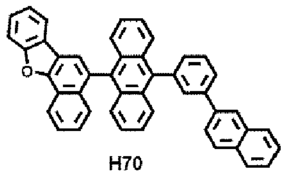
H70

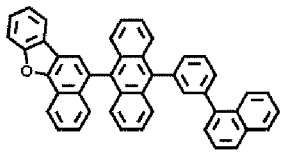
H71

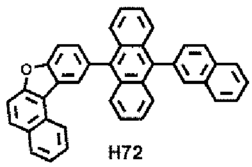
H72

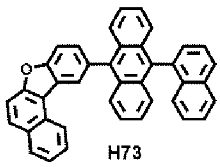
H73

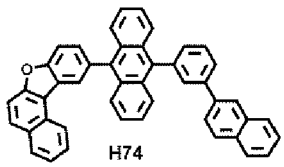
H74

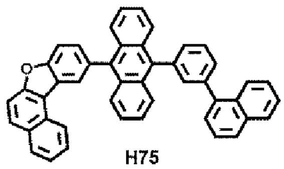
H75

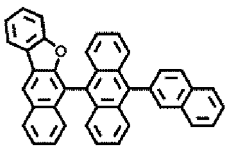
H76

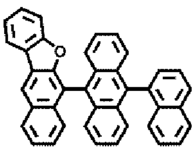
H77

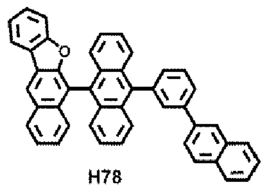
H78

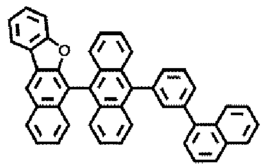
H79

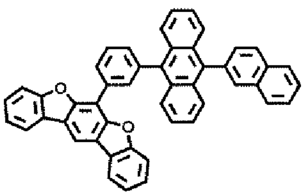
H80

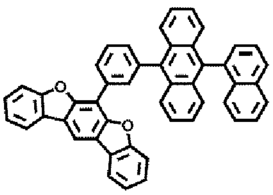
H81

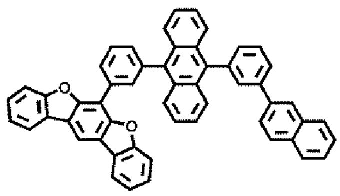
H82

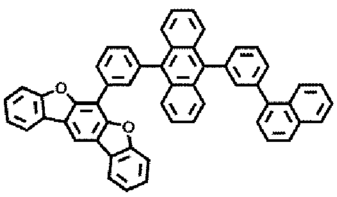
H83

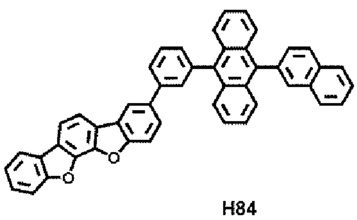
H84

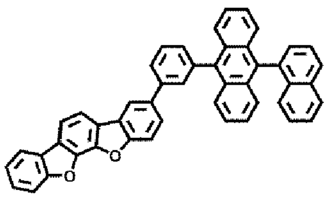
H85

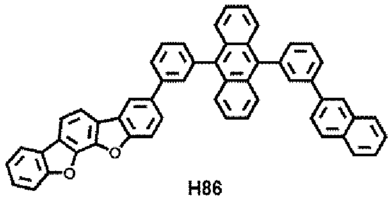
H86

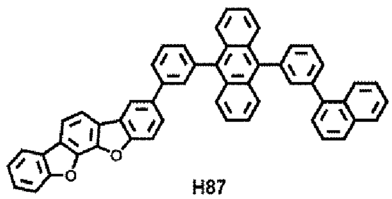
H87

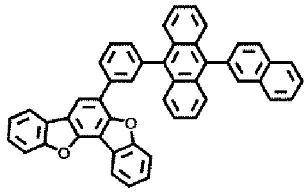
H88

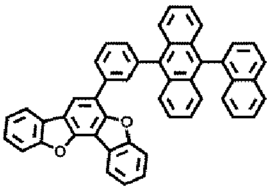
H89

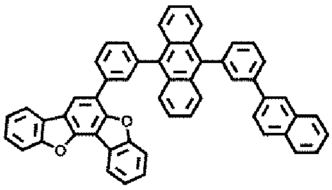
H90

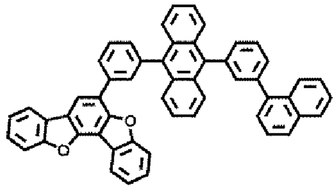
H91

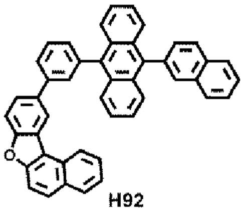
H92

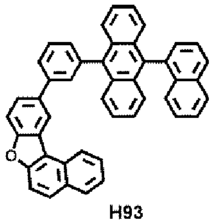
H93

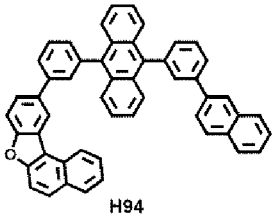
H94

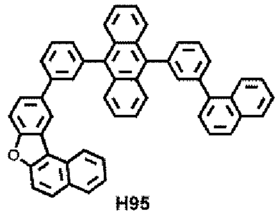
H95

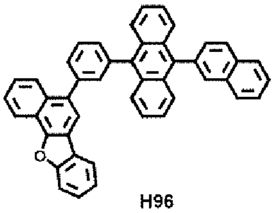
H96

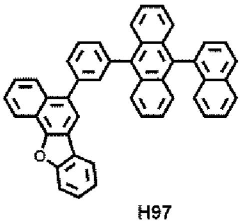
H97

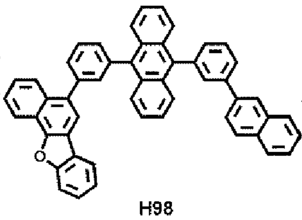
H98

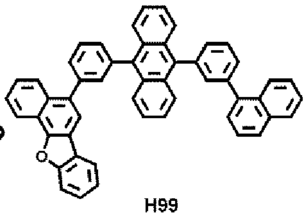
H99

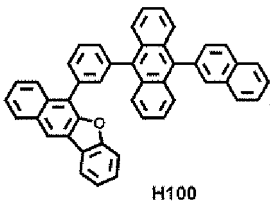
H100

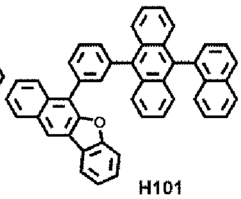
H101

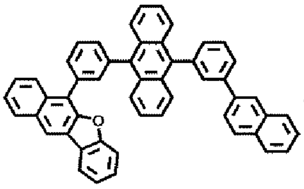
H102

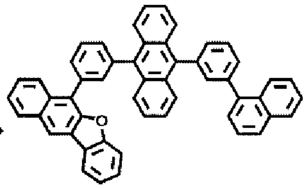
H103

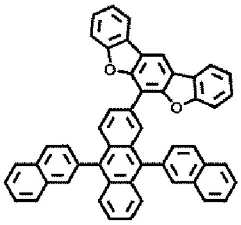
H104

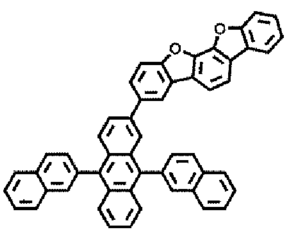
H105

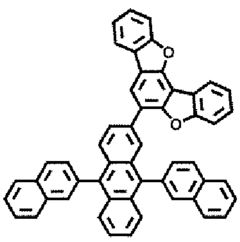
H106

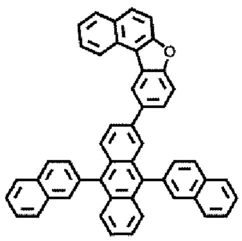
H107

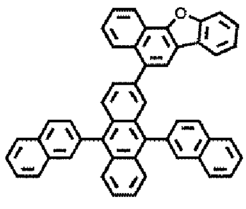
H108

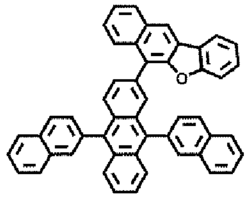
H109

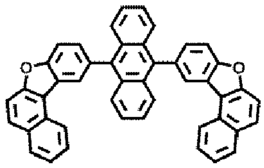
H110

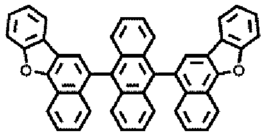
H111

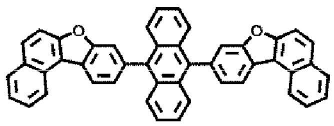
H112

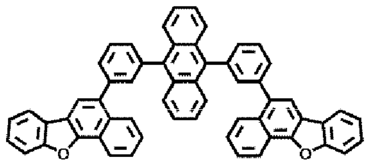
H113

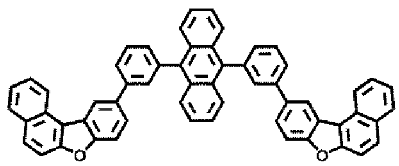
H114

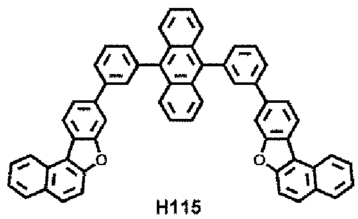
H115

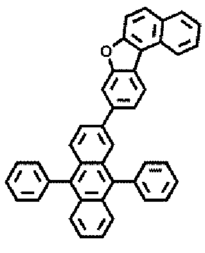
H116

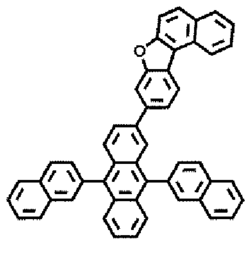
H117

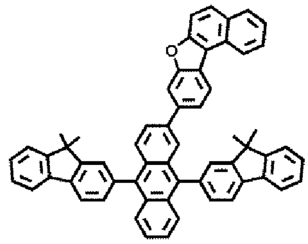
H118

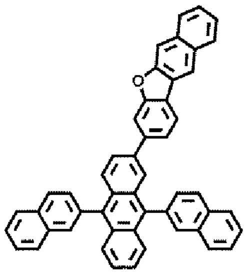
H119

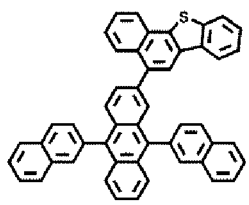
H120

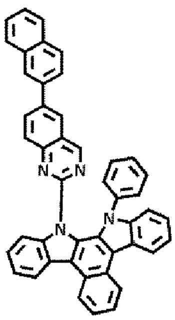
H121

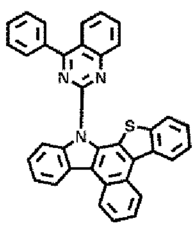
H122

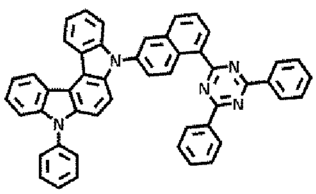
H123

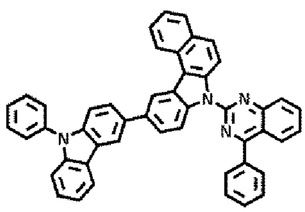
H124

.

In some embodiments, the host may comprise a silicon-containing compound, a phosphine oxide-containing compound, or any combination thereof.

The host may comprise one type (or kind) of compound only, or two or more different types (or kinds) of compounds. As such, embodiments may be modified in various ways.

**Phosphorescent dopant**

The emission layer may comprise the first compound described herein as a phosphorescent dopant.

In some embodiments, the emission layer may comprise the first compound, and when the first compound serves as an ancillary dopant, the emission layer may comprise a phosphorescent dopant.

The phosphorescent dopant may comprise at least one transition metal as a center metal.

The phosphorescent dopant may comprise a monodentate ligand, a bidentate ligand, a tridentate ligand, a tetradentate ligand, a pentadentate ligand, a hexadentate ligand, or any combination thereof.

The phosphorescent dopant may be electrically neutral.

In some embodiments, the phosphorescent dopant may comprise an organometallic complex represented by Formula 401:

Formula 401 $M(L_{401})_{xc1}(L_{402})_{xc2}$

wherein, in Formulae 401,

M may be transition metal (e.g., iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
$L_{401}$ may be a ligand represented by Formula 402, and xc1 may be 1, 2, or 3, and when xc1 is 2 or greater, at least two $L_{401}$(s) may be identical to or different from each other,
$L_{402}$ may be an organic ligand, and xc2 may be an integer from 0 to 4, and when xc2 is 2 or greater, at least two $L_{402}$(s) may be identical to or different from each

Formula 402

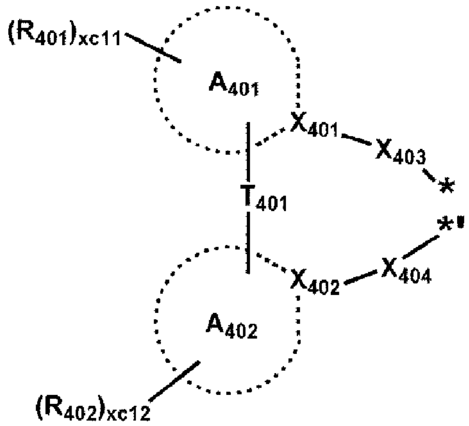

,

wherein, in Formulae 402$X_{401}$ and $X_{402}$ may each independently be nitrogen or carbon,
ring $A_{401}$ and ring $A_{402}$ may each independently be a $C_3$-$C_{60}$ carbocyclic group or a $C_1$-$C_{60}$ heterocyclic group,
$T_{401}$ may be a single bond, *-O-*', *-S-*', *-C(=O)-*', *-N($Q_{411}$)-*', *-C($Q_{411}$)($Q_{412}$)-*', *-C($Q_{411}$)=C($Q_{412}$)-*', *-C($Q_{411}$)=*', or *=C=*',
$X_{403}$ and $X_{404}$ may each independently be a chemical bond (e.g., a covalent bond or a coordinate bond), O, S, N($Q_{413}$), B($Q_{413}$), P($Q_{413}$), C($Q_{413}$)($Q_{414}$), or Si($Q_{413}$)($Q_{414}$),
$Q_{411}$ to $Q_{414}$ may each be understood by referring to the description of $Q_1$ provided herein,
$R_{401}$ and $R_{402}$ may each independently be hydrogen, deuterium, -F, -Cl, -Br, - I, a hydroxyl group, a cyano group, a nitro group, a $C_1$-$C_{20}$ alkyl group unsubstituted or substituted with at least one $R_{10a}$, a $C_1$-$C_{20}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, -Si($Q_{401}$)($Q_{402}$)($Q_{403}$), -N($Q_{401}$)($Q_{402}$), -B($Q_{401}$)($Q_{402}$), -C(=O)($Q_{401}$), - S(=O)$_2$($Q_{401}$), or -P(=O)($Q_{401}$)($Q_{402}$),
$Q_{401}$ to $Q_{403}$ may each be understood by referring to the description of $Q_1$ provided herein,
xc11 and xc12 may each independently be an integer from 0 to 10, and
* and *' in Formula 402 each indicate a binding site to M in Formula 401.

In one or more embodiments, in Formula 402, i) $X_{401}$ may be nitrogen, and $X_{402}$ may be carbon, or ii) $X_{401}$ and $X_{402}$ may both be nitrogen.

In one or more embodiments, when xc1 in Formula 401 is 2 or greater, two ring $A_{401}$ (s) of at least two $L_{401}$(s) may optionally be bound via $T_{402}$ as a linking group, and/or two ring $A_{402}$(s) may optionally be bound via $T_{403}$ as a linking group (*see e.g.,* Compounds PD1 to PD4 and PD7). $T_{402}$ and $T_{403}$ may each be understood by referring to the description of $T_{401}$ provided herein.

$L_{402}$ in Formula 401 may be any suitable organic ligand. For example, $L_{402}$ may be a halogen group, a diketone group (e.g., an acetylacetonate group), a carboxylic acid group (e.g., a picolinate group), -C(=O), an isonitrile group, -CN, or a phosphorus group (e.g., a phosphine group and/or a phosphite group).

The phosphorescent dopant may be, for example, one of Compounds PD1 to PD25 or any combination thereof:

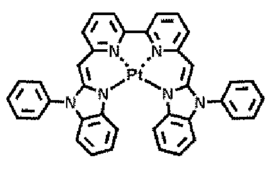
PD1
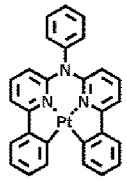
PD2
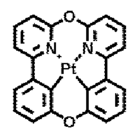
PD3
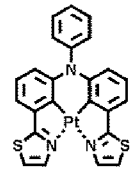
PD4
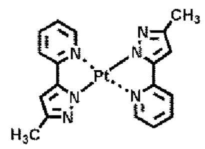
PD5
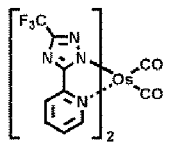
PD6
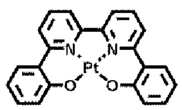
PD7
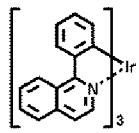
PD8
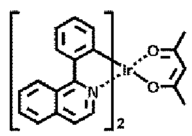
PD9
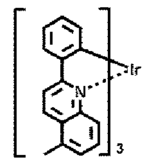
PD10
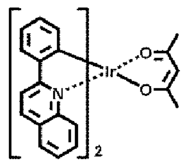
PD11
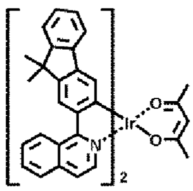
PD12
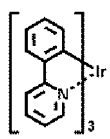
PD13
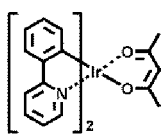
PD14
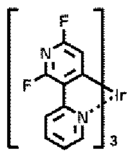
PD15
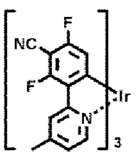
PD16
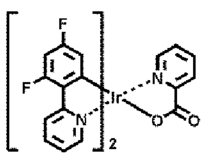
PD17
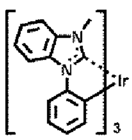
PD18
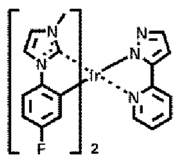
PD19
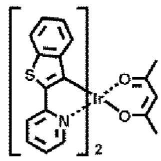
PD20
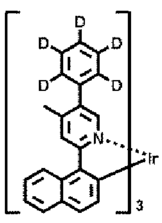
PD21
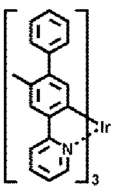
PD22
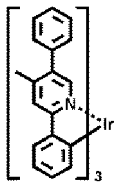
PD23
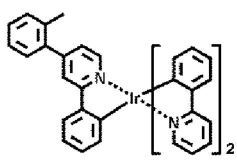
PD24
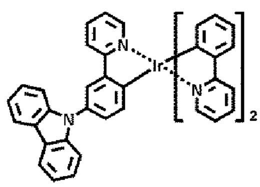
PD25
.

## Fluorescent dopant

In some embodiments, the emission layer may comprise the first compound, and when the first compound serves as an ancillary dopant, the emission layer may comprise a fluorescent dopant.

In some embodiments, the emission layer may comprise the first compound, and when the first compound serves as a phosphorescent dopant, the emission layer may comprise an ancillary dopant.

The fluorescent dopant and the ancillary dopant may each independently comprise an arylamine compound,

a styrylamine compound, a boron-containing compound, or any combination thereof.

In some embodiments, the fluorescent dopant and the ancillary dopant may each independently comprise the compound represented by Formula 501:

Formula 501

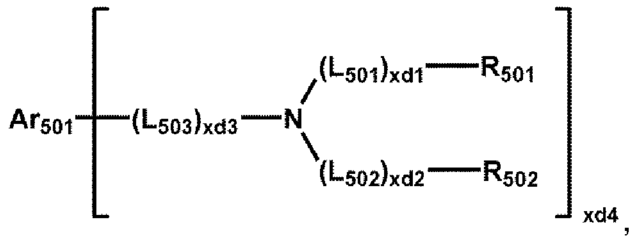

wherein, in Formula 501,

$Ar_{501}$, $L_{501}$ to $L_{503}$, $R_{501}$, and $R_{502}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
xd1 to xd3 may each independently be 0, 1, 2, or 3, and
xd4 may be 1, 2, 3, 4, 5, or 6.

In some embodiments, in Formula 501, $Ar_{501}$ may comprise a condensed ring group (e.g., an anthracene group, a chrysene group, and/or a pyrene group), in which at least three monocyclic groups are condensed.

In some embodiments, xd4 in Formula 501 may be 2.

In some embodiments, the fluorescent dopant and the ancillary dopant may each independently comprise one of Compounds FD1 to FD36, DPVBi, DPAVBi, or any combination thereof:

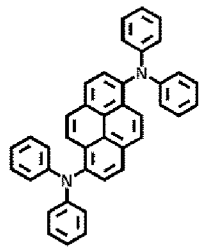

FD1

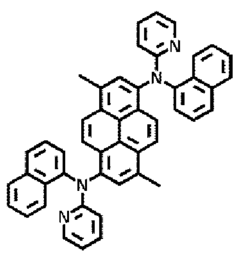

FD2

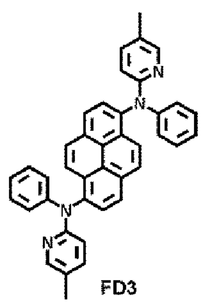

FD3

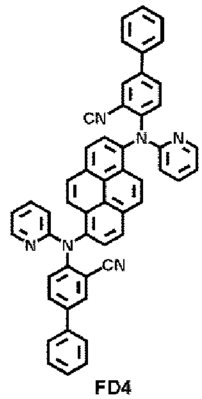

FD4

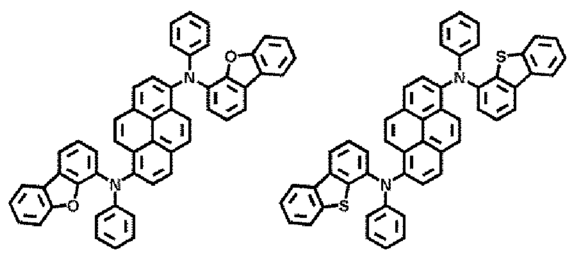

FD5

FD6

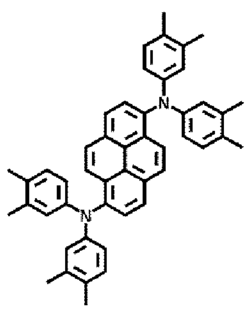

FD7

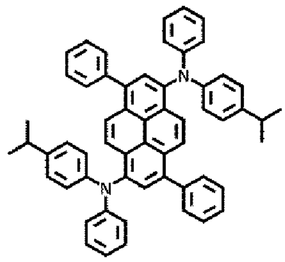

FD8

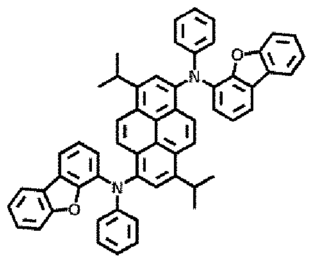
FD9

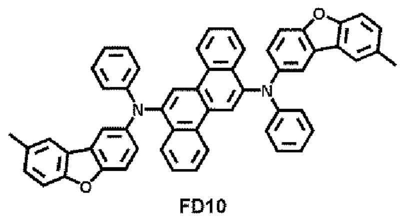
FD10

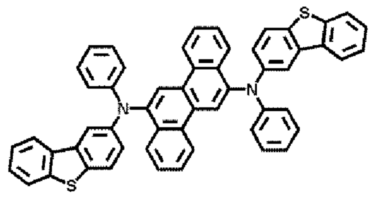
FD11

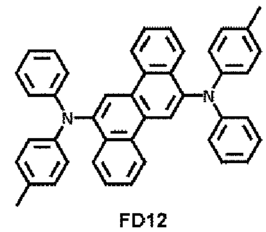
FD12

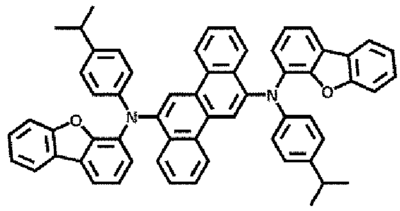
FD13

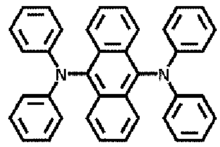
FD14

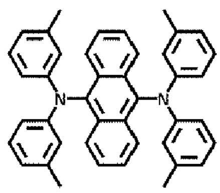
FD15

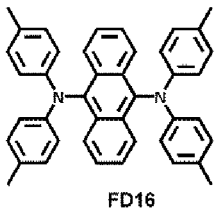
FD16

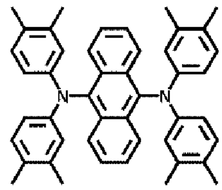
FD17

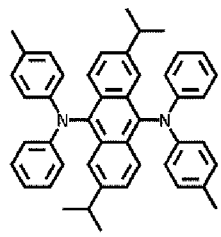
FD18

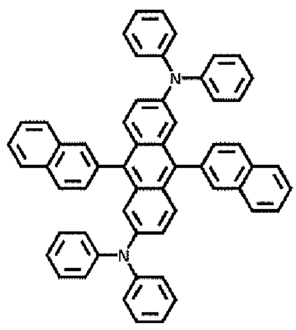
FD19

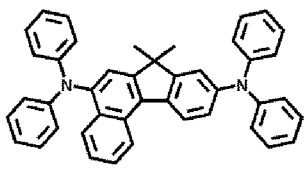
FD20

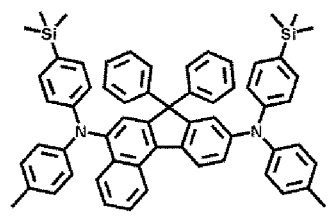
FD21

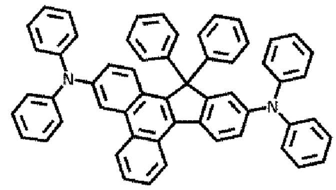
FD22

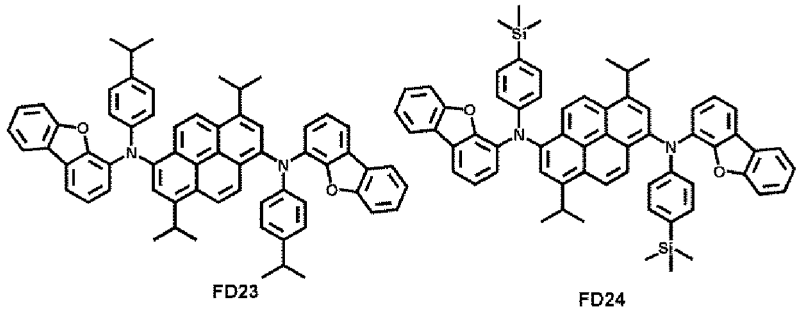
FD23

FD24

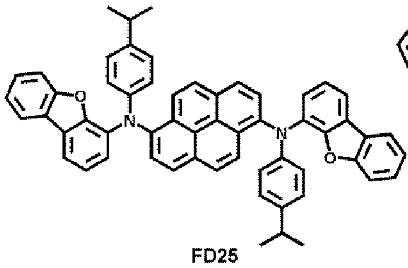

FD25

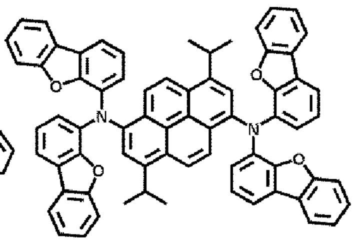

FD26

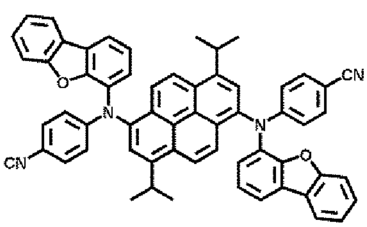

FD27

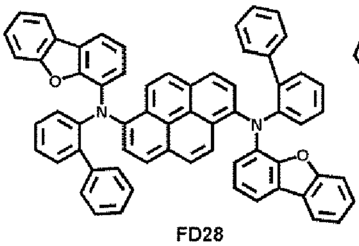

FD28

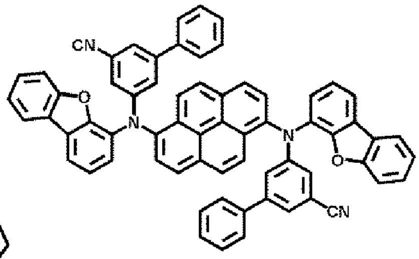

FD29

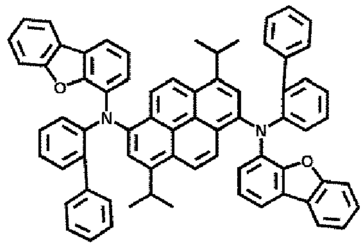

FD30

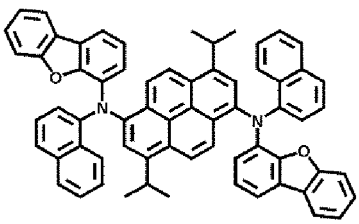

FD31

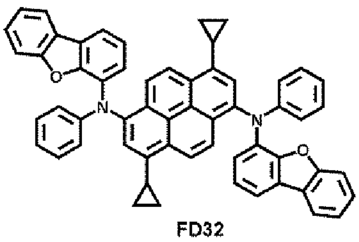

FD32

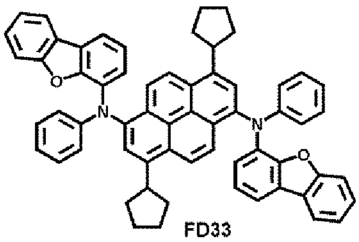

FD33

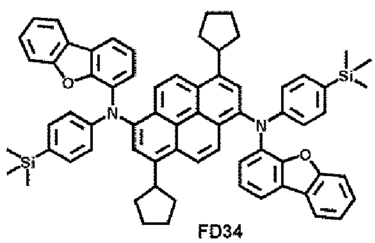

FD34

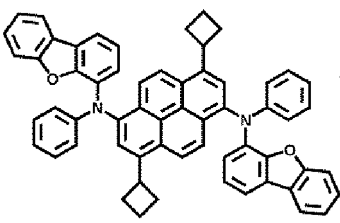

FD35

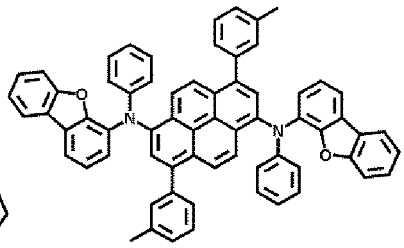

FD36

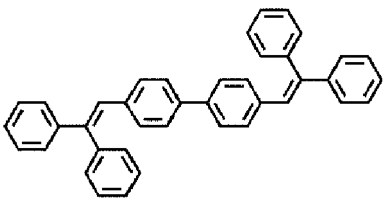

DPVBi

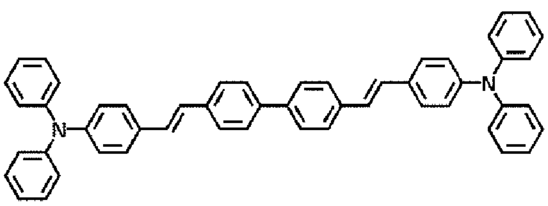

DPAVBi

In some embodiments, the fluorescent dopant and the ancillary dopant may each independently comprise the fourth compound represented by Formula 502 or Formula 503.

**Electron transport region in interlayer 130**

The electron transport region may have i) a single-layered structure comprising (e.g., consisting of) a single layer comprising (e.g., consisting of) a single material, ii) a single-layered structure comprising (e.g., consisting of) a single layer comprising a plurality of different materials, or iii) a multi-layered structure having a plurality of layers comprising a plurality of different materials.

The electron transport region may comprise a buffer layer, a hole blocking layer, an electron control layer, an electron transport layer, or an electron injection layer.

In some embodiments, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein layers of each structure are sequentially stacked on the emission layer in each stated order.

The electron transport region (e.g., a buffer layer, a hole blocking layer, an electron control layer, and/or an electron transport layer in the electron transport region) may comprise a metal-free compound comprising at least one $\pi$ electron-deficient nitrogen-containing $C_1$-$C_{60}$ cyclic group.

In some embodiments, the electron transport region may comprise a compound represented by Formula 601:

Formula 601 $$[Ar_{601}]_{xe11}\text{-}[(L_{601})_{xe1}\text{-}R_{601}]_{xe21},$$

wherein, in Formula 601,

$Ar_{601}$ and $L_{601}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
xe11 may be 1, 2, or 3,
xe1 may be 0, 1, 2, 3, 4, or 5,
$R_{601}$ may be a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, $-Si(Q_{601})(Q_{602})(Q_{603})$, $-C(=O)(Q_{601})$, $-S(=O)_2(Q_{601})$, or $-P(=O)(Q_{601})(Q_{602})$,
$Q_{601}$ to $Q_{603}$ may each be understood by referring to the description of $Q_1$ provided herein,
xe21 may be 1, 2, 3, 4, or 5, and
at least one of $Ar_{601}$, $L_{601}$, and $R_{601}$ may each independently be a $\pi$ electron-deficient nitrogen-containing $C_1$-$C_{60}$ cyclic group unsubstituted or substituted with at least one $R_{10a}$.

In some embodiments, when xe11 in Formula 601 is 2 or greater, at least two $Ar_{601}$(s) may be bound via a single bond.

In some embodiments, in Formula 601, $Ar_{601}$ may be a substituted or unsubstituted anthracene group.

In some embodiments, the electron transport region may comprise a compound represented by Formula 601-1:

Formula 601-1

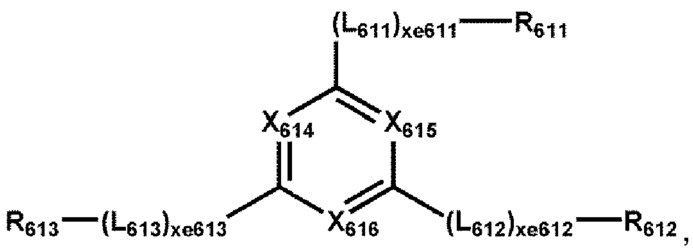

wherein, in Formula 601-1,

$X_{614}$ may be N or $C(R_{614})$, $X_{615}$ may be N or $C(R_{615})$, $X_{616}$ may be N or $C(R_{616})$, at least one selected from $X_{614}$ to $X_{616}$ may be N,
$L_{611}$ to $L_{613}$ may each be understood by referring to the description of $L_{601}$ provided herein,
xe611 to xe613 may each be understood by referring to the description of xe1 provided herein,
$R_{611}$ to $R_{613}$ may each be understood by referring to the description of $R_{601}$ provided herein, and
$R_{614}$ to $R_{616}$ may each independently be hydrogen, deuterium, -F, -Cl, -Br, -I, a hydroxyl group, a cyano group, a nitro group, a $C_1$-$C_{20}$ alkyl group, a $C_1$-$C_{20}$ alkoxy group, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$.

For example, in Formulae 601 and 601-1, xe1 and xe611 to xe613 may each independently be 0, 1, or 2.

The electron transport region may comprise one of Compounds ET1 to ET45, 2,9-dimethyl-4,7-diphenyl-1,10-phenanthroline (BCP), 4,7-diphenyl-1,10-phenanthroline (Bphen), $Alq_3$, BAlq, TAZ, NTAZ, or any combination thereof:

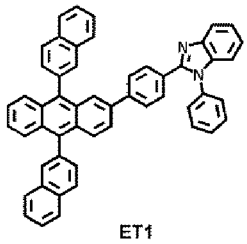
ET1

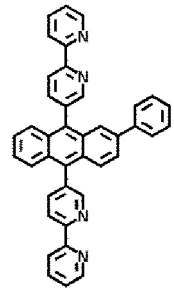
ET2

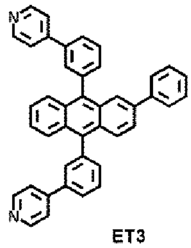
ET3

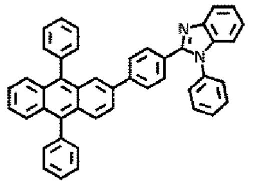
ET4

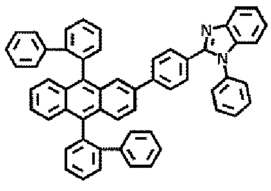
ET5

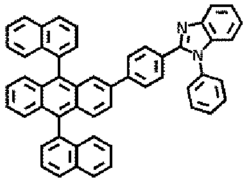
ET6

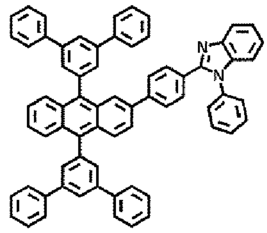
ET7

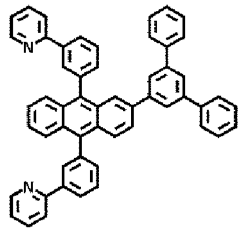
ET8

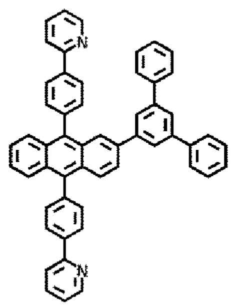
ET9

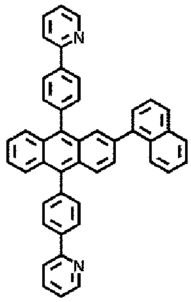
ET10

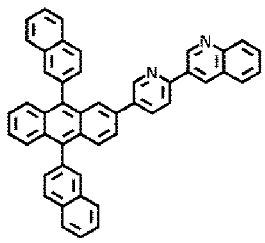
ET11

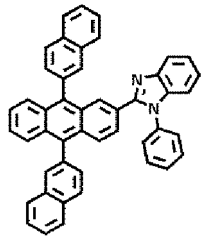
ET12

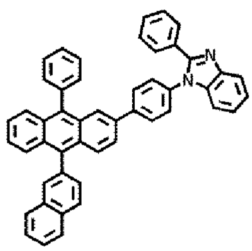
ET13

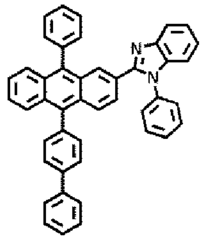
ET14

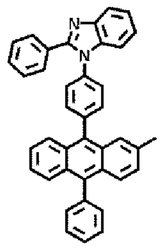
ET15

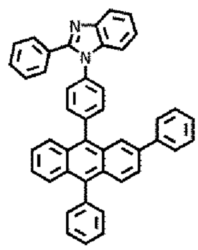
ET16

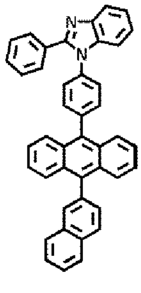
ET17

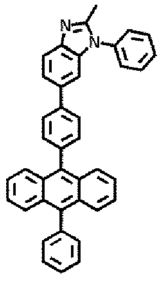
ET18

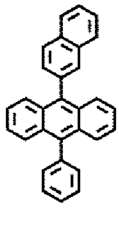
ET19

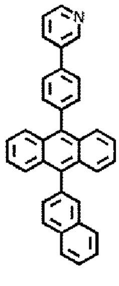
ET20

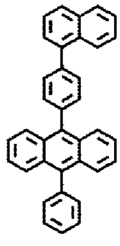
ET21

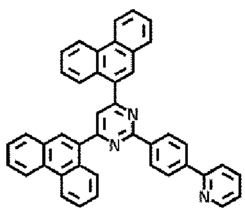
ET22

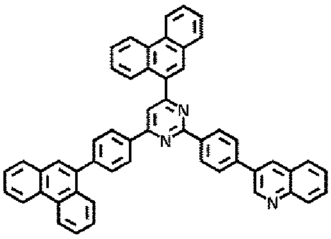
ET23

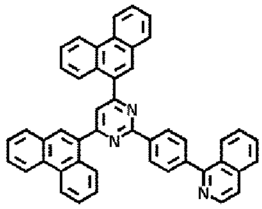
ET24

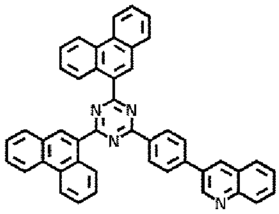
ET25

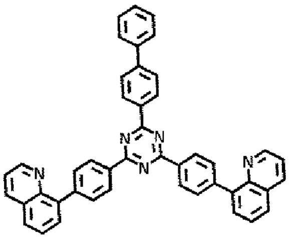
ET26

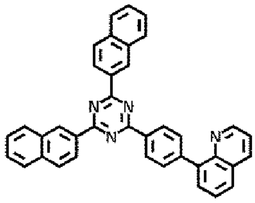
ET27

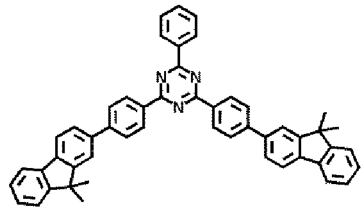
ET28

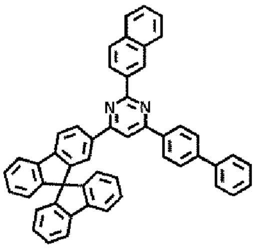
ET29

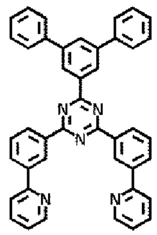
ET30

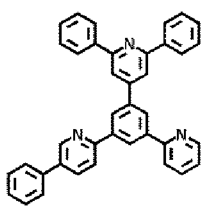
ET31

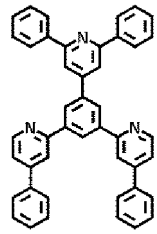
ET32

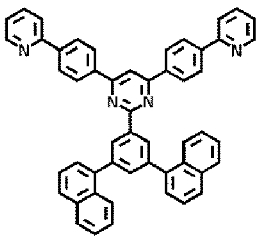
ET33

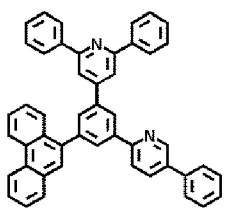
ET34

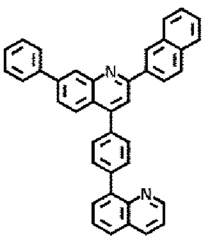
ET35

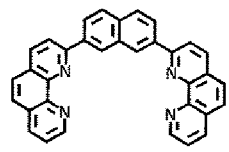
ET36

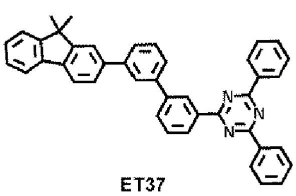
ET37

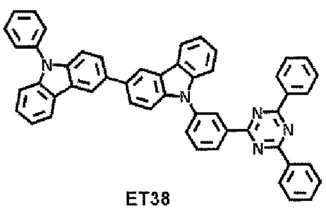
ET38

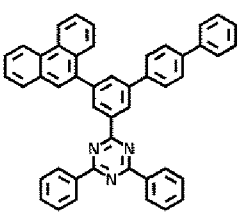
ET39

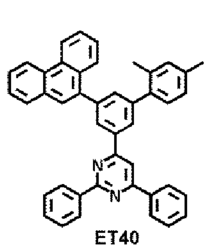
ET40

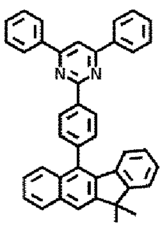
ET41

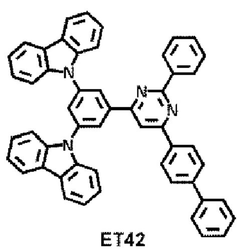
ET42

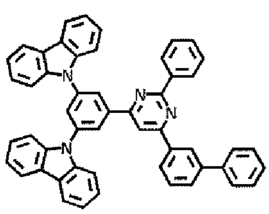
ET43

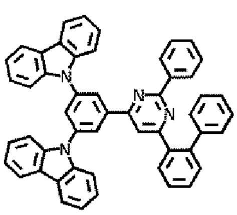
ET44

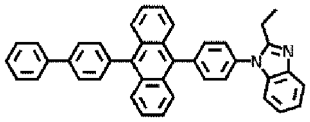

ET45

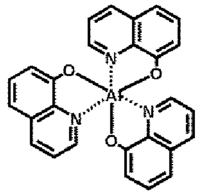

Alq3

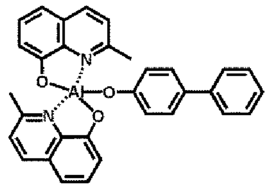

BAlq

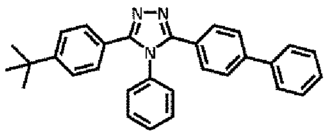

TAZ

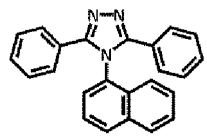

NTAZ .

The thickness of the electron transport region may be in a range of about 100 Å to about 5,000 Å, and in some embodiments, about 160 Å to about 4,000 Å. When the electron transport region comprises a buffer layer, a hole blocking layer, an electron control layer, an electron transport layer, or any combination thereof, the thicknesses of the buffer layer, the hole blocking layer, or the electron control layer may each independently be in a range of about 20 Å to about 1,000 Å, for example, about 30 Å to about 300 Å, and the thickness of the electron transport layer may be in a range of about 100 Å to about 1,000 Å, for example, about 150 Å to about 500 Å. When the thicknesses of the buffer layer, the hole blocking layer, the electron control layer, and/or the electron transport layer are each within their respective ranges, excellent (or improved) hole transport characteristics may be obtained without a substantial increase in driving voltage.

The electron transport region (for example, the electron transport layer in the electron transport region) may further comprise, in addition to the materials described above, a metal-containing material.

The metal-containing material may comprise an alkali metal complex, an alkaline earth metal complex, or any combination thereof. A metal ion of the alkali metal complex may be a lithium (Li) ion, a sodium (Na) ion, a potassium (K) ion, a rubidium (Rb) ion, or a cesium (Cs) ion. A metal ion of the alkaline earth metal complex may be a beryllium (Be) ion, a magnesium (Mg) ion, a calcium (Ca) ion, a strontium (Sr) ion, or a barium (Ba) ion. Ligand coordinated with the metal ion of the alkali metal complex and the alkaline earth metal complex may each independently be hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, cyclopentadiene, or any combination thereof.

For example, the metal-containing material may comprise a Li complex. The Li complex may comprise, e.g., Compound ET-D1 (LiQ) and/or Compound ET-D2:

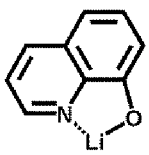

ET-D1

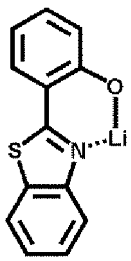

ET-D2 .

The electron transport region may comprise an electron injection layer that facilitates injection of electrons from the second electrode 150. The electron injection layer may be in direct contact with the second electrode 150.

The electron injection layer may have i) a single-layered structure comprising (e.g., consisting of) a single layer comprising (e.g., consisting of) a single material, ii) a single-layered structure comprising (e.g., consisting of) a single layer comprising a plurality of different materials, or iii) a multi-layered structure having a plurality of layers comprising a plurality of different materials.

The electron injection layer may comprise an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may be Li, Na, K, Rb, Cs or any combination thereof. The alkaline earth metal may be Mg,

Ca, Sr, Ba, or any combination thereof. The rare earth metal may be Sc, Y, Ce, Tb, Yb, Gd, or any combination thereof.

The alkali metal-containing compound, the alkaline earth metal-containing compound, and the rare earth metal-containing compound may respectively be oxides, halides (e.g., fluorides, chlorides, bromides, and/or iodines), tellurides, or any combination thereof of the alkali metal, the alkaline earth metal, and the rare earth metal.

The alkali metal-containing compound may be selected from alkali metal oxides (such as $Li_2O$, $Cs_2O$, and/or $K_2O$), alkali metal halides (such as LiF, NaF, CsF, KF, LiI, NaI, CsI, and/or KI), or any combination thereof. The alkaline earth-metal-containing compound may comprise alkaline earth-metal oxides (such as BaO, SrO, CaO, $Ba_xSr_{1-x}O$ (wherein x is a real number satisfying 0<x<1), and/or $Ba_xCa_{1-x}O$ (wherein x is a real number satisfying 0<x<1)). The rare earth metal-containing compound may comprise $YbF_3$, $ScF_3$, $Sc_2O_3$, $Y_2O_3$, $Ce_2O_3$, $GdF_3$, $TbF_3$, $YbI_3$, $ScI_3$, $TbI_3$, or any combination thereof. In some embodiments, the rare earth metal-containing compound may comprise a lanthanide metal telluride. Non-limiting examples of the lanthanide metal telluride may comprise LaTe, CeTe, PrTe, NdTe, PmTe, SmTe, EuTe, GdTe, TbTe, DyTe, HoTe, ErTe, TmTe, YbTe, LuTe, $La_2Te_3$, $Ce_2Te_3$, $Pr_2Te_3$, $Nd_2Te_3$, $Pm_2Te_3$, $Sm_2Te_3$, $Eu_2Te_3$, $Gd_2Te_3$, $Tb_2Te_3$, $Dy_2Te_3$, $Ho_2Te_3$, $Er_2Te_3$, $Tm_2Te_3$, $Yb_2Te_3$, $Lu_2Te_3$, and the like.

The alkali metal complex, the alkaline earth metal complex, and the rare earth metal complex may respectively comprise: i) one of metal ions of the alkali metal, alkaline earth metal, and rare earth metal described above and ii) a ligand bound to the metal ion, e.g., hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, cyclopentadiene, or any combination thereof.

The electron injection layer may comprise (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In some embodiments, the electron injection layer may further comprise an organic material (e.g., a compound represented by Formula 601).

In some embodiments, the electron injection layer may comprise (e.g., consist of) i) an alkali metal-containing compound (e.g., alkali metal halide), or ii) a) an alkali metal-containing compound (e.g., alkali metal halide); and b) an alkali metal, an alkaline earth metal, a rare earth metal, or any combination thereof. In some embodiments, the electron injection layer may be a KI:Yb co-deposition layer, a RbI:Yb co-deposition layer, and/or the like.

When the electron injection layer further comprises an organic material, the alkali metal, the alkaline earth metal, the rare earth metal, the alkali metal-containing compound, the alkaline earth metal-containing compound, the rare earth metal-containing compound, the alkali metal complex, the alkaline earth metal complex, the rare earth metal complex, or any combination thereof may be homogeneously or non-homogeneously dispersed in a matrix comprising the organic material.

The thickness of the electron injection layer may be in a range of about 1 Å to about 100 Å, and in some embodiments, about 3 Å to about 90 Å. When the thickness of the electron injection layer is within any of these ranges, excellent (or improved) electron injection characteristics may be obtained without a substantial increase in driving voltage.

**Second electrode 150**

The second electrode 150 may be on the interlayer 130. In one or more embodiments, the second electrode 150 may be a cathode, that is an electron injection electrode. In this embodiment, a material for forming the second electrode 150 may be a material having a low work function, for example, a metal, an alloy, an electrically conductive compound, or any combination thereof.

The second electrode 150 may comprise lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a semi-transmissive electrode, or a reflective electrode.

The second electrode 150 may have a single-layered structure, or a multi-layered structure comprising two or more layers.

**Capping layer**

A first capping layer may be located outside the first electrode 110, and/or a second capping layer may be located outside the second electrode 150. In some embodiments, the light-emitting device 10 may have a structure in which the first capping layer, the first electrode 110, the interlayer 130, and the second electrode 150 are sequentially stacked in this stated order, a structure in which the first electrode 110, the interlayer 130, the second electrode 150, and the second capping layer are sequentially stacked in this stated order, or a structure in which the first capping layer, the first electrode 110, the interlayer 130, the second electrode 150, and the second capping layer are sequentially stacked in this stated order.

In the light-emitting device 10, light emitted from the emission layer in the interlayer 130 may pass through the first electrode 110 (which may be a semi-transmissive electrode or a transmissive electrode) and through the first capping layer to the outside. In the light-emitting device 10, light emitted from the emission layer in the interlayer 130 may pass through the second electrode 150 (which may be a semi-transmissive electrode or a transmissive electrode) and through the second capping layer to the outside.

The first capping layer and the second capping layer may improve the external luminescence efficiency based on the principle of constructive interference. Accordingly, the optical extraction efficiency of the light-emitting device 10 may be increased, thus improving luminescence efficiency of the light-emitting device 10.

The first capping layer and the second capping layer may each comprise a material having a refractive index of 1.6 or higher (at 589 nm).

The first capping layer and the second capping layer may each independently be a capping layer comprising an organic material, an inorganic capping layer comprising an inorganic material, or a composite capping layer comprising an organic material and an inorganic material.

At least one of the first capping layer and the second capping layer may each independently comprise one or more selected from carbocyclic compounds, heterocyclic compounds, amine group-containing compounds, porphine derivatives, phthalocyanine derivatives, naphthalocyanine derivatives, alkali metal complexes, alkaline earth metal complexes, and any combinations thereof. The carbocyclic compound, the heterocyclic compound, and the amine group-containing compound may optionally be substituted with a substituent containing O, N, S, Se, Si, F, Cl, Br, I, or any combination thereof. In some embodiments, at least one of the first capping layer and the second capping layer may each independently comprise an amine group-containing compound.

In some embodiments, at least one of the first capping layer and the second capping layer may each independently comprise the compound represented by Formula 201, the compound represented by Formula 202, or any combination thereof.

In one or more embodiments, at least one of the first capping layer and the second capping layer may each independently comprise one of Compounds HT28 to HT33, one of Compounds CP1 to CP6, β-NPB, or any combination thereof:

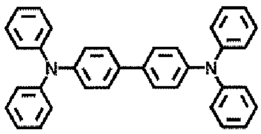

CP1

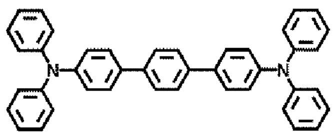

CP2

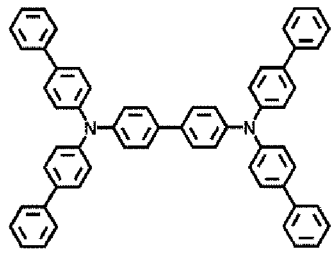

CP3

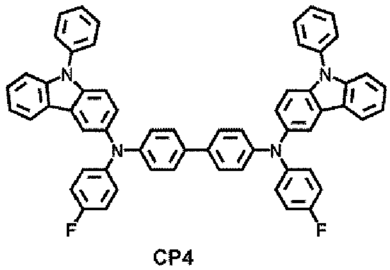

CP4

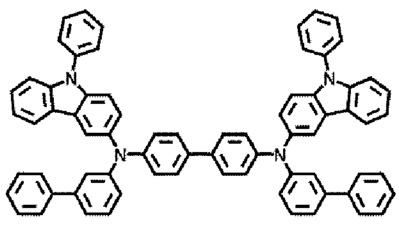

CP5

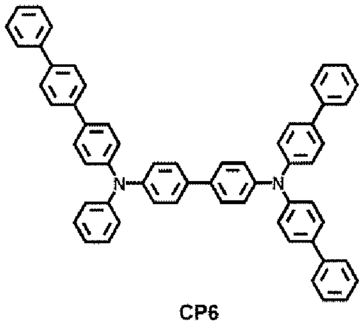

CP6

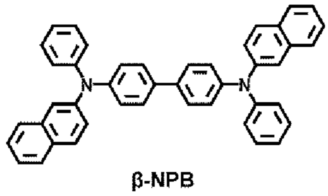

β-NPB

.

**Electronic apparatus**

The light-emitting device may be comprised in various suitable electronic apparatuses. In some embodiments, an electronic apparatus comprising the light-emitting device may be an emission apparatus or an authentication apparatus.

The electronic apparatus (e.g., an emission apparatus) may further comprise, in addition to the light-emitting device, i) a color filter, ii) a color-conversion layer, or iii) a color filter and a color-conversion layer. The color filter and/or the color-conversion layer may be disposed on at least one traveling direction of light emitted from the light-emitting device. For example, light emitted from the light-emitting device may be blue light or white light. The light-emitting device may be understood by referring to the description thereof provided herein. In some embodiments, the color-conversion layer may comprise quantum dots.

The electronic apparatus may comprise a first substrate. The first substrate may comprise a plurality of sub-pixel areas, the color filter may comprise a plurality of color filter areas respectively corresponding to the plurality of sub-pixel areas, and the color-conversion layer may comprise a plurality of color-conversion areas respectively corresponding to the plurality of sub-pixel areas.

A pixel defining film may be located between the plurality of sub-pixel areas to define each sub-pixel area.

The color filter may further comprise a plurality of color filter areas and light-blocking patterns between the plurality of color filter areas, and the color-conversion layer may further comprise a plurality of color-conversion areas and light-blocking patterns between the plurality of color-conversion areas.

The plurality of color filter areas (and/or a plurality of color-conversion areas) may comprise: a first area to emit first color light; a second area to emit second color light; and/or a third area to emit third color light, and the first color light, the second color light, and/or the third color light may have different maximum emission wavelengths. In some embodiments, the first color light may be red light, the second color light may be green light, and the third color light may be blue light. In some embodiments, the plurality of color filter areas (and/or the plurality of color-conversion areas) may each comprise quantum dots. In some embodiments, the first area may comprise red quantum dots, the second area may comprise green quantum dots, and the third area may not comprise a quantum dot. The quantum dot may be understood by referring to the description of the quantum dot provided herein. The first area, the second area, and/or the third area may each further comprise an emitter.

In some embodiments, the light-emitting device may emit first light, the first area may absorb the first light to emit 1-1 color light, the second area may absorb the first light to emit 2-1 color light, and the third area may absorb the first light to emit 3-1 color light. In this embodiment, the 1-1 color light, the 2-1 color light, and the 3-1 color light may each have a different maximum emission wavelength. In some embodiments, the first light may be blue light, the 1-1 color light may be red light, the 2-1 color light may be green light, and the 3-1 color light may be blue light.

The electronic apparatus may further comprise a thin-film transistor, in addition to the light-emitting device. The thin-film transistor may comprise a source electrode, a drain electrode, and an active layer, wherein one of the source electrode or the drain electrode may be electrically connected to one of the first electrode or the second electrode of the light-emitting device.

The thin-film transistor may further comprise a gate electrode, a gate insulating film, and/or the like.

The active layer may comprise a crystalline silicon, an amorphous silicon, an organic semiconductor, and/or an oxide semiconductor.

The electronic apparatus may further comprise an encapsulation unit for sealing the light-emitting device. The encapsulation unit may be located between the color filter and/or the color-conversion layer and the light-emitting device. The encapsulation unit may allow light to pass to the outside from the light-emitting device and may prevent or reduce the permeation of the air and moisture into the light-emitting device at the same time. The encapsulation unit may be a sealing substrate comprising a transparent glass and/or a plastic substrate. The encapsulation unit may be a thin-film encapsulating layer comprising at least one of an organic layer or an inorganic layer. When the encapsulation unit is a

thin film encapsulating layer, the electronic apparatus may be flexible.

In addition to the color filter and/or the color-conversion layer, one or more functional layers may be disposed on the encapsulation unit, depending on the use of an electronic apparatus. Examples of the functional layer may comprise a touch screen layer, a polarization layer, and the like. The touch screen layer may be a resistive touch screen layer, a capacitive touch screen layer, or an infrared beam touch screen layer. The authentication apparatus may be, for example, a biometric authentication apparatus that identifies an individual according biometric information (e.g., a fingertip, a pupil, and/or the like).

The authentication apparatus may further comprise a biometric information collecting unit, in addition to the light-emitting device described above.

The electronic apparatus may be applicable to various suitable displays, an optical source, lighting, a personal computer (e.g., a mobile personal computer), a cellphone, a digital camera, an electronic note, an electronic dictionary, an electronic game console, a medical device (e.g., an electronic thermometer, a blood pressure meter, a glucometer, a pulse measuring device, a pulse wave measuring device, an electrocardiograph recorder, an ultrasonic diagnosis device, an endoscope display device), a fish finder, various measurement devices, gauges (e.g., gauges of an automobile, an airplane, a ship), a projector, and/or the like.

**Descriptions of FIGS. 2 and 3**

FIG. 2 is a schematic cross-sectional view of a light-emitting apparatus according to one or more embodiments.

An emission apparatus in FIG. 2 may comprise a substrate 100, a thin-film transistor, a light-emitting device, and an encapsulation unit 300 sealing the light-emitting device.

The substrate 100 may be a flexible substrate, a glass substrate, or a metal substrate. A buffer layer 210 may be on the substrate 100. The buffer layer 210 may prevent or reduce penetration of impurities through the substrate 100, and may provide a flat surface on the substrate 100.

A thin-film transistor may be on the buffer layer 210. The thin-film transistor may comprise an active layer 220, a gate electrode 240, a source electrode 260, and a drain electrode 270.

The active layer 220 may comprise an inorganic semiconductor (such as silicon and/or polysilicon), an organic semiconductor, or an oxide semiconductor, and may comprise a source area, a drain area and a channel area.

A gate insulating film 230 for insulating the active layer 220 and the gate electrode 240 may be on the active layer 220, and the gate electrode 240 may be on the gate insulating film 230.

An interlayer insulating film 250 may be on the gate electrode 240. The interlayer insulating film 250 may be between the gate electrode 240 and the source electrode 260, and between the gate electrode 240 and the drain electrode 270 to provide insulation therebetween.

The source electrode 260 and the drain electrode 270 may be on the interlayer insulating film 250. The interlayer insulating film 250 and the gate insulating film 230 may be formed to expose the source area and the drain area of the active layer 220, and the source electrode 260 and the drain electrode 270 may be adjacent to the exposed source area and the exposed drain area of the active layer 220.

Such a thin-film transistor may be electrically connected to a light-emitting device to drive the light-emitting device, and may be protected by a passivation layer 280. The passivation layer 280 may comprise an inorganic insulating film, an organic insulating film, or a combination thereof. A light-emitting device may be on the passivation layer 280. The light-emitting device may comprise a first electrode 110, an interlayer 130, and a second electrode 150.

The first electrode 110 may be on the passivation layer 280. The passivation layer 280 may not fully cover the drain electrode 270, and may expose a specific (or set) area of the drain electrode 270, and the first electrode 110 may be disposed to connect to (e.g., to contact) the exposed area of the drain electrode 270.

A pixel-defining film 290 may be on the first electrode 110. The pixel-defining film 290 may expose a specific (or set) area of the first electrode 110, and the interlayer 130 may be formed in the exposed area. The pixel-defining film 290 may be a polyimide or polyacryl organic film. In one or more embodiments, some of the upper layers of the interlayer 130 may extend to the upper portion of the pixel-defining film 290 and may be disposed in the form of a common layer.

The second electrode 150 may be on the interlayer 130, and a capping layer 170 may be additionally formed on the second electrode 150. The capping layer 170 may be formed to cover the second electrode 150.

The encapsulation unit 300 may be on the capping layer 170. The encapsulation unit 300 may be on the light-emitting device to protect a light-emitting device from moisture and/or oxygen. The encapsulation unit 300 may comprise: an inorganic film comprising silicon nitride ($SiN_x$), silicon oxide ($SiO_x$), indium tin oxide, indium zinc oxide, or any combination thereof; an organic film comprising polyethylene terephthalate, polyethylene naphthalate, polycarbonate, polyimide, polyethylene sulfonate, polyoxy methylene, polyarylate, hexamethyl disiloxane, an acrylic resin (e.g., polymethyl methacrylate, polyacrylic acid, and/or the like), an epoxy resin (e.g., aliphatic glycidyl ether (AGE) and/or the like), or any combination thereof; or a combination of the inorganic film and the organic film.

FIG. 3 is a schematic cross-sectional view of another light-emitting apparatus according to one or more embodiments.

The emission apparatus shown in FIG. 3 may be substantially identical to the emission apparatus shown in FIG. 2, except that a light-shielding pattern 500 and a functional area 400 are additionally located on the encapsulation unit 300. The functional area 400 may be i) a color filter area, ii) a color-conversion area, or iii) a combination of a color filter area and a color-conversion area. In some embodiments, the light-emitting device shown in FIG. 3 comprised in the emission apparatus may be a tandem light-emitting device.

**Manufacturing method**

The layers constituting the hole transport region, the emission layer, and the layers constituting the electron transport region may be formed in a specific region by using one or more suitable methods selected from vacuum deposition, spin coating, casting, Langmuir-Blodgett (LB) deposition, ink-jet printing, laser printing, and laser-induced thermal imaging.

When the layers constituting the hole transport region, the emission layer, and the layers constituting the electron transport region are each independently formed by vacuum deposition, the vacuum deposition may be performed at a deposition temperature in a range of about 100 °C to about 500 °C at a vacuum degree in a range of about $10^{-8}$ torr to about $10^{-3}$ torr, and at a deposition rate in a range of about 0.01 Angstroms per second (Å/sec) to about 100 Å/sec, depending on the material to be comprised in each layer and the structure of each layer to be formed.

**General definitions of terms**

The term "$C_3$-$C_{60}$ carbocyclic group" as used herein refers to a cyclic group consisting of carbon atoms only as ring-forming atoms, and having 3 to 60 ring-forming carbon atoms. The term "$C_1$-$C_{60}$ heterocyclic group" as used herein refers to a cyclic group having 1 to 60 ring-forming carbon atoms, in addition to a heteroatom other than a carbon atom. The $C_3$-$C_{60}$ carbocyclic group and the $C_1$-$C_{60}$ heterocyclic group may each independently be a monocyclic group consisting of one ring or a polycyclic group in which at least two rings are condensed. For example, the total number of ring-forming atoms in the $C_1$-$C_{60}$ heterocyclic group may be in a range of 1 to 60.

The term "cyclic group" as used herein may comprise the $C_3$-$C_{60}$ carbocyclic group and the $C_1$-$C_{60}$ heterocyclic group.

The term "π electron-rich $C_3$-$C_{60}$ cyclic group" refers to a cyclic group having 3 to 60 carbon atoms and not comprising *-N=*' as a ring-forming moiety. The term "π electron-deficient nitrogen-containing $C_1$-$C_{60}$ cyclic group" as used herein refers to a heterocyclic group having 1 to 60 carbon atoms and *-N=*' as a ring-forming moiety.

In some embodiments,

the $C_3$-$C_{60}$ carbocyclic group may be i) a T1 group or ii) a group in which at least two T1 groups are condensed (for example, the $C_3$-$C_{60}$ carbocyclic group may be a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),

the $C_1$-$C_{60}$ heterocyclic group may be i) a T2 group, ii) a group in which at least two T2 groups are condensed, or iii) a group in which at least one T2 group is condensed with at least one T1 group (for example, the $C_1$-$C_{60}$ heterocyclic group may be a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonapthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an

imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),

the π electron-rich $C_3$-$C_{60}$ cyclic group may be i) a T1 group, ii) a condensed group in which at least two T1 groups are condensed, iii) a T3 group, iv) a condensed group in which at least two T3 groups are condensed, or v) a condensed group in which at least one T3 group is condensed with at least one T1 group (for example, the π electron-rich $C_3$-$C_{60}$ cyclic group may be a $C_3$-$C_{60}$ carbocyclic group, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonapthothiophene group, a benzonaphthosilole group, a benzofurodibenzofuran group, a benzofurodibenzothiophene group, a benzothienodibenzothiophene group, and/or the like), and

the π electron-deficient nitrogen-containing $C_1$-$C_{60}$ cyclic group may be i) a T4 group, ii) a group in which at least twos T4 groups are condensed, iii) a group in which at least one T4 group is condensed with at least one T1 group, iv) a group in which at least one T4 group is condensed with at least one T3 group, or v) a group in which at least one T4 group, at least one T1 group, and at least one T3 group are condensed (for example, he π electron-deficient nitrogen-containing $C_1$-$C_{60}$ cyclic group may be a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),

wherein the T1 group may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,

the T2 group may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group,

the T3 group may be a furan group, a thiophene group, a 1H-pyrrole group, a silole group, or a borole group, and

the T4 group may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The term "cyclic group", "$C_3$-$C_{60}$ carbocyclic group", "$C_1$-$C_{60}$ heterocyclic group", "π electron-rich $C_3$-$C_{60}$ cyclic group", or "π electron-deficient nitrogen-containing $C_1$-$C_{60}$ cyclic group" as used herein may be a group condensed with any suitable cyclic group, a monovalent group, or a polyvalent group (e.g., a divalent group, a trivalent group, a quadvalent group, and/or the like), depending on the structure of the formula to which the term is applied. For example, a "benzene group" may be a benzo group, a phenyl group, a phenylene group, and/or the like, and this may be understood by one of ordinary skill in the art, depending on the structure of the formula comprising the "benzene group".

Examples of the monovalent $C_3$-$C_{60}$ carbocyclic group and the monovalent $C_1$-$C_{60}$ heterocyclic group may comprise a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group. Examples of the divalent $C_3$-$C_{60}$ carbocyclic group and the divalent $C_1$-$C_{60}$ heterocyclic group may comprise a $C_3$-$C_{10}$ cycloalkylene group, a $C_1$-$C_{10}$ heterocycloalkylene group, a $C_3$-$C_{10}$ cycloalkenylene group, a $C_1$-$C_{10}$ heterocycloalkenylene group, a $C_6$-$C_{60}$ arylene group, a $C_1$-$C_{60}$ heteroarylene group, a divalent non-aromatic condensed polycyclic group, and a divalent non-aromatic condensed heteropolycyclic group.

The term "$C_1$-$C_{60}$ alkyl group" as used herein refers to a linear or branched aliphatic hydrocarbon monovalent

group having 1 to 60 carbon atoms, and non-limiting examples thereof comprise a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, and a tert-decyl group. The term "$C_1$-$C_{60}$ alkylene group" as used herein refers to a divalent group having the same structure as the $C_1$-$C_{60}$ alkyl group.

The term "$C_2$-$C_{60}$ alkenyl group" as used herein refers to a hydrocarbon group having at least one carbon-carbon double bond in the middle and/or at either terminus of the $C_2$-$C_{60}$ alkyl group. Non-limiting examples thereof comprise an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a monovalent hydrocarbon group having at least one carbon-carbon triple bond in the middle and/or at either terminus of the $C_2$-$C_{60}$ alkyl group. Non-limiting examples thereof comprise an ethynyl group and a propynyl group. The term "$C_2$-$C_{60}$ alkynylene group" as used herein refers to a divalent group having the same structure as the $C_2$-$C_{60}$ alkynyl group.

The term "$C_1$-$C_{60}$ alkoxy group" as used herein refers to a monovalent group represented by $-OA_{101}$ (wherein $A_{101}$ is a $C_1$-$C_1$ alkyl group). Non-limiting examples thereof comprise a methoxy group, an ethoxy group, and an isopropyloxy group.

The term "$C_3$-$C_{10}$ cycloalkyl group" as used herein refers to a monovalent saturated hydrocarbon monocyclic group comprising 3 to 10 carbon atoms. Non-limiting examples of the $C_3$-$C_{10}$ cycloalkyl group as used herein comprise a cyclopropyl group, a cyclobutyl group, a cyclopentyl group, a cyclohexyl group, a cycloheptyl group, a cyclooctyl group, an adamantanyl group, a norbornanyl (bicyclo[2.2.1]heptyl) group, a bicyclo[1.1.1]pentyl group, a bicyclo[2.1.1]hexyl group, and/or a bicyclo[2.2.2]octyl group). The term "$C_3$-$C_{10}$ cycloalkylene group" as used herein refers to a divalent group having the same structure as the $C_3$-$C_{10}$ cycloalkyl group.

The term "$C_1$-$C_{10}$ heterocycloalkyl group" as used herein refers to a monovalent cyclic group comprising at least one heteroatom, other than carbon atoms, as a ring-forming atom, and having 1 to 10 carbon atoms. Non-limiting examples thereof comprise a 1 ,2,3,4-oxatriazolidinyl group, a tetrahydrofuranyl group, and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent cyclic group that has 3 to 10 carbon atoms and at least one carbon-carbon double bond in its ring, and is not aromatic. Non-limiting examples thereof comprise a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent cyclic group comprising at least one heteroatom, other than carbon atoms, as a ring-forming atom, 1 to 10 carbon atoms, and at least one double bond in its ring. Non-limiting examples of the $C_1$-$C_{10}$ heterocycloalkenyl group comprise a 4,5-dihydro-1 ,2,3,4-oxatriazolyl group, a 2,3-dihydrofuranyl group, and a 2,3-dihydrothiophenyl group. The term "$C_1$-$C_{10}$ heterocycloalkylene group" as used herein refers to a divalent group having the same structure as the $C_1$-$C_{10}$ heterocycloalkyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 6 carbon atoms. The term "$C_6$-$C_{60}$ arylene group" as used herein refers to a divalent group having the same structure as the $C_6$-$C_{60}$ aryl group. Non-limiting examples of the $C_6$-$C_{60}$ aryl group comprise a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the $C_6$-$C_{60}$ aryl group and the $C_6$-$C_{60}$ arylene group each independently comprise two or more rings, the respective rings may be fused.

The term "$C_1$-$C_{60}$ heteroaryl group" as used herein refers to a monovalent group having a heterocyclic aromatic system further comprising at least one heteroatom, other than carbon atoms, as a ring-forming atom, and 1 to 60 carbon atoms. The term "$C_1$-$C_{60}$ heteroarylene group" as used herein refers to a divalent group having the same structure as the $C_1$-$C_{60}$ heteroaryl group . Non-limiting examples of the $C_1$-$C_{60}$ heteroaryl group comprise a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the $C_1$-$C_{60}$ heteroaryl group and the $C_1$-$C_{60}$ heteroarylene group each independently comprise two or more rings, the respective rings may be fused.

The term "monovalent non-aromatic condensed polycyclic group" as used herein refers to a monovalent group that has two or more rings condensed and only carbon atoms as ring forming atoms (e.g., 8 to 60 carbon atoms), wherein the entire molecular structure (as a whole) is non-aromatic. Non-limiting examples of the monovalent non-aromatic condensed polycyclic group comprise an indenyl group, a fluorenyl group, a spiro-bifluorenyl group, a benzofluorenyl group, an indenophenanthrenyl group, and an indenoanthracenyl group. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group that has two or more condensed rings and at least one heteroatom, other than carbon atoms (e.g., 1 to 60 carbon atoms), as a ring-forming atom, wherein the entire molecular structure (as a whole) is non-aromatic. Non-limiting examples of the monovalent non-aromatic condensed heteropolycyclic group comprise a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzooxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group" as used herein refers to a divalent group having substantially the same structure as the monovalent non-aromatic condensed heteropolycyclic group.

The term "$C_6$-$C_{60}$ aryloxy group" as used herein refers to a monovalent group represented by $-OA_{102}$ (wherein $A_{102}$ is the $C_6$-$C_{60}$ aryl group). The term "$C_6$-$C_{60}$ arylthio group" as used herein refers to a monovalent group represented by $-SA_{103}$ (wherein $A_{103}$ is the $C_6$-$C_{60}$ aryl group).

The term "$R_{10a}$" as used herein may be:

deuterium (-D), -F, -Cl, -Br, -I, a hydroxyl group, a cyano group, or a nitro group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each independently unsubstituted or substituted with deuterium, -F, - Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, - $Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, - $P(=O)(Q_{11})(Q_{12})$, or any combination thereof;

a $C_3$-$C_{60}$ carbocyclic group, a $C_1$-$C_{60}$ heterocyclic group, a $C_6$-$C_{60}$ aryloxy group, or a $C_6$-$C_{60}$ arylthio group, each independently unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, $-Si(Q_{21})(Q_{22})(Q_{23})$, $-N(Q_{21})(Q_{22})$, $-B(Q_{21})(Q_{22})$, $-C(=O)(Q_{21})$, $-S(=O)_2(Q_{21})$, $-P(=O)(Q_{21})(Q_{22})$, or any combination thereof; or

$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, or - $P(-O)(Q_{31})(Q_{32})$.

$Q_1$ to $Q_3$, $Q_{11}$ to $Q_{13}$, $Q_{21}$ to $Q_{23}$, and $Q_{31}$ to $Q_{33}$ may each independently be hydrogen; deuterium; -F; -Cl; -Br; -I; a hydroxyl group; a cyano group; a nitro group; a $C_1$-$C_{60}$ alkyl group; a $C_2$-$C_{60}$ alkenyl group; a $C_2$-$C_{60}$ alkynyl group; a $C_1$-$C_{60}$ alkoxy group; or a $C_3$-$C_{60}$ carbocyclic group or a $C_1$-$C_{60}$ heterocyclic group, where, when present, each $C_1$-$C_{60}$ alkyl group; $C_2$-$C_{60}$ alkenyl group; $C_2$-$C_{60}$ alkynyl group; $C_1$-$C_{60}$ alkoxy group; $C_3$-$C_{60}$ carbocyclic group or a $C_1$-$C_{60}$ heterocyclic group is independently optionally substituted with deuterium, -F, a cyano group, a $C_1$-$C_{60}$ alkyl group, a $C_1$-$C_{60}$ alkoxy group, a phenyl group, a biphenyl group, a pyridinyl group, a pyrimidinyl group, a pyridazinyl group, a pyrazinyl group, a triazinyl group, or any combination thereof.

The term "heteroatom" as used herein refers to any atom other than a carbon atom. Non-limiting examples of the heteroatom may comprise O, S, N, P, Si, B, Ge, Se, or any combination thereof.

"Ph" used herein represents a phenyl group, "Me" used herein represents a methyl group, "Et" used herein represents an ethyl group, "tert-Bu" or "$Bu^t$" used herein represents a tert-butyl group, "OMe" used herein represents a methoxy group, and "D" as used herein represents deuterium.

The term "biphenyl group" as used herein refers to a phenyl group substituted with at least one phenyl group. The "biphenyl group" belongs to "a substituted phenyl group" having a "$C_6$-$C_{60}$ aryl group" as a substituent.

The term "terphenyl group" as used herein refers to a phenyl group substituted with at least one biphenyl group. The "terphenyl group" belongs to "a substituted phenyl group" having a "$C_6$-$C_{60}$ aryl group substituted with a $C_6$-$C_{60}$

aryl group" as a substituent.

The symbols *, *' and *" as used herein, unless defined otherwise, refer to a binding site to an adjacent atom in a corresponding formula.

Certain groups are specified herein as being substituted or unsubstituted (for example, "substituted with at least one of..."). Unless otherwise specified, when a group is substituted it is typically substituted with 1, 2, 3 or 4 substituents. For example, when a group is substituted it may substituted with 1, 2 or 3 substituents; 1 or 2 substituents; or 1 substituent. Groups which are not specified as being substituted or unsubstituted are typically unsubstituted.

Hereinafter, compounds and a light-emitting device according to one or more embodiments will be described in more detail with reference to Synthesis Examples and Examples. The wording "B was used instead of A" used in describing Synthesis Examples means that an amount of B used was identical to an amount of A used in terms of molar equivalents.

**Examples**

**Synthesis Example 1 (Synthesis of Compound D6)**

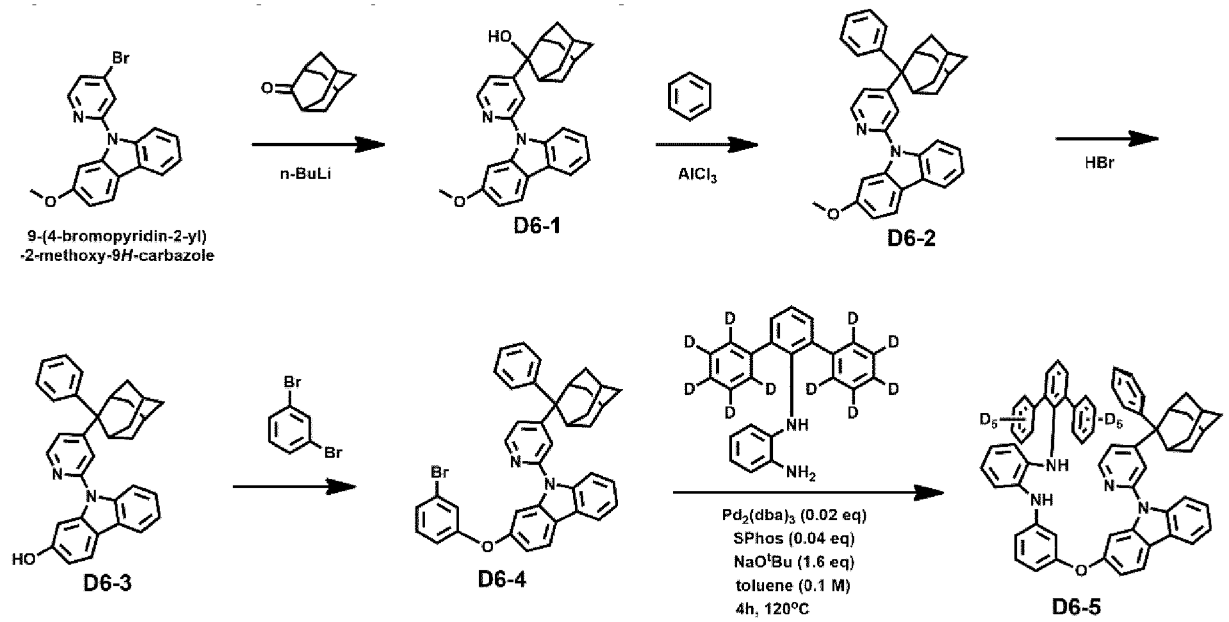

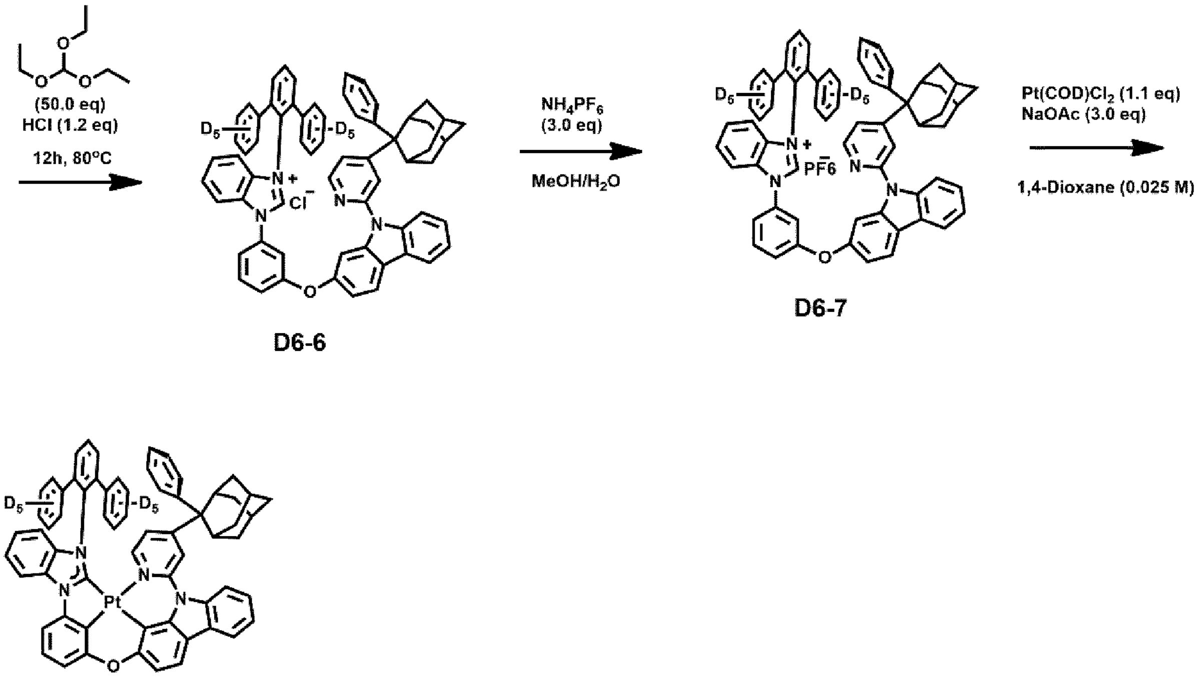


D6-6

D6-7

D6

### Synthesis of Intermediate D6-1

25.0 g (70.8 mmol) of 9-(4-bromopyridin-2-yl)-2-methoxy-9H-carbazole was mixed with 700 mL of tetrahydrofuran, the temperature was lowered to -78 °C, and 39 mL of n-BuLi solution (2.0 molar (M) in hexane) was added thereto, follwed by stirring for 1 hour at the same temperature. Then, 21.3 g (141.6 mmol) of 2-adamantanone was added thereto, and the temperature was raised to room temperature, followed by stirring for 24 hours. Once the reaction was complete, a NaHCOs solution was added thereto, and an organic layer was extracted therefrom using ethyl acetate, and the extracted organic layer was washed with saturated NaCl aqueous solution, followed by drying using sodium sulfate. The resulting product was subjected to column chromatography to thereby obtain 22.3 g (52.5 mmol) of Intermediate D6-1.

### Synthesis of Intermediate D6-2

22.3 g (52.5 mmol) of Intermediate D6-1 and 21.0 g (157.5 mmol) of $AlCl_3$ were stirred for 24 hours at room temperature with excess benzene in a nitrogen atmosphere. Once the reaction was complete, a NaHCOs solution was added thereto for neutralization, and an organic layer was extracted therefrom using ethyl acetate, and the extracted organic layer was washed with saturated NaCl aqueous solution, followed by drying using sodium sulfate. The resulting product was subjected to column chromatography to thereby obtain 20.0 g (41.2 mmol) of Intermediate D6-2.

### Synthesis of Intermediate D6-3

20.2 g (41.7 mmol) of Intermediate D6-2 was suspended in an excess hydrobromic acid solution, followed by raising the temperature to 110 °C and stirring for 24 hours. Once the reaction was complete, the temperature was lowered to room temperature, and a proper amount of NaHCOs was added thereto for neutralization. Then, 300 mL of distilled water was added thereto, and an organic layer was extracted therefrom using ethyl acetate, and the extracted organic layer was washed using saturated sodium chloride aqueous solution, followed by drying using $MgSO_4$. The resulting product was subjected to column chromatography to thereby obtain 18.9 g (39.5 mmol) of Intermediate D6-3.

### Synthesis of Intermediate D6-4

15.4 g (32.7mmol) of Intermediate D6-3, 8.2 g (34.6 mmol) of 1,3-dibromobenzene, 13.9 g (65.4 mmol, 2.0 eq.) of $K_3PO_4$, 0.6 g (3.3 mmol, 0.1 eq.) of CuI, and 1.3 g (3.3 mmol) of di([1,1'-biphenyl]-2-yl)oxalamide were added to a reaction vessel, and the mixture was suspended in 80 mL of dimethyl sulfoxide, followed by raising the temperature to 160 °C and stirring for 12 hours. Once the reaction was complete, the temperature was lowered to room temperature,

and 300 mL of distilled water was added thereto. Then, an organic layer was extracted therefrom using ethyl acetate, and the extracted organic layer was washed with saturated NaCl aqueous solution, followed by drying using sodium sulfate. The resulting product was subjected to column chromatography to thereby obtain 16.5 g (26.3 mmol) of Intermediate D6-4.

**Synthesis of Intermediate D6-5**

23.8 g (38.1 mmol) of Intermediate D6-4, 15.8 g (45.7 mmol) of *N*[1]-([1,1':3',1"-terphenyl]-2'-yl-2,2",3,3",4,4",5,5",6,6"-$d_{10}$)benzene-1,2-diamine, 0.4 g (0.76 mmol, 0.02 eq.) of $Pd_2(dba)_3$, 0.6 g (1.52 mmol, 0.04 eq.) of SPhos, and 4.8 g (49.5 mmol, 1.6 eq.) of NaO*t*Bu were added to a reaction vessel, and the mixture was suspended in 100 mL of toluene (0.1 M), followed by raising the temperature to 120 °C and stirring for 4 hours. Once the reaction was complete, the temperature was lowered to room temperature, and 300 mL of distilled water was added thereto. Then, an organic layer was extracted therefrom using ethyl acetate, and the extracted organic layer was washed with saturated NaCl aqueous solution, followed by drying using sodium sulfate. The resulting product was subjected to column chromatography to thereby obtain 23.6 g (26.5 mmol) of Intermediate D6-5.

**Synthesis of Intermediate D6-6**

23.2 g (26.0 mmol) of Intermediate D6-5, 216 mL (1.3 mol, 50.0 eq.) of triethyl orthoformate, and 0.9 mL (31.2 mmol, 1.2 eq.) of HCl (37 %) were added to a reaction vessel, and the temperature was raised to 80 °C and stirred for 12 hours. Once the reaction was complete, the temperature was cooled to room temperature, and the resulting solid was filtered and washed using ether. Then, the washed solid was dried to thereby obtain 22.5 g (23.4 mmol) of Intermediate D6-6.

**Synthesis of Intermediate D6-7**

21.1 g (22.5 mmol) of Intermediate D6-6 and 11.0 g (67.5 mmol, 3.0 eq.) of $NH_4PF_6$ were added to a reaction vessel, and the mixture was suspended in a mixed solution of 100 mL of methyl alcohol and 50 mL of water (at a volumetric ratio of 2:1), followed by stirring at room temperature for 24 hours. Once the reaction was complete, the resulting solid was filtered and washed using ether. Then, the washed solid was dried to thereby obtain 26.0 g (16.8 mmol) of Intermediate D6-7.

**Synthesis of Compound D6**

16.5 g (15.8 mmol) of Intermediate D6-7, 6.2 g (16.7 mmol, 1.1 eq.) of dichloro(1 ,5-cyclooctadiene)platinum, and 3.9 g (47.4 mmol, 3.0 eq.) of NaOAc were suspended in 300 mL of 1,4-dioxane (0.025 M), and the temperature was raised to 110 °C, followed by stirrring for 72 hours. Once the reaction was complete, the temperature was cooled to room temperature, 250 mL of distilled water was added thereto, and an organic layer was extracted therefrom using ethyl acetate, and the extracted organic layer was washed using NaCl aqueous solution and dried using $MgSO_4$. The resulting product was subjected to column chromatography to thereby obtain 5.5 g (5.1 mmol) of Compound D6.

**Synthesis Example 2 (Synthesis of Compound D12)**

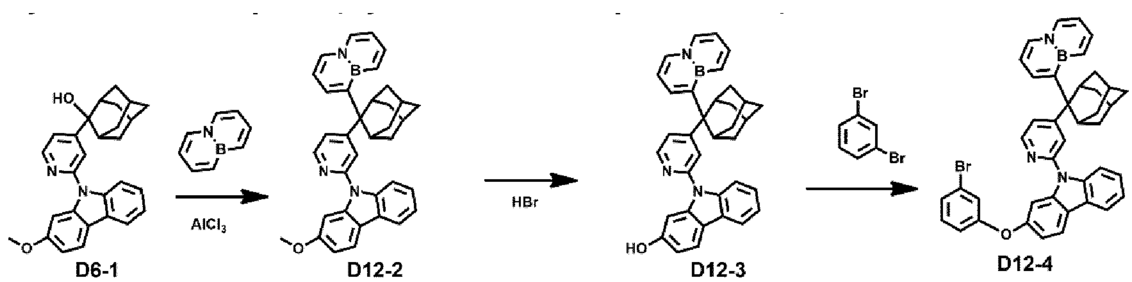

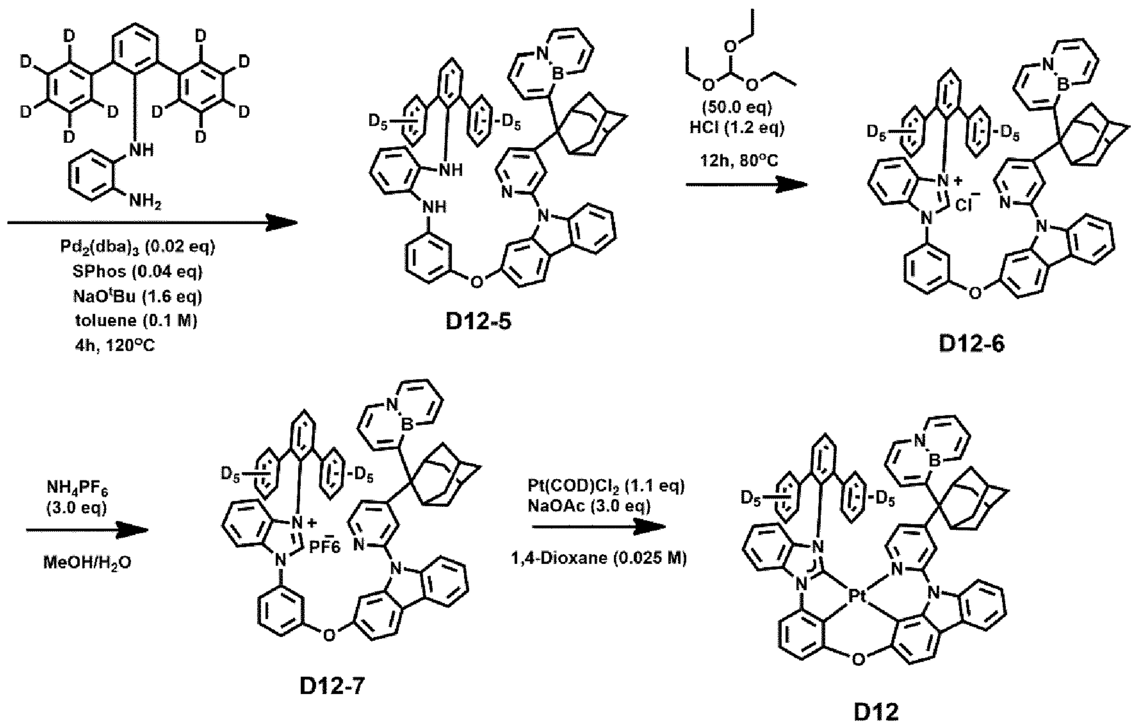


D12-5

D12-6

D12-7

D12

### Synthesis of Intermediate D12-2

22.3 g (52.5 mmol) of Intermediate D6-1, 21.0 g (157.5 mmol) of $AlCl_3$, and 4a,8a-azaboranaphthalene (1.0 eq.) were stirred for 24 hours at a temperature of 40 °C with excess dichloromethane in a nitrogen atmosphere. Once the reaction was complete, a NaHCOs solution was added thereto for neutralization, and an organic layer was extracted therefrom using ethyl acetate, and the extracted organic layer was washed with saturated NaCl aqueous solution, followed by drying using sodium sulfate. The resulting product was subjected to column chromatography to thereby obtain Intermediate D12-2.

### Synthesis of Intermediate D12-3

Intermediate D12-3 was obtained in substantially the same manner as in Synthesis of Intermediate D6-3 in Synthesis Example 1, except that Intermediate D12-2 was used instead of Intermediate D6-2.

### Synthesis of Intermediate D12-4

Intermediate D12-4 was obtained in substantially the same manner as in Synthesis of Intermediate D6-4 in Synthesis Example 1, except that Intermediate D12-3 was used instead of Intermediate D6-3.

### Synthesis of Intermediate D12-5

Intermediate D12-5 was obtained in substantially the same manner as in Synthesis of Intermediate D6-5 in Synthesis Example 1, except that Intermediate D12-4 was used instead of Intermediate D6-4.

### Synthesis of Intermediate D12-6

Intermediate D12-6 was obtained in substantially the same manner as in Synthesis of Intermediate D6-6 in Synthesis Example 1, except that Intermediate D12-5 was used instead of Intermediate D6-5.

### Synthesis of Intermediate D12-7

Intermediate D12-7 was obtained in substantially the same manner as in Synthesis of Intermediate D6-7 in Synthesis Example 1, except that Intermediate D12-6 was used instead of Intermediate D6-6.

**Synthesis of Compound D12**

5.60 g (4.90 mmol) of Compound D12 was obtained in substantially the same manner as in Synthesis of Compound D6 in Synthesis Example 1, except that Intermediate D12-7 was used instead of Intermediate D6-7.

**Synthesis Example 3 (Synthesis of Compound D27)**

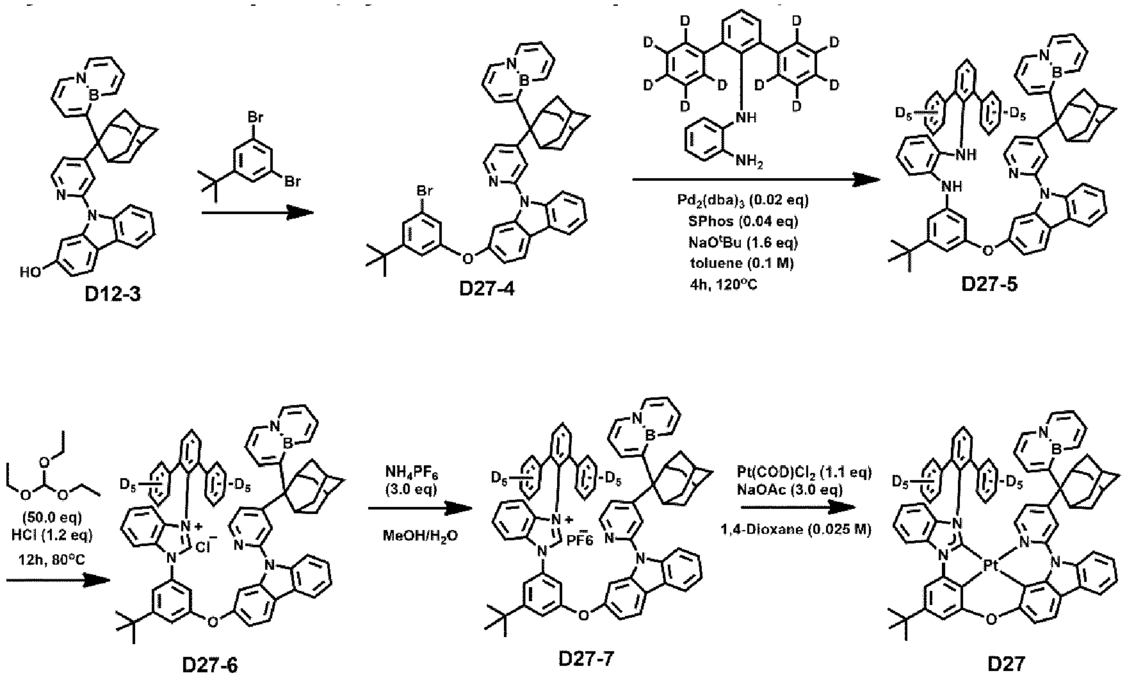


**Synthesis of Intermediate D27-4**

Intermediate D27-4 was synthesized in substantially the same manner as in Synthesis of Intermediate D12-4 in Synthesis Example 2, except that 1,3-dibromo-5-(tert-butyl)benzene was used instead of 1,3-dibromobenzene.

**Synthesis of Intermediate D27-5**

Intermediate D27-5 was obtained in substantially the same manner as in Synthesis of Intermediate D12-5 in Synthesis Example 2, except that Intermediate D27-4 was used instead of Intermediate D12-4.

**Synthesis of Intermediate D27-6**

Intermediate D27-6 was obtained in substantially the same manner as in Synthesis of Intermediate D12-6 in Synthesis Example 2, except that Intermediate D27-5 was used instead of Intermediate D12-5.

**Synthesis of Intermediate D27-7**

Intermediate D27-7 was obtained in substantially the same manner as in Synthesis of Intermediate D12-7 in Synthesis Example 2, except that Intermediate D27-6 was used instead of Intermediate D12-6.

**Synthesis of Compound D27**

5.88 g (4.90 mmol) of Compound D27 was obtained in substantially the same manner as in Synthesis of Compound D12 in Synthesis Example 2, except that Intermediate D27-7 was used instead of Intermediate D12-7.

**Synthesis Example 4 (Synthesis of Compound D81)**

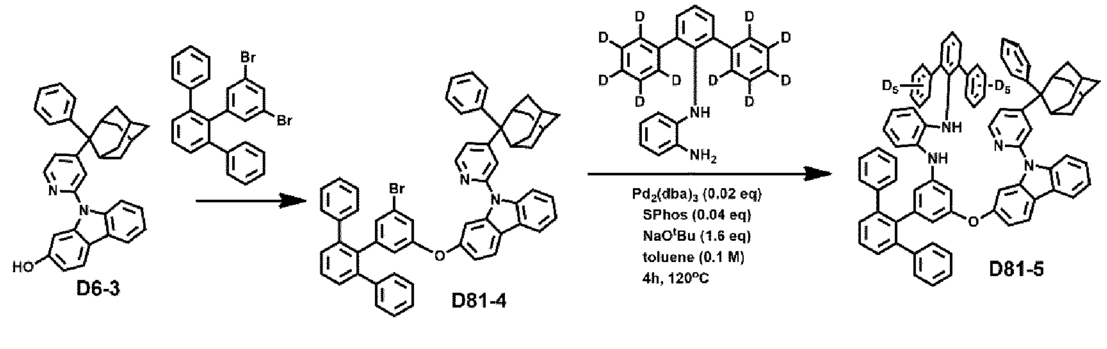


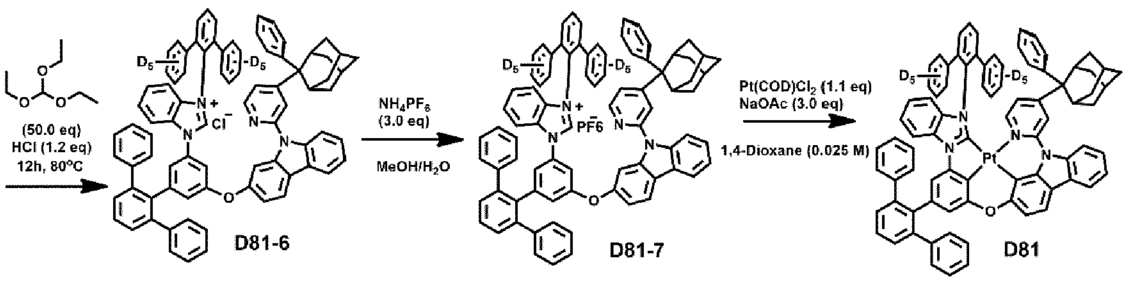


**Synthesis of Intermediate D81-4**

Intermediate D81-4 was synthesized in substantially the same manner as in Synthesis of Intermediate D6-4 in Synthesis Example 1, except that 3,5-dibromo-6'-phenyl-1,1':2',1"-terphenyl was used instead of 1,3-dibromobenzene.

**Synthesis of Intermediate D81-5**

Intermediate D81-5 was obtained in substantially the same manner as in Synthesis of Intermediate D6-5 in Synthesis Example 1, except that Intermediate D81-4 was used instead of Intermediate D6-4.

**Synthesis of Intermediate D81-6**

Intermediate D81-6 was obtained in substantially the same manner as in Synthesis of Intermediate D6-6 in Synthesis Example 1, except that Intermediate D81-5 was used instead of Intermediate D6-5.

**Synthesis of Intermediate D81-7**

Intermediate D81-7 was obtained in substantially the same manner as in Synthesis of Intermediate D6-7 in Synthesis Example 1, except that Intermediate D81-6 was used instead of Intermediate D6-6.

**Synthesis of Compound D81**

5.22 g (3.95 mmol) of Compound D81 was obtained in substantially the same manner as in Synthesis of Compound D6 in Synthesis Example 1, except that Intermediate D81-7 was used instead of Intermediate D6-7.

**Synthesis Example 5 (Synthesis of Compound D302)**

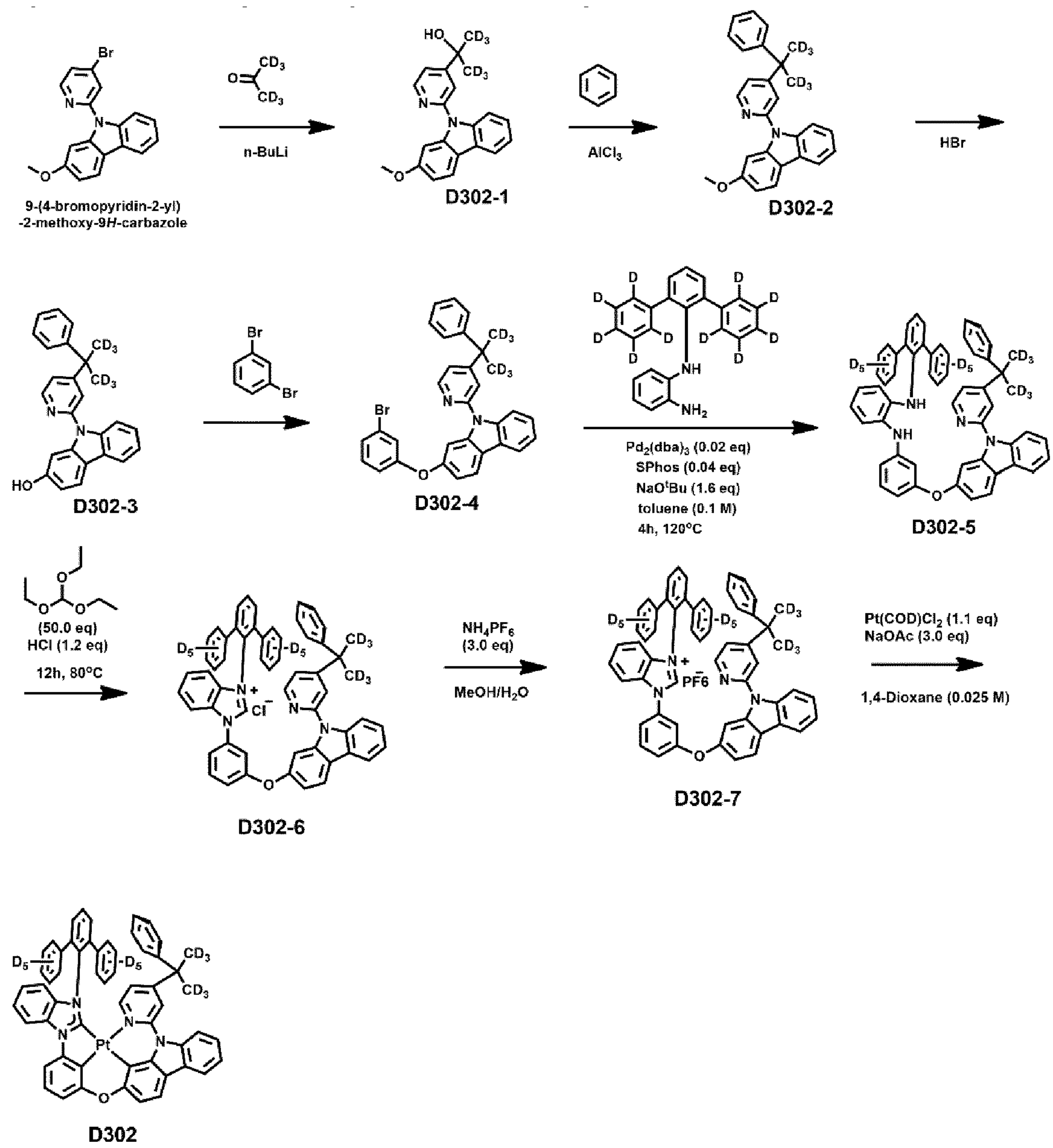


9-(4-bromopyridin-2-yl)-2-methoxy-9*H*-carbazole

D302-1

D302-2

D302-3

D302-4

D302-5

D302-6

D302-7

D302

## Synthesis of Intermediate D302-1

Intermediate D302-1 was synthesized in substantially the same manner as in Synthesis of Intermediate D6-1 in Synthesis Example 1, except that acetone-$d_6$ was used instead of 2-adamantanone.

## Synthesis of Intermediate D302-2

Intermediate D302-2 was obtained in substantially the same manner as in Synthesis of Intermediate D6-2 in Synthesis Example 1, except that Intermediate D302-1 was used instead of Intermediate D6-1.

## Synthesis of Intermediate D302-3

Intermediate D302-3 was obtained in substantially the same manner as in Synthesis of Intermediate D6-3 in Synthesis Example 1, except that Intermediate D302-2 was used instead of Intermediate D6-2.

## Synthesis of Intermediate D302-4

Intermediate D302-4 was obtained in substantially the same manner as in Synthesis of Intermediate D6-4 in

Synthesis Example 1, except that Intermediate D302-3 was used instead of Intermediate D6-3.

**Synthesis of Intermediate D302-5**

Intermediate D302-5 was obtained in substantially the same manner as in Synthesis of Intermediate D6-5 in Synthesis Example 1, except that Intermediate D302-4 was used instead of Intermediate D6-4.

**Synthesis of Intermediate D302-6**

Intermediate D302-6 was obtained in substantially the same manner as in Synthesis of Intermediate D6-6 in Synthesis Example 1, except that Intermediate D302-5 was used instead of Intermediate D6-5.

**Synthesis of Intermediate D302-7**

Intermediate D302-7 was obtained in substantially the same manner as in Synthesis of Intermediate D6-7 in Synthesis Example 1, except that Intermediate D302-6 was used instead of Intermediate D6-6.

**Synthesis of Compound D302**

5.73 g (5.69 mmol) of Compound D302 was obtained in substantially the same manner as in Synthesis of Compound D6 in Synthesis Example 1, except that Intermediate D302-7 was used instead of Intermediate D6-7.

Compounds synthesized in the Synthesis Examples 1 to 5 were identified by $^1$H nuclear magnetic resonance (NMR) and matrix-assisted laser desorption/ionization mass spectrometry time-of-flight mass spectroscopy (MALDI-TOF MS). The results thereof are shown in Table 1. Methods of synthesizing compounds other than the compounds synthesized in Synthesis Examples 1 to 5 may be easily understood by those skilled in the art by referring to the synthesis pathways and raw materials described above.

Table 1

| Compo und | $^1$H NMR ($CDCl_3$ , 500 MHz) | MALDI-TOF MS M$^+$] | |
|---|---|---|---|
| | | found | calc. |
| D6 | δ 8.87 (*d*, 1H, $^3J_{H-H}$ = 6.4 Hz), 8.10 (*d*, 1H, $^3J_{H-H}$ = 7.1 Hz), 8.04 (*s*, 1H), 7.96 (*d*, 1H, $^3J_{H-H}$ = 8.3 Hz), 7.92 (*d*, 1H, $^3J_{H-H}$ = 8.1 Hz), 7.76 (*d*, 1H, $^3J_{H-H}$ = 8.3 Hz), 7.56 (*td*, 1H, $^3J_{H-H}$ = 7.1 Hz, $^4J_{H-H}$ = 1.1 Hz), 7.46-7.43 (m, 6H), 7.29 (*d*, 1H, $^3J_{H-H}$ = 8.2 Hz), 7.23-7.20 (m 6H), 7.05-7.00 (m, 2H), 6.84 (*d*, 1H, $^3J_{H-H}$ = 8.0 Hz), 6.23 (*d*, 1H, $^3J_{H-H}$ = 5.0 Hz), 3.04 (m, 2H), 1.98-1.69 (m, 12H). | 1093.4 3 | 1093.4 1 |
| D12 | δ 8.88 (*d*, 1H, $^3J_{H-H}$ = 6.4 Hz), 8.10-8.08 (*m*, 2H), 8.02 (*s*, 1H), 7.96 (d, 1H, $^3J_{H-H}$ = 8.3 Hz), 7.94-7.92 (*m*, 2H) 7.83-7.77 (*m*, 2H), 7.76 (d, 1H, $^3J_{H-H}$ = 8.3 Hz), 7.56 (*td*, 1H, $^3J_{H-H}$ = 7.1 Hz, $^4J_{H-H}$ = 1.1 Hz), 7.46-7.43 (*m*, 3H), 7.29 (*d*, 1H, $^3J_{H-H}$ = 8.2 Hz), 7.23-7.20 (*m*, 5H), 7.05-7.00 (*m*, 2H), 6.84 (d, 1H, $^3J_{H-H}$ = 8.0 Hz), 6.83-6.81 (*m*, 2H), 6.23 (*d*, 1H, $^3J_{H-H}$ = 5.0 Hz), 3.05 (m, 2H), 1.98-1.69 (m, 12H). | 1144.4 7 | 1144.4 4 |
| D27 | δ 8.87 (*d*, 1H, $^3J_{H-H}$ = 6.4 Hz), 8.11-8.07 (*m*, 2H), 8.03 (*s*, 1H), 7.94 (*d*, 1H, $^3J_{H-H}$ = 8.3 Hz), 7.93-7.91 (*m*, 2H) 7.83-7.77 (*m*, 2H), 7.75 (d, 1H, $^3J_{H-H}$ = 8.3 Hz), 7.54 (*td*, 1H, $^3J_{H-H}$ = 7.1 Hz, $^4J_{H-H}$ = 1.1 Hz), 7.47-7.43 (*m*, 2H), 7.28 (*d*, 1H, $^3J_{H-H}$ = 8.2 Hz), 7.23-7.18 (*m*, 5H), 7.04-7.01 (*m*, 2H), 6.85 (d, 1H, $^3J_{H-H}$ = 8.0 Hz), 6.84-6.82 (*m*, 2H), 6.24 (*d*, 1H, $^3J_{H-H}$ = 5.0 Hz), 3.04 (m, 2H), 1.98-1.69 (m, 12H), 1.32 (*s*, 9H). | 1200.5 2 | 1200.5 0 |

(continued)

| Compo und | $^1H$ NMR ($CDCl_3$ , 500 MHz) | MALDI-TOF MS M+] | |
|---|---|---|---|
| | | found | calc. |
| D81 | δ 8.86 (*d*, 1H, $^3J_{H-H}$ = 6.4 Hz), 8.11 (*d*, 1H, $^3J_{H-H}$ = 7.1 Hz), 8.02 (s, 1H), 7.94 (*d*, 1H, $^3J_{H-H}$ = 8.3 Hz), 7.90 (*d*, 1H, $^3J_{H-H}$ = 8.1 Hz), 7.76 (*d*, 1H, $^3J_{H-H}$ = 8.3 Hz), 7.50-7.43 (m, 11H), 7.30 (*d*, 1H, $^3J_{H-H}$ = 8.2 Hz), 7.23-7.20 (m 14H), 7.04-7.01 (m, 2H), 6.83 (d, 1H, $^3J_{H-H}$ = 8.0 Hz), 6.22 (*d*, 1H, $^3J_{H-H}$ = 5.0 Hz), 3.03 (m, 2H), 1.98-1.68 (m, 12H). | 1321.51 | 1321.50 |
| D302 | δ 8.88 (*d*, 1H, $^3J_{H-H}$ = 6.4 Hz), 8.04 (*d*, 1H, $^3J_{H-H}$ = 7.7 Hz, $^4J_{H-H}$ = 1.3 Hz), 7.98 (d, 1H, $^3J_{H-H}$ = 8.3 Hz), 7.89 (*d*, 1H, $^4J_{H-H}$ = 1.8 Hz), 7.74 (*d*, 1H, $^3J_{H-H}$ = 8.2 Hz), 7.67 (*d*, 1H, $^3J_{H-H}$ = 7.6 Hz), 7.48 (*d*, 1H, $^3J_{H-H}$ = 7.6 Hz, $^4J_{H-H}$ = 0.8 Hz), 7.44-7.40 (m, 4H), 7.36-7.20 (m, 10H), 7.07 (*d*, 1H, $^3J_{H-H}$ = 8.1 Hz, $^4J_{H-H}$ = 0.8 Hz), 7.05 (td, 1H, $^3J_{H-H}$ = 8.1 Hz, $^4J_{H-H}$ = 0.8 Hz), 6.87 (*d*, 1H, $^3J_{H-H}$ = 7.8 Hz). | 1007.43 | 1007.39 |

**Evaluation Example 1**

HOMO and LUMO energy levels of Compounds D6, D12, D27, D81, and D302 were evaluated according to the method in Table 2. The results thereof are shown in Table 3.

Table 2

| | |
|---|---|
| HOMO energy level evaluation method | A potential (V)-current (A) graph of each compound was obtained by using cyclic voltammetry (CV) (electrolyte: 0.1 M $BBu_4NPF_6$/ solvent: dimethylforamide (DMF)/ electrode: 3 electrode system (working electrode: GC, reference electrode: Ag/AgCI, auxiliary electrode: Pt)), and then, from oxidation onset of the graph, a HOMO energy level of the compound was calculated. |
| LUMO energy level evaluation method | A potential (V)-current (A) graph of each compound was obtained by using cyclic voltammetry (CV) (electrolyte: 0.1 M $BBu_4NPF_6$/ solvent: dimethylforamide (DMF)/ electrode: 3 electrode system (working electrode: GC, reference electrode: Ag/AgCI, auxiliary electrode: Pt)), and then, from reduction onset of the graph, a LUMO energy level of the compound was calculated. |

Table 3

| Compound No. | HOMO (eV) | LUMO (eV) |
|---|---|---|
| D6 | -5.26 | -2.09 |
| D12 | -5.22 | -2.22 |
| D27 | -5.23 | -2.24 |
| D81 | -5.25 | -2.25 |
| D302 | -5.26 | -2.14 |

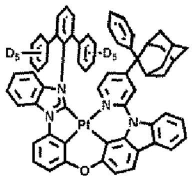
D6

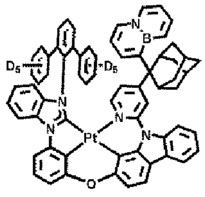
D12

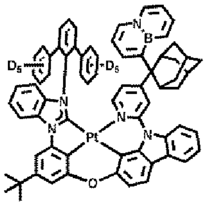
D27

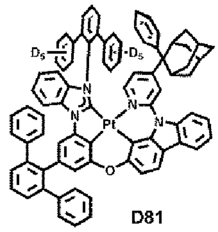
D81

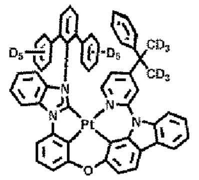
D302

## Evaluation Example 2

Film 1 having a thickness of 40 nm was prepared by vacuum-co-depositing ETH66, HTH29, and D6 on a quartz substrate at a vacuum degree of $10^{-7}$ torr. Here, regarding the amounts of Compounds ETH66, HTH29, and D6, a weight ratio of Compound ETH66 to Compound HTH29 was 3:7, and the content of Compound D6 was 10 parts by weight based on 100 parts by weight of the film. Subsequently, Films 2 to 5 were respectively prepared in substantially the same manner as in synthesis of Film 1, except that Compounds D12, D27, D81, or D302 was respectively used instead of Compound D6.

The emission spectrum of each of the Films was measured by using a Hamamatsu Quantaurus-QY absolute PL quantum yield measurement system equipped with a xenon light source, a monochromator, a photonic multichannel analyzer, and an integrating sphere, and utilizing PLOY measurement software (Hamamatsu Photonics, Ltd., Shizuoka, Japan). At the time of measurement, the excitation wavelength was measured by scanning from 320 nm to 380 nm at 10 nm intervals, of which the spectrum measured at the excitation wavelength of 340nm was taken, and the maximum emission wavelength of the dopant comprised in each Film was obtained. The results are shown in Table 4.

Subsequently, regarding the emission quantum yield, the excitation wavelengths of Films 1 to 5 were measured by using Quantaurus-QY Absolute PL spectrometer (Hamamatsu) by scanning from 320 nm to 380 nm at 10 nm intervals, of which the spectrum at the excitation wavelength of 340nm was taken to obtain the emission quantum yield (PLQY). Emission quantum yield of the dopant comprise in each Film is shown in Table 4.

Table 4

| Film No. | Film composition | Maximum emission wavelength (nm) | PLQY (%) |
|---|---|---|---|
| 1 | ETH66 : HTH29 : D6 | 456 | 93 |
| 2 | ETH66 : HTH29 : D12 | 457 | 94 |
| 3 | ETH66 : HTH29 : D27 | 458 | 94 |
| 4 | ETH66 : HTH29 : D81 | 458 | 95 |
| 5 | ETH66 : HTH29 : D302 | 456 | 89 |

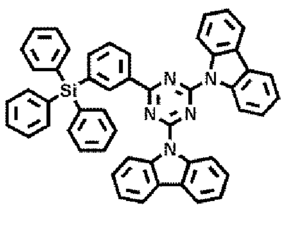
ETH66

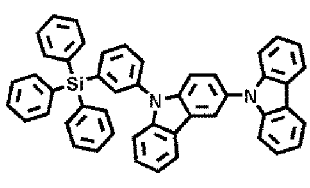
HTH29

Referring to the results of Table 4, Compounds D6, D12, D27, D81, and D302 were found to emit blue light having excellent PLOY.

## Evaluation Example 3

The PL spectrum of each of Films 1 to 5 was evaluated at room temperature by using a time-resolved photoluminescence (TRPL) measurement system, FluoTime 300 (available from PicoQuant), and a pumping source, PLS 340 (available from PicoQuant, excitation wavelength=340 nm, spectral width=20 nm). Then, a wavelength of the main

peak in the PL spectrum was determined, and upon photon pulses (pulse width=500 picoseconds, ps) applied to the film by PLS 340, the number of photons emitted at the wavelength of the main peak for each film was repeatedly measured over time by time-correlated single photon counting (TCSPC), thereby obtaining TRPL curves available for the sufficient fitting. Based on the results obtained therefrom, one or more exponential decay functions were set forth for the fitting, thereby obtaining $T_{decay}$(Ex), i.e., a decay time, for each of Films 1 to 5. The results thereof are shown in Table 5. The functions used for the fitting are as described in Equation 20, and a decay time $T_{decay}$ having the largest value among values for each of the exponential decay functions used for the fitting was taken as $T_{decay}$(Ex), i.e., a decay time. Here, during the same measurement time as the measurement time for obtaining TRPL curves, the same measurement was repeated once more in a dark state (i.e., a state where a pumping signal incident on each of the films was blocked), thereby obtaining a baseline or a background signal curve available as a baseline for the fitting:

Equation 20

$$f(t) = \sum_{i=1}^{n} A_i \, exp\left(-t/T_{decay,i}\right)$$

Table 5

| Film No. | Film composition | Decay time ($T$) (microseconds, $\mu$s) |
|---|---|---|
| 1 | ETH66 : HTH29 : D6 | 2.17 |
| 2 | ETH66 : HTH29 : D12 | 2.05 |
| 3 | ETH66 : HTH29 : D27 | 2.02 |
| 4 | ETH66 : HTH29 : D81 | 2.03 |
| 5 | ETH66 : HTH29 : D302 | 2.31 |

Referring to the results of Table 5, Compounds D6, D12, D27, D81, and D302 were found to have excellent decay time.

**Example 1**

As an anode, a 15 Ohms per square centimeter ($\Omega/cm^2$) (1,200 Å) ITO glass substrate (available from Corning Inc.) was cut to a size of 50 millimeters (mm) x 50 mm x 0.7 mm, sonicated in isopropyl alcohol and pure water for 5 minutes in each solvent, cleaned with ultraviolet rays for 30 minutes, and then with ozone, and was mounted on a vacuum deposition apparatus.

2-TNATA was vacuum-deposited on the anode to form a hole injection layer having a thickness of 600 Å, and 4,4'-bis[N-(1-naphthyl)-N-phenylamino]biphenyl (hereinafter, referred as "NPB") was vacuum-deposited on the hole injection layer to form a hole transport layer having a thickness of 300 Å.

Compound D6 (as the first compound), Compound ETH66 (as the second compound), and Compound HTH29 (as the third compound) were vacuum-deposited on the hole transport layer to form an emission layer having a thickness of 400 Å. Here, the content of Compound D6 was 10 wt%, based on 100 wt% of the total weight of the emission layer, and the weight ratio of Compound ETH66 to Compound HTH29 was 3:7.

Compound ETH2 was deposited on the emission layer to form a hole blocking layer having a thickness of 50 Å, $Alq_3$ was deposited on the hole blocking layer to form an electron transport layer having a thickness of 300 Å, LiF was vacuum-deposited on the electron transport layer to form an electron injection layer having a thickness of 10 Å, and Al was vacuum-deposited on the electron injection layer to form a cathode having a thickness of 3,000 Å, thereby completing the manufacture of an organic light-emitting device.

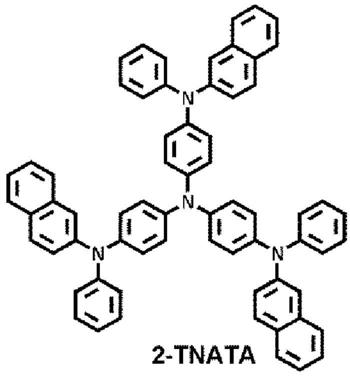

2-TNATA

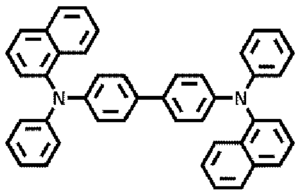

NPB

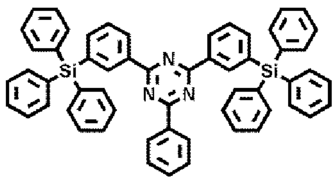

ETH2

**Examples 2 to 6**

Organic light-emitting devices were manufactured in substantially the same manner as in Example 1, except that the compounds shown in Table 6 were used instead of the first compound, the second compound, and the third compound in the formation of each respective emission layer.

**Evaluation Example 4**

The driving voltage (V), color purity (CIEx,y), luminescence efficiency (cd/A), color-conversion efficiency (cd/A/y), maximum emission wavelength (nm), and lifespan ($T_{95}$) at 1,000 cd/m$^2$ of the organic light-emitting devices manufactured in Examples 1 to 6 were measured by using Keithley source-measure unit (SMU) 236 and a luminance meter PR650. The results thereof are shown in Tables 6 and 7. In Table 7, the lifespan ($T_{95}$) indicates a time (in hours) that it took for the luminance of each light-emitting device to decline to 95 % of its initial luminance. The electroluminescence spectra, the luminance-luminescence efficiency graph, and the time-luminance graph of Examples 1 to 6 are respectively shown in FIGS. 4, 6, and 7.

Table 6

| No. | Dopant | Host | | Luminance (cd/m$^2$) | Driving voltage (V) | Color purity (CIEx,y) |
|---|---|---|---|---|---|---|
| | First compound | Second compound | Third compound | | | |
| Example 1 | D6 | ETH66 | HTH29 | 1000 | 5.4 | (0.14, 0.17) |
| Example 2 | D6 | ETH65 | HTH41 | 1000 | 5.5 | (0.14, 0.17) |
| Example 3 | D12 | ETH66 | HTH29 | 1000 | 5.5 | (0.14, 0.17) |
| Example 4 | D27 | ETH66 | HTH29 | 1000 | 5.3 | (0.14, 0.17) |
| Example 5 | D81 | ETH66 | HTH29 | 1000 | 5.3 | (0.14, 0.17) |

(continued)

| No. | Dopant | Host | | Luminance (cd/m$^2$) | Driving voltage (V) | Color purity (CIEx,y) |
|---|---|---|---|---|---|---|
| | First compound | Second compound | Third compound | | | |
| Example 6 | D302 | ETH66 | HTH29 | 1000 | 5.4 | (0.14, 0.17) |

Table 7

| No. | Dopant | Host | | Luminescence efficiency (cd/A) | Colorconversion efficiency (cd/A/y) | Maximum emission wavelength (nm) | Lifespan ($T_{95}$) (hours) |
|---|---|---|---|---|---|---|---|
| | First compound | Second compound | Third compound | | | | |
| Example 1 | D6 | ETH66 | HTH29 | 21.4 | 126.2 | 462 | 78.2 |
| Example 2 | D6 | ETH65 | HTH41 | 19.7 | 118.4 | 462 | 61.1 |
| Example 3 | D12 | ETH66 | HTH29 | 19.7 | 118.3 | 462 | 85.1 |
| Example 4 | D27 | ETH66 | HTH29 | 21.9 | 126.2 | 463 | 87.2 |
| Example 5 | D81 | ETH66 | HTH29 | 21.9 | 126.4 | 463 | 86.2 |
| Example 6 | D302 | ETH66 | HTH29 | 20.9 | 124.2 | 462 | 63.0 |

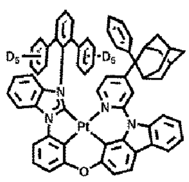
D6

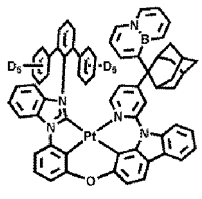
D12

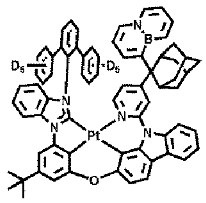
D27

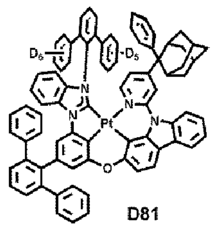
D81

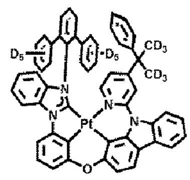
D302

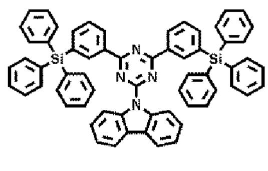
ETH65

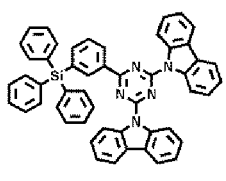
ETH66

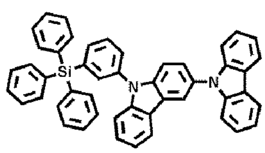
HTH29

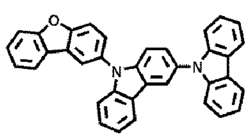
HTH41

Referring to the results of Tables 6 and 7, the organic light-emitting devices of Examples 1 to 6 were each found to have excellent driving voltage, color purity, luminescence efficiency, color-conversion efficiency, and lifespan characteristics, and to emit dark blue light.

**Example 7**

An organic light-emitting device was manufactured in substantially the same manner as in Example 1, except that Compound D6 (as the first compound), Compound ETH66 (as the second compound), Compound HTH29 (as the third compound), and Compound DFD1 (as the fourth compound) were vacuum-deposited on the hole transport layer instead of Compound D6 (as the first compound), Compound ETH66 (as the second compound), and Compound HTH29 (as the third compound) in the formation of the emission layer. Here, the content of Compound D6 was 10 wt%, based on 100 wt% of the total weight of the emission layer, the content of Compound DFD1 was 0.5 wt%, based on 100 wt% of the total weight of the emission layer, and the weight ratio of Compound ETH66 to Compound HTH29 was 3:7.

**Example 8**

An organic light-emitting device was manufactured in substantially the same manner as in Example 7, except that Compound DFD2 was used instead of Compound DFD1 as the fourth compound.

**Evaluation Example 5**

The driving voltage (V), color purity (CIEx,y), luminescence efficiency (cd/A), color-conversion efficiency (cd/A/y), maximum emission wavelength (nm), and lifespan ($T_{95}$) at 1,000 cd/m$^2$ of the organic light-emitting devices manufactured in Examples 7 and 8 were measured by using the same methods as those in Evaluation Example 4. The results thereof are shown in Tables 8 and 9. The electroluminescence spectra, the luminance-luminescence efficiency graph, and the time-luminance graph of Examples 7 and 8 are respectively shown in FIGS. 5, 6, and 7.

Table 8

| No. | Dopant | Host | | Ancillary dopant | Luminance (cd/m$^2$) | Driving voltage (V) | Color purity (CIEx,y) |
|---|---|---|---|---|---|---|---|
| | First compound | Second compound | Third compound | Fourth compound | | | |
| Example 7 | D6 | ETH66 | HTH29 | DFD1 | 1000 | 4.3 | (0.13, 0.14) |
| Example 8 | D6 | ETH66 | HTH29 | DFD2 | 1000 | 5.6 | (0.14, 0.14) |

Table 9

| No. | Dopant | Host | | Ancillary dopant | Luminescence efficiency (cd/A) | Color-conversion efficiency (cd/A/y) | Maximum emission wavelength (nm) | Lifespan ($T_{95}$) (hours) |
|---|---|---|---|---|---|---|---|---|
| | First compound | Second compound | Third compound | Fourth compound | | | | |
| Example 7 | D6 | ETH66 | HTH29 | DFD1 | 21.6 | 152.9 | 469 | 120.3 |
| Example 8 | D6 | ETH66 | HTH29 | DFD2 | 17.4 | 121.8 | 463 | 94.2 |

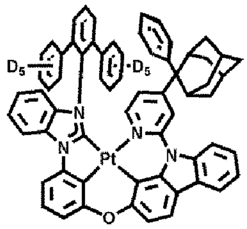
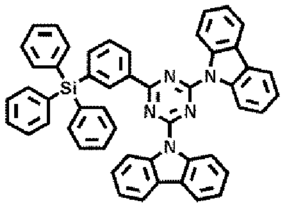
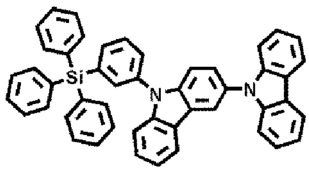

D6 ETH66 HTH29

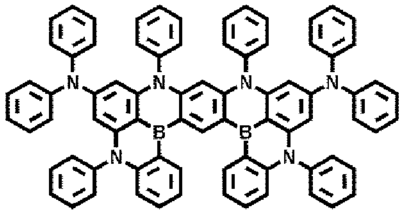
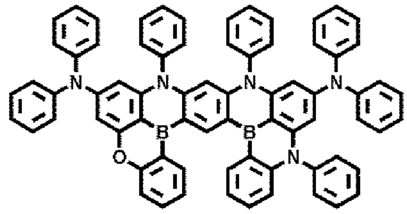

DFD1 DFD2

Referring to the results of Tables 8 and 9, the organic light-emitting devices of Examples 7 and 8 were each found to have excellent driving voltage, color purity, luminescence efficiency, color-conversion efficiency, and lifespan characteristics, and to emit dark blue light.

### Example 11

An organic light-emitting device was manufactured in substantially the same manner as in Example 1, except that Compound D6 (as the first compound) and Compound HTH29 (as the third compound) were vacuum-deposited on the hole transport layer to form an emission layer having a thickness of 300 Å, instead of Compound D6 (as the first compound), Compound ETH29 (as the second compound), and Compound HTH66 (as the third compound) that were used to form an emission layer having a thickness of 400 Å. Here, the content of Compound D6 was 10 wt%, based on 100 wt% of the total weight of the emission layer.

### Comparative Example 1

An organic light-emitting device was manufactured in substantially the same manner as in Example 11, except that Compound CE1 was used instead of Compound D6 to form an emission layer.

### Evaluation Example 6

The driving voltage (V), color purity (CIEx,y), luminescence efficiency (cd/A), color-conversion efficiency (cd/A/y), maximum emission wavelength (nm), and lifespan ($T_{95}$ at room temperature) at 1,000 cd/m$^2$ of the organic light-emitting devices manufactured in Example 11 and Comparative Example 1 were measured by using the same methods as those in Evaluation Example 4. The results thereof are shown in Tables 10 and 11. The electroluminescence spectra, the luminance-luminescence efficiency graph, and the time-luminance graph of Example 11 and Comparative Example 1 are respectively shown in FIGS. 4, 6, and 7.

Table 10

| No. | Dopant | Host | Luminance (cd/m$^2$) | Driving voltage (V) | Color purity (CIEx,y) |
|---|---|---|---|---|---|
| Example 11 | D6 | HTH29 | 1000 | 6.0 | (0.14,0.17) |
| Comparative Example 1 | CE1 | HTH29 | 1000 | 6.4 | (0.14,0.19) |

Table 11

| No. | Dopant | Host | Luminescence efficiency (cd/A) | Color-conversion efficiency (cd/A/y) | Maximum emission wavelengt h (nm) | Lifespan ($T_{95}$) (hours) |
|---|---|---|---|---|---|---|
| Example 11 | D6 | HTH29 | 10.8 | 56.8 | 455 | 5.0 |
| Comparative Example 1 | CE1 | HTH29 | 9.6 | 51.6 | 454 | 2.5 |

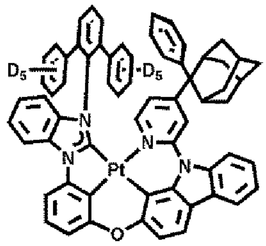

D6

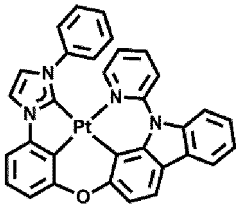

CE1

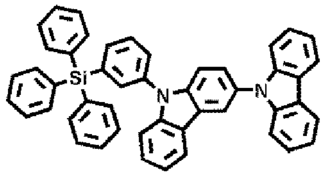

HTH29

Referring to the results of Tables 10 and 11, the organic light-emitting device of Example 11 was found to have excellent driving voltage, color purity, luminescence efficiency, color-conversion efficiency, and lifespan characteristics, and to emit dark blue light, as compared with Comparative Example 1.

As apparent from the foregoing description, the light-emitting device may have excellent driving voltage, current density, high luminescence efficiency, and long lifespan, and may be used in the manufacture of a high quality electronic apparatus.

As used herein, the terms "use," "using," and "used" may be considered synonymous with the terms "utilize," "utilizing," and "utilized," respectively.

In addition, the terms "substantially," "about," and similar terms are used as terms of approximation and not as terms of degree, and are intended to account for the inherent deviations in measured or calculated values that would be recognized by those of ordinary skill in the art.

Also, any numerical range recited herein is intended to comprise all subranges of the same numerical precision subsumed within the recited range. For example, a range of "1.0 to 10.0" is intended to comprise all subranges between (and comprising) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to comprise all lower numerical limitations subsumed therein and any minimum numerical limitation recited in this specification is intended to comprise all higher numerical limitations subsumed therein. Accordingly, Applicant reserves the right to amend this specification, comprising the claims, to expressly recite any sub-range subsumed within the ranges expressly recited herein.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the present disclosure as defined by the following claims.

## Claims

**1.** A light-emitting device comprising:

a first electrode (110);
a second electrode (150) facing the first electrode; and
an interlayer (130) between the first electrode and the second electrode, the interlayer comprising an emission layer,
wherein the interlayer further comprises:

i) a first compound; and

ii) a second compound comprising at least one π electron-deficient nitrogen-containing $C_1$-$C_{60}$ cyclic group, a third compound, a fourth compound capable of emitting delayed fluorescent light, or any combination thereof, and

the first compound, the second compound, the third compound, and the fourth compound are different from one another,

wherein the first compound is represented by Formula 1

Formula 1

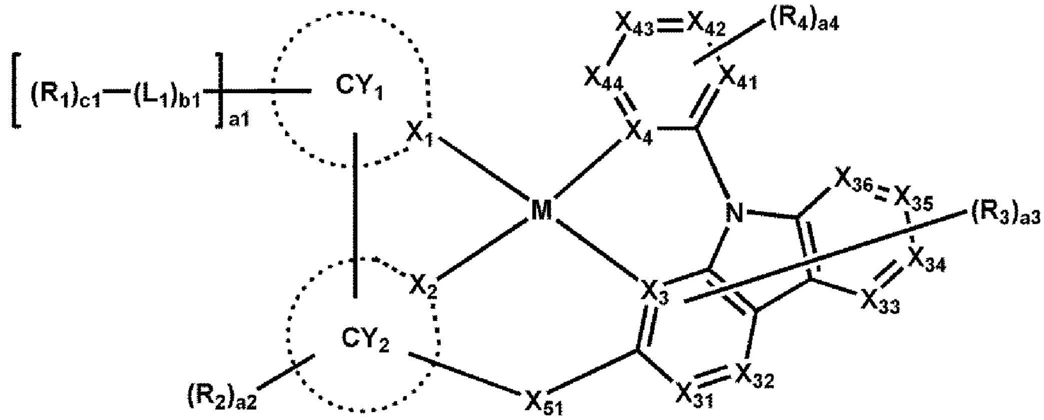

wherein, in Formula 1, M is platinum (Pt), palladium (Pd), gold (Au), nickel (Ni), silver (Ag), or copper (Cu),

in Formula 1, $X_1$ to $X_4$ are each independently C or N,

in Formula 1, i) a bond between $X_1$ and M is a coordinate bond, and ii) one of a bond between $X_2$ and M, a bond between $X_3$ and M, and a bond between $X_4$ and M is a coordinate bond, and the other two bonds are each a covalent bond,

in Formula 1, ring $CY_1$ is i) a $X_1$-containing 5-membered ring, ii) a $X_1$-containing 5-membered ring condensed with at least one 6-membered ring, or iii) a $X_1$-containing 6-membered ring,

in Formula 1, ring $CY_2$ is a $C_3$-$C_{60}$ carbocyclic group or a $C_1$-$C_{60}$ heterocyclic group,

in Formula 1, $X_{31}$ to $X_{36}$ and $X_{41}$ to $X_{44}$ are each independently C or N,

in Formula 1, $X_{51}$ is *-N($R_5$)-*', *-B($R_5$)-*', *-P($R_5$)-*', *-C($R_{5a}$)($R_{5b}$)-*', *-Si(R5a)(R5b)-*', *-Ge(R5a)(R5b)-*', *-S-*', *-Se-*', *-O-*', *-C(=O)-*', *-S(=O)-*', *-S(=O)$_2$-*', *-C($R_5$)=*', *=C($R_5$)-*', *-C($R_{5a}$)=C($R_{5b}$)-*', *-C(=S)-*', or *-C=C-*', and * and *' each indicate a binding site to an adjacent atom,

in Formula 1, $L_1$ is a single bond, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,

in Formula 1, b1 is an integer from 1 to 5,

in Formula 1, c1 is an integer from 0 to 5, a1 and a4 are each independently an integer from 0 to 4, a2 is an integer from 0 to 10, and a3 is an integer from 0 to 6, provided that the sum of a1 to a4 is 1 or greater, and at least one of *-$(L_1)_{b1}$-$(R_1)_{c1}$(s) in the number of a1, at least one of $R_2$(s) in the number of a2, at least one of $R_3$(s) in the number of a3, at least one of $R_4$(s) in the number of a4, or any combination thereof are each independently the group represented by Formula 1-1 or the group represented by Formula 1-2,

in Formula 1, $R_1$ to $R_5$, $R_{5a}$, and $R_{5b}$ are each independently a group represented by Formula 1-1, a group represented by Formula 1-2, hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, - C($Q_1$)($Q_2$)($Q_3$), -Si($Q_1$)($Q_2$)($Q_3$), -N($Q_1$)($Q_2$), -B($Q_1$)($Q_2$), -C(=O)($Q_1$), -S(=O)$_2$($Q_1$), or - P(=O)($Q_1$)($Q_2$),

Formula 1-1

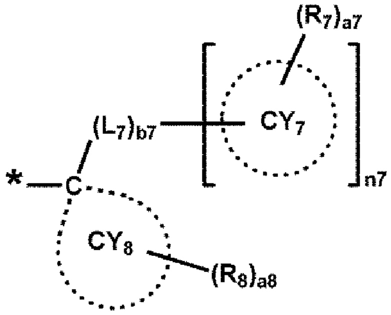

Formula 1-2

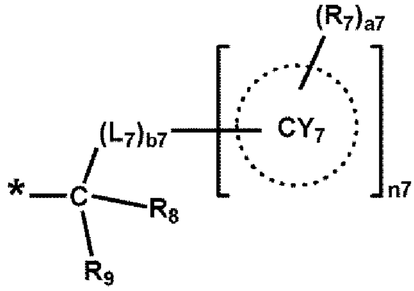

,

in Formulae 1-1 and 1-2, $L_7$ is a single bond, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
in Formulae 1-1 and 1-2, b7 is an integer from 1 to 5,
in Formulae 1-1 and 1-2, ring $CY_7$ is a $C_3$-$C_{60}$ carbocyclic group or a $C_1$-$C_{60}$ heterocyclic group,
in Formulae 1-1 and 1-2, n7 is an integer from 1 to 5,
in Formula 1-1, ring $CY_8$ is a non-aromatic $C_3$-$C_{60}$ carbocyclic group or a non-aromatic $C_1$-$C_{60}$ heterocyclic group,
in Formulae 1-1 and 1-2, $R_7$ to $R_9$ are each independently the same as described for $R_1$,
in Formulae 1-1 and 1-2, a7 and a8 are each independently an integer from 0 to 20,
at least two groups represented by $*-(L_1)_{b1}-(R_1)_{c1}$ in the number of a1 are optionally bound to form a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
at least two of $R_2$(s) in the number of a2 are optionally bound to form a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
at least two of $R_3$(s) in the number of a3 are optionally bound to form a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
at least two of $R_4$(s) in the number of a4 are optionally bound to form a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
at least two of $R_1$ to $R_5$, $R_{5a}$, and $R_{5b}$(s) are optionally bound to form a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$, and
each $R_{10a}$ is independently:

deuterium (-D), -F, -Cl, -Br, -I, a hydroxyl group, a cyano group, or a nitro group;
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each independently unsubstituted or substituted with deuterium, -F, -Cl, - Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, - $Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, - $P(=O)(Q_{11})(Q_{12})$, or any combination thereof;
a $C_3$-$C_{60}$ carbocyclic group, a $C_1$-$C_{60}$ heterocyclic group, a $C_6$-$C_{60}$ aryloxy group, or a $C_6$-$C_{60}$ arylthio group, each independently unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, $-Si(Q_{21})(Q_{22})(Q_{23})$, $-N(Q_{21})(Q_{22})$, $-B(Q_{21})(Q_{22})$, $-C(=O)(Q_{21})$, $-S(=O)_2(Q_{21})$, $-P(=O)(Q_{21})(Q_{22})$, or any combination thereof; or
$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, or - $P(=O)(Q_{31})(Q_{32})$, and
wherein $Q_1$ to $Q_3$, $Q_{11}$ to $Q_{13}$, $Q_{21}$ to $Q_{23}$, and $Q_{31}$ to $Q_{33}$ are each independently hydrogen; deuterium; -F; -Cl; -Br; -I; a hydroxyl group; a cyano group; a nitro group; a $C_1$-$C_{60}$ alkyl group; a $C_2$-$C_{60}$ alkenyl group; a $C_2$-$C_{60}$ alkynyl group; a $C_1$-$C_{60}$ alkoxy group; a $C_3$-$C_{60}$ carbocyclic group or a $C_1$-$C_{60}$ heterocyclic group, wherein, when present, each $C_1$-$C_{60}$ alkyl group; $C_2$-$C_{60}$ alkenyl group; $C_2$-$C_{60}$ alkynyl group; $C_1$-$C_{60}$ alkoxy group; $C_3$-$C_{60}$ carbocyclic group or $C_1$-$C_{60}$ heterocyclic group is optionally independently substituted with deuterium, -F, a cyano group, a $C_1$-$C_{60}$ alkyl group, a $C_1$-$C_{60}$ alkoxy group, a phenyl group, a biphenyl group, a pyridinyl group, a pyrimidinyl group, a pyridazinyl group, a pyrazinyl group, a triazinyl group, or

any combination thereof, and,
wherein the third compound comprises a group represented by Formula 3

Formula 3

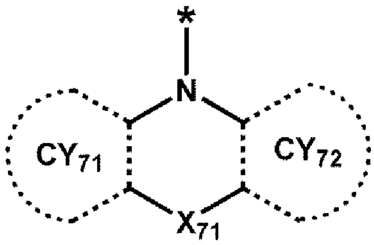

,

in Formula 3, ring $CY_{71}$ and ring $CY_{72}$ are each independently a $\pi$ electron-rich $C_3$-$C_{60}$ cyclic group or a pyridine group,
in Formula 3, $X_{71}$ is a single bond or a linking group comprising O, S, N, B, C, Si, or any combination thereof,
in Formula 3, * indicates a binding site to an adjacent atom, and
the following compounds are excluded from the third compound:

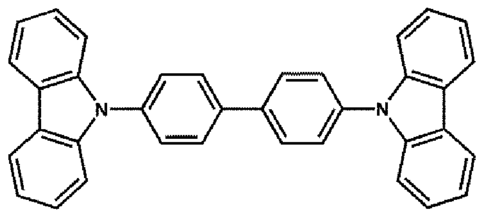

CBP

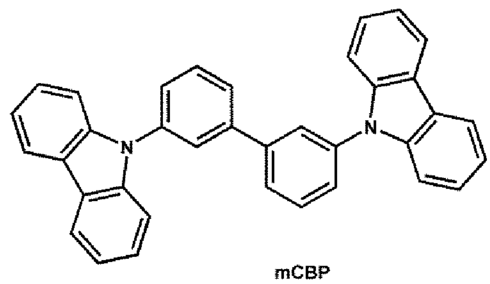

mCBP

.

**2.** The light-emitting device of claim 1, wherein the second compound comprises a pyridine group, a pyrimidine group, a pyrazine group, a pyridazine group, a triazine group, or any combination thereof.

**3.** The light-emitting device of claim 1 or 2, wherein the interlayer comprises

(i) the second compound; and/or
(ii) the third compound, the fourth compound, or any combination thereof; and/or
(iii) the fourth compound.

**4.** The light-emitting device of any one of claims 1 to 3, wherein the fourth compound is a compound comprising at least one cyclic group comprising boron (B) and nitrogen (N) as ring-forming atoms.

**5.** The light-emitting device of any one of claims 1 to 4, wherein the fourth compound comprises a condensed ring in which at least one third ring is condensed with at least one fourth ring, wherein

the third ring is a cyclopentane group, a cyclohexane group, a cycloheptane group, a cyclooctane group, a cyclopentene group, a cyclohexene group, a cycloheptene group, a cyclooctene group, an adamantane group, a norbornene group, a norobornane group, a bicyclo[1.1.1]pentane group, a bicyclo[2.1.1]hexane group, a bicyclo[2.2.2]octane group, a benzene group, a pyridine group, a pyrimidine group, a pyridazine group, a pyrazine group, or a triazine group, and
the fourth ring is a 1,2-azaborinine group, a 1,3-azaborinine group, a 1,4-azaborinine group, a 1,2-dihydro-1,2-azaborinine group, a 1,4-oxaborinine group, a 1,4-thiaborinine group, or a 1,4-dihydroborinine group.

**6.** The light-emitting device of any one of claims 1 to 5, wherein the emission layer comprises: i) the first compound; and ii) the second compound, the third compound, the fourth compound, or any combination thereof, and

the first compound is capable of emitting phosphorescent light or fluorescent light, and

the emission layer is capable of emitting the phosphorescent light or the fluorescent light emitted from the first compound.

**7.** The light-emitting device of any one of claims 1 to 6, wherein the first compound is capable of emitting phosphorescent light or fluorescent light, and
the phosphorescent light or the fluorescent light is blue light.

**8.** The light-emitting device of any one of claims 1 to 7, wherein the $X_1$-containing 5-membered ring in ring $CY_1$ in Formula 1 is a pyrrole group, a pyrazole group, an imidazole group, a triazole group, an oxazole group, an isooxazole group, a thiazole group, an isothiazole group, an oxadiazole group, or a thiadiazole group, and
the 6-membered ring that is condensed with the $X_1$-containing 5-membered ring in ring $CY_1$ in Formula 1, and the $X_1$-containing 6-membered ring in ring $CY_1$, are each independently a benzene group, a pyridine group, or a pyrimidine group.

**9.** The light-emitting device of any one of claims 1 to 8, wherein, in Formula 1, a4 is an integer from 1 to 4, and one or more of $R_4$(s) in the number of a4 are each independently the group represented by Formula 1-1 or the group represented by Formula 1-2.

**10.** The light-emitting device of any one of claims 1 to 9, wherein, in Formulae 1-1 and 1-2, ring $CY_7$ is i) a first ring, ii) a second ring, iii) a condensed ring in which at least two first rings are condensed, iv) a condensed ring in which at least two second rings are condensed, or v) a condensed ring in which at least one first ring and at least one second ring are condensed, wherein

the first ring is a cyclopentane group, a cyclohexane group, a cycloheptane group, a cyclooctane group, a cyclopentene group, a cyclohexene group, a cycloheptene group, a cyclooctene group, an adamantane group, a norbornene group, a norobornane group, a bicyclo[1.1.1]pentane group, a bicyclo[2.1.1]hexane group, a bicyclo[2.2.2]octane group, or a benzene group, and
the second ring is a pyrrole group, a furan group, a thiophene group, a silole group, a pyrazole group, an imidazole group, a triazole group, an oxazole group, an isooxazole group, a thiazole group, an isothiazole group, an oxadiazole group, a thiadiazole group, a pyridine group, a pyrimidine group, a pyridazine group, a pyrazine group, a triazine group, a 1,2-azaborinine group, a 1,3-azaborinine group, a 1,4-azaborinine group, a 1,2-dihydro-1,2-azaborinine group, a 1,4-oxaborinine group, a 1,4-thiaborinine group, or a 1,4-dihydroborinine group.

**11.** The light-emitting device of any one of claims 1 to 10, wherein, in Formula 1-1, ring $CY_8$ is a cyclopentane group, a cyclohexane group, a cycloheptane group, a cyclooctane group, a cyclopentene group, a cyclohexene group, a cycloheptene group, a cyclooctene group, an adamantane group, a norbornene group, a norobornane group, a bicyclo[1.1.1]pentane group, a bicyclo[2.1.1]hexane group, or a bicyclo[2.2.2]octane group; or wherein, in Formula 1-1, ring $CY_8$ is a group represented by one of Formulae CY8-1 to CY8-8:

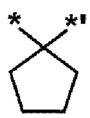
CY8-1

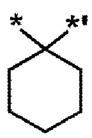
CY8-2

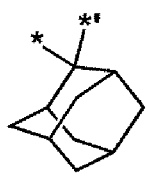
CY8-3

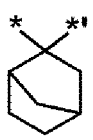
CY8-4

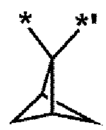
CY8-5

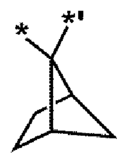
CY8-6

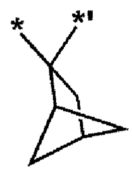
CY8-7

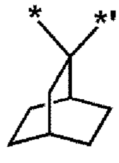
CY8-8

, and
wherein, in Formulae CY8-1 to CY8-8, * indicates a binding site to an adjacent atom in Formula 1, and *' indicates

a binding site to $L_7$ in Formula 1-1.

**12.** The light-emitting device of any one of claims 1 to 11, wherein the second compound is a compound represented by Formula 2:

Formula 2

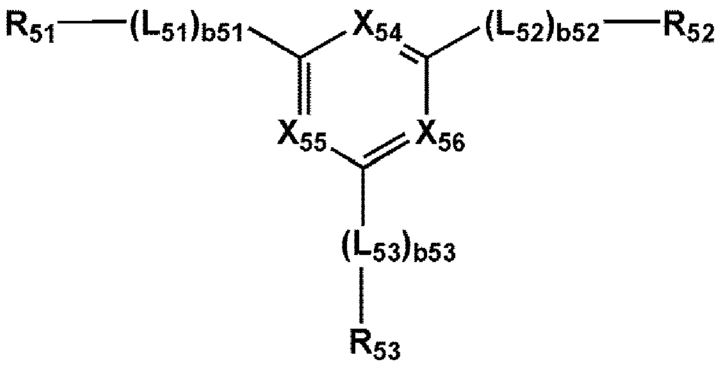

,

and
wherein, in Formula 2,

$L_{51}$ to $L_{53}$ are each independently a single bond, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
b51 to b53 are each independently an integer from 1 to 5,
$X_{54}$ is N or C($R_{54}$), $X_{55}$ is N or C($R_{55}$), $X_{56}$ is N or C($R_{56}$), and at least one selected from $X_{54}$ to $X_{56}$ is N, and
$R_{51}$ to $R_{56}$ are each independently hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, -C($Q_1$)($Q_2$)($Q_3$), -Si($Q_1$)($Q_2$)($Q_3$), - N($Q_1$)($Q_2$), -B($Q_1$)($Q_2$), -C(=O)($Q_1$), -S(=O)$_2$($Q_1$), or -P(=O)($Q_1$)($Q_2$), wherein each of $R_{10a}$ and $Q_1$ to $Q_3$ is independently the same as described in relation to Formula 1.

**13.** The light-emitting device of any one of claims 1 to 12, wherein the third compound is a compound represented by Formula 3-1, a compound represented by Formula 3-2, a compound represented by Formula 3-3, a compound represented by Formula 3-4, a compound represented by Formula 3-5, or any combination thereof:

Formula 3-1

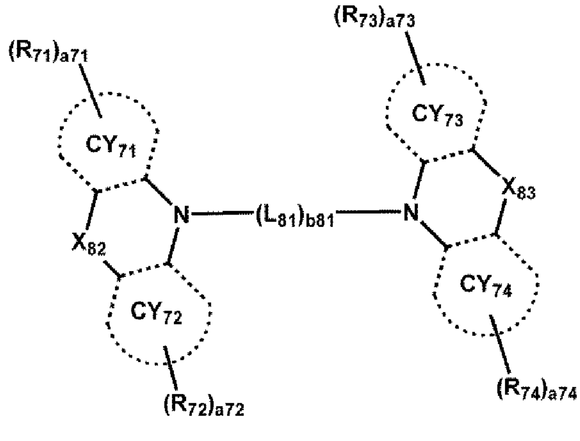

Formula 3-2

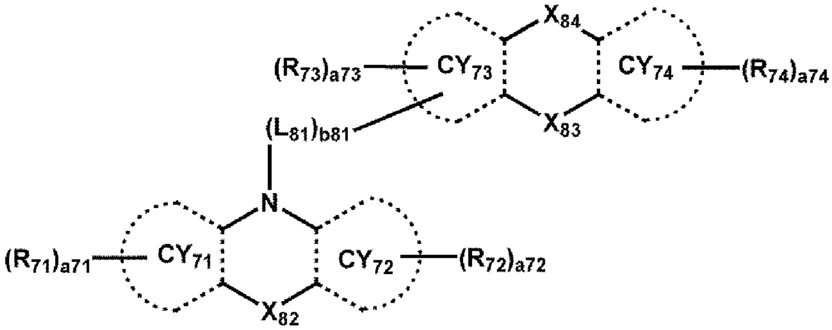

Formula 3-3

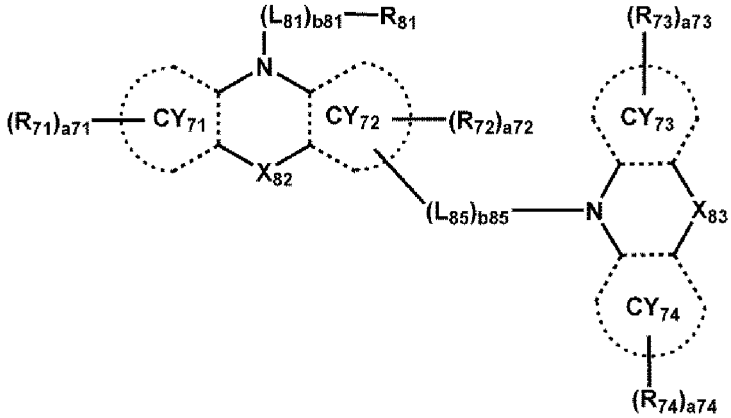

Formula 3-4

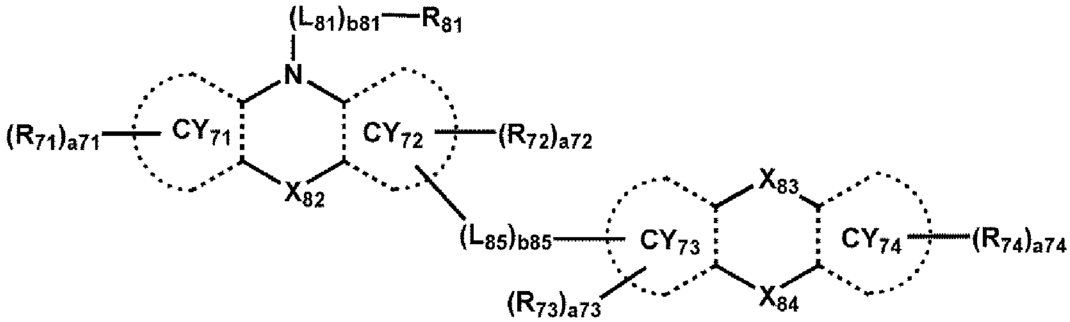

Formula 3-5

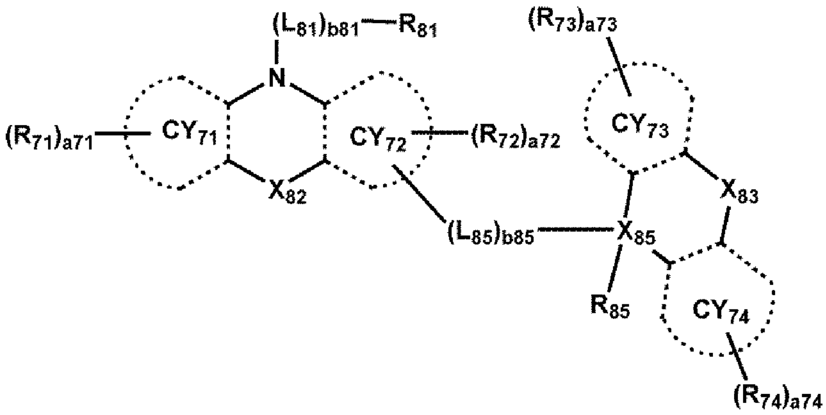

,

and
wherein, in Formulae 3-1 to 3-5,

ring $CY_{71}$ to ring $CY_{74}$ are each independently a $\pi$ electron-rich $C_3$-$C_{60}$ cyclic group or a pyridine group,
$X_{82}$ is a single bond, O, S, N-[$(L_{82})_{b82}$-$R_{82}$], C($R_{82a}$)($R_{82b}$), or Si($R_{82a}$)($R_{82b}$),
$X_{83}$ is a single bond, O, S, N-[$(L_{83})_{b83}$-$R_{83}$], C($R_{83a}$)($R_{83b}$), or Si($R_{83a}$)($R_{83b}$),
$X_{84}$ is O, S, N-[(L8$_4$)b8$_4$-R8$_4$], C(R8$_4$a)(R8$_4$b), or Si(R8$_4$a)(R8$_4$b),
$X_{85}$ is C or Si,
$L_{81}$ to $L_{85}$ are each independently a single bond, *-C($Q_4$)($Q_5$)-*', *-Si($Q_4$)($Q_5$)-*', a $\pi$ electron-rich $C_3$-$C_{60}$ cyclic group unsubstituted or substituted with at least one $R_{10a}$, or a pyridine group unsubstituted or substituted with at least one $R_{10a}$, wherein $Q_4$ and $Q_5$ are each understood by referring to the description of $Q_1$,
b81 to b85 are each independently an integer from 1 to 5,
$R_{71}$ to $R_{74}$, $R_{81}$ to $R_{85}$, $R_{82a}$, $R_{82b}$, $R_{83a}$, $R_{83b}$, $R_{84a}$, and $R_{84b}$ are each independently hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, -C($Q_1$)($Q_2$)($Q_3$), -Si($Q_1$)($Q_2$)($Q_3$), - N($Q_1$)($Q_2$), -B($Q_1$)($Q_2$), -C(=O)($Q_1$), -S(=O)$_2$($Q_1$), or -P(=O)($Q_1$)($Q_2$),
a71 to a74 are each independently an integer from 0 to 20 and ,
each $R_{10a}$ and $Q_1$ to $Q_3$ is independently the same as described in relation to Formula 1,
* and *' each indicate a binding site to an adjacent atom.

**14.** The light-emitting device of any one of claims 1 to 13, wherein the fourth compound is a compound represented by Formula 502, a compound represented by Formula 503, or any combination thereof:

Formula 502

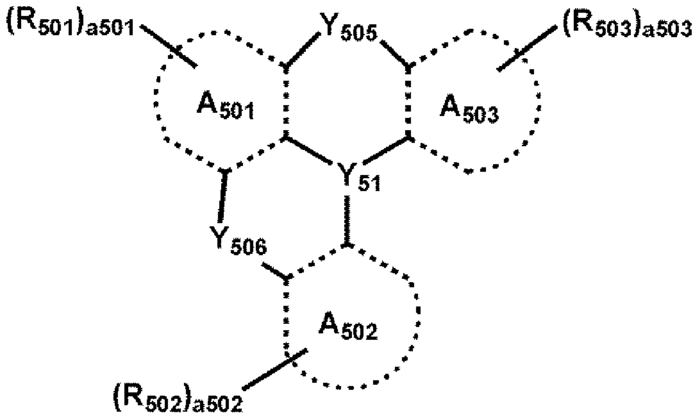

Formula 503

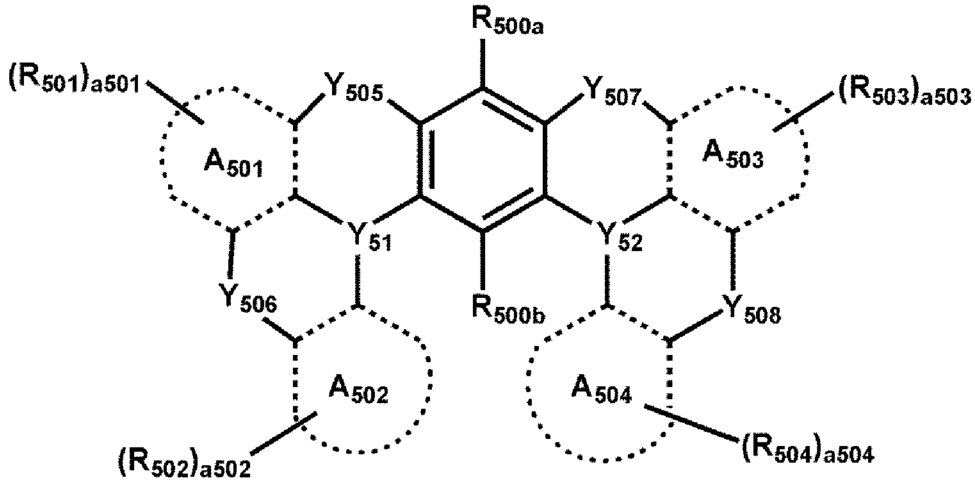

,

and
wherein, in Formulae 502 and 503,

ring $A_{501}$ to ring $A_{504}$ are each independently a $C_3$-$C_{60}$ carbocyclic group or a $C_1$-$C_{60}$ heterocyclic group,
$Y_{505}$ is O, S, $N(R_{505})$, $B(R_{505})$, $C(R_{505a})(R_{505b})$, or $Si(R_{505a})(R_{505b})$,
$Y_{506}$ is O, S, $N(R_{506})$, $B(R_{506})$, $C(R_{506a})(R_{506b})$, or $Si(R_{506a})(R_{506b})$,
$Y_{507}$ is O, S, $N(R_{507})$, $B(R_{507})$, $C(R_{507a})(R_{507b})$, or $Si(R_{507a})(R_{507b})$,
$Y_{508}$ is O, S, $N(R_{508})$, $B(R_{508})$, $C(R_{508a})(R_{508b})$, or $Si(R_{508a})(R_{508b})$,
$Y_{51}$ and $Y_{52}$ are each independently B, P(=O), or S(=O),
$R_{500a}$, $R_{500b}$, $R_{501}$ to $R_{508}$, $R_{505a}$, $R_{505b}$, $R_{506a}$, $R_{506b}$, $R_{507a}$, $R_{507b}$, $R_{508a}$, and $R_{508b}$ are each independently hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, $-C(Q_1)(Q_2)(Q_3)$, $-Si(Q_1)(Q_2)(Q_3)$, - $N(Q_1)(Q_2)$, $-B(Q_1)(Q_2)$, $-C(=O)(Q_1)$, $-S(=O)_2(Q_1)$, or $-P(=O)(Q_1)(Q_2)$,
a501 to a504 are each independently an integer from 0 to 20, and
each $R_{10a}$ and $Q_1$ to $Q_3$ is independently the same as described in relation to Formula 1.

**15.** An electronic apparatus comprising the light-emitting device of any one of claims 1 to 14, preferably further comprising a thin-film transistor, wherein the thin-film transistor comprises a source electrode (260) and a drain electrode (270), and the first electrode (110) of the light-emitting device is electrically connected to one of the source electrode or the drain electrode of the thin-film transistor and/or, further comprising: a color filter, a color-conversion layer, a touchscreen layer, and/or a polarization layer.

**Patentansprüche**

**1.** Lichtemittierende Vorrichtung, umfassend:

eine erste Elektrode (110);
eine zweite Elektrode (150), die der ersten Elektrode zugewandt ist; und
eine Zwischenschicht (130) zwischen der ersten Elektrode und der zweiten Elektrode, wobei die Zwischenschicht eine Emissionsschicht umfasst,
wobei die Zwischenschicht ferner Folgendes umfasst:

i) eine erste Verbindung; und
ii) eine zweite Verbindung umfassend zumindest eine $\pi$-elektronendefiziente stickstoffhaltige cyclische

$C_1$-$C_{60}$-Gruppe, eine dritte Verbindung, eine vierte Verbindung, die in der Lage ist, verzögertes Fluoreszenzlicht zu emittieren, oder eine beliebige Kombination davon, und

wobei sich die erste Verbindung, die zweite Verbindung, die dritte Verbindung und die vierte Verbindung voneinander unterscheiden,
wobei die erste Verbindung durch Formel 1 dargestellt ist

Formel 1

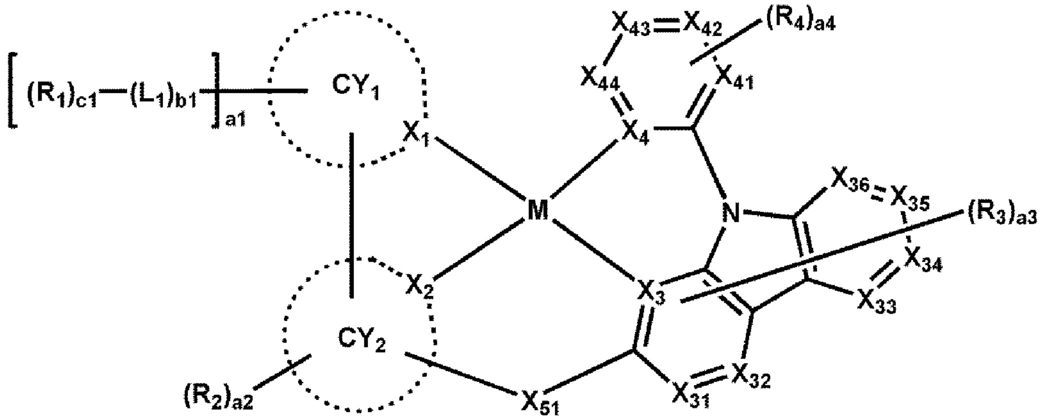

wobei in Formel 1 M Platin (Pt), Palladium (Pd), Gold (Au), Nickel (Ni), Silber (Ag) oder Kupfer (Cu) ist,
in Formel 1 $X_1$ bis $X_4$ jeweils unabhängig C oder N sind,
in Formel 1 i) eine Bindung zwischen $X_1$ und Meine Koordinatenbindung ist und ii) eine von einer Bindung zwischen $X_2$ und M, einer Bindung zwischen $X_3$ und M und einer Bindung zwischen $X_4$ und M eine Koordinatenbindung ist und die anderen zwei Bindungen jeweils eine kovalente Bindung sind,
in Formel 1 Ring $CY_1$ i) ein $X_1$-haltiger 5-gliedriger Ring, ii) ein $X_1$-haltiger 5-gliedriger Ring kondensiert mit zumindest einem 6-gliedrigen Ring oder iii) ein $X_1$-haltiger 6-gliedriger Ring ist,
in Formel 1 Ring $CY_2$ eine carbocyclische $C_3$-$C_{60}$-Gruppe oder eine heterocyclische $C_1$-$C_{60}$-Gruppe ist,
in Formel 1 $X_{31}$ bis $X_{36}$ und $X_{41}$ bis $X_{44}$ jeweils unabhängig C oder N sind,
in Formel 1 $X_{51}$ *-N($R_5$)-*', *-B($R_5$)-*', *-P($R_5$)-*', *-C($R_{5a}$)($R_{5b}$)-*', *-Si($R_{5a}$)($R_{5b}$)-*', *-Ge($R_{5a}$)($R_{5b}$)-*', *-S-*', *-Se-*', *-O-*', *-C(=O)-*', *-S(=O)-*', *-S(=O)$_2$-*', *-C($R_5$)=*', *=C($R_5$)-*', *-C($R_{5a}$)=C($R_{5b}$)-*', *-C(=S)-*' oder *-C=C-*' ist und * und *' jeweils eine Bindungsstelle zu einem benachbarten Atom angeben,
in Formel 1 $L_1$ eine Einfachbindung, eine carbocyclische $C_3$-$C_{60}$-Gruppe, unsubstituiert oder substituiert mit zumindest einem $R_{10a}$, oder eine heterocyclische $C_1$-$C_{60}$-Gruppe, unsubstituiert oder substituiert mit zumindest einem $R_{10a}$ ist,
in Formel 1 b1 eine ganze Zahl von 1 bis 5 ist,
in Formel 1 c1 eine ganze Zahl von 0 bis 5 ist, a1 und a4 jeweils unabhängig eine ganze Zahl von 0 bis 4 sind, a2 eine ganze Zahl von 0 bis 10 ist, und a3 eine ganze Zahl von 0 bis 6 ist, vorausgesetzt, dass die Summe von a1 bis a4 1 oder größer ist, und zumindest eines von *-$(L_1)_{b1}$-$(R_1)_{c1}$(s) in der Zahl von a1, zumindest eines von $R_2$(s) in der Zahl von a2, zumindest eines von $R_3$(s) in der Zahl von a3, zumindest eines von $R_4$(s) in der Zahl von a4 oder eine beliebige Kombination davon jeweils unabhängig die Gruppe dargestellt durch Formel 1-1 oder die Gruppe dargestellt durch Formel 1-2 sind,
in Formel 1 $R_1$ bis $R_5$, $R_{5a}$ und $R_{5b}$ jeweils unabhängig eine Gruppe dargestellt durch Formel 1-1, eine Gruppe dargestellt durch Formel 1-2, Wasserstoff, Deuterium, -F, -Cl, -Br, -I, eine Hydroxylgruppe, eine Cyanogruppe, eine Nitrogruppe, eine $C_1$-$C_{60}$-Alkylgruppe, unsubstituiert oder substituiert mit zumindest einem $R_{10a}$, eine $C_2$-$C_{60}$-Alkenylgruppe, unsubstituiert oder substituiert mit zumindest einem $R_{10a}$, eine $C_2$-$C_{60}$-Alkinylgruppe, unsubstituiert oder substituiert mit zumindest einem $R_{10a}$, eine $C_1$-$C_{60}$-Alkoxygruppe, unsubstituiert oder substituiert mit zumindest einem $R_{10a}$, eine carbocyclische $C_3$-$C_{60}$-Gruppe, unsubstituiert oder substituiert mit zumindest einem $R_{10a}$, eine heterocyclische $C_1$-$C_{60}$-Gruppe, unsubstituiert oder substituiert mit zumindest einem $R_{10a}$, eine $C_6$-$C_{60}$-Aryloxygruppe, unsubstituiert oder substituiert mit zumindest einem $R_{10a}$, eine $C_6$-$C_{60}$-Arylthiogruppe, unsubstituiert oder substituiert mit zumindest einem $R_{10a}$, -C($Q_1$)($Q_2$)($Q_3$), -Si($Q_1$)($Q_2$)($Q_3$), -N($Q_1$)($Q_2$), -B($Q_1$)($Q_2$), -C(=O)($Q_1$), -S(=O)$_2$($Q_1$) oder - P(=O)($Q_1$)((Formel 1-1 Formel 1-2 sind,

Formula 1-1

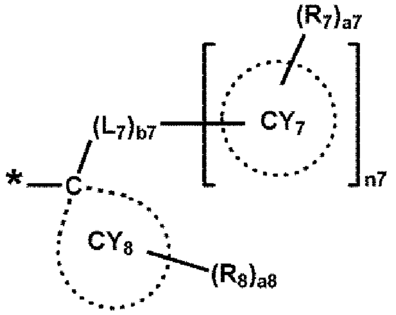

Formula 1-2

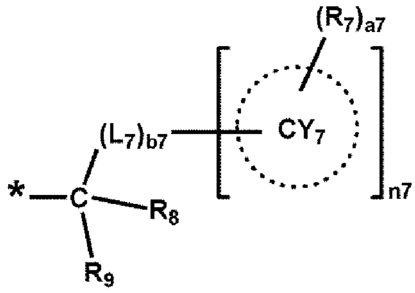

,

in Formel 1-1 und 1-2 $L_7$ eine Einfachbindung, eine carbocyclische $C_3$-$C_{60}$-Gruppe, unsubstituiert oder substituiert mit zumindest einem $R_{10a}$, oder eine heterocyclische $C_1$-$C_{60}$-Gruppe, unsubstituiert oder substituiert mit zumindest einem $R_{10a}$ ist,
in Formel 1-1 und 1-2 b7 eine ganze Zahl von 1 bis 5 ist,
in Formel 1-1 und 1-2 Ring $CY_7$ eine carbocyclische $C_3$-$C_{60}$-Gruppe oder eine heterocyclische $C_1$-$C_{60}$-Gruppe ist,
in Formel 1-1 und 1-2 n7 eine ganze Zahl von 1 bis 5 ist,
in Formel 1-1 Ring $CY_8$ eine nichtaromatische carbocyclische $C_3$-$C_{60}$-Gruppe oder eine nichtaromatische heterocyclische $C_1$-$C_{60}$-Gruppe ist,
in Formel 1-1 und 1-2 $R_7$ bis $R_9$ jeweils unabhängig die gleichen wie für $R_1$ beschrieben sind,
in Formel 1-1 und 1-2 a7 und a8 jeweils unabhängig eine ganze Zahl von 0 bis 20 sind,
zumindest zwei Gruppen dargestellt durch $*-(L_1)_{b1}-(R_1)_{C1}$ in der Zahl von a1 optional gebunden sind, um eine carbocyclische $C_3$-$C_{60}$-Gruppe, unsubstituiert oder substituiert mit zumindest einem $R_{10a}$, oder eine heterocyclische $C_1$-$C_{60}$-Gruppe, unsubstituiert oder substituiert mit zumindest einem $R_{10a}$, zu bilden,
zumindest zwei von $R_2$(s) in der Zahl von a2 optional gebunden sind, um eine carbocyclische $C_3$-$C_{60}$-Gruppe, unsubstituiert oder substituiert mit zumindest einem $R_{10a}$, oder eine heterocyclische $C_1$-$C_{60}$-Gruppe, unsubstituiert oder substituiert mit zumindest einem $R_{10a}$, zu bilden,
zumindest zwei von $R_3$(s) in der Zahl von a3 optional gebunden sind, um eine carbocyclische $C_3$-$C_{60}$-Gruppe, unsubstituiert oder substituiert mit zumindest einem $R_{10a}$, oder eine heterocyclische $C_1$-$C_{60}$-Gruppe, unsubstituiert oder substituiert mit zumindest einem $R_{10a}$, zu bilden,
zumindest zwei von $R_4$(s) in der Zahl von a4 optional gebunden sind, um eine carbocyclische $C_3$-$C_{60}$-Gruppe, unsubstituiert oder substituiert mit zumindest einem $R_{10a}$, oder eine heterocyclische $C_1$-$C_{60}$-Gruppe, unsubstituiert oder substituiert mit zumindest einem $R_{10a}$, zu bilden,
zumindest zwei von $R_1$ bis $R_5$, $R_{5a}$ und $R_{5b}$(s) optional gebunden sind, um eine carbocyclische $C_3$-$C_{60}$-Gruppe, unsubstituiert oder substituiert mit zumindest einem $R_{10a}$, oder eine heterocyclische $C_1$-$C_{60}$-Gruppe, unsubstituiert oder substituiert mit zumindest einem $R_{10a}$, zu bilden,
jedes $R_{10a}$ unabhängig wie folgt ist:

Deuterium (-D), -F, -Cl, -Br, -I, eine Hydroxylgruppe, eine Cyanogruppe oder eine Nitrogruppe;
eine $C_1$-$C_{60}$-Alkylgruppe, eine $C_2$-$C_{60}$-Alkenylgruppe, eine $C_2$-$C_{60}$-Alkinylgruppe oder eine $C_1$-$C_{60}$-Alkoxygruppe, jeweils unabhängig unsubstituiert oder substituiert mit Deuterium, -F, -Cl, - Br, -I, einer Hydroxylgruppe, einer Cyanogruppe, einer Nitrogruppe, einer carbocyclischen $C_3$-$C_{60}$-Gruppe, einer heterocyclischen$C_1$-$C_{60}$-Gruppe, einer $C_6$-$C_{60}$-Aryloxygruppe, einer $C_6$-$C_{60}$-Arylthiogruppe, $-Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, - $P(=O)(Q_{11})(Q_{12})$ oder einer beliebigen Kombination davon;
eine carbocyclische $C_3$-$C_{60}$-Gruppe, eine heterocyclische $C_1$-$C_{60}$-Gruppe, eine $C_6$-$C_{60}$-Aryloxygruppe oder eine $C_6$-$C_{60}$-Arylthiogruppe, jeweils unabhängig unsubstituiert oder substituiert mit Deuterium, -F, -Cl, -Br, -I, einer Hydroxylgruppe, einer Cyanogruppe, einer Nitrogruppe, einer $C_1$-$C_{60}$-Alkylgruppe, einer $C_2$-$C_{60}$-Alkenylgruppe, einer $C_2$-$C_{60}$-Alkinylgruppe, einer $C_1$-$C_{60}$-Alkoxygruppe, einer carbocyclischen $C_3$-$C_{60}$-Gruppe, einer heterocyclischen $C_1$-$C_{60}$-Gruppe, einer $C_6$-$C_{60}$-Aryloxygruppe, einer $C_6$-$C_{60}$-Arylthiogruppe, $-Si(Q_{21})(Q_{22})(Q_{23})$, - $N(Q_{21})(Q_{22})$, $-B(Q_{21})(Q_{22})$, $-C(=O)(Q_{21})$, $-S(=O)_2(Q_{21})$, $-P(=O)(Q_{21})(Q_{22})$ oder einer beliebigen Kombination davon; oder
$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$ oder - $P(=O)(Q_{31})(Q_{32})$, und
wobei $Q_1$ bis $Q_3$, $Q_{11}$ bis $Q_{13}$, $Q_{21}$ bis $Q_{23}$ und $Q_{31}$ bis $Q_{33}$ jeweils unabhängig Wasserstoff; Deuterium; -F; -Cl; -Br; -I; eine Hydroxylgruppe; eine Cyanogruppe; eine Nitrogruppe; eine $C_1$-$C_{60}$-Alkylgruppe, eine

$C_2$-$C_{60}$-Alkenylgruppe, eine $C_2$-$C_{60}$-Alkinylgruppe, eine $C_1$-$C_{60}$-Alkoxygruppe; eine carbocyclische $C_3$-$C_{60}$-Gruppe oder eine heterocyclische $C_1$-$C_{60}$-Gruppe sind, wobei, wenn vorhanden, jede $C_1$-$C_{60}$-Alkylgruppe, $C_2$-$C_{60}$-Alkenylgruppe, $C_2$-$C_{60}$-Alkinylgruppe; $C_1$-$C_{60}$-Alkoxygruppe, carbocyclische $C_3$-$C_{60}$-Gruppe oder heterocyclische $C_1$-$C_{60}$-Gruppe optional unabhängig substituiert ist mit Deuterium, -F, einer Cyanogruppe, einer $C_1$-$C_{60}$-Alkylgruppe, einer $C_1$-$C_{60}$-Alkoxygruppe, einer Phenylgruppe, einer Biphenylgruppe, einer Pyridinylgruppe, einer Pyrimidinylgruppe, einer Pyridazinylgruppe, einer Pyrazinylgruppe, einer Triazinylgruppe oder einer beliebigen Kombination davon, und
wobei die dritte Verbindung eine Gruppe dargestellt durch Formel 3 umfasst

Formel 3

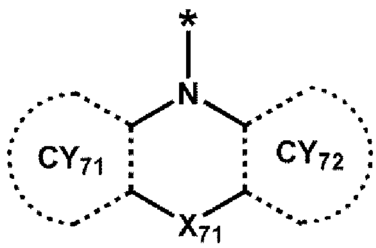
,

in Formel 3 Ring $CY_{71}$ und Ring $CY_{72}$ jeweils unabhängig eine $\pi$-elektronenreiche cyclische $C_3$-$C_{60}$-Gruppe oder eine Pyridingruppe sind,
in Formel 3 $X_{71}$ eine Einfachbindung oder eine Verbindungsgruppe ist, die O, S, N, B, C, Si oder eine beliebige Kombination davon umfasst,
in Formel 3 * eine Bindungsstelle zu einem benachbarten Atom angibt, und
die folgenden Verbindungen von der dritten Verbindung ausgeschlossen sind:

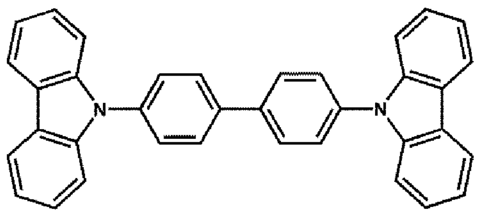
CBP

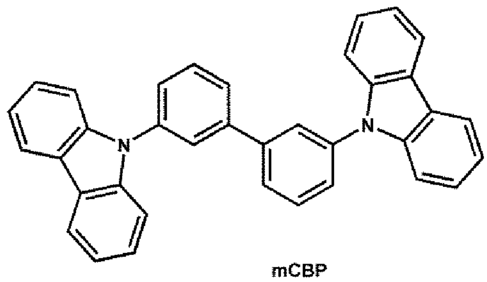
mCBP
.

2. Lichtemittierende Vorrichtung nach Anspruch 1, wobei die zweite Verbindung eine Pyridingruppe, eine Pyrimidingruppe, eine Pyrazingruppe, eine Pyridazingruppe, eine Triazingruppe oder eine beliebige Kombination davon umfasst.

3. Lichtemittierende Vorrichtung nach Anspruch 1 oder 2, wobei die Zwischenschicht

(i) die zweite Verbindung; und/oder
(ii) die dritte Verbindung, die vierte Verbindung oder eine beliebige Kombination davon; und/oder
(iii) die vierte Verbindung umfasst.

4. Lichtemittierende Vorrichtung nach einem der Ansprüche 1 bis 3, wobei die vierte Verbindung eine Verbindung ist, die zumindest eine cyclische Gruppe umfasst, die Bor (B) und Stickstoff (N) als ringbildende Atome umfasst.

5. Lichtemittierende Vorrichtung nach einem der Ansprüche 1 bis 4, wobei die vierte Verbindung einen kondensierten Ring umfasst, in dem zumindest ein dritter Ring mit zumindest einem vierten Ring kondensiert ist, wobei

der dritte Ring eine Cyclopentangruppe, eine Cyclohexangruppe, eine Cycloheptangruppe, eine Cyclooctangruppe, eine Cyclopentengruppe, eine Cyclohexengruppe, eine Cycloheptengruppe, eine Cyclooctengruppe, eine Adamantangruppe, eine Norbornengruppe, eine Norobornangruppe, eine Bicyclo[1.1.1]Pentangruppe,

eine Bicyclo[2.1.1]Hexangruppe, eine Bicyclo[2.2.2]Octangruppe, eine Benzolgruppe, eine Pyridingruppe, eine Pyrimidingruppe, eine Pyridazingruppe, eine Pyrazingruppe oder eine Triazingruppe ist, und
der vierte Ring eine 1,2-Azaboriningruppe, eine 1,3-Azaboriningruppe, eine 1,4-Azaboriningruppe, eine 1,2-Dihydro-1,2-Azaboriningruppe, eine 1,4-Oxaboriningruppe, eine 1,4-Thiaboriningruppe oder eine 1,4-Dihydroboriningruppe ist.

**6.** Lichtemittierende Vorrichtung nach einem der Ansprüche 1 bis 5, wobei die Emissionsschicht Folgendes umfasst: i) die erste Verbindung; und ii) die zweite Verbindung, die dritte Verbindung, die vierte Verbindung oder eine beliebige Kombination davon, und

die erste Verbindung in der Lage ist, phosphoreszierendes Licht oder fluoreszierendes Licht zu emittieren, und die Emissionsschicht in der Lage ist, das phosphoreszierende Licht oder das fluoreszierende Licht, das von der ersten Verbindung emittiert wird, zu emittieren.

**7.** Lichtemittierende Vorrichtung nach einem der Ansprüche 1 bis 6, wobei die erste Verbindung in der Lage ist, phosphoreszierendes Licht oder fluoreszierendes Licht zu emittieren, und
das phosphoreszierende Licht oder das fluoreszierende Licht blaues Licht ist.

**8.** Lichtemittierende Vorrichtung nach einem der Ansprüche 1 bis 7, wobei der $X_1$-haltige 5-gliedrige Ring in Ring $CY_1$ in Formel 1 eine Pyrrolgruppe, eine Pyrazolgruppe, eine Imidazolgruppe, eine Triazolgruppe, eine Oxazolgruppe, eine Isooxazolgruppe, eine Thiazolgruppe, eine Isothiazolgruppe, eine Oxadiazolgruppe oder eine Thiadiazolgruppe ist, und
der 6-gliedrige Ring, der mit dem $X_1$-haltigen 5-gliedrigen Ring in Ring $CY_1$ in Formel 1 kondensiert ist, und der $X_1$-haltige 6-gliedrige Ring in Ring $CY_1$ jeweils unabhängig eine Benzolgruppe, eine Pyridingruppe oder eine Pyrimidingruppe sind.

**9.** Lichtemittierende Vorrichtung nach einem der Ansprüche 1 bis 8, wobei in Formel 1 a4 eine ganze Zahl von 1 bis 4 ist und eines oder mehrere von $R_4$(s) in der Zahl von a4 jeweils unabhängig die Gruppe dargestellt durch Formel 1-1 oder die Gruppe dargestellt durch Formel 1-2 sind.

**10.** Lichtemittierende Vorrichtung nach einem der Ansprüche 1 bis 9, wobei in Formel 1-1 und 1-2 Ring $CY_7$ i) ein erster Ring, ii) ein zweiter Ring, iii) ein kondensierter Ring, in dem zumindest zwei erste Ringe kondensiert sind, iv) ein kondensierter Ring, in dem zumindest zwei zweite Ringe kondensiert sind, oder v) ein kondensierter Ring, in dem zumindest ein erster Ring und zumindest ein zweiter Ring kondensiert sind, ist, wobei

der erste Ring eine Cyclopentangruppe, eine Cyclohexangruppe, eine Cycloheptangruppe, eine Cyclooctangruppe, eine Cyclopentengruppe, eine Cyclohexengruppe, eine Cycloheptengruppe, eine Cyclooctengruppe, eine Adamantangruppe, eine Norbornengruppe, eine Norobornangruppe, eine Bicyclo[1.1.1]Pentangruppe, eine Bicyclo[2.1.1]Hexangruppe, eine Bicyclo[2.2.2]Octangruppe oder eine Benzolgruppe ist, und
der zweite Ring eine Pyrrolgruppe, eine Furangruppe, eine Thiophengruppe, eine Silolgruppe, eine Pyrazolgruppe, eine Imidazolgruppe, eine Triazolgruppe, eine Oxazolgruppe, eine Isooxazolgruppe, eine Thiazolgruppe, eine Isothiazolgruppe, eine Oxadiazolgruppe, eine Thiadiazolgruppe, eine Pyridingruppe, eine Pyrimidingruppe, eine Pyridazingruppe, eine Pyrazingruppe, eine Triazingruppe, eine 1,2-Azaboriningruppe, eine 1,3-Azaboriningruppe, eine 1,4-Azaboriningruppe, eine 1,2-Dihydro-1,2-Azaboriningruppe, eine 1,4-Oxaboriningruppe, eine 1,4-Thiaboriningruppe oder eine 1,4-Dihydroboriningruppe ist.

**11.** Lichtemittierende Vorrichtung nach einem der Ansprüche 1 bis 10, wobei in Formel 1-1 Ring $CY_8$ eine Cyclopentangruppe, eine Cyclohexangruppe, eine Cycloheptangruppe, eine Cyclooctangruppe, eine Cyclopentengruppe, eine Cyclohexengruppe, eine Cycloheptengruppe, eine Cyclooctengruppe, eine Adamantangruppe, eine Norbornengruppe, eine Norobornangruppe, eine Bicyclo[1.1.1]Pentangruppe, eine Bicyclo[2.1.1]Hexangruppe oder eine Bicyclo[2.2.2]Octangruppe ist; oder wobei in Formel 1-1 Ring $CY_8$ eine Gruppe dargestellt durch eine von Formel CY8-1 bis CY8-8 ist:

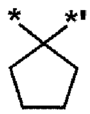
CY8-1

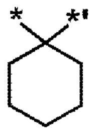
CY8-2

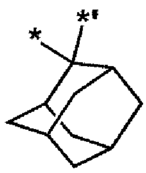
CY8-3

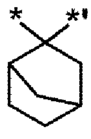
CY8-4

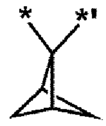
CY8-5

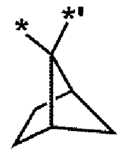
CY8-6

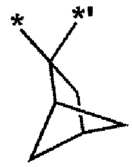
CY8-7

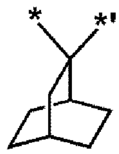
CY8-8

, und

wobei in Formel CY8-1 bis CY8-8 * eine Bindungsstelle zu einem benachbarten Atom in Formel 1 angibt und *' eine Bindungsstelle zu $L_7$ in Formel 1-1 angibt.

**12.** Lichtemittierende Vorrichtung nach einem der Ansprüche 1 bis 11, wobei die zweite Verbindung eine Verbindung dargestellt durch Formel 2 ist:

Formel 2

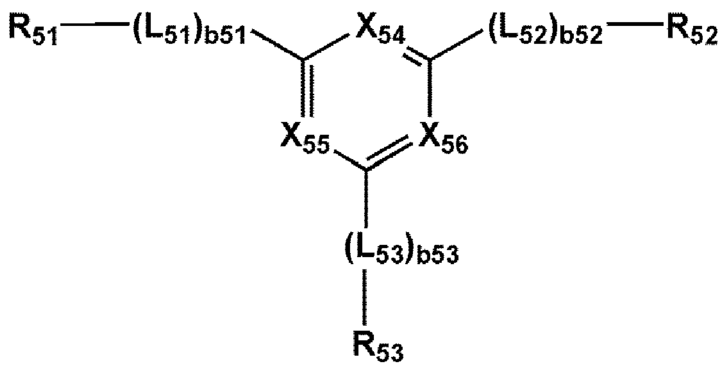

,

und

wobei in Formel 2

$L_{51}$ bis $L_{53}$ jeweils unabhängig eine Einfachbindung, eine carbocyclische $C_3$-$C_{60}$-Gruppe, unsubstituiert oder substituiert mit zumindest einem $R_{10a}$, oder eine heterocyclische $C_1$-$C_{60}$-Gruppe, unsubstituiert oder substituiert mit zumindest einem $R_{10a}$ sind,

b51 bis b53 jeweils unabhängig eine ganze Zahl von 1 bis 5 sind,

$X_{54}$ N oder $C(R_{54})$ ist, $X_{55}$ N oder $C(R_{55})$ ist, $X_{56}$ N oder $C(R_{56})$ ist und zumindest eines ausgewählt aus $X_{54}$ bis $X_{56}$ N ist, und

$R_{51}$ bis $R_{56}$ jeweils unabhängig Wasserstoff, Deuterium, -F, -Cl, -Br, -I, eine Hydroxylgruppe, eine Cyanogruppe, eine Nitrogruppe, eine $C_1$-$C_{60}$-Alkylgruppe, unsubstituiert oder substituiert mit zumindest einem $R_{10a}$, eine $C_2$-$C_{60}$-Alkenylgruppe, unsubstituiert oder substituiert mit zumindest einem $R_{10a}$, eine $C_2$-$C_{60}$-Alkinylgruppe, unsubstituiert oder substituiert mit zumindest einem $R_{10a}$, eine $C_1$-$C_{60}$-Alkoxygruppe, unsubstituiert oder substituiert mit zumindest einem $R_{10a}$, eine carbocyclische $C_3$-$C_{60}$-Gruppe, unsubstituiert oder substituiert mit zumindest einem $R_{10a}$, eine heterocyclische $C_1$-$C_{60}$-Gruppe, unsubstituiert oder substituiert mit zumindest einem $R_{10a}$, eine $C_6$-$C_{60}$-Aryloxygruppe, unsubstituiert oder substituiert mit zumindest einem $R_{10a}$, eine $C_6$-$C_{60}$-Arylthiogruppe, unsubstituiert oder substituiert mit zumindest einem $R_{10a}$, $-C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$ oder - $P(=O)(Q_1)(Q_2)$ sind, wobei jedes von $R_{10a}$ und $Q_1$ bis $Q_3$ unabhängig das gleiche wie in Bezug auf Formel 1 beschrieben ist.

13. Lichtemittierende Vorrichtung nach einem der Ansprüche 1 bis 12, wobei die dritte Verbindung eine Verbindung dargestellt durch Formel 3-1, eine Verbindung dargestellt durch Formel 3-2, eine Verbindung dargestellt durch Formel 3-3, eine Verbindung dargestellt durch Formel 3-4, eine Verbindung dargestellt durch Formel 3-5 oder eine beliebige Kombination davon ist:

Formel 3-1

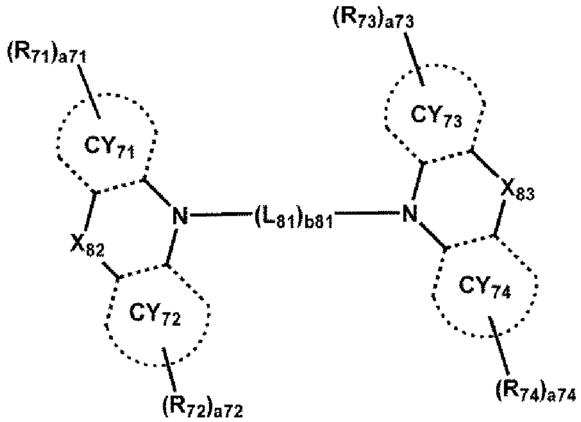

Formel 3-2

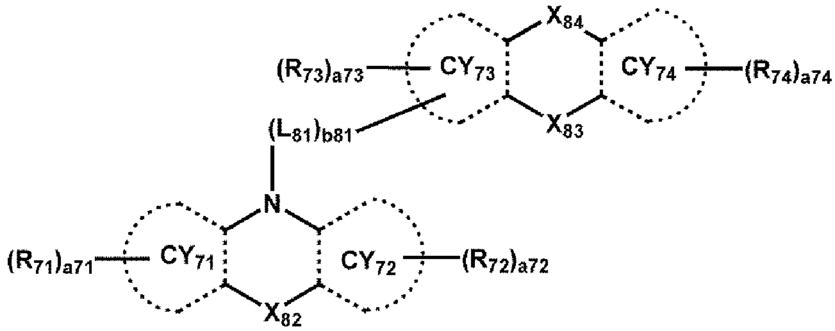

Formel 3-3

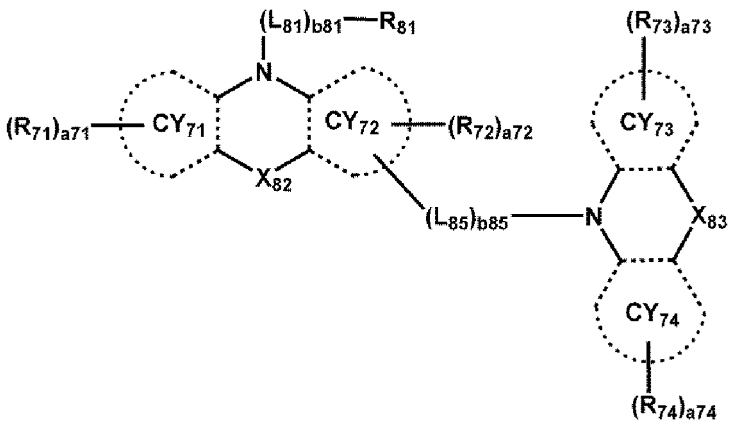

Formel 3-4

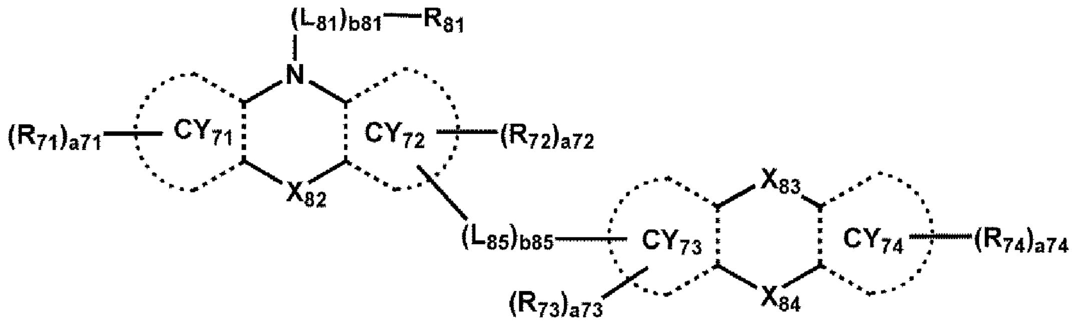

Formel 3-5

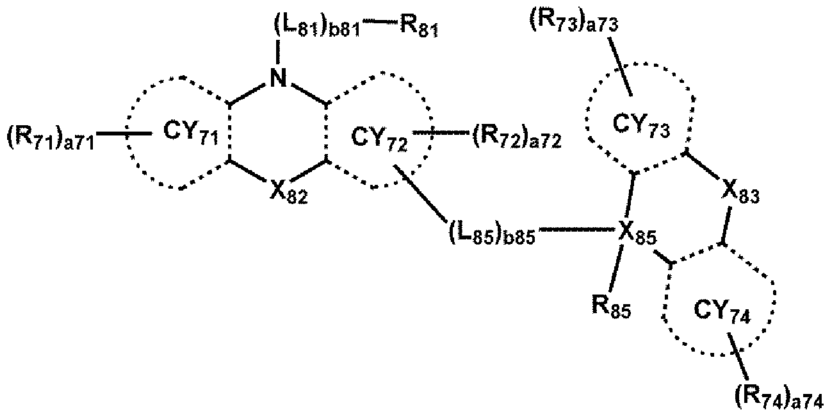

,

und

wobei in Formel 3-1 bis 3-5

Ring $CY_{71}$ bis Ring $CY_{74}$ jeweils unabhängig eine $\pi$-elektronenreiche cyclische $C_3$-$C_{60}$-Gruppe oder eine Pyridingruppe sind,

$X_{82}$ eine Einfachbindung, O, S, N-[$(L_{82})_{b82}$-$R_{82}$], $C(R_{82a})(R_{82b})$ oder $Si(R_{82a})(R_{82b})$ ist,

$X_{83}$ eine Einfachbindung, O, S, N-[$(L_{83})_{b83}$-$R_{83}$], $C(R_{82a})(R_{82b})$ oder $Si(R_{82a})(R_{83b})$ ist,

$X_{84}$ O, S, N-[$(L_{84})_{b84}$-$R_{84}$], $C(R_{84a})(R_{84b})$ oder $Si(R_{84a})(R_{84b})$ ist,

$X_{85}$ C oder Si ist,

$L_{81}$ bis $L_{85}$ jeweils unabhängig eine Einfachbindung, *-C($Q_4$)($Q_5$)-*', *-Si($Q_4$)($Q_5$)-*', eine $\pi$-elektronenreiche cyclische $C_3$-$C_{60}$-Gruppe, unsubstituiert oder substituiert mit zumindest einem $R_{10a}$, oder eine Pyridingruppe, unsubstituiert oder substituiert mit zumindest einem $R_{10a}$ sind, wobei $Q_4$ und $Q_5$ jeweils verstanden werden, indem auf die Beschreibung von $Q_1$ Bezug genommen wird,

b81 bis b85 jeweils unabhängig eine ganze Zahl von 1 bis 5 sind,

$R_{71}$ bis $R_{74}$, $R_{81}$ bis $R_{85}$, $R_{82a}$, $R_{82b}$, $R_{83a}$, $R_{83b}$, $R_{84a}$ und $R_{84b}$ jeweils unabhängig Wasserstoff, Deuterium, -F, -Cl, -Br, -I, eine Hydroxylgruppe, eine Cyanogruppe, eine Nitrogruppe, eine $C_1$-$C_{60}$-Alkylgruppe, unsubstituiert oder substituiert mit zumindest einem $R_{10a}$, eine $C_2$-$C_{60}$-Alkenylgruppe, unsubstituiert oder substituiert mit zumindest einem $R_{10a}$, eine $C_2$-$C_{60}$-Alkinylgruppe, unsubstituiert oder substituiert mit zumindest einem $R_{10a}$, eine $C_1$-$C_{60}$-Alkoxygruppe, unsubstituiert oder substituiert mit zumindest einem $R_{10a}$, eine carbocyclische $C_3$-$C_{60}$-Gruppe, unsubstituiert oder substituiert mit zumindest einem $R_{10a}$, eine heterocyclische $C_1$-$C_{60}$-Gruppe, unsubstituiert oder substituiert mit zumindest einem $R_{10a}$, eine $C_6$-$C_{60}$-Aryloxygruppe, unsubstituiert oder substituiert mit zumindest einem $R_{10a}$, eine $C_6$-$C_{60}$-Arylthiogruppe, unsubstituiert oder substituiert mit zumindest einem $R_{10a}$, -C($Q_1$)($Q_2$)($Q_3$), - Si($Q_1$)($Q_2$)($Q_3$), -N($Q_1$)($Q_2$), -B($Q_1$)($Q_2$), -C(=O)($Q_1$), -S(=O)$_2$($Q_1$) oder -P(=O)($Q_1$)($Q_2$) sind,

a71 bis a74 jeweils unabhängig eine ganze Zahl von 0 bis 20 sind, und

jedes $R_{10a}$ und $Q_1$ bis $Q_3$ unabhängig das gleiche wie in Bezug auf Formel 1 beschrieben ist,

* und *' jeweils eine Bindungsstelle zu einem benachbarten Atom angeben.

**14.** Lichtemittierende Vorrichtung nach einem der Ansprüche 1 bis 13, wobei die vierte Verbindung eine Verbindung dargestellt durch Formel 502, eine Verbindung dargestellt durch Formel 503 oder eine beliebige Kombination davon ist:

Formel 502

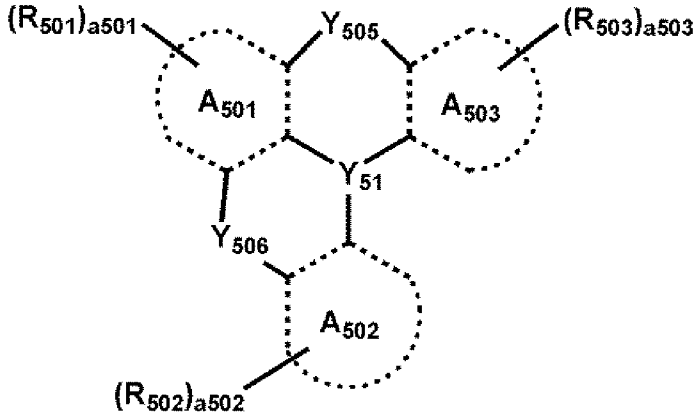

Formel 503

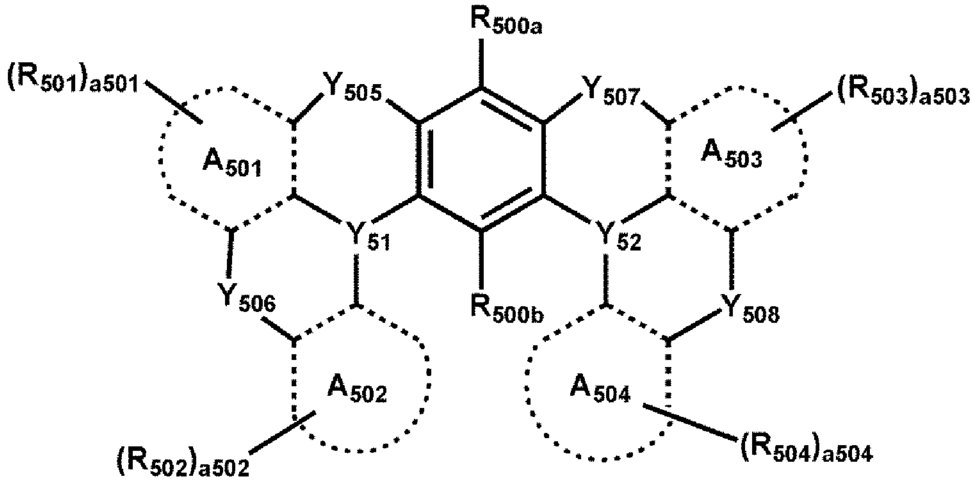

,

und

wobei in Formel 502 und 503,

Ring $A_{501}$ bis Ring $A_{504}$ jeweils unabhängig eine carbocyclische $C_3$-$C_{60}$-Gruppe oder eine heterocyclische $C_1$-$C_{60}$-Gruppe sind,

$Y_{505}$ O, S, $N(R_{505})$, $B(R_{505})$, $C(R_{505a})(R_{505b})$ oder $Si(R_{505a})(R_{505b})$ ist,

$Y_{506}$ O, S, $N(R_{506})$, $B(R_{506})$, $C(R_{506a})(R_{506b})$ oder $Si(R_{506a})(R_{506b})$ ist,

$Y_{507}$ O, S, $N(R_{507})$, $B(R_{507})$, $C(R_{507a})(R_{507b})$ oder $Si(R_{507a})(R_{507b})$ ist,

$Y_{508}$ O, S, $N(R_{508})$, $B(R_{508})$, $c(R_{508a})(R_{508b})$ oder $Si(R_{508a})(R_{508b})$ ist,

$Y_{51}$ und $Y_{52}$ jeweils unabhängig B, P(=O) oder S(=O) sind,

$R_{500a}$, $R_{500b}$, $R_{501}$ bis $R_{508}$, $R_{505a}$, $R_{505b}$, $R_{506a}$, $R_{506b}$, $R_{507a}$, $R_{507b}$, $R_{508}$ und $_{508b}$ jeweils unabhängig Wasserstoff, Deuterium, -F, -Cl, -Br, -I, eine Hydroxylgruppe, eine Cyanogruppe, eine Nitrogruppe, eine $C_1$-$C_{60}$-Alkylgruppe, unsubstituiert oder substituiert mit zumindest einem $R_{10a}$, eine $C_2$-$C_{60}$-Alkenylgruppe, unsubstituiert oder substituiert mit zumindest einem $R_{10a}$, eine $C_2$-$C_{60}$-Alkinylgruppe, unsubstituiert oder substituiert mit zumindest einem $R_{10a}$, eine $C_1$-$C_{60}$-Alkoxygruppe, unsubstituiert oder substituiert mit zumindest einem $R_{10a}$, eine

carbocyclische $C_3$-$C_{60}$-Gruppe, unsubstituiert oder substituiert mit zumindest einem $R_{10a}$, eine heterocyclische $C_1$-$C_{60}$-Gruppe, unsubstituiert oder substituiert mit zumindest einem $R_{10a}$, eine $C_6$-$C_{60}$-Aryloxygruppe, unsubstituiert oder substituiert mit zumindest einem $R_{10a}$, eine $C_6$-$C_{60}$-Arylthiogruppe, unsubstituiert oder substituiert mit zumindest einem $R_{10a}$, $-C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$ oder $-P(=O)(Q_1)(Q_2)$ sind,
a501 bis a504 jeweils unabhängig eine ganze Zahl von 0 bis 20 sind, und
jedes $R_{10a}$ und $Q_1$ bis $Q_3$ unabhängig das gleiche wie in Bezug auf Formel 1 beschrieben ist.

**15.** Elektronische Einrichtung, umfassend die lichtemittierende Vorrichtung nach einem der Ansprüche 1 bis 14, bevorzugt ferner umfassend einen Dünnfilmtransistor, wobei der Dünnfilmtransistor eine Source-Elektrode (260) und eine Drain-Elektrode (270) umfasst und die erste Elektrode (110) der lichtemittierenden Vorrichtung elektrisch mit einer von der Source-Elektrode oder der Drain-Elektrode des Dünnfilmtransistors verbunden ist und/oder ferner umfassend: einen Farbfilter, eine Farbumwandlungsschicht, eine Touchscreen-Schicht und/oder eine Polarisationsschicht.

## Revendications

**1.** Dispositif électroluminescent comprenant

une première électrode (110) ;
une seconde électrode (150) faisant face à la première électrode ; et
une couche intermédiaire (130) entre la première électrode et la seconde électrode, la couche intermédiaire comprenant une couche émissive,
la couche intermédiaire comprenant en outre :

i) un premier composé ; et
ii) un deuxième composé comprenant au moins un groupe $C_1$-$C_{60}$ cyclique contenant de l'azote pauvre en électrons $\pi$, un troisième composé, un quatrième composé capable d'émettre une lumière fluorescente temporisée, ou toute combinaison de ceux-ci, et

le premier composé, le deuxième composé, le troisième composé et le quatrième composé étant différents les uns des autres,
le premier composé étant représenté par la Formule 1

Formule 1

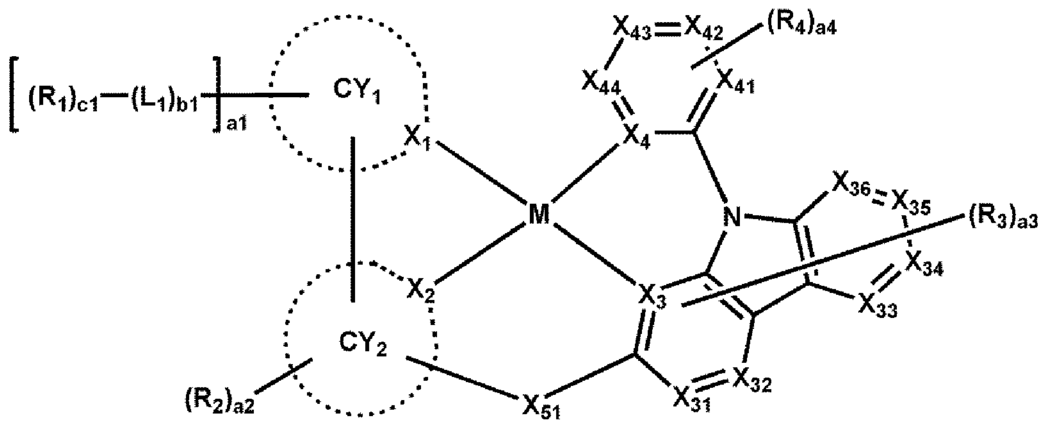

où, dans la Formule 1, M est platine (Pt), palladium (Pd), or (Au), nickel (Ni), argent (Ag), ou cuivre (Cu),
dans la Formule 1, $X_1$ à $X_4$ sont chacun indépendamment C ou N,
dans la Formule 1, i) une liaison entre $X_1$ et M est une liaison de coordination, et ii) l'une d'une liaison entre $X_2$ et M, une liaison entre $X_3$ et M, et une liaison entre $X_4$ et M est une liaison de coordination, et les deux autres liaisons sont chacune une liaison covalente,
dans la Formule 1, l'anneau $CY_1$ est i) un anneau à 5 chaînons contenant $X_1$, ii) un anneau à 5 chaînons contenant $X_1$ condensé avec au moins un anneau à 6 chaînons, ou iii) un anneau à 6 chaînons contenant $X_1$,

dans la Formule 1, l'anneau $CY_2$ est un groupe $C_3$-$C_{60}$ carbocyclique ou un groupe $C_1$-$C_{60}$ hétérocyclique,
dans la Formule 1, $X_{31}$ à $X_{36}$ et $X_{41}$ à $X_{44}$ sont chacun indépendamment C ou N,
dans la Formule 1, $X_{51}$ est *-N($R_5$)-*', *-B($R_5$)-*', *-P($R_5$)-*', *-C($R_{5a}$)($R_{5b}$)-*', *-Si($R_{5a}$)($R_{5b}$)-*', *-Ge($R_{5a}$)($R_{5b}$)-*', *-S-*', *-Se-*', *-O-*', *-C(=O)-*', *-S(=O)-*', *-S(=O)$_2$-*', *-C($R_5$)=*', *=C($R_5$)-*', *-C($R_{5a}$)=C($R_{5b}$)-*', *-C(=S)-*', ou *-C≡C-*', et * et *' indiquent chacun un site de liaison à un atome adjacent,
dans la Formule 1, $L_1$ est une liaison simple, un groupe $C_3$-$C_{60}$ carbocyclique non substitué ou substitué par au moins un $R_{10a}$, ou un groupe $C_1$-$C_{60}$ hétérocyclique non substitué ou substitué par au moins un $R_{10a}$,
dans la Formule 1, b1 est un nombre entier de 1 à 5,
dans la Formule 1, c1 est un nombre entier de 0 à 5, a1 et a4 sont chacun indépendamment un nombre entier de 0 à 4, a2 est un nombre entier de 0 à 10, et a3 est un nombre entier de 0 à 6, étant entendu que la somme de a1 à a4 est 1 ou plus, et qu'au moins un de *-$(L_1)_{b1}$-$(R_1)c_1$(s) dans le nombre de a1, au moins un de $R_2$(S) dans le nombre de a2, au moins un de $R_3$(S) dans le nombre de a3, au moins un de $R_4$(s) dans le nombre de a4, ou toute combinaison de ceux-ci sont chacun indépendamment le groupe représenté par la Formule 1-1 ou le groupe représenté par la Formule 1-2,
dans la Formule 1, $R_1$ à $R_5$, $R_{5a}$, et $R_{5b}$ sont chacun indépendamment un groupe représenté par la Formule 1-1, un groupe représenté par la Formule 1-2, hydrogène, deutérium, -F, -Cl, -Br, -I, un groupe hydroxyle, un groupe cyano, un groupe nitro, un groupe $C_1$-$C_{60}$ alkyle non substitué ou substitué par au moins un $R_{10a}$, un groupe $C_2$-$C_{60}$ alkényle non substitué ou substitué par au moins un $R_{10a}$, un groupe $C_2$-$C_{60}$ alkynyle non substitué ou substitué par au moins un $R_{10a}$, un groupe $C_1$-$C_{60}$ alkoxy non substitué ou substitué par au moins un $R_{10a}$, un groupe $C_3$-$C_{60}$ carbocyclique non substitué ou substitué par au moins un $R_{10a}$, un groupe $C_1$-$C_{60}$ hétérocyclique non substitué ou substitué par au moins un $R_{10a}$, un groupe $C_6$-$C_{60}$ aryloxy non substitué ou substitué par au moins un $R_{10a}$, un groupe $C_6$-$C_{60}$ arylthio non substitué ou substitué par au moins un $R_{10a}$, -C($Q_1$)($Q_2$)($Q_3$), -Si($Q_1$)($Q_2$)($Q_3$), -N($Q_1$)($Q_2$), -B($Q_1$)($Q_2$), -C(=O)($Q_1$), -S(=O)$_2$($Q_1$), ou -P(=O)($Q_1$)($Q_2$),

Formula 1-1

Formule 1-1

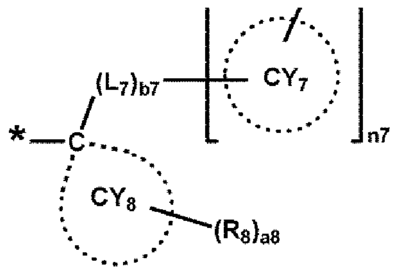

Formule 1-2

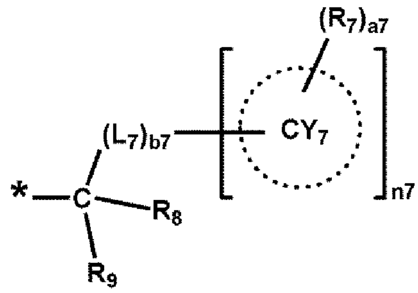

,

dans les Formules 1-1 et 1-2, $L_7$ est une liaison simple, un groupe $C_3$-$C_{60}$ carbocyclique non substitué ou substitué par au moins un $R_{10a}$, ou un groupe $C_1$-$C_{60}$ hétérocyclique non substitué ou substitué par au moins un $R_{10a}$,
dans les Formules 1-1 et 1-2, b7 est un nombre entier de 1 à 5,
dans les Formules 1-1 et 1-2, l'anneau $CY_7$ est un groupe $C_3$-$C_{60}$ carbocyclique ou un groupe $C_1$-$C_{60}$ hétérocyclique,
dans les Formules 1-1 et 1-2, n7 est un nombre entier de 1 à 5,
dans la Formule 1-1, l'anneau $CY_8$ est un groupe $C_3$-$C_{60}$ carbocyclique non aromatique ou un groupe $C_1$-$C_{60}$ hétérocyclique non aromatique,
dans les Formules 1-1 et 1-2, $R_7$ à $R_9$ sont chacun indépendamment identiques à la description relative à $R_1$,
dans les Formules 1-1 et 1-2, a7 et a8 sont chacun indépendamment un nombre entier de 0 à 20,
au moins deux groupes représentés par *-$(L_1)_{b1}$-$(R_1)_{C1}$ dans le nombre de a1 sont éventuellement liés pour former un groupe $C_3$-$C_{60}$ carbocyclique non substitué ou substitué par au moins un $R_{10a}$, ou un groupe $C_1$-$C_{60}$ hétérocyclique non substitué ou substitué par au moins un $R_{10a}$,
au moins deux de $R_2$(S) dans le nombre de a2 sont éventuellement liés pour former un groupe $C_3$-$C_{60}$ carbocyclique non substitué ou substitué par au moins un $R_{10a}$, ou un groupe $C_1$-$C_{60}$ hétérocyclique non substitué ou substitué par au moins un $R_{10a}$,
au moins deux de $R_3$(s) dans le nombre de a3 sont éventuellement liés pour former un groupe $C_3$-$C_{60}$ carbocyclique non substitué ou substitué par au moins un $R_{10a}$, ou un groupe $C_1$-$C_{60}$ hétérocyclique non substitué ou substitué par au moins un $R_{10a}$,
au moins deux de $R_4$(s) dans le nombre de a4 sont éventuellement liés pour former un groupe $C_3$-$C_{60}$ carbo-

cyclique non substitué ou substitué par au moins un $R_{10a}$, ou un groupe $C_1$-$C_{60}$ hétérocyclique non substitué ou substitué par au moins un $R_{10a}$,
au moins deux de $R_1$ à $R_5$, $R_{5a}$, et $R_{5b}$(s) sont éventuellement liés pour former un groupe $C_3$-$C_{60}$ carbocyclique non substitué ou substitué par au moins un $R_{10a}$, ou un groupe $C_1$-$C_{60}$ hétérocyclique non substitué ou substitué par au moins un $R_{10a}$, et
chaque $R_{10a}$ est indépendamment :

deutérium (-D), -F, -Cl, -Br, -I, un groupe hydroxyle, un groupe cyano ou un groupe nitro ;
un groupe $C_1$-$C_{60}$ alkyle, un groupe $C_2$-$C_{60}$ alkényle, un groupe $C_2$-$C_{60}$ alkynyle, ou un groupe $C_1$-$C_{60}$ alkoxy, chacun indépendamment non substitué ou substitué par deutérium, -F, -Cl, - Br, -I, un groupe hydroxyle, un groupe cyano, un groupe nitro, un groupe $C_3$-$C_{60}$ carbocyclique, un groupe $C_1$-$C_{60}$ hétérocyclique, un groupe $C_6$-$C_{60}$ aryloxy, un groupe $C_6$-$C_{60}$ arylthio, -Si($Q_{11}$)($Q_{12}$)($Q_{13}$), - N($Q_{11}$)($Q_{12}$), -B($Q_{11}$)($Q_{12}$), -C(=O)($Q_{11}$), -S(=O)$_2$($Q_{11}$), -P(=O)($Q_{11}$)($Q_{12}$), ou toute combinaison de ceux-ci ;
un groupe $C_3$-$C_{60}$ carbocyclique, un groupe $C_1$-$C_{60}$ hétérocyclique, un groupe $C_6$-$C_{60}$ aryloxy, ou un groupe $C_6$-$C_{60}$ arylthio, chacun indépendamment non substitué ou substitué par deutérium, -F, -Cl, -Br, -I, un groupe hydroxyle, un groupe cyano, un groupe nitro, un groupe $C_1$-$C_{60}$ alkyle, un groupe $C_2$-$C_{60}$ alkényle, un groupe $C_2$-$C_{60}$ alkynyle, un groupe $C_1$-$C_{60}$ alkoxy, un groupe $C_3$-$C_{60}$ carbocyclique, un groupe $C_1$-$C_{60}$ hétérocyclique, un groupe $C_6$-$C_{60}$ aryloxy, un groupe $C_6$-$C_{60}$ arylthio, -Si($Q_{21}$)($Q_{22}$)($Q_{23}$), -N($Q_{21}$)($Q_{22}$), -B($Q_{21}$)($Q_{22}$), -C(=O)($Q_{21}$), -S(=O)$_2$($Q_{21}$), - P(=O)($Q_{21}$)($Q_{22}$), ou toute combinaison de ceux-ci ; ou
-Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), ou - P(=O)($Q_{31}$)($Q_{32}$), et
où $Q_1$ à $Q_3$, $Q_{11}$ à $Q_{13}$, $Q_{21}$ à $Q_{23}$, et $Q_{31}$ à $Q_{33}$ sont chacun indépendamment hydrogène ; deutérium ; -F ; -Cl ; -Br ; -I ; un groupe hydroxyle ; un groupe cyano ; un groupe nitro ; un groupe $C_1$-$C_{60}$ alkyle ; un groupe $C_2$-$C_{60}$ alkényle ; un groupe $C_2$-$C_{60}$ alkynyle ; un groupe $C_1$-$C_{60}$ alkoxy ; un groupe $C_3$-$C_{60}$ carbocyclique ou un groupe $C_1$-$C_{60}$ hétérocyclique, où, lorsqu'il est présent, chaque groupe $C_1$-$C_{60}$ alkyle ; groupe $C_2$-$C_{60}$ alkényle ; groupe $C_2$-$C_{60}$ alkynyle ; groupe $C_1$-$C_{60}$ alkoxy ; groupe $C_3$-$C_{60}$ carbocyclique ou groupe $C_1$-$C_{60}$ hétérocyclique est éventuellement indépendamment substitué par deutérium, -F, un groupe cyano, un groupe $C_1$-$C_{60}$ alkyle, un groupe $C_1$-$C_{60}$ alkoxy, un groupe phényle, un groupe biphényle, un groupe pyridinyle, un groupe pyrimidinyle, un groupe pyridazinyle, un groupe pyrazinyle, un groupe triazinyle, ou toute combinaison de ceux-ci, et,
où le troisième composé comprend un groupe représenté par la Formule 3

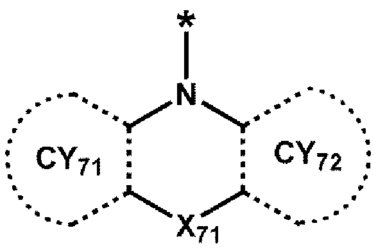

Formule 3

,

dans la Formule 3, l'anneau $CY_{71}$ et l'anneau $CY_{72}$ sont chacun indépendamment un groupe $C_3$-$C_{60}$ cyclique riche en électrons $\pi$ ou un groupe pyridine,
dans la Formule 3, $X_{71}$ est une liaison simple ou un groupe de liaison comprenant O, S, N, B, C, Si, ou toute combinaison de ceux-ci,
dans la Formule 3, * indique un site de liaison à un atome adjacent, et les composés suivants sont exclus du troisième composé :

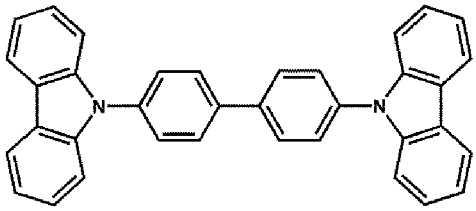

CBP

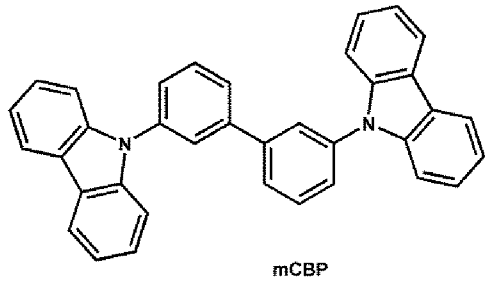

mCBP .

**2.** Dispositif électroluminescent selon la revendication 1, dans lequel le deuxième composé comprend un groupe pyridine, un groupe pyrimidine, un groupe pyrazine, un groupe pyridazine, un groupe triazine, ou toute combinaison de ceux-ci.

**3.** Dispositif électroluminescent selon la revendication 1 ou 2, dans lequel la couche intermédiaire comprend

(i) le deuxième composé ; et/ou
(ii) le troisième composé, le quatrième composé ou toute combinaison de ceux-ci ; et/ou
(iii) le quatrième composé.

**4.** Dispositif électroluminescent selon l'une quelconque des revendications 1 à 3, dans lequel le quatrième composé est un composé comprenant au moins un groupe cyclique comprenant bore (B) et azote (N) comme atomes formant l'anneau.

**5.** Dispositif électroluminescent selon l'une quelconque des revendications 1 à 4, dans lequel le quatrième composé comprend un anneau condensé dans lequel au moins un troisième anneau est condensé avec au moins un quatrième anneau, dans lequel

le troisième anneau est un groupe cyclopentane, un groupe cyclohexane, un groupe cycloheptane, un groupe cyclooctane, un groupe cyclopentène, un groupe cyclohexène, un groupe cycloheptène, un groupe cyclooctène, un groupe adamantane, un groupe norbornène, un groupe norobornane, un groupe bicyclo[1.1.1]pentane, un groupe bicyclo[2.1.1]hexane, un groupe bicyclo[2.2.2]octane, un groupe benzène, un groupe pyridine, un groupe pyrimidine, un groupe pyridazine, un groupe pyrazine ou un groupe triazine, et
le quatrième anneau est un groupe 1,2-azaborinine, un groupe 1,3-azaborinine, un groupe 1,4-azaborinine, un groupe 1,2-dihydro-1,2-azaborinine, un groupe 1,4-oxaborinine, un groupe 1,4-thiaborinine, ou un groupe 1,4-dihydroborinine.

**6.** Dispositif électroluminescent selon l'une quelconque des revendications 1 à 5, dans lequel la couche émissive comprend : i) le premier composé ; et ii) le deuxième composé, le troisième composé, le quatrième composé, ou toute combinaison de ceux-ci, et

le premier composé est capable d'émettre une lumière phosphorescente ou une lumière fluorescente, et
la couche émissive est capable d'émettre la lumière phosphorescente ou la lumière fluorescente émise par le premier composé.

**7.** Dispositif électroluminescent selon l'une quelconque des revendications 1 à 6, dans lequel le premier composé est capable d'émettre une lumière phosphorescente ou une lumière fluorescente, et
la lumière phosphorescente ou la lumière fluorescente est une lumière bleue.

**8.** Dispositif électroluminescent selon l'une quelconque des revendications 1 à 7, dans lequel l'anneau à 5 chaînons contenant $X_1$ dans l'anneau $CY_1$ dans la Formule 1 est un groupe pyrrole, un groupe pyrazole, un groupe imidazole, un groupe triazole, un groupe oxazole, un groupe isooxazole, un groupe thiazole, un groupe isothiazole, un groupe oxadiazole, ou un groupe thiadiazole, et
l'anneau à 6 chaînons qui est condensé avec l'anneau à 5 chaînons contenant $X_1$ dans l'anneau $CY_1$ dans la Formule 1, et l'anneau à 6 chaînons contenant $X_1$ dans l'anneau $CY_1$, sont chacun indépendamment un groupe benzène, un groupe pyridine ou un groupe pyrimidine.

**9.** Dispositif électroluminescent selon l'une quelconque des revendications 1 à 8, dans lequel, dans la Formule 1, a4 est un nombre entier de 1 à 4, et un ou plusieurs de $R_4$(s) dans le nombre de a4 sont chacun indépendamment le groupe représenté par la Formule 1-1 ou le groupe représenté par la Formule 1-2.

**10.** Dispositif électroluminescent selon l'une quelconque des revendications 1 à 9, dans lequel, dans les Formules 1-1 et 1-2, l'anneau $CY_7$ est i) un premier anneau, ii) un deuxième anneau, iii) un anneau condensé dans lequel au moins deux premiers anneaux sont condensés, iv) un anneau condensé dans lequel au moins deux deuxièmes anneaux sont condensés, ou v) un anneau condensé dans lequel au moins un premier anneau et au moins un deuxième anneau sont condensés, où

le premier anneau est un groupe cyclopentane, un groupe cyclohexane, un groupe cycloheptane, un groupe cyclooctane, un groupe cyclopentène, un groupe cyclohexène, un groupe cycloheptène, un groupe cyclooctène, un groupe adamantane, un groupe norbornène, un groupe norobornane, un groupe bicyclo[1.1.1]pentane, un groupe bicyclo[2.1.1]hexane, un groupe bicyclo[2.2.2]octane, ou un groupe benzène, et
le deuxième anneau est un groupe pyrrole, un groupe furane, un groupe thiophène, un groupe silole, un groupe pyrazole, un groupe imidazole, un groupe triazole, un groupe oxazole, un groupe isooxazole, un groupe thiazole, un groupe isothiazole, un groupe oxadiazole, un groupe thiadiazole, un groupe pyridine, un groupe pyrimidine, un groupe pyridazine, un groupe pyrazine, un groupe triazine, un groupe 1,2-azaborinine, un groupe 1,3-azaborinine, un groupe 1,4-azaborinine, un groupe 1,2-dihydro-1,2-azaborinine, un groupe 1,4-oxaborinine, un groupe 1,4-thiaborinine, ou un groupe 1,4-dihydroborinine.

**11.** Dispositif électroluminescent selon l'une quelconque des revendications 1 à 10, dans lequel, dans la Formule 1-1, l'anneau $CY_8$ est un groupe cyclopentane, un groupe cyclohexane, un groupe cycloheptane, un groupe cyclooctane, un groupe cyclopentène, un groupe cyclohèxene, un groupe cycloheptène, un groupe cyclooctène, un groupe adamantane, un groupe norbornène, un groupe norobornane, un groupe bicyclo[1.1.1]pentane, un groupe bicyclo[2.1.1]hexane, ou un groupe bicyclo[2.2.2]octane ; ou dans lequel, dans la Formule 1-1, l'anneau $CY_8$ est un groupe représenté par l'une des Formules CY8-1 à CY8-8 :

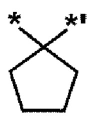
CY8-1
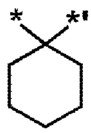
CY8-2
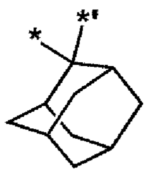
CY8-3
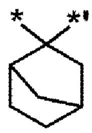
CY8-4
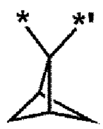
CY8-5
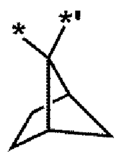
CY8-6
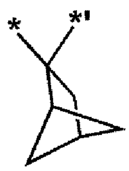
CY8-7

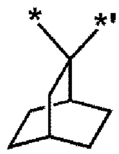
CY8-8

, et où, dans les Formules CY8-1 à CY8-8, * indique un site de liaison à un atome adjacent dans la Formule 1, et *' indique un site de liaison à $L_7$ dans la Formule 1-1.

**12.** Dispositif électroluminescent selon l'une quelconque des revendications 1 à 11, dans lequel le deuxième composé est un composé représenté par la Formule 2 :
Formule 2
où, dans la Formule 2,

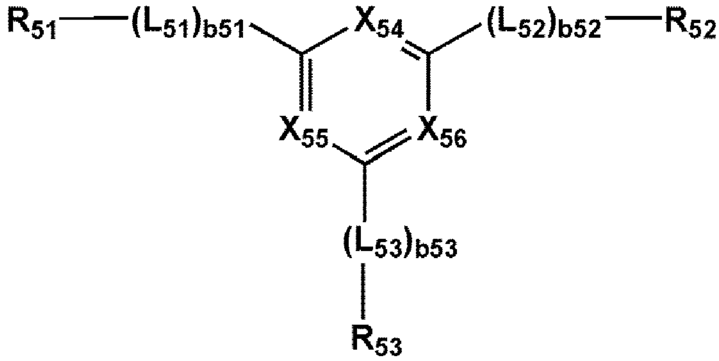

,

et

$L_{51}$ à $L_{53}$ sont chacun indépendamment une liaison simple, un groupe $C_3$-$C_{60}$ carbocyclique non substitué ou substitué par au moins un $R_{10a}$, ou un groupe $C_1$-$C_{60}$ hétérocyclique non substitué ou substitué par au moins un $R_{10a}$,
b51 à b53 sont chacun indépendamment un nombre entier de 1 à 5,
$X_{54}$ est N ou C($R_{54}$), $X_{55}$ est N ou C($R_{55}$), $X_{56}$ est N ou C($R_{56}$), et au moins un élément sélectionné entre $X_{54}$ à $X_{56}$ est N, et
$R_{51}$ à $R_{56}$ sont chacun indépendamment hydrogène, deutérium, -F, -Cl, -Br, -I, un groupe hydroxyle, un groupe cyano, un groupe nitro, un groupe $C_1$-$C_{60}$ alkyle non substitué ou substitué par au moins un $R_{10a}$, un groupe $C_2$-$C_{60}$ alkényle non substitué ou substitué par au moins un $R_{10a}$, un groupe $C_2$-$C_{60}$ alkynyle non substitué ou substitué par au moins un $R_{10a}$, un groupe $C_1$-$C_{60}$ alkoxy non substitué ou substitué par au moins un $R_{10a}$, un groupe $C_3$-$C_{60}$ carbocyclique non substitué ou substitué par au moins $R_{10a}$, un groupe $C_1$-$C_{60}$ hétérocyclique non substitué ou substitué par au moins un $R_{10a}$, un groupe $C_6$-$C_{60}$ aryloxy non substitué ou substitué par au moins un $R_{10a}$, un groupe $C_6$-$C_{60}$ arylthio non substitué ou substitué par au moins un $R_{10a}$, - C($Q_1$)($Q_2$)($Q_3$), -Si($Q_1$)($Q_2$)($Q_3$), -N($Q_1$)($Q_2$), -B($Q_1$)($Q_2$), -C(=O)($Q_1$), -S(=O)$_2$($Q_1$) ou - P(=O)($Q_1$)($Q_2$), où chacun de $R_{10a}$ et $Q_1$ à $Q_3$ est indépendamment identique à la description relative à la Formule 1.

13. Dispositif électroluminescent selon l'une quelconque des revendications 1 à 12, dans lequel le troisième composé est un composé représenté par la Formule 3-1, un composé représenté par la Formule 3-2, un composé représenté par la Formule 3-3, un composé représenté par la Formule 3-4, un composé représenté par la Formule 3-5, ou toute combinaison de ceux-ci :

Formule 3-1

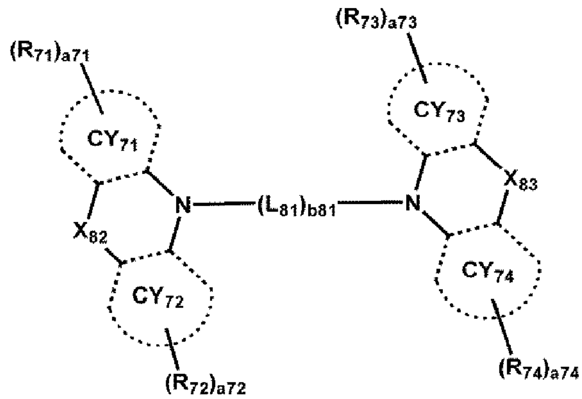

Formule 3-2

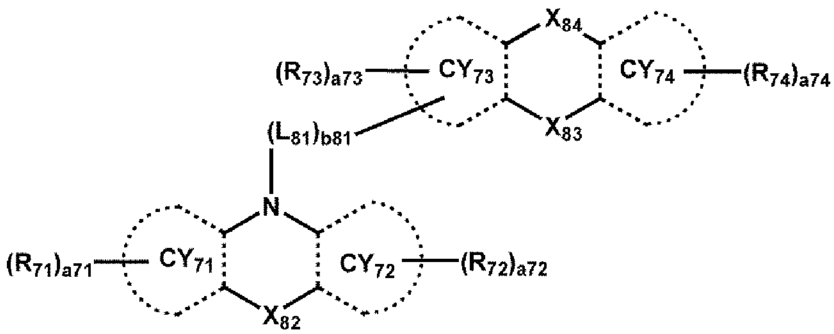

Formule 3-3

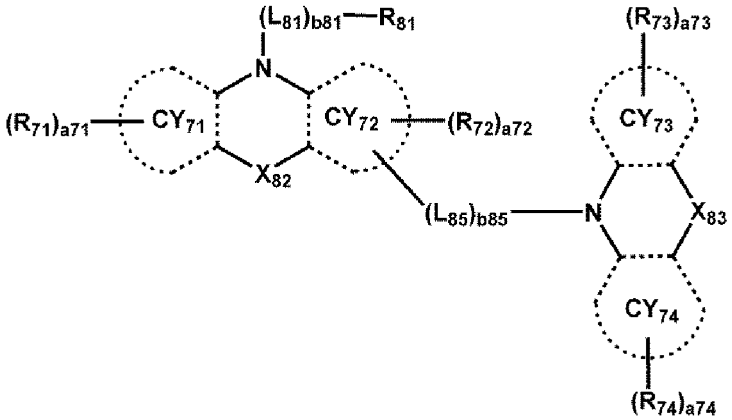

Formule 3-4

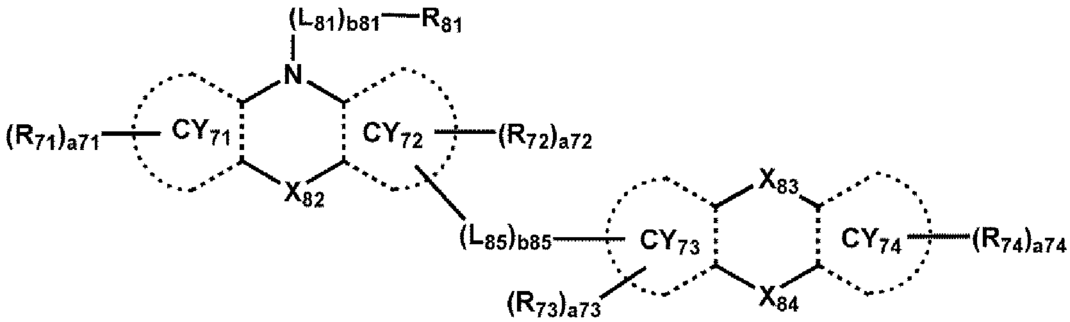

Formule 3-5

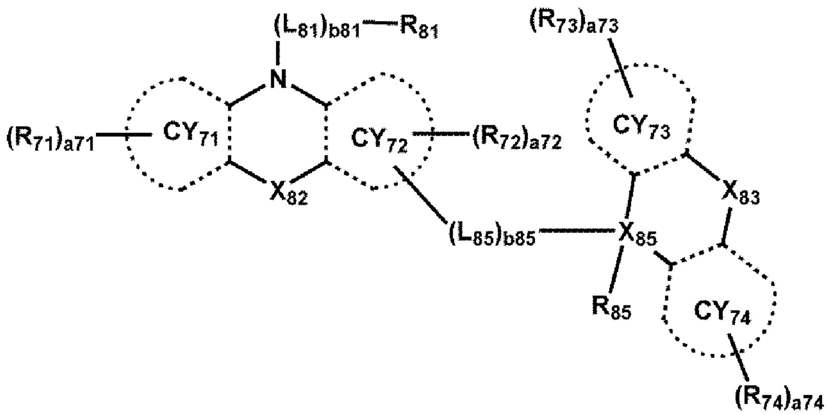

,

et

où, dans les Formules 3-1 à 3-5,

les anneaux $CY_{71}$ à $CY_{74}$ sont chacun indépendamment un groupe $C_3$-$C_{60}$ cyclique riche en électrons $\pi$ ou un groupe pyridine,
$X_{82}$ est une liaison simple, O, S, N-[$(L_{82})_{b82}$-$R_{82}$], $C(R_{82a})(R_{82b})$ ou $Si(R_{82a})(R_{82b})$,
$X_{83}$ est une liaison simple, O, S, N-[$(L_{83})_{b83}$-$R_{83}$], $C(R_{83a})(R_{83b})$ ou $Si(R_{83a})(R_{83b})$,
$X_{84}$ est O, S, N-[$(L_{84})_{b84}$-$R_{84}$], $C(R_{84a})(R_{84b})$ ou $Si(R_{84a})(R_{84b})$,
$X_{85}$ est C ou Si,
$L_{81}$ à $L_{85}$ sont chacun indépendamment une liaison simple, *-C($Q_4$)($Q_5$)-*', *-Si($Q_4$)($Q_5$)-*', un groupe $C_3$-$C_{60}$ cyclique riche en électrons $\pi$ non substitué ou substitué par au moins un $R_{10a}$, ou un groupe pyridine non substitué ou substitué par au moins un $R_{10a}$, où $Q_4$ et $Q_5$ sont chacun entendus par référence à la description de $Q_1$,
b81 à b85 sont chacun indépendamment un nombre entier de 1 à 5,
$R_{71}$ à $R_{74}$, $R_{81}$ à $R_{85}$, $R_{82a}$, $R_{82b}$, $R_{83a}$, $R_{83b}$, $R_{84a}$, et $R_{84b}$ sont chacun indépendamment hydrogène, deutérium, -F, -Cl, -Br, -I, un groupe hydroxyle, un groupe cyano, un groupe nitro, un groupe $C_1$-$C_{60}$ alkyle non substitué ou substitué par au moins un $R_{10a}$, un groupe $C_2$-$C_{60}$ alkényle non substitué ou substitué par au moins un $R_{10a}$, un groupe $C_2$-$C_{60}$ alkynyle non substitué ou substitué par au moins un $R_{10a}$, un groupe $C_1$-$C_{60}$ alkoxy non substitué ou substitué par au moins un $R_{10a}$, un groupe $C_3$-$C_{60}$ carbocyclique non substitué ou substitué par au moins un $R_{10a}$, un groupe $C_1$-$C_{60}$ hétérocyclique non substitué ou substitué par au moins un $R_{10a}$, un groupe $C_6$-$C_{60}$ aryloxy non substitué ou substitué par au moins un $R_{10a}$, un groupe $C_6$-$C_{60}$ arylthio non substitué ou substitué par au moins un $R_{10a}$, -C($Q_1$)($Q_2$)($Q_3$), -Si($Q_1$)($Q_2$)($Q_3$), -N($Q_1$)($Q_2$), -B($Q_1$)($Q_2$), -C(=O)($Q_1$), -S(=O)$_2$($Q_1$) ou -P(=O)($Q_1$)($Q_2$),
a71 à a74 sont chacun indépendamment un nombre entier de 0 à 20 et,
chaque $R_{10a}$ et $Q_1$ à $Q_3$ est indépendamment identique à la description relative à la Formule 1,
* et *' indiquent chacun un site de liaison à un atome adjacent.

**14.** Dispositif électroluminescent selon l'une quelconque des revendications 1 à 13, dans lequel le quatrième composé est un composé représenté par la Formule 502, un composé représenté par la Formule 503, ou toute combinaison de ceux-ci :

Formule 502

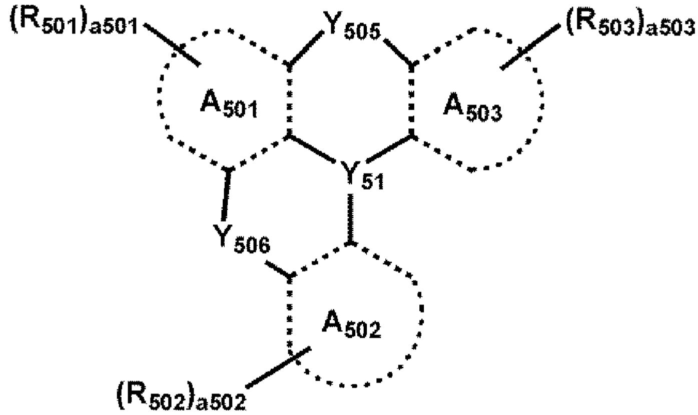

Formule 503

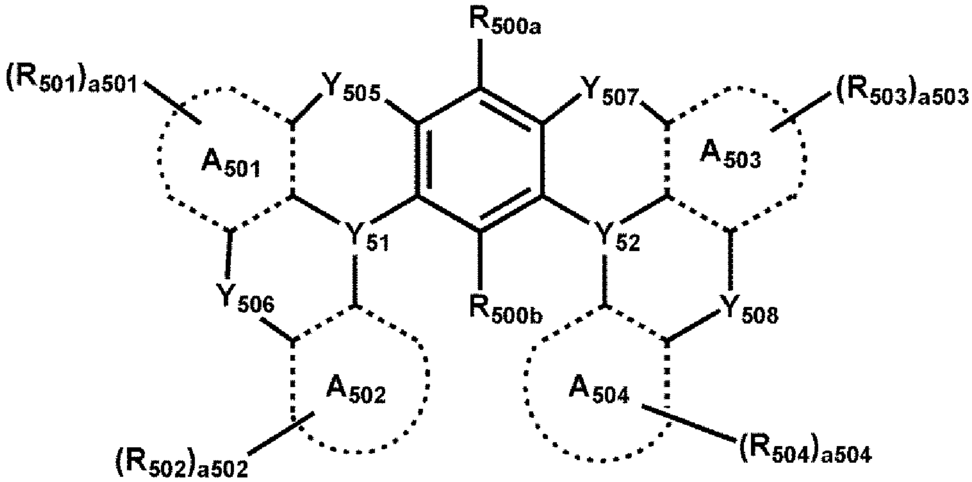

,

et dans lequel, dans les Formules 502 et 503,

les anneaux $A_{501}$ à $A_{504}$ sont chacun indépendamment un groupe $C_3$-$C_{60}$ carbocyclique ou un groupe $C_1$-$C_{60}$ hétérocyclique,
$Y_{505}$ est O, S, $N(R_{505})$, $B(R_{505})$, $C(R_{505a})(R_{505b})$ ou $Si(R_{505a})(R_{505b})$,
$Y_{506}$ est O, S, $N(R_{506})$, $B(R_{506})$, $C(R_{506a})(R_{506b})$ ou $Si(R_{506a})(R_{506b})$,
$Y_{507}$ est O, S, $N(R_{507})$, $B(R_{507})$, $C(R_{507a})(R_{507b})$ ou $Si(R_{507a})(R_{507b})$,
$Y_{508}$ est O, S, $N(R_{508})$, $B(R_{508})$, $C(R_{508a})(R_{508b})$, ou $Si(R_{508a})(R_{508b})$,
$Y_{51}$ et $Y_{52}$ sont chacun indépendamment B, P(=O) ou S(=O),
$R_{500a}$, $R_{500b}$, $R_{501}$ à $R_{508}$, $R_{505a}$, $R_{505b}$, $R_{506a}$, $R_{506b}$, $R_{507a}$, $R_{507b}$, $R_{508a}$ et $R_{508b}$ sont chacun indépendamment hydrogène, deutérium, -F, -Cl, -Br, -I, un groupe hydroxyle, un groupe cyano, un groupe nitro, un groupe $C_1$-$C_{60}$ alkyle non substitué ou substitué par au moins un $R_{10a}$, un groupe $C_2$-$C_{60}$ alkényle non substitué ou substitué par au moins un $R_{10a}$, un $C_2$-$C_{60}$ alkynyle non substitué ou substitué par au moins un $R_{10a}$, un groupe $C_1$-$C_{60}$ alkoxy non substitué ou substitué par au moins un $R_{10a}$, un groupe $C_3$-$C_{60}$ carbocyclique non substitué ou substitué par au moins un $R_{10a}$, un groupe $C_1$-$C_{60}$ hétérocyclique non substitué ou substitué par au moins un $R_{10a}$, un groupe $C_6$-$C_{60}$ aryloxy non substitué ou substitué par au moins un $R_{10a}$, un groupe $C_6$-$C_{60}$ arylthio non substitué ou substitué par au moins un $R_{10a}$, $-C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$ ou $-P(=O)(Q_1)(Q_2)$,
a501 à a504 sont chacun indépendamment un nombre entier de 0 à 20, et
chaque $R_{10a}$ et $Q_1$ à $Q_3$ est indépendamment identique à la description relative à la Formule 1.

**15.** Appareil électronique comprenant le dispositif électroluminescent selon l'une quelconque des revendications 1 à 14, comprenant en outre de préférence un transistor en couches minces, le transistor en couches minces comprenant

une électrode source (260) et une électrode drain (270), et la première électrode (110) du dispositif électroluminescent étant connectée électriquement à l'une de l'électrode source ou de l'électrode drain du transistor en couches minces, et/ou comprenant en outre un filtre coloré, une couche de conversion de couleur, une couche d'écran tactile, et/ou une couche de polarisation.

FIG. 1

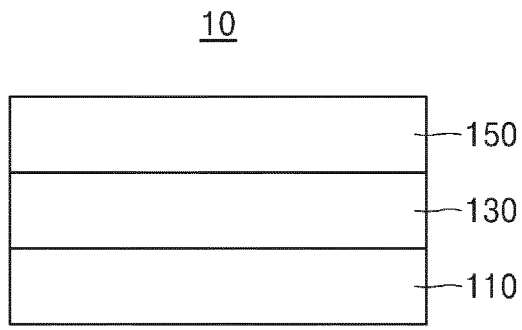

FIG. 2

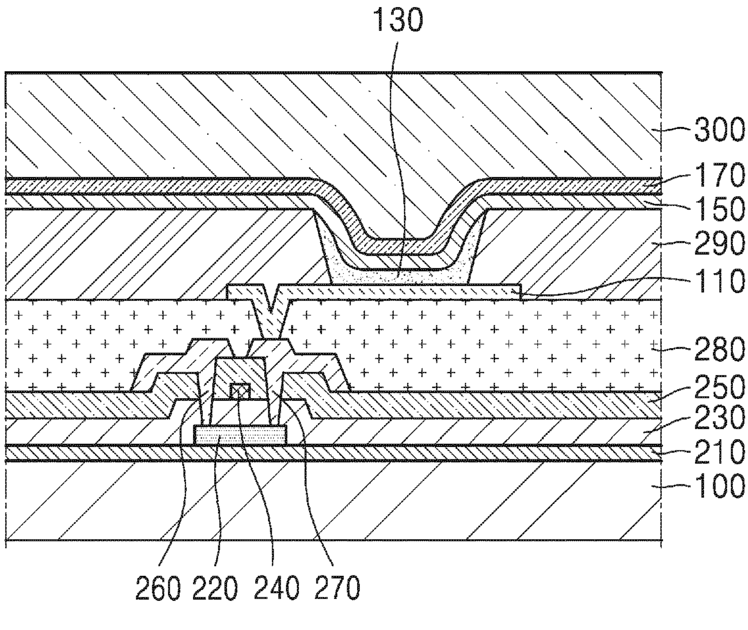

FIG. 3

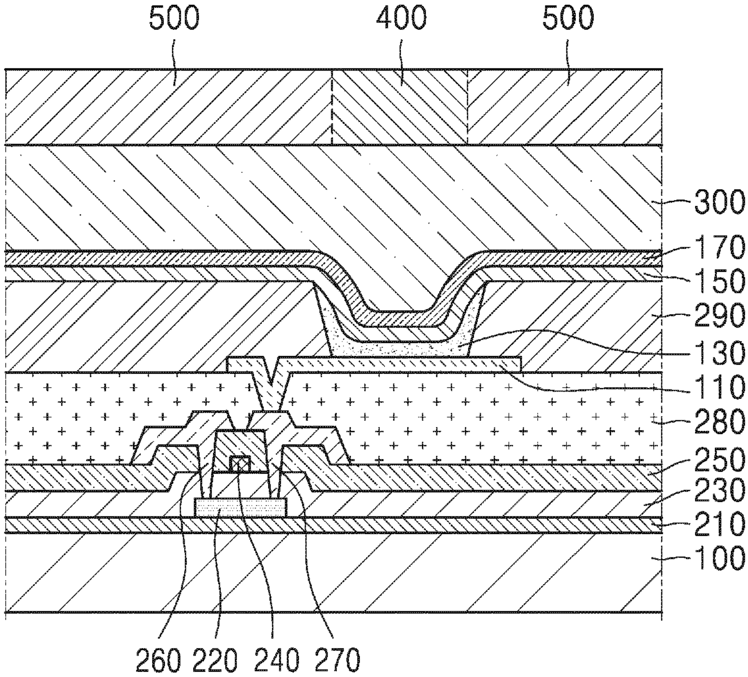
500
400
500
300
170
150
290
130
110
280
250
230
210
100
260 220 240 270

FIG. 4

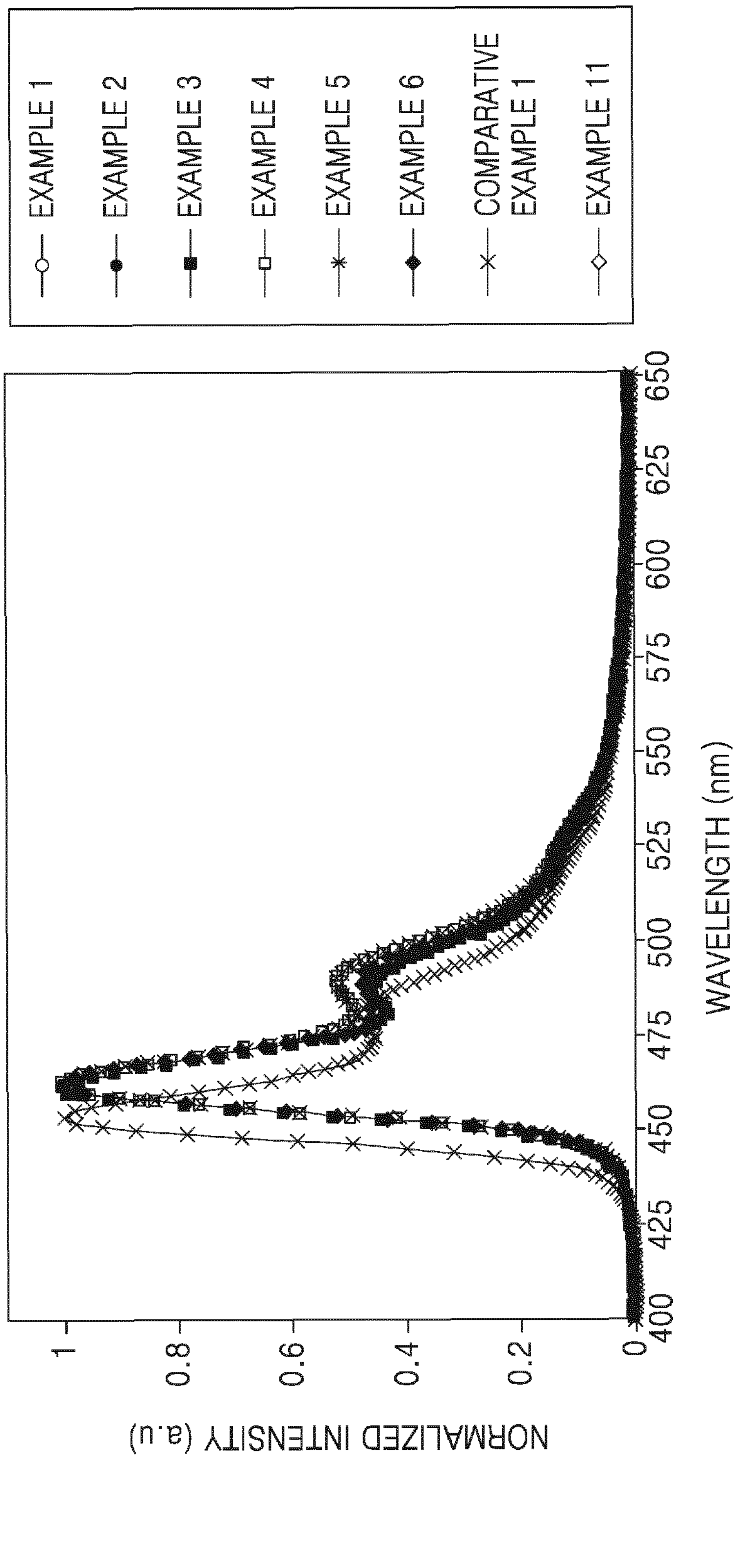

NORMALIZED INTENSITY (a.u)
0
0.2
0.4
0.6
0.8
1
400
425
450
475
500
525
550
575
600
625
650
WAVELENGTH (nm)
EXAMPLE 1
EXAMPLE 2
EXAMPLE 3
EXAMPLE 4
EXAMPLE 5
EXAMPLE 6
COMPARATIVE EXAMPLE 1
EXAMPLE 11

FIG. 5

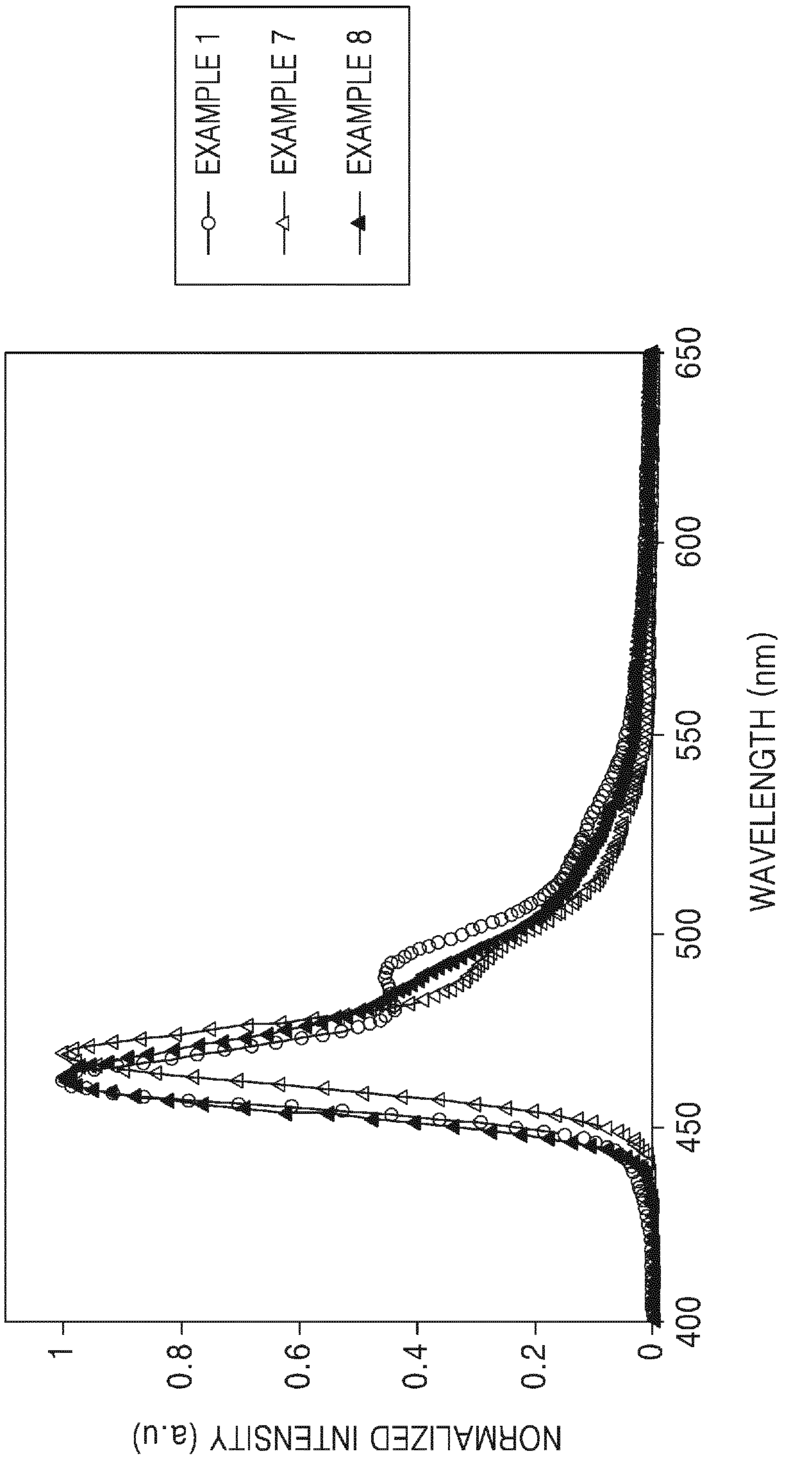

EXAMPLE 1
EXAMPLE 7
EXAMPLE 8
NORMALIZED INTENSITY (a.u)
0
0.2
0.4
0.6
0.8
1
400
450
500
550
600
650
WAVELENGTH (nm)

FIG. 6

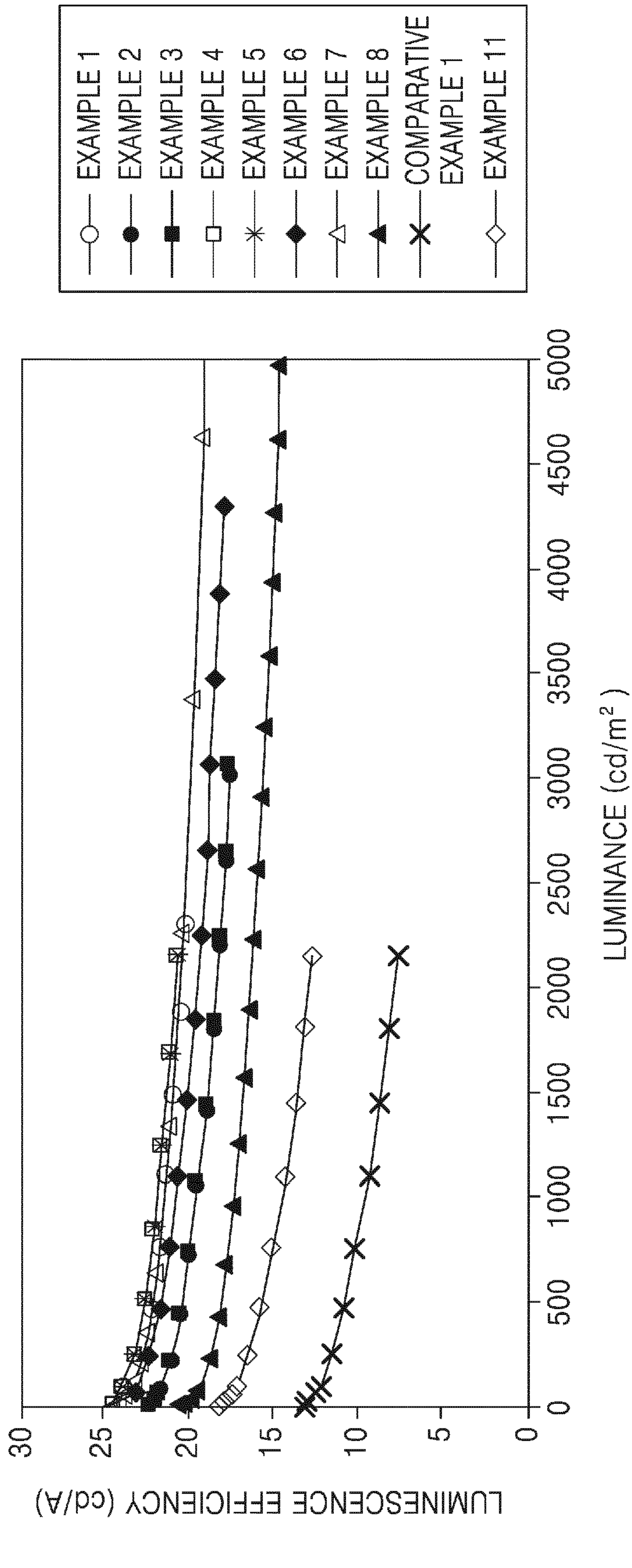

EXAMPLE 1
EXAMPLE 2
EXAMPLE 3
EXAMPLE 4
EXAMPLE 5
EXAMPLE 6
EXAMPLE 7
EXAMPLE 8
COMPARATIVE EXAMPLE 1
EXAMPLE 11
LUMINESCENCE EFFICIENCY (cd/A)
LUMINANCE (cd/m²)
0
5
10
15
20
25
30
500
1000
1500
2000
2500
3000
3500
4000
4500
5000

FIG. 7

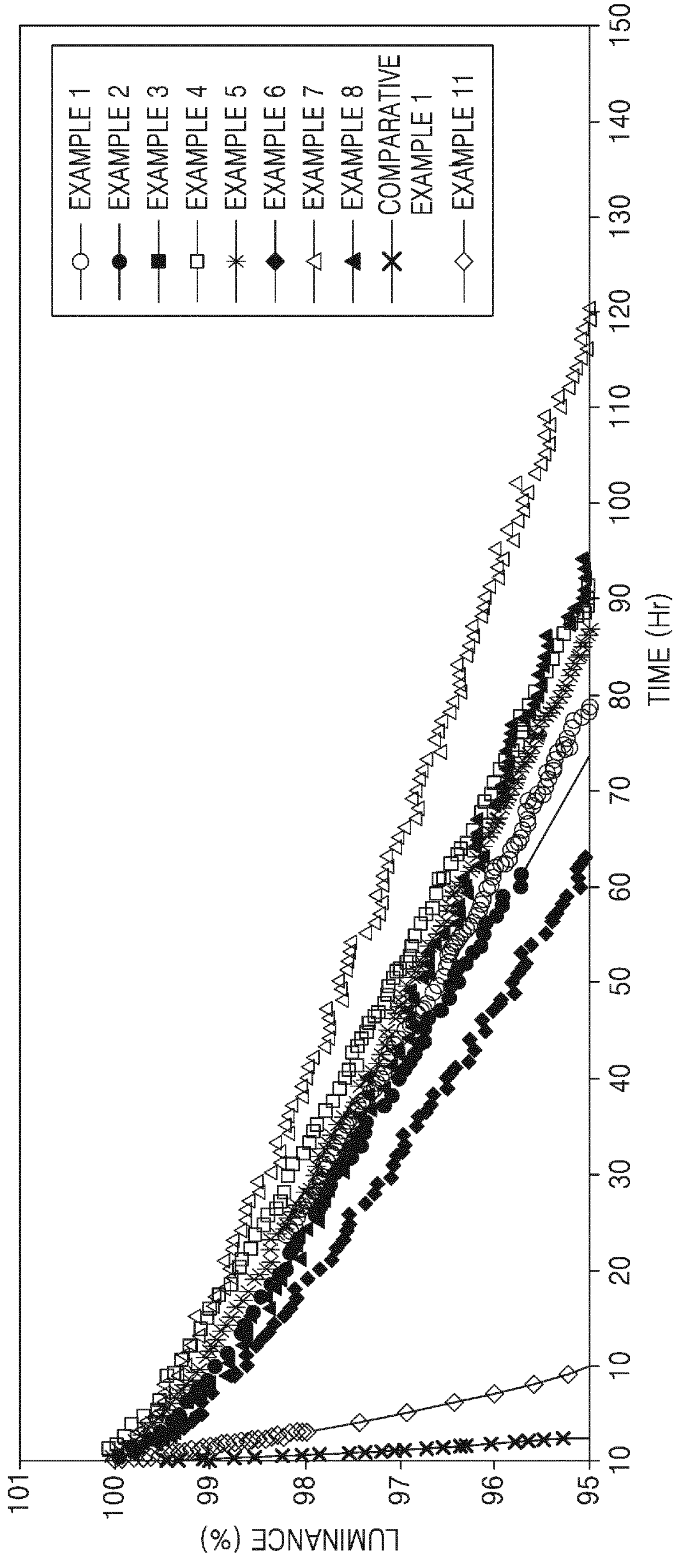
EXAMPLE 1
EXAMPLE 2
EXAMPLE 3
EXAMPLE 4
EXAMPLE 5
EXAMPLE 6
EXAMPLE 7
EXAMPLE 8
COMPARATIVE EXAMPLE 1
EXAMPLE 11
LUMINANCE (%)
101
100
99
98
97
96
95
TIME (Hr)
10
10
20
30
40
50
60
70
80
90
100
110
120
130
140
150

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020200086448
- EP 3544076 A1